(19) Europäisches Patentamt
European Patent Office
Office européen des brevets

(11) EP 4 707 281 A1

(12) EUROPEAN PATENT APPLICATION
published in accordance with Art. 153(4) EPC

(43) Date of publication:
**11.03.2026 Bulletin 2026/11**

(21) Application number: **24800113.3**

(22) Date of filing: **30.04.2024**

(51) International Patent Classification (IPC):
***C07F 5/02*** (2006.01) ***C09D 11/00*** (2014.01)
***C09K 11/06*** (2006.01) ***H10K 50/12*** (2023.01)
***H10K 50/854*** (2023.01) ***H10K 59/00*** (2023.01)
***H10K 59/10*** (2023.01) ***H10K 59/123*** (2023.01)
***H10K 59/65*** (2023.01) ***H10K 59/90*** (2026.01)
***H10K 59/95*** (2026.01) ***H10K 71/12*** (2023.01)
***H10K 85/30*** (2023.01) ***H10K 85/60*** (2023.01)
***H10K 101/20*** (2023.01) ***H10K 101/40*** (2023.01)

(52) Cooperative Patent Classification (CPC):
**C07F 5/02; C09D 11/00; C09K 11/06; H10K 50/12; H10K 50/854; H10K 59/00; H10K 59/10; H10K 59/123; H10K 59/65; H10K 59/90; H10K 59/95; H10K 71/12; H10K 85/30; H10K 85/60;** H10K 2101/20; (Cont.)

(86) International application number:
**PCT/JP2024/016708**

(87) International publication number:
**WO 2024/228382 (07.11.2024 Gazette 2024/45)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **02.05.2023 JP 2023076114**
**26.03.2024 JP 2024049552**

(71) Applicants:
- **Canon Kabushiki Kaisha**
  **Tokyo, 146-8501 (JP)**
- **Kyushu University, National University Corporation**
  **Nishi-ku**
  **Fukuoka-shi**
  **Fukuoka 819-0395 (JP)**

(72) Inventors:
- **FUJISAWA, Kaori**
  **Tokyo 146-8501 (JP)**
- **HOTTA, Katsuyuki**
  **Tokyo 146-8501 (JP)**
- **YAMADA, Takayoshi**
  **Tokyo 146-8501 (JP)**
- **YASUDA, Takuma**
  **Fukuoka-shi, Fukuoka 819-0395 (JP)**
- **PARK, Inseob**
  **Fukuoka-shi, Fukuoka 819-0395 (JP)**
- **MIN, Hyukgi**
  **Fukuoka-shi, Fukuoka 819-0395 (JP)**

(74) Representative: **TBK**
**Bavariaring 4-6**
**80336 München (DE)**

# (54) ORGANIC COMPOUND AND ORGANIC LIGHT EMITTING ELEMENT

(57) An organic compound is represented by formula (1-1) or (1-2) below,

EP 4 707 281 A1

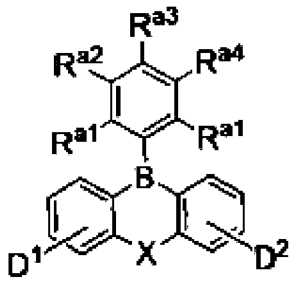
General formula (1-1)

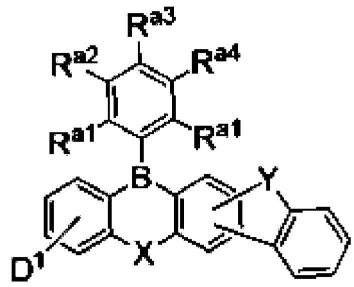
General formula(1-2)

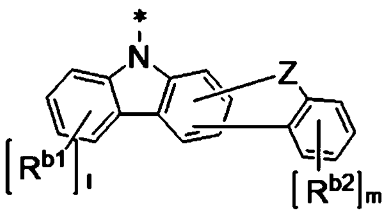
General formula(2-1)

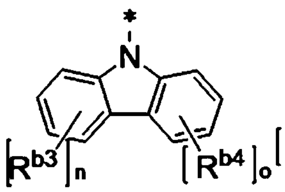
General formula(2-2)

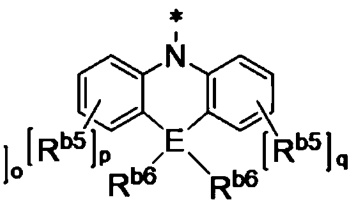
General formula(2-3)

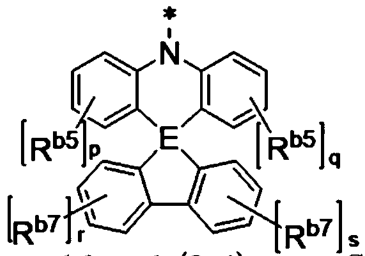
General formula(2-4)

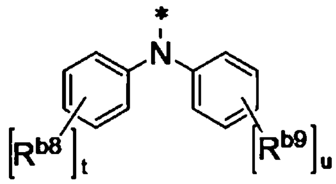
General formula(2-5)

in formulas (1-1) and (1-2), $R^{a1}$ to $R^{a4}$ are each independently selected from a hydrogen atom, an alkyl group, and the like, provided that $R^{a1}$ is not a hydrogen atom, X is a selenium atom or a tellurium atom, Y is selected from an oxygen, and the like, $D^1$ is a group represented by any one of formulas (2-1) to (2-5), $D^2$ is a hydrogen atom or a group represented by any one of formulas (2-1) to (2-5), in formulas (2-1) to (2-5) * represents a binding site, $R^{b1}$ to $R^{b9}$ are each independently selected from a deuterium atom, an alkyl group, and the like, Z is selected from an oxygen atom, and the like, E is a carbon atom, a silicon atom, or a germanium atom, l, m, n, r, or s is an integer of 0 or more and 4 or less, o is an integer of 1 or more and 4 or less, p or q is 0 or 1, and each of t and u is an integer of 0 or more and 5 or less.

(52) Cooperative Patent Classification (CPC): (Cont.)
H10K 2101/40

## Description

### TECHNICAL FIELD

The present invention relates to an organic compound and an organic light emitting element using the organic compound.

### BACKGROUND ART

An organic light emitting element (hereinafter may be referred to as an "organic electroluminescence element" or an "organic EL element") is an electronic element including a first electrode, a second electrode, and an organic compound layer between these electrodes. By injecting electrons and holes from the pair of electrodes, excitons of a light emitting organic compound in the organic compound layer are produced, and the organic EL element emits light when the excitons return to the ground state.

A delayed fluorescence material generally has a structure in which a donor moiety and an acceptor moiety are bound (hereinafter referred to as a "donor acceptor type"). A donor acceptor type delayed fluorescence material in an excited state causes reverse intersystem crossing from an excited triplet state to an excited singlet state, and then radiates fluorescence when returning from the excited singlet state to the ground state. That is to say, not only the excited singlet state but also the excited triplet state can be used for fluorescence emission via the reverse intersystem crossing, and accordingly, a higher light emission efficiency can be achieved with the delayed fluorescence material compared with usual fluorescence materials.

After this principle was found, various delayed fluorescence materials have been found through various studies. As donor acceptor type delayed fluorescence materials, a compound A and a compound B are disclosed in PTL 1 and PTL 2, respectively. Also, it is known to increase the reverse intersystem crossing rate by introducing a heavy atom into a donor acceptor type delayed fluorescence material (NPL 1), and NPL 2 discloses a delayed fluorescence material in which a chalcogen heavy atom is introduced into a compound that exhibits a multiple resonance effect.

[Chem. 1]

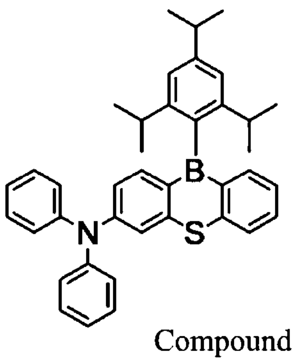

Compound A

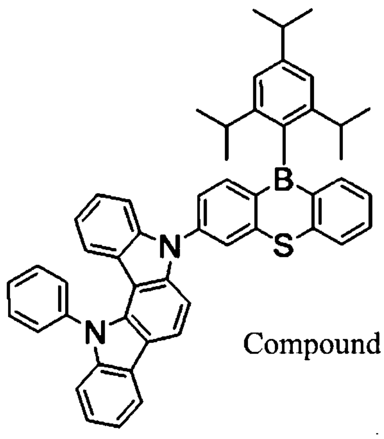

Compound B

On the other hand, a vapor deposition process in which film formation is performed mainly in a vacuum system is widely known as a method for manufacturing an organic EL element, but a light emitting layer is commonly formed by dispersing a light emitting material in a host material, and this is a multi-component vapor deposition process, and accordingly is complex and leads to an increase in the cost. Therefore, non-doped organic EL light emitting layers that are formed using only a light emitting material are also proposed, but it is known that the intensity of light emitted from a light emitting material becomes low when the concentration of the light emitting material is high (hereinafter referred to as "concentration quenching").

### CITATION LIST

### PATENT LITERATURE

PTL 1: International Publication No. 2022/009883
PTL 2: International Publication No. 2015/072537

NON-PATENT LITERATURE

NPL 1: Nat Commun 11, 3909 (2020). s41467
NPL 2: Angew. Chem. Int. Ed.61 (2022). e202205684

SUMMARY OF INVENTION

TECHNICAL PROBLEM

Every material that radiates delayed fluorescence is not necessarily useful as a light emitting material. Some delayed fluorescence materials undergo a reduction in the light emission efficiency (hereinafter referred to as "roll-off") due to accumulation of excitons in a high current density region or rapid degradation (hereinafter may be referred to as "reduction in the element lifespan") when the element is driven for a long period of time. Therefore, a very large number of delayed fluorescence materials actually have room for improvement in their practical utility.

The compound A described in PTL 1 and the compound B described in PTL 2 also have the above-described problems of donor acceptor type delayed fluorescence materials, and there is room for improvement to realize an element with a long lifespan while suppressing the roll-off. Also, the concentration quenching is noticeable in the case of the compound A, and there are problems in realizing a non-doped organic EL light emitting layer. The donor acceptor type delayed fluorescence material disclosed in NPL 1, into which a heavy atom is introduced to increase the reverse intersystem crossing rate, has a high reverse intersystem crossing rate, but has a low light emission efficiency because of the use of bromine as the heavy atom.

SOLUTION TO PROBLEM

The present invention was made in view of the above problems, and has an object of providing a delayed fluorescence material that imparts element characteristics including improved roll-off characteristics and improved lifespan. Another object of the present invention is to provide a non-doped element of which the concentration quenching is suppressed.

An organic compound according to the present invention is characterized by being represented by General formula (1-1) or (1-2) below.

[Chem. 2]

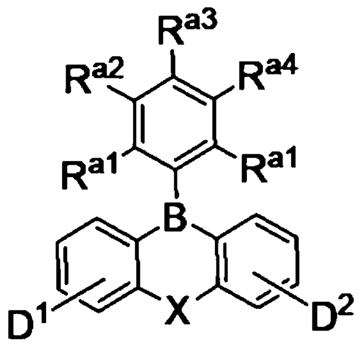

General formula (1-1)

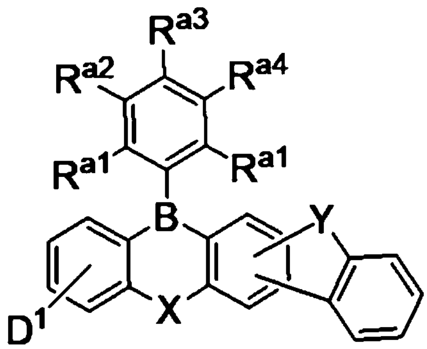

General formula (1-2)

In General formulas (1-1) and (1-2), $R^{a1}$ to $R^{a4}$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group. However, $R^{a1}$ is not a hydrogen atom.

X is a selenium atom or a tellurium atom.

Y is selected from an oxygen atom, a sulfur atom, a selenium atom, a tellurium atom, and a nitrogen atom having an alkyl group or an aryl group as a substituent.

$D^1$ is a group represented by any one of General formulas (2-1) to (2-5) below. $D^2$ is a hydrogen atom or a group represented by any one of General formulas (2-1) to (2-5) below. In General formulas (2-1) to (2-5) below, * represents a binding site.

[Chem. 3]

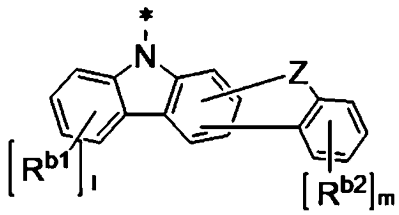

General formula (2-1)

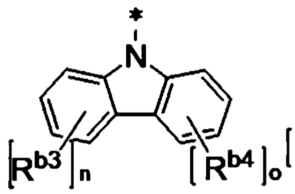

General formula (2-2)

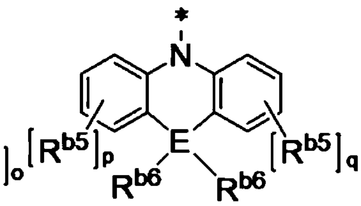

General formula (2-3)

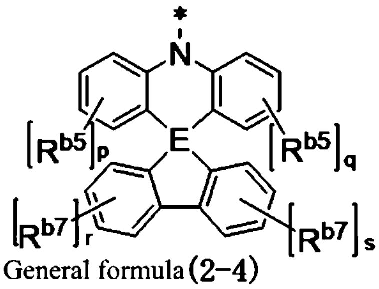

General formula (2-4)

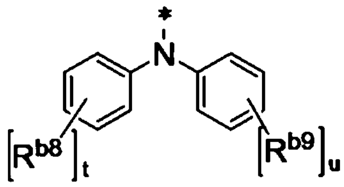

General formula (2-5)

In General formulas (2-1) to (2-5), $R^{b1}$ to $R^{b9}$ are each independently selected from a deuterium atom, a substituted or unsubstituted alkyl group, a substituted or unsubstituted alkoxy group, a substituted or unsubstituted aryl group, a substituted or unsubstituted nitrogen-containing heteroaryl group, and a substituted or unsubstituted amino group.

Z is selected from an oxygen atom, a sulfur atom, a selenium atom, a tellurium atom, and a nitrogen atom having an alkyl group or an aryl group as a substituent.

E is a carbon atom, a silicon atom, or a germanium atom.

Each of 1, m, n, r, and s is an integer of 0 or more and 4 or less. o is an integer of 1 or more and 4 or less. Each of p and q is 0 or 1. Each of t and u is an integer of 0 or more and 5 or less.

Another organic compound according to the present invention is characterized by satisfying Expression (a) below, Expression (b) below, and Expression (c) below, and being represented by any one of General formulas (1-1), (1-2), and (4) to (7) below.

$$k_r > 5 \times 10^5\ s^{-1} \quad \cdots (a)$$

$$k_{RISC}/k_r > 0.2 \quad \cdots (b)$$

$$k_{RISC}/k_{ISC} > 0.001 \quad \cdots (c)$$

$k_r$: a rate constant from an excited singlet state to a ground state

$k_{RISC}$: a reverse intersystem crossing rate constant between the excited singlet state and an excited triplet state

$k_{ISC}$: an intersystem crossing rate constant between the excited singlet state and the excited triplet state

[Chem. 4]

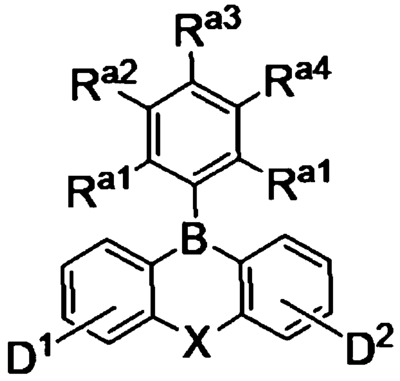

General formula (1-1)

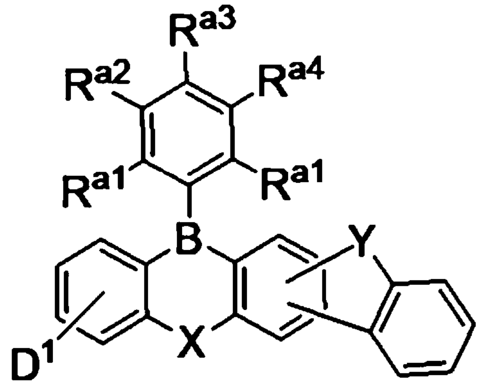

General formula (1-2)

In General formulas (1-1) and (1-2), $R^{a1}$ to $R^{a4}$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group. However, $R^{a1}$ is not a hydrogen atom.

X is a selenium atom or a tellurium atom.

Y is selected from an oxygen atom, a sulfur atom, a selenium atom, a tellurium atom, and a nitrogen atom having an alkyl group or an aryl group as a substituent.

$D^1$ is a group represented by any one of General formulas (2-1) to (2-5) below. $D^2$ is a hydrogen atom or a group represented by any one of General formulas (2-1) to (2-5) below. In General formulas (2-1) to (2-5) below, * represents a binding site.

[Chem. 5]

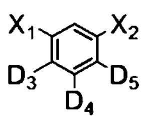

General formula (4)

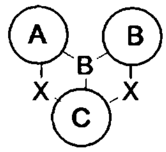

General formula (5)

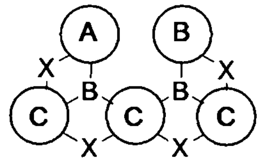

General formula (6)

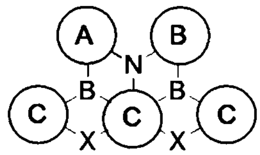

General formula (7)

In General formula (4), $X_1$ and $X_2$ are each independently selected from a hydrogen atom, a deuterium atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group. However, $X_2$ is not a hydrogen atom or a deuterium atom.

$D_3$ to $D_5$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, a cyano group, and groups represented by General formulas (2-1) to (2-5). However, at least one of $D_3$ to $D_5$ is independently selected from the groups represented by General formulas (2-1) to (2-5).

In General formulas (5) to (7), X is selected from an oxygen atom, a sulfur atom, a selenium atom, a tellurium atom, a nitrogen atom having an alkyl group or an aryl group as a substituent, and a single bond.

Rings A to C are each independently selected from a substituted or unsubstituted aryl and a heteroaryl, and the rings A and B may be bound to each other with a single bond.

[Chem. 6]

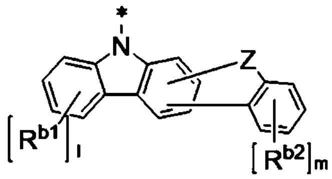

General formula (2-1)

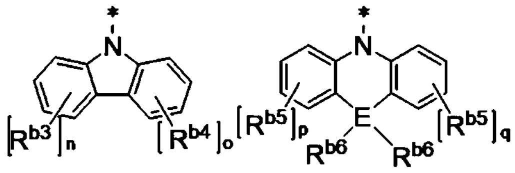

General formula (2-2) General formula (2-3)

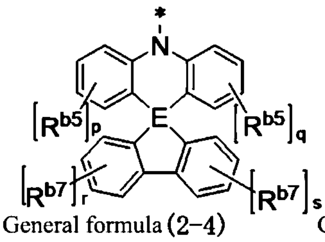

General formula (2-4)

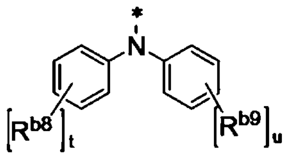

General formula (2-5)

In General formulas (2-1) to (2-5), $R^{b1}$ to $R^{b9}$ are each independently selected from a deuterium atom, a substituted or unsubstituted alkyl group, a substituted or unsubstituted alkoxy group, a substituted or unsubstituted aryl group, a substituted or unsubstituted nitrogen-containing heteroaryl group, and a substituted or unsubstituted amino group.

Z is selected from an oxygen atom, a sulfur atom, a selenium atom, a tellurium atom, and a nitrogen atom having an alkyl group or an aryl group as a substituent.

E is a carbon atom, a silicon atom, or a germanium atom.

Each of 1, m, n, r, and s is an integer of 0 or more and 4 or less. o is an integer of 1 or more and 4 or less. Each of p and q is 0 or 1. Each of t and u is an integer of 0 or more and 5 or less.

ADVANTAGEOUS EFFECTS OF INVENTION

By using the organic compound according to the present invention, it is possible to provide an organic light emitting element with suppressed roll-off characteristics and a long lifespan and a non-doped element of which the concentration quenching is suppressed.

Other features and advantages of the present invention will be apparent from the following description taken in conjunction with the accompanying drawings. Note that the same reference numerals denote the same or like components throughout the accompanying drawings.

BRIEF DESCRIPTION OF DRAWINGS

The accompanying drawings, which are incorporated in and constitute a part of the specification, illustrate embodiments of the invention and, together with the description, serve to explain principles of the invention.

FIG. 1A is a conceptual diagram of a light emitting layer of an organic light emitting element according to an embodiment of the present invention.

FIG. 1B is a conceptual diagram of a light emitting layer of an organic light emitting element according to an embodiment of the present invention.

FIG. 1C is a conceptual diagram of a light emitting layer of an organic light emitting element according to an embodiment of the present invention.

FIG. 1D is a conceptual diagram of a light emitting layer of an organic light emitting element according to an embodiment of the present invention.

FIG. 2A is a schematic cross-sectional view showing an example of a pixel of a display device according to an embodiment of the present invention.

FIG. 2B is a schematic cross-sectional view of an example of a display device in which an organic light emitting element according to an embodiment of the present invention is used.

FIG. 3 is a schematic diagram showing an example of a display device according to an embodiment of the present invention.

FIG. 4A is a schematic diagram showing an example of an imaging device according to an embodiment of the present

invention.

FIG. 4B is a schematic diagram showing an example of an electronic device according to an embodiment of the present invention.

FIG. 5A is a schematic diagram showing an example of a display device according to an embodiment of the present invention.

FIG. 5B is a schematic diagram showing an example of a foldable display device.

FIG. 6A is a schematic diagram showing an example of an illumination device according to an embodiment of the present invention.

FIG. 6B is a schematic diagram showing an example of a movable body including a vehicle lighting device according to an embodiment of the present invention.

FIG. 7A is a schematic diagram showing an example of a wearable device according to an embodiment of the present invention.

FIG. 7B is a schematic diagram showing another example of a wearable device according to an embodiment of the present invention.

FIG. 8A is a schematic diagram showing an example of an image forming device according to an embodiment of the present invention.

FIG. 8B is a schematic diagram showing an example of an exposure light source of the image forming device according to an embodiment of the present invention.

FIG. 8C is a schematic diagram showing an example of the exposure light source of the image forming device according to an embodiment of the present invention.

DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

(1) Organic compound

First, the following describes an organic compound according to the present invention. The organic compound according to the present invention is an organic compound represented by General formula (1-1) or (1-2) below. There is no particular limitation on the types of isotopes of hydrogen atoms present in a molecule of the organic compound according to the present invention, and all hydrogen atoms present in the molecule may be $^{1}H$ or some or all of them may be $^{2}H$ (deuterium), for example. The organic compound according to the present invention may be a compound that exhibits delayed fluorescence and may be a compound that exhibits thermally activated delayed fluorescence (TADF).

[Chem. 7]

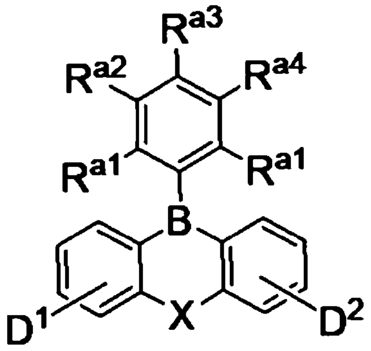

General formula (1-1)

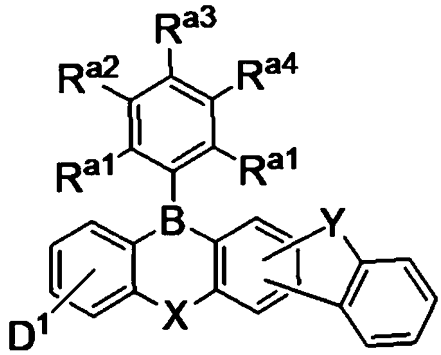

General formula(1-2)

<$Ra^1$ to $Ra^4$>

In General formulas (1-1) and (1-2), $R^{a1}$ to $R^{a4}$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group. However, $R^{a1}$ is not a hydrogen atom.

$R^{a1}$ and $R^{a3}$ are each preferably an alkyl group, more preferably an alkyl group having 1 to 3 carbon atoms, and further preferably a methyl group or an isopropyl group. $R^{a2}$ and $R^{a4}$ are preferably hydrogen atoms. $R^{a1}$s may be the same as each other or different from each other.

The alkyl group may be an alkyl group having 1 to 20 carbon atoms. Examples of the alkyl group include a methyl group, an ethyl group, a normal propyl group, an isopropyl group, a normal butyl group, a tertiary butyl group, a secondary butyl group, a pentyl group, a hexyl group, an octyl group, a cyclohexyl group, a tertiary pentyl group, and a 3-methylpentane-3-yl group, but are not limited to these.

Examples of the alkoxy group include the above alkyl groups substituted with oxygen, but are not limited to these.

The aryl group may be an aryl group having 6 to 20 carbon atoms. Examples of the aryl group include a phenyl group and a naphthyl group, but are not limited to these.

The heterocyclic group may be a heterocyclic group having 3 to 24 carbon atoms. Examples of the heterocyclic group include a pyridyl group, a carbazolyl group, an acridinyl group, and a phenanthrolyl group, but are not limited to these.

Examples of the aralkyl group include a benzyl group, but are not limited to this.

Examples of the amino group include a dimethylamino group, a diethylamino group, a dibenzylamino group, a diphenylamino group, and a ditolylamino group, but are not limited to these.

Examples of substituents that the alkyl group, the alkoxy group, the aryl group, the heterocyclic group, the aralkyl group, and the amino group may further have include: alkyl groups such as a methyl group, an ethyl group, a normal propyl group, an isopropyl group, a normal butyl group, and a tertiary butyl group; aralkyl groups such as a benzyl group; aryl groups such as a phenyl group and a biphenyl group; heteroaryl groups such as a pyridyl group, a pyrrolyl group, a pyrazoyl group, and a triazyl group; amino groups such as a dimethylamino group, a diethylamino group, a dibenzylamino group, a diphenylamino group, and a ditolylamino group; alkoxy groups such as a methoxy group, an ethoxy group, and a propoxy group; aryloxy groups such as a phenoxy group; a deuterium atom; and a cyano group, but are not limited to these.

<X>

In General formulas (1-1) and (1-2), X is a selenium atom or a tellurium atom.

<Y>

In General formulas (1-1) and (1-2), Y is selected from an oxygen atom, a sulfur atom, a selenium atom, a tellurium atom, and a nitrogen atom having an alkyl group or an aryl group as a substituent.

Examples of the alkyl group and the aryl group include groups similar to those described regarding $Ra^1$ to $Ra^4$, but are not limited to these. The alkyl group and the aryl group may further have substituents, and examples of those substituents include groups similar to those described regarding $Ra^1$ to $Ra^4$, but are not limited to these.

<$D^1$, $D^2$>

In General formulas (1-1) and (1-2), $D^1$ is a group represented by any one of General formulas (2-1) to (2-5) below. $D^2$ is a hydrogen atom or a group represented by any one of General formulas (2-1) to (2-5) below. In General formulas (2-1) to (2-5) below, * represents a binding site.

[Chem. 8]

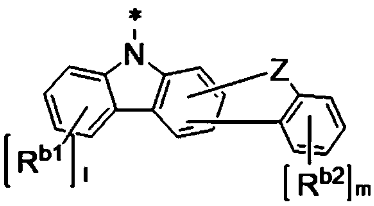

General formula (2-1)

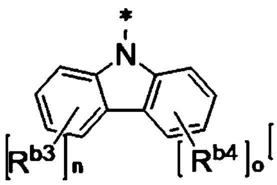

General formula (2-2)

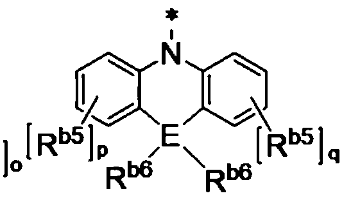

General formula (2-3)

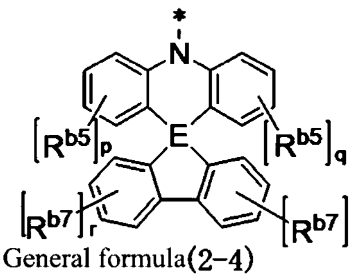

General formula (2-4)

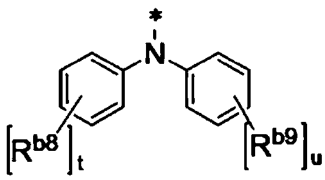

General formula (2-5)

<Rb' to $Rb^9$>

In General formulas (2-1) to (2-5), $R^{b1}$ to $R^{b9}$ are each independently selected from a deuterium atom, a substituted or unsubstituted alkyl group, a substituted or unsubstituted alkoxy group, a substituted or unsubstituted aryl group, a substituted or unsubstituted nitrogen-containing heteroaryl group, and a substituted or unsubstituted amino group.

If 1 and m in General formula (2-1) are integers of 2 or more, $R^{b1}$s may be the same as each other or different from each other, and $R^{b2}$s may be the same as each other or different from each other. If n and o in General formula (2-2) are integers of 2 or more, $R^{b3}$s may be the same as each other or different from each other, and $R^{b4}$s may be the same as each other or different from each other. In General formula (2-3), $R^{b5}$s may be the same as each other or different from each other, and $R^{b6}$s may be the same as each other or different from each other. In General formula (2-4), $R^{b5}$s may be the same as each other or different from each other, and $R^{b7}$s may be the same as each other or different from each other, and if r and s are integers of 2 or more, $R^{b7}$s may be the same as each other or different from each other. If t and u in General formula (2-5) are integers of 2 or more, $R^{b8}$s may be the same as each other or different from each other, and $R^{b9}$s may be the same as each other or different from each other.

Examples of the alkyl group, the alkoxy group, the aryl group, and the amino group include groups similar to those described regarding $Ra^1$ to $Ra^4$, but are not limited to these.

The nitrogen-containing heteroaryl group may be a nitrogen-containing heteroaryl group having 3 to 24 carbon atoms. Examples of the nitrogen-containing heteroaryl group include a pyridyl group, a carbazolyl group, an acridinyl group, and a phenanthrolyl group, but are not limited to these.

Examples of substituents that the alkyl group, the alkoxy group, the aryl group, the nitrogen-containing heteroaryl group, and the amino group may further have include groups similar to those described regarding $Ra^1$ to $Ra^4$, but are not limited to these.

<Z>

In General formulas (2-1) to (2-5), Z is selected from an oxygen atom, a sulfur atom, a selenium atom, a tellurium atom, and a nitrogen atom having an alkyl group or an aryl group as a substituent.

Examples of the alkyl group and the aryl group include groups similar to those described regarding $Ra^1$ to $Ra^4$, but are not limited to these. The alkyl group and the aryl group may further have substituents, and examples of those

substituents include groups similar to those described regarding $Ra^1$ to $Ra^4$, but are not limited to these.

<E>

In General formulas (2-1) to (2-5), E is a carbon atom, a silicon atom, or a germanium atom.

<l to u>

In General formula (2-1), each of l and m is an integer of 0 or more and 4 or less. In General formula (2-2), n is an integer of 0 or more and 4 or less, and o is an integer of 1 or more and 4 or less. In General formulas (2-3) and (2-4), each of p and q is 0 or 1. In General formula (2-4), each of r and s is an integer of 0 or more and 4 or less. In General formula (2-5), each of t and u is an integer of 0 or more and 5 or less.

A more preferable compound is represented by General formula (1-3) below and emits light within a range from blue to green.

[Chem. 9]

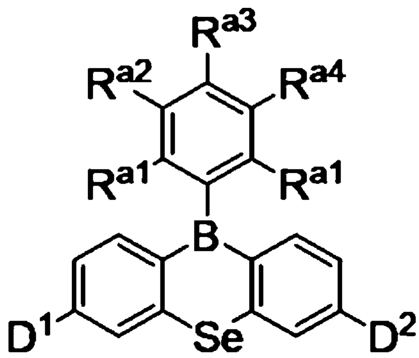

General formula (1-3)

In order to prevent concentration quenching, it is preferable that $D^1$ is a group represented by any one of General formulas (2-1) to (2-4), and $D^2$ is a hydrogen atom or a group represented by any one of General formulas (2-1) to (2-4). More preferably, $D^1$ is a group represented by any one of General formulas (3-1) to (3-4) below, and $D^2$ is a hydrogen atom or a group represented by any one of General formulas (3-1) to (3-4) below.

[Chem. 10]

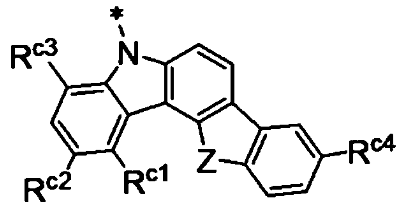

General formula (3-1)

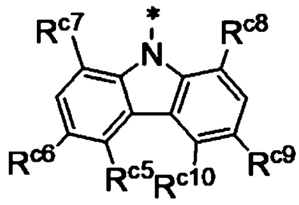

General formula (3-2)

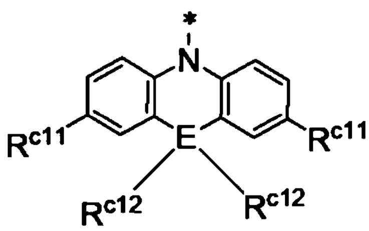

General formula (3-3)

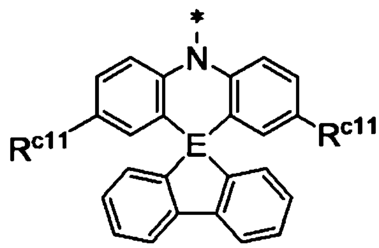

General formula (3-4)

In General formulas (3-1) and (3-2), $R^{c1}$ to $R^{c10}$ are each independently selected from a hydrogen atom, a deuterium atom, a substituted or unsubstituted alkyl group, a substituted or unsubstituted alkoxy group, a substituted or unsubstituted phenyl group, a substituted or unsubstituted carbazole group, and a substituted or unsubstituted diphenylamino group. However, at least one of $R^{c8}$ to $R^{c10}$ is not a hydrogen atom.

In General formulas (3-3) and (3-4), $R^{c11}$s are each independently selected from a hydrogen atom, a methyl group, an isopropyl group, and a tertiary butyl group. $R^{c12}$s are each independently selected from a methyl group and a substituted or unsubstituted phenyl group.

The group represented by any one of General formulas (2-1) to (2-5) is preferably any one of groups represented by Dal to Dw4 below. The group represented by Dal is a group represented by General formula (2-5), and the groups represented by Db1 to Dw4 are groups represented by any one of General formulas (2-1) to (2-4). Also, the groups represented by Df1 to Dw4 are groups represented by any one of General formulas (3-1) to (3-4).

[Chem. 11]

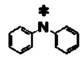
Da 1

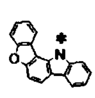
Db 1

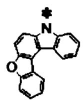
Db 2

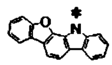
Db 3

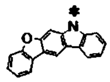
Db 4

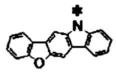
Db 5

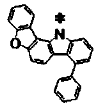
Db 6

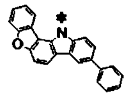
Db 7

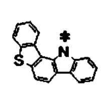
Dc 1

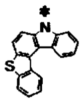
Dc 2

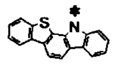
Dc 3

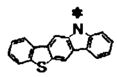
Dc 4

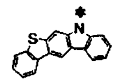
Dc 5

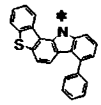
Dc 6

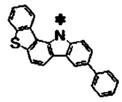
Dc 7

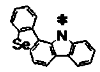
Dd 1

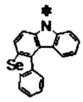
Dd 2

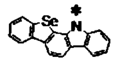
Dd 3

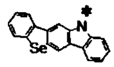
Dd 4

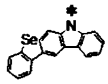
Dd 5

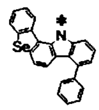
Dd 6

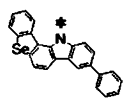
Dd 7

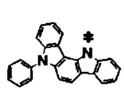
De 1

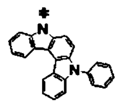
De 2

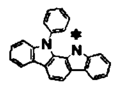
De 3

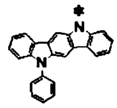
De 4

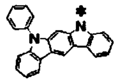
De 5

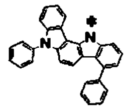
De 6

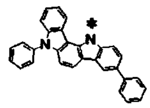
De 7

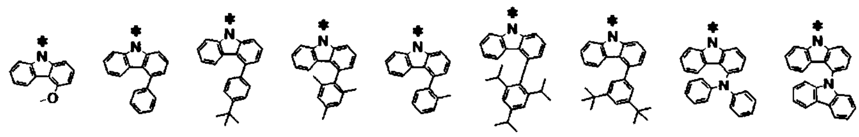
Df 1 Df 2 Df 3 Df 4 Df 5 Df 6 Df 7 Df 8 Df 9

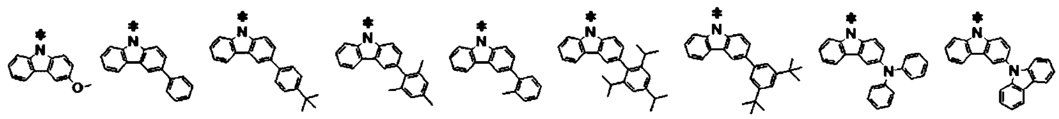
Dg 1 Dg 2 Dg 3 Dg 4 Dg 5 Dg 6 Dg 7 Dg 8 Dg 9

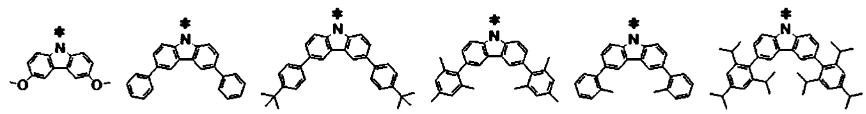
Dh 1 Dh 2 Dh 3 Dh 4 Dh 5 Dh 6

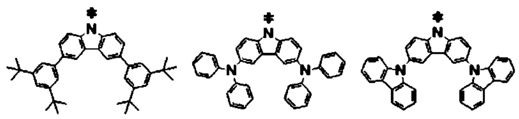
Dh 7 Dh 8 Dh 9

[Chem. 12]

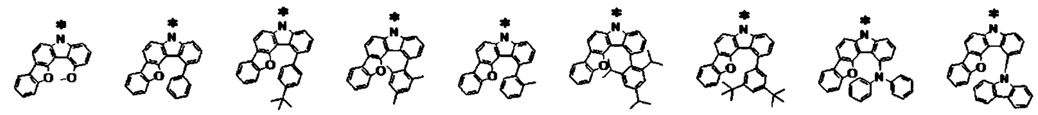

Di 1 Di 2 Di 3 Di 4 Di 5 Di 6 Di 7 Di 8 Di 9

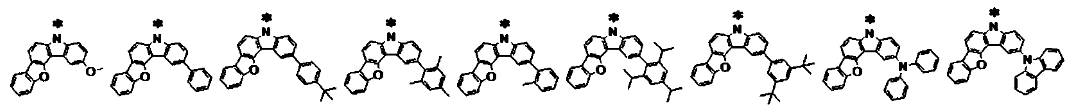

Dj 1 Dj 2 Dj 3 Dj 4 Dj 5 Dj 6 Dj 7 Dj 8 Dj 9

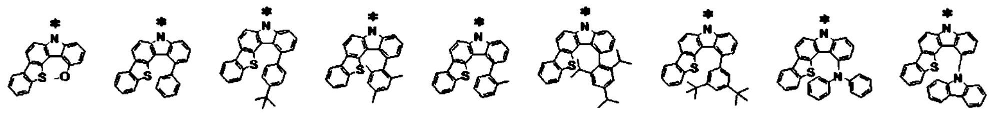

Dk 1 Dk 2 Dk 3 Dk 4 Dk 5 Dk 6 Dk 7 Dk 8 Dk 9

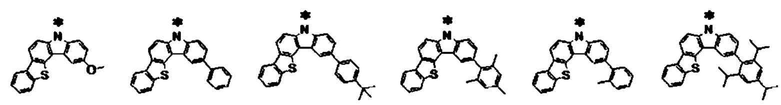

Dl 1 Dl 2 Dl 3 Dl 4 Dl 5 Dl 6

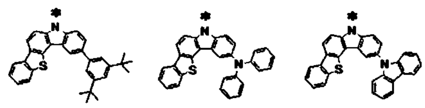

Dl 7 Dl 8 Dl 9

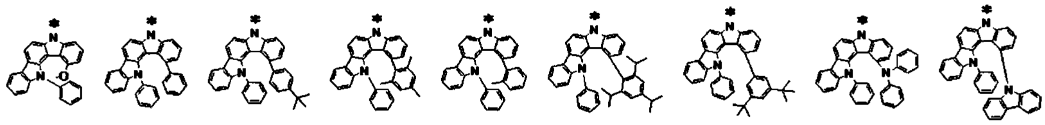

Dm1 Dm2 Dm3 Dm4 Dm5 Dm6 Dm7 Dm8 Dm9

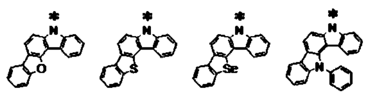

Dn 1 Dn 2 Dn 3 Dn 4

[Chem. 13]

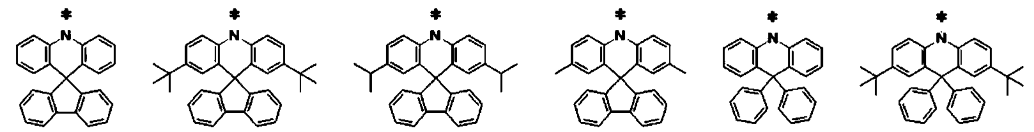

Do1 Do2 Do3 Do4 Dp1 Dp2

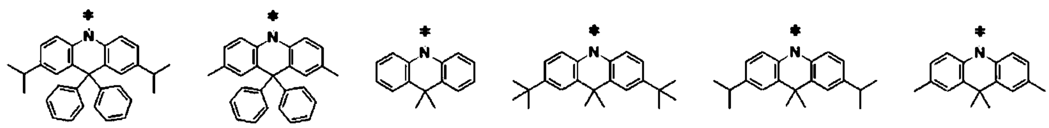

Dp3 Dp4 Dq1 Dq2 Dq3 Dq4

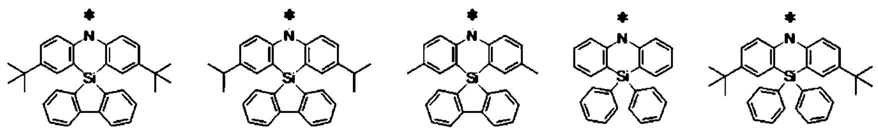

Dr1 Dr2 Dr3 Dr4 Ds1 Ds2

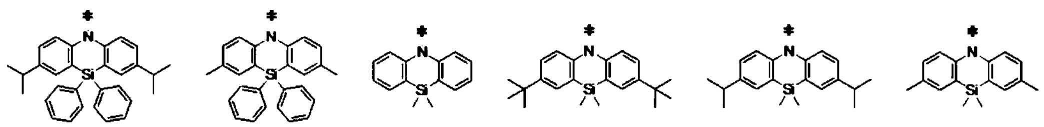

Ds3 Ds4 Dt1 Dt2 Dt3 Dt4

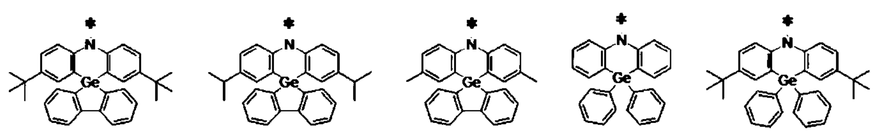

Du1 Du2 Du3 Du4 Dv1 Dv2

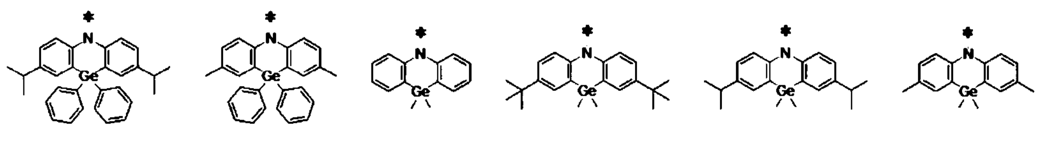

Dv3 Dv4 Dw1 Dw2 Dw3 Dw4

<Characteristics>

The organic compound represented by General formula (1-1) or (1-2) has the following characteristics.

(1) A heteraborin skeleton into which Se or Te is introduced is used, and a bulky aryl group is introduced to boron, and therefore, a high reverse intersystem crossing rate and a long element lifespan can be achieved.

(2) A bulky donor type substituent is used, and therefore, the roll-off characteristics can be suppressed well, and even when the organic compound is used as an assist dopant in a non-doped element, a long lifespan can be achieved and the roll-off characteristics can be suppressed well.
(3) When a bulkier substituent is used, concentration quenching can be suppressed, and when the organic compound is used as a dopant for a non-doped element, a long lifespan can be achieved and the roll-off characteristics can be suppressed well.

The following describes these characteristics.

(1) A heteraborin skeleton into which Se or Te is introduced is used, and a bulky aryl group is introduced to boron, and therefore, a high reverse intersystem crossing rate and a long element lifespan can be achieved.
It is known that the reverse intersystem crossing rate of a donor acceptor type delayed fluorescence material becomes higher when the heavy atom effect is used, but there is a problem in the selection of an appropriate heavy atom. The inventors of the present invention conducted intensive studies and conceived that a chalcogen heavy element such as Se or Te would increase the reverse intersystem crossing rate without impairing light emission properties. In the organic compound according to the present embodiment, a heteraborin skeleton into which Se or Te is introduced is used, and a bulky aryl group, e.g., a phenyl group in which Ra1 is not a hydrogen atom is introduced to boron, and therefore, a high reverse intersystem crossing rate and a long element lifespan can be achieved.
(2) A bulky donor type substituent is used, and therefore, the roll-off characteristics can be suppressed well, and even when the organic compound is used as an assist dopant in a non-doped element, a long lifespan can be achieved and the roll-off characteristics can be suppressed well.
In general, concentration quenching occurs due to interaction between molecules. The inventors of the present invention conceived that, if a bulky substituent is used, concentration quenching will be prevented, and the introduction of a substituent larger than the heteraborin skeleton will lead to improvement of element characteristics. In the organic compound according to the present embodiment, a donor type substituent larger than the heteraborin skeleton, e.g., a group represented by any one of General formulas (2-1) to (2-5) is introduced. Therefore, the organic compound according to the present embodiment can suppress the roll-off characteristics well, and even when the organic compound is used as an assist dopant in a non-doped element, a long lifespan can be achieved and the roll-off characteristics can be suppressed well.
(3) When a bulkier donor type substituent is used, concentration quenching can be suppressed, and when the organic compound is used as a dopant for a non-doped element, a long lifespan can be achieved and the roll-off characteristics can be suppressed well.

The inventors of the present invention conceived that concentration quenching will be suppressed more effectively when a bulkier donor type substituent is used. The inventors conceived that such a light emitting material can be used as a dopant for a non-doped element for which concentration quenching has a significant influence on the element efficiency. By using a bulkier donor type substituent in the organic compound according to the present embodiment, it is possible to suppress concentration quenching, and when the organic compound is used as a dopant for a non-doped element, a high efficiency and a long lifespan can be achieved and the roll-off characteristics can be suppressed well.

<Specific Examples>

The following shows specific examples of the organic compound represented by General formula (1-1) or (1-2). However, the present invention is not limited to these examples.
Organic compounds shown in Groups 1 to 20 are organic compounds represented by General formula (1-1), and organic compounds shown in Groups 21 to 30 are organic compounds represented by General formula (1-2). Also, the organic compounds shown in Groups 1 to 19 are organic compounds represented by General formula (1-3). The organic compounds shown in Groups 2 to 20 are organic compounds in which $D^1$ is a group represented by any one of General formulas (2-1) to (2-4), and $D^2$ is a hydrogen atom or a group represented by any one of General formulas (2-1) to (2-4). The organic compounds shown in Groups 6 to 20 are compounds in which $D^1$ is a group represented by any one of General formulas (3-1) to (3-4), and $D^2$ is a hydrogen atom or a group represented by any one of General formulas (3-1) to (3-4).

[Chem. 14]

[Group 1]

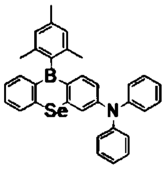
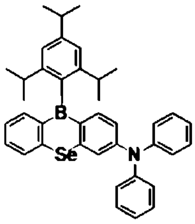
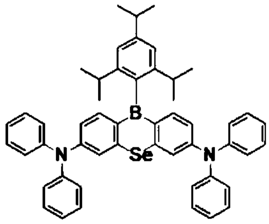
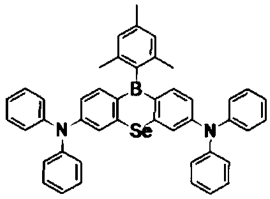

[Chem. 15]

[Group 2-1]

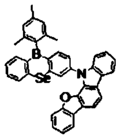
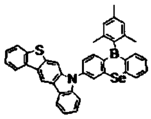
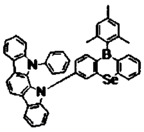
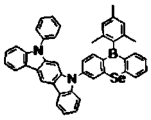
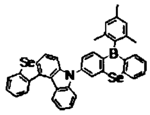
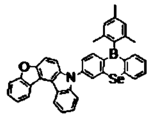
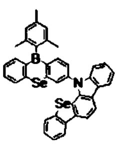
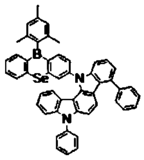
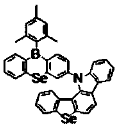
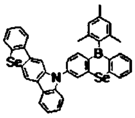
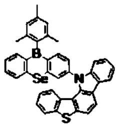
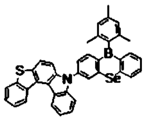
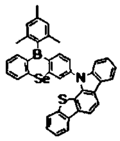
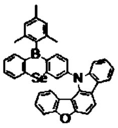
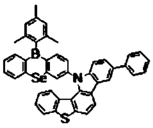
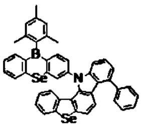
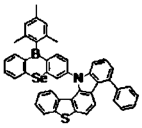
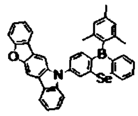
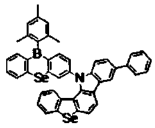
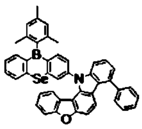
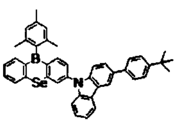
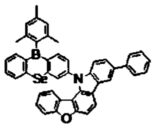
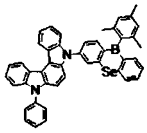
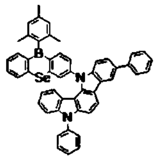
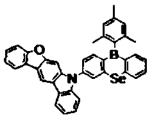
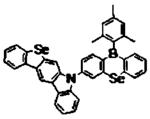
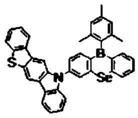

[Chem. 16]

[Group 2-2]

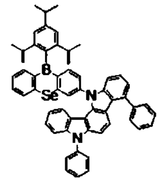
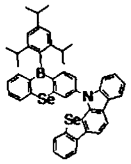
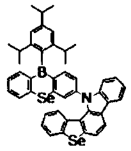
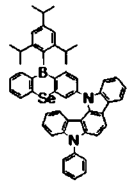
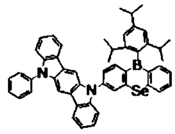
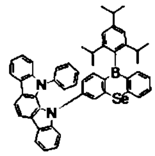

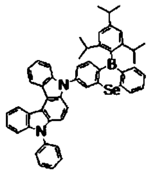
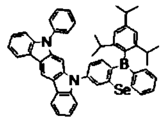
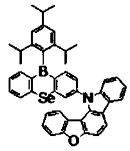
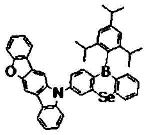
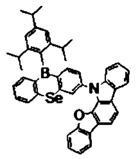

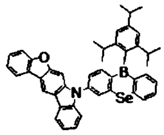
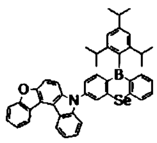
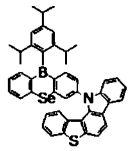
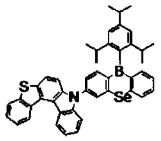
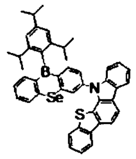

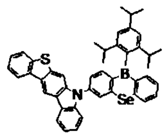
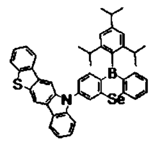
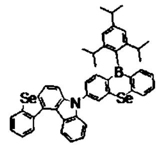
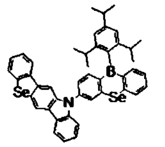
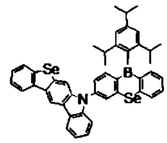

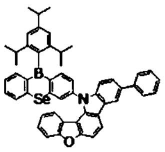
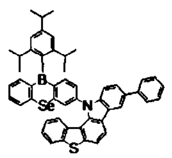
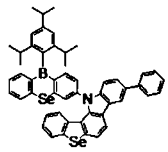
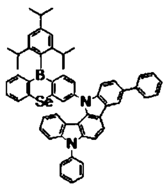
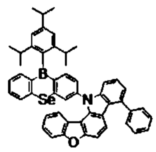

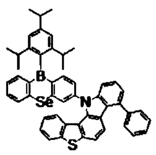
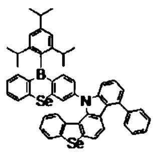

[Chem. 17]

[Group 3]

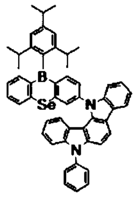
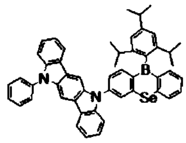
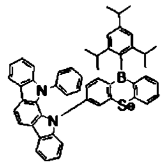
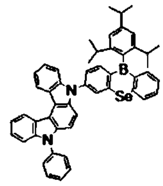
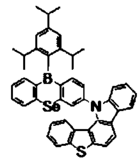
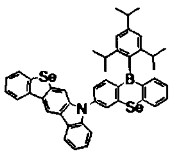
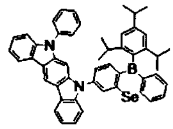
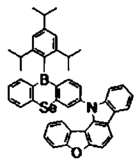
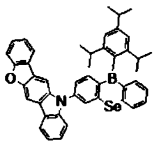
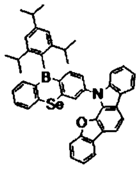
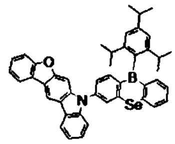
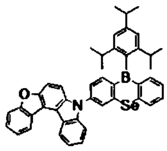
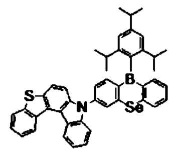
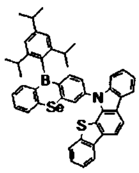
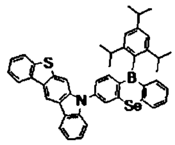
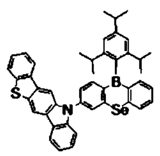
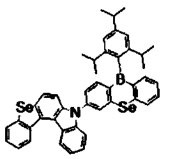
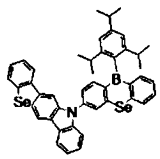
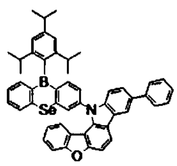
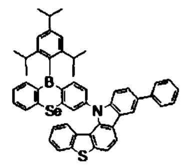
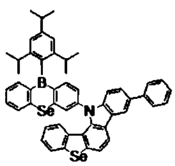
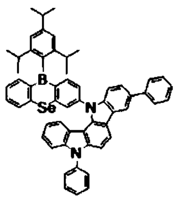
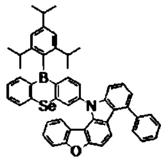
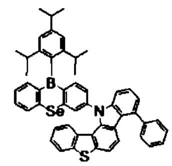
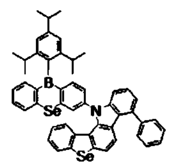

[Chem. 18]

[Group 4]

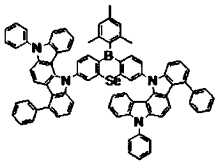
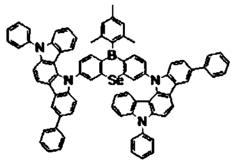
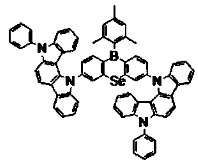
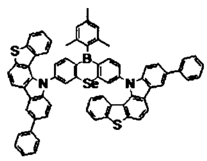

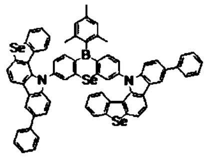
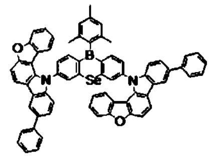
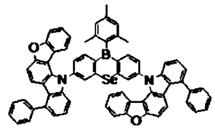
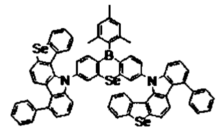

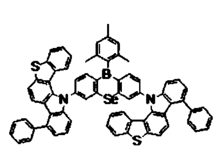
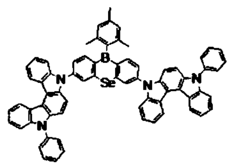
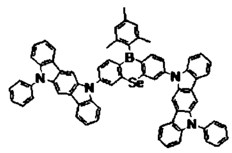

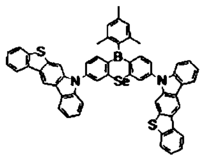
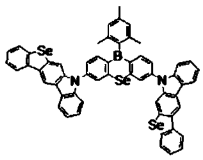
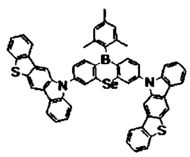
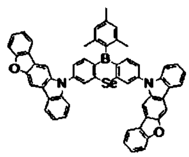
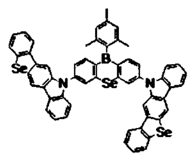

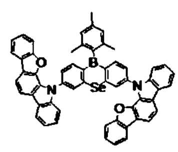
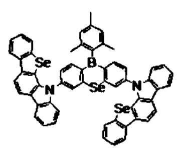
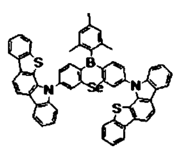
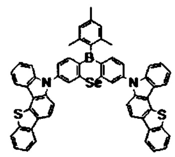
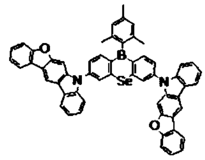

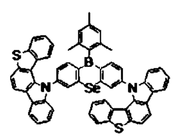
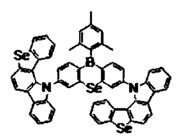
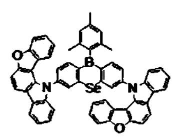
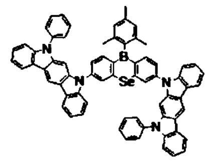

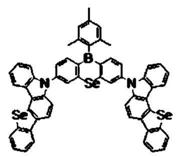
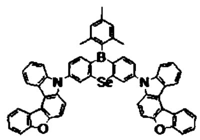
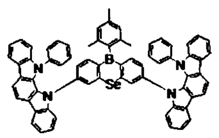
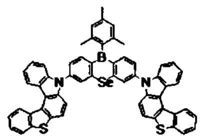
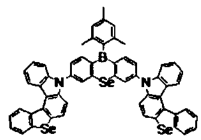

[Chem. 19]

[Group 5]

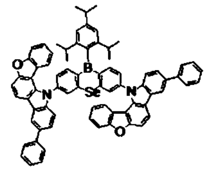 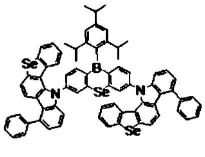 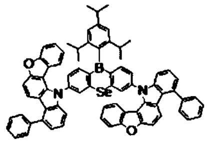 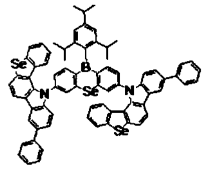

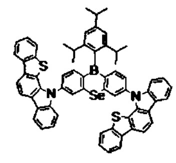 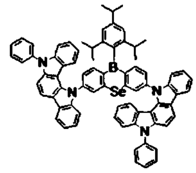 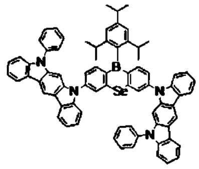 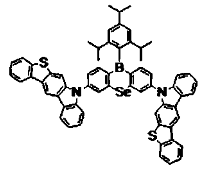 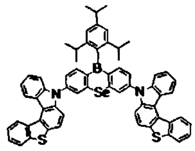

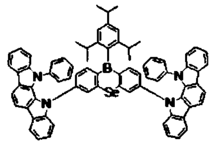 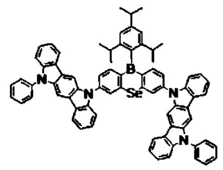 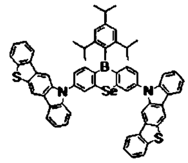 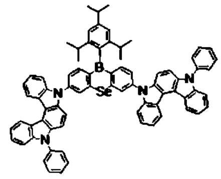

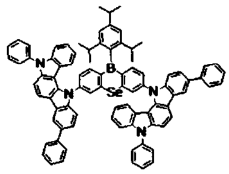 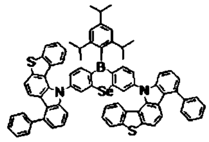 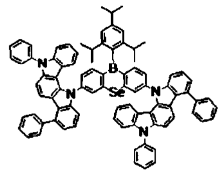 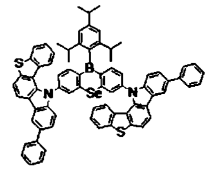

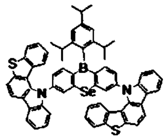 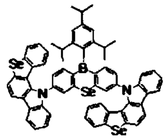 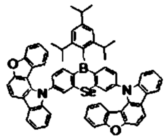 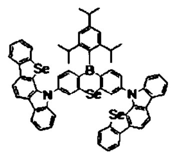 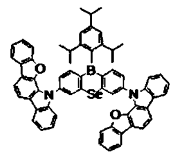

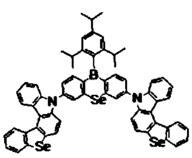 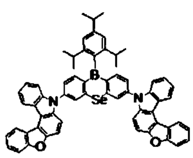 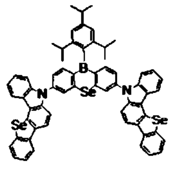 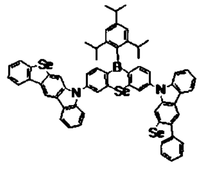 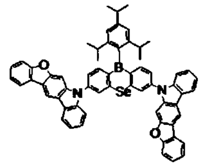

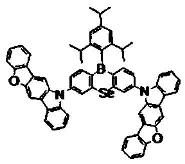 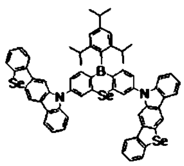

[Chem. 20]

[Group 6-1]

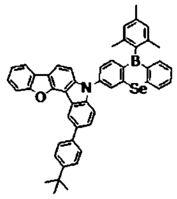
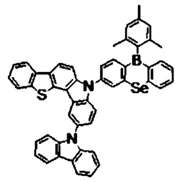
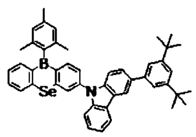
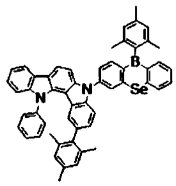
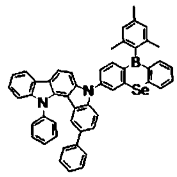
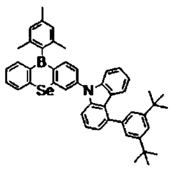
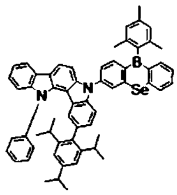
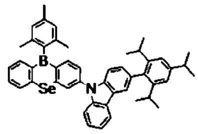
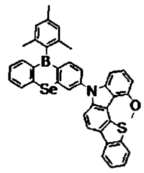
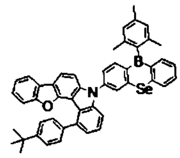
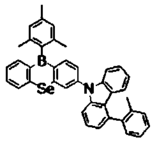
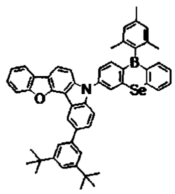
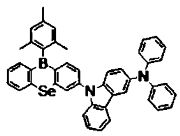
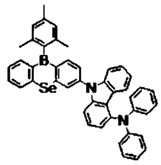
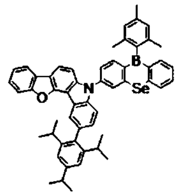
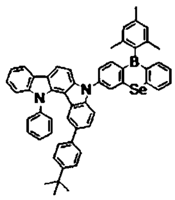
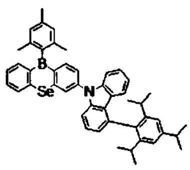
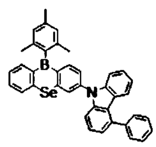
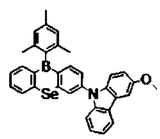
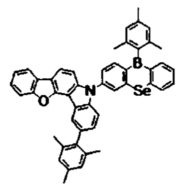
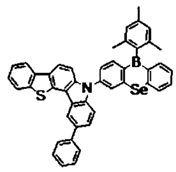

[Chem. 21]

[Group 6-2]

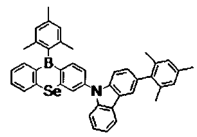 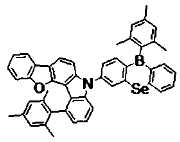 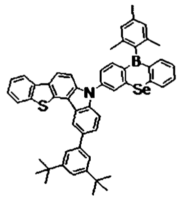 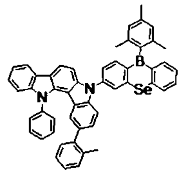 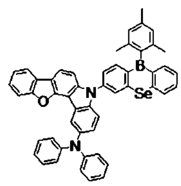

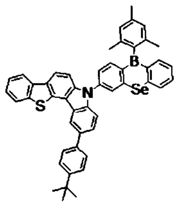 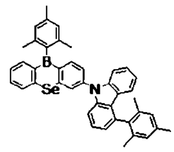 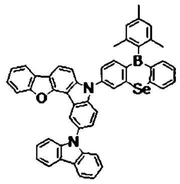 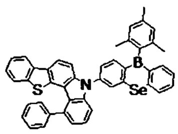 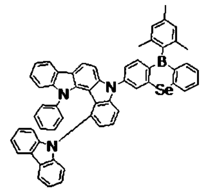

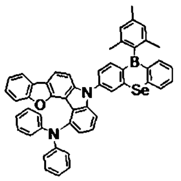 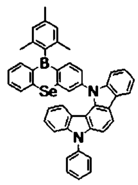 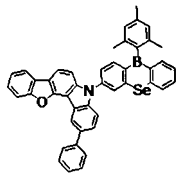 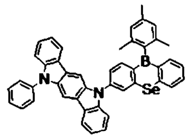 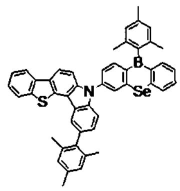

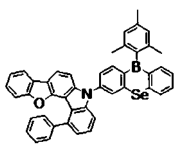 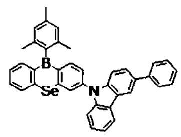 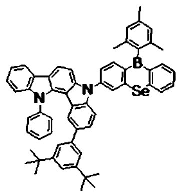 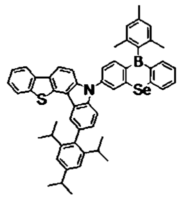

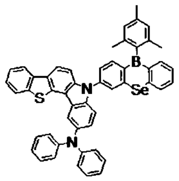 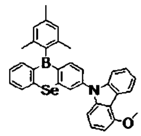 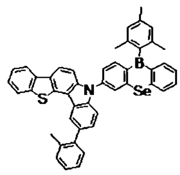 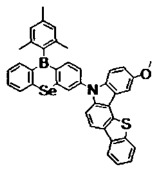 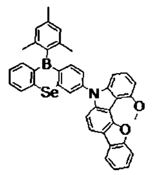

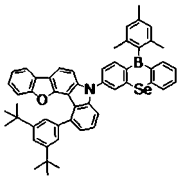 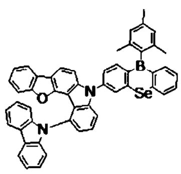 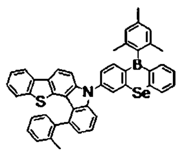 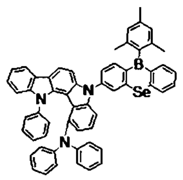 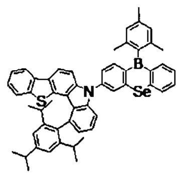

[Chem. 22]

[Group 7-1]

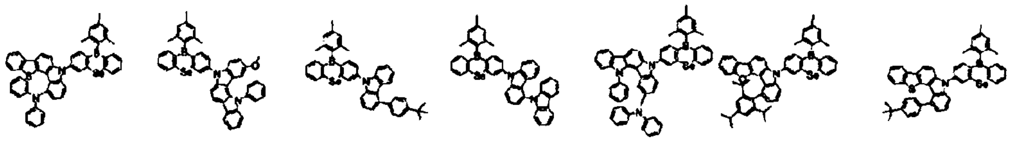

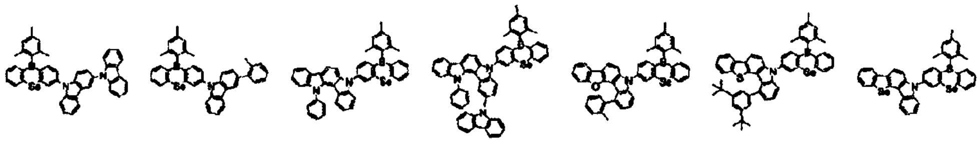

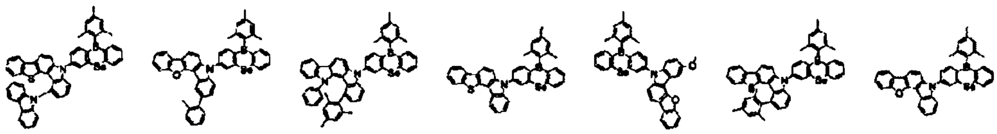

[Chem. 23]

[Group 7-2]

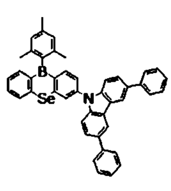
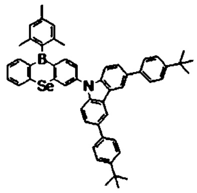
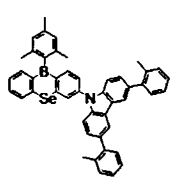
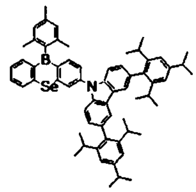
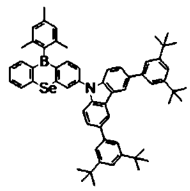

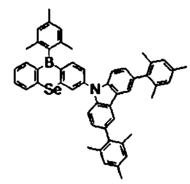
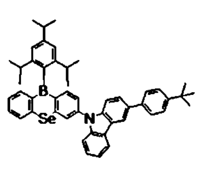
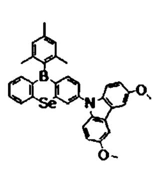
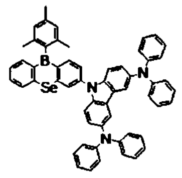
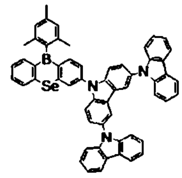

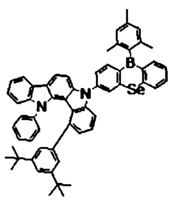
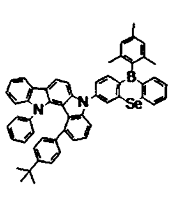
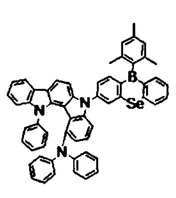
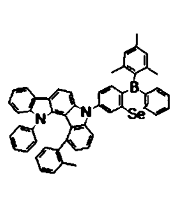
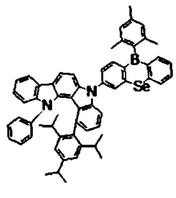

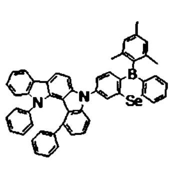
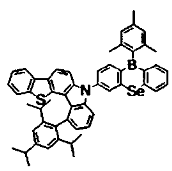
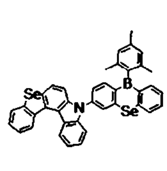
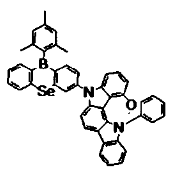
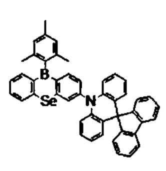

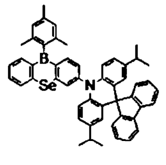
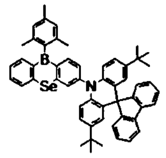
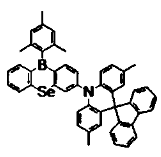
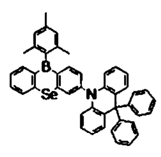
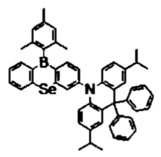

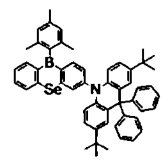
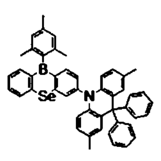
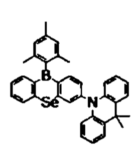
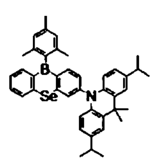
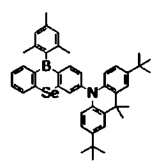

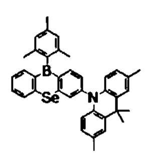
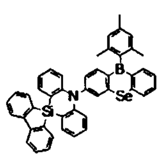
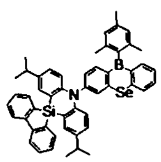
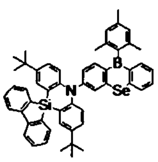
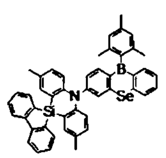
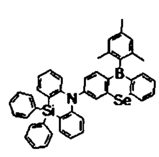

[Chem. 24]

[Group 8-1]

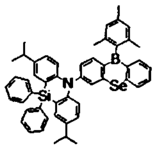
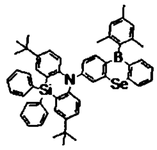
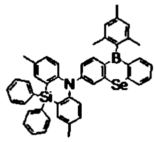
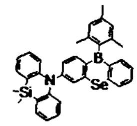
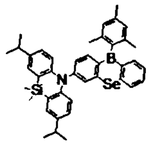
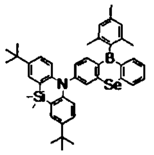
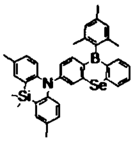
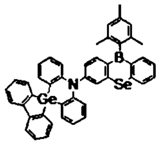
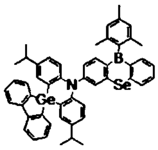
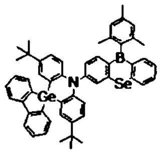
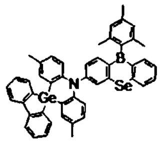
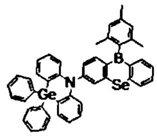
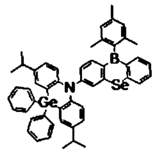
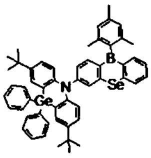
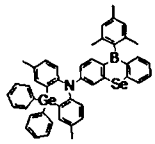
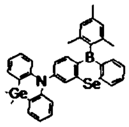
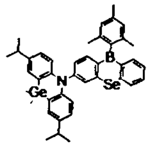
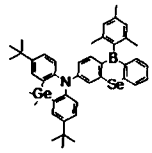
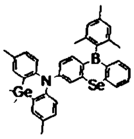

[Chem. 25]

[Group 8-2]

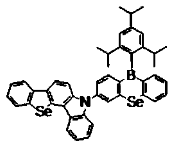
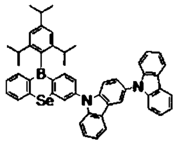
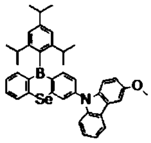
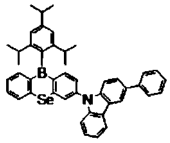
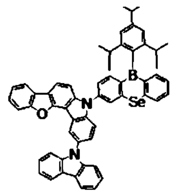
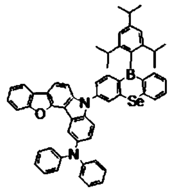
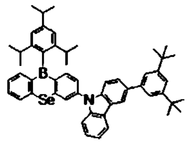
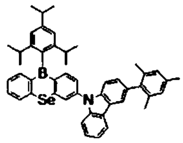
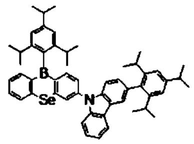
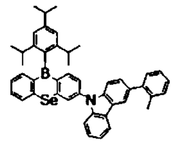
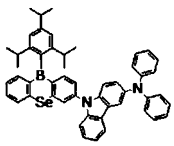
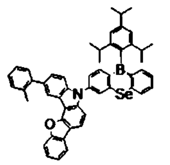
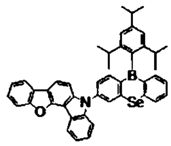
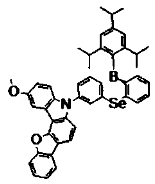
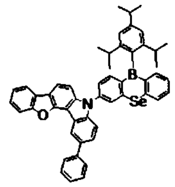
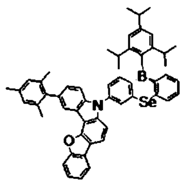
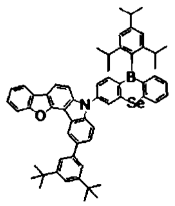
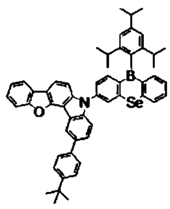
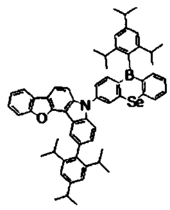
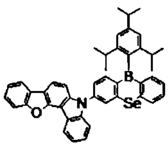
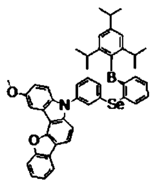
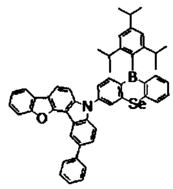
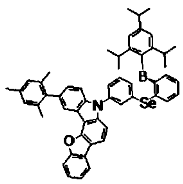
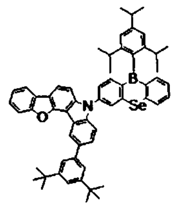
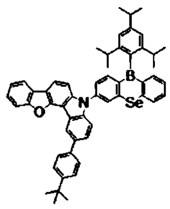
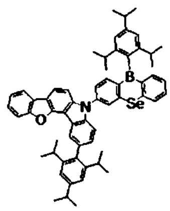
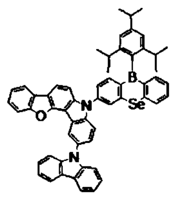
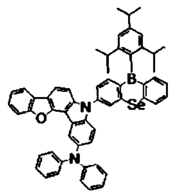
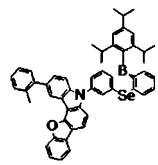

[Chem. 26]

[Group 9-1]

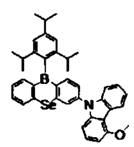
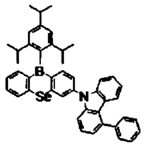
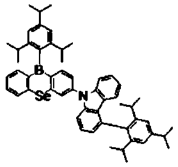
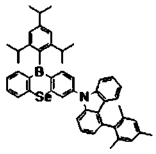
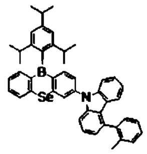
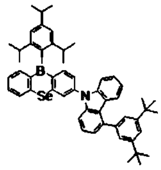
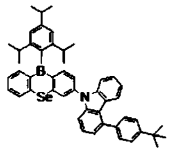
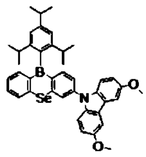
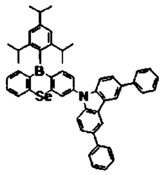
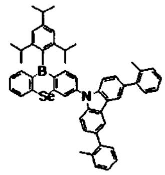
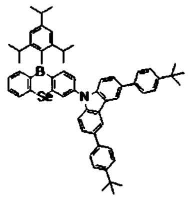
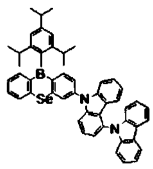
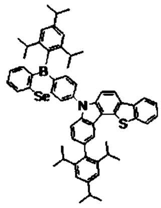
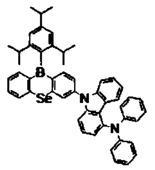
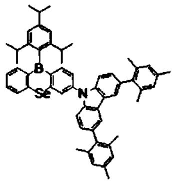
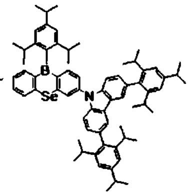
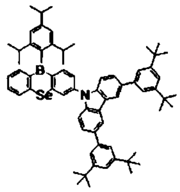
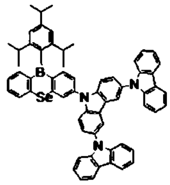
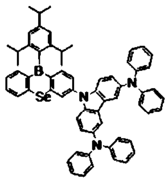
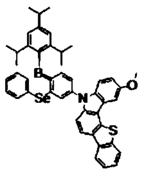
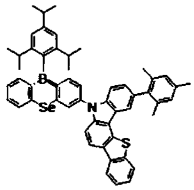
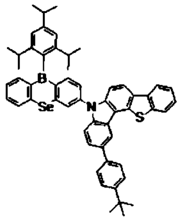
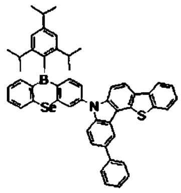
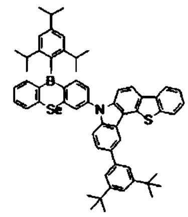
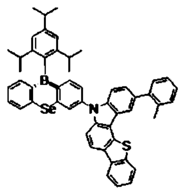
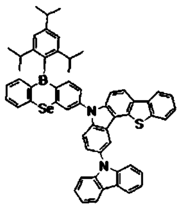
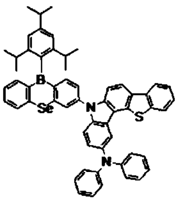
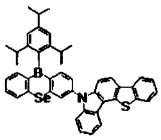
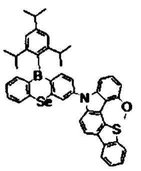
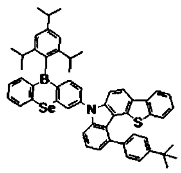
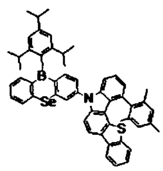
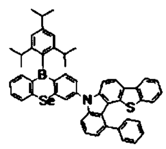
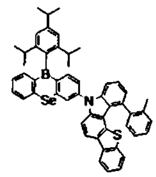
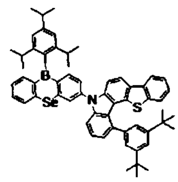
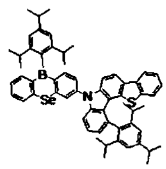

[Chem. 27]

[Group 9-2]

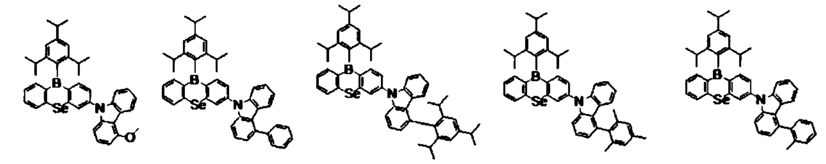

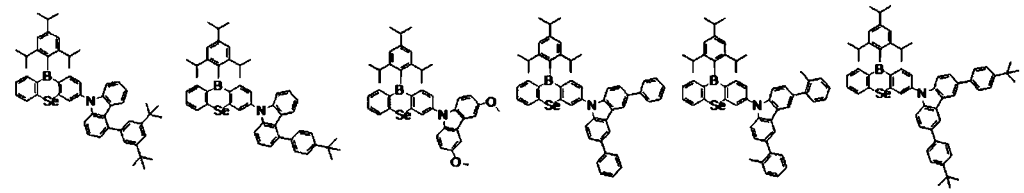

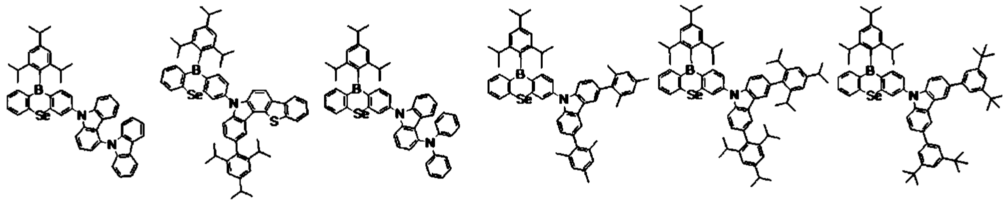

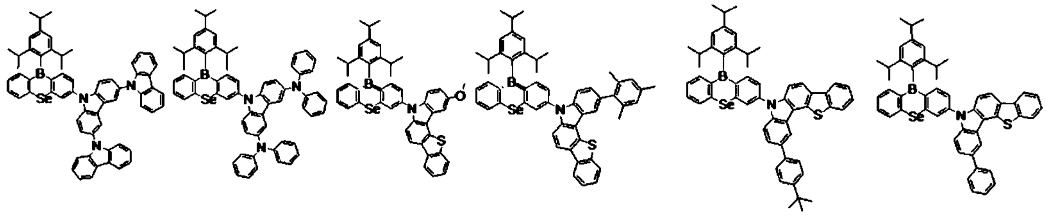

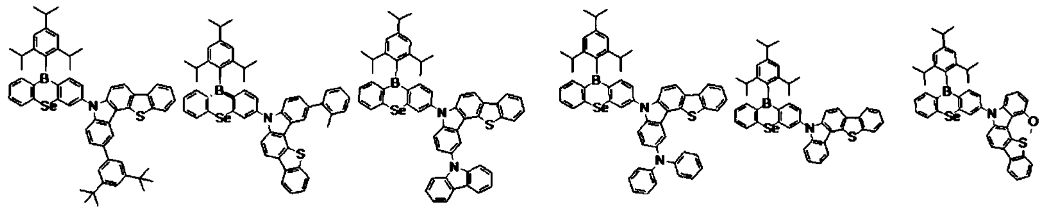

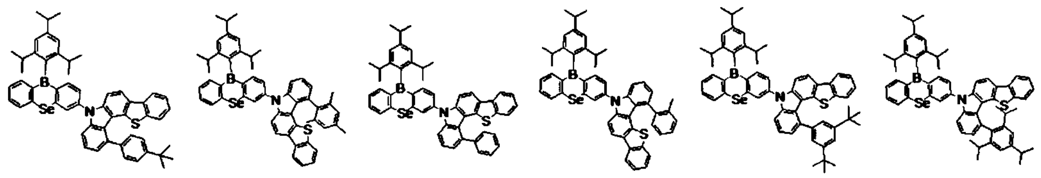

[Chem. 28]

[Group 10-1]

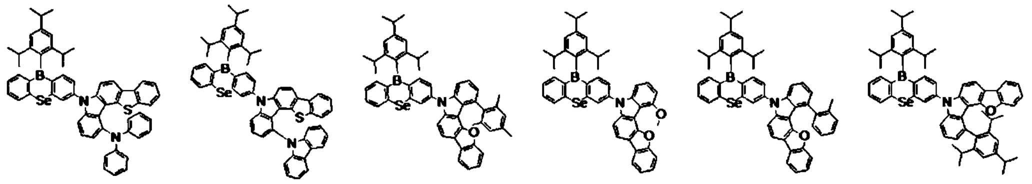

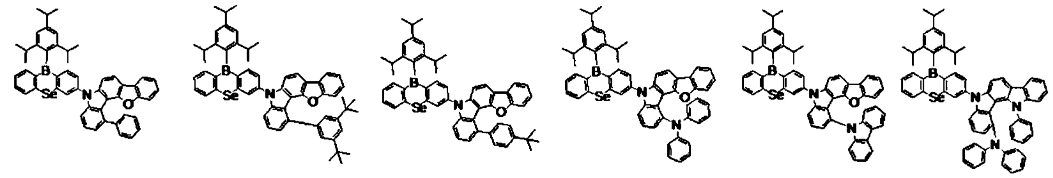

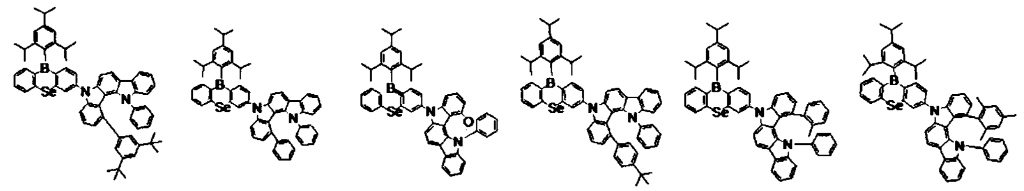

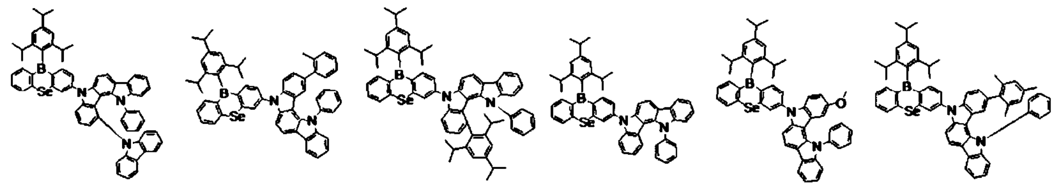

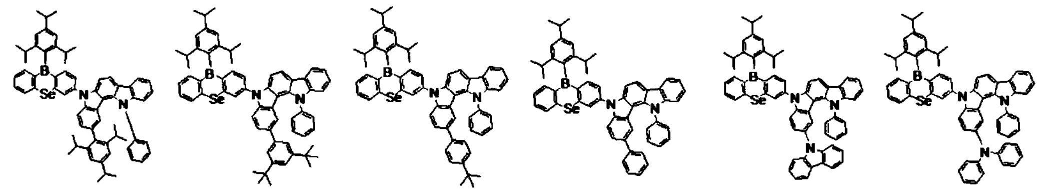

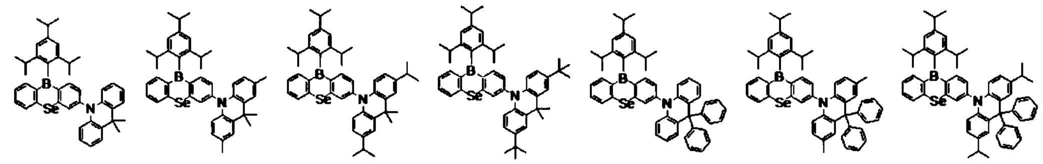

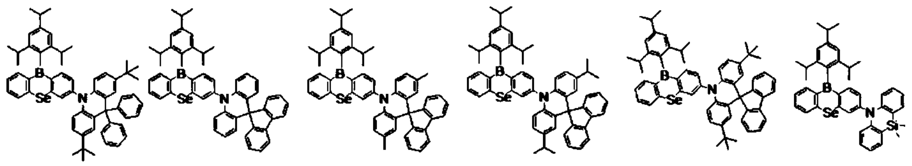

[Chem. 29]

[Group 10-2]

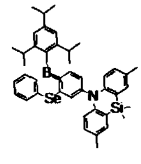
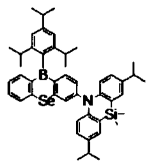
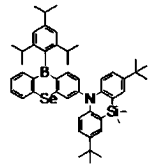
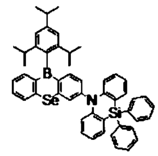
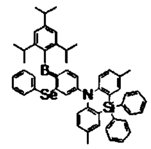
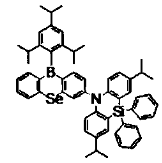
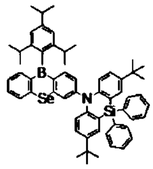
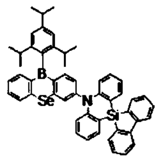
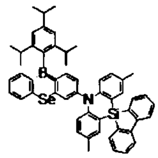
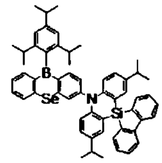
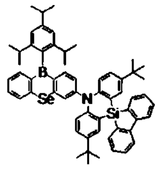
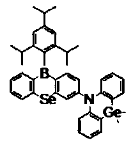
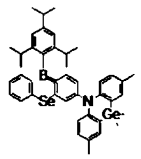
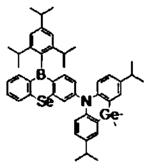
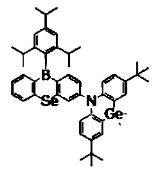
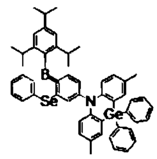
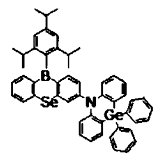
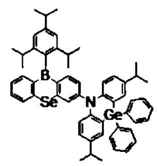
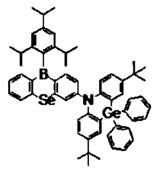
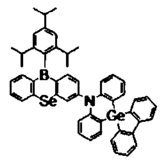
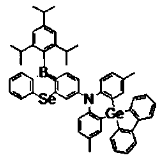
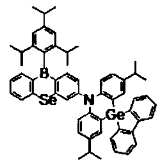
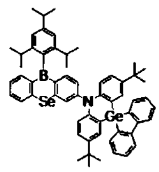
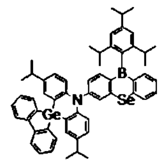
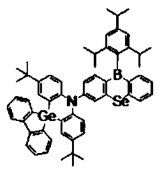

[Chem. 30]

[Group 11]

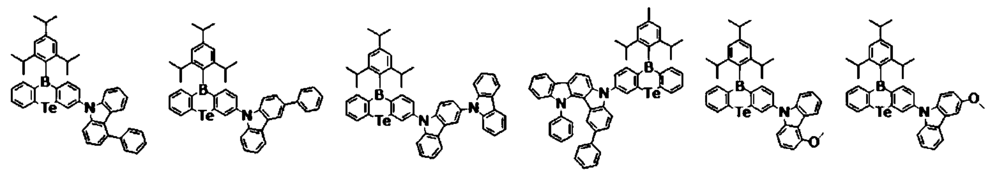

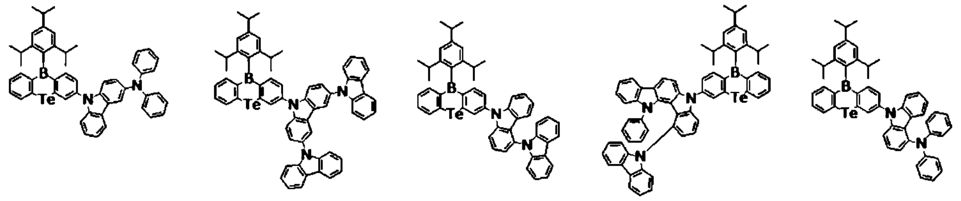

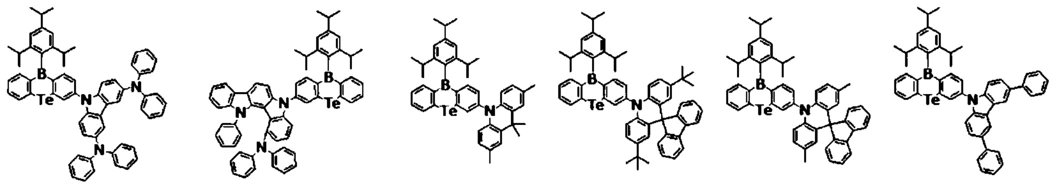

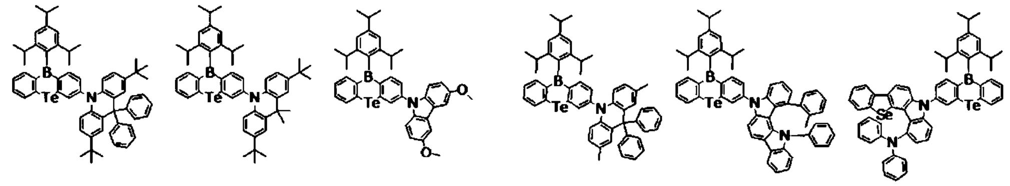

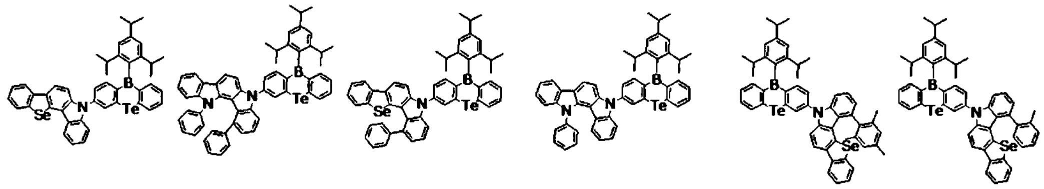

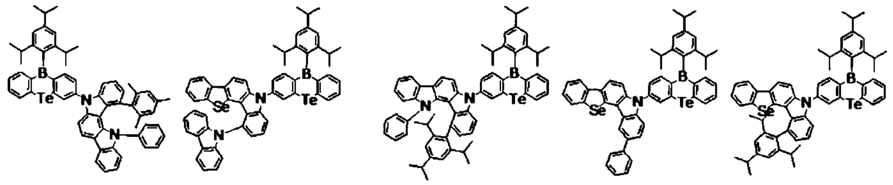

[Chem. 31]

[Group 12]

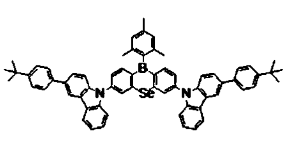
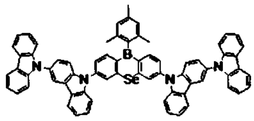
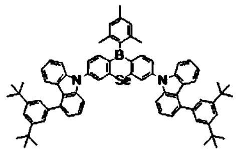
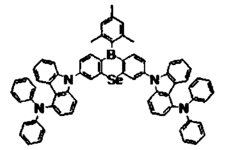
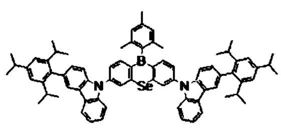
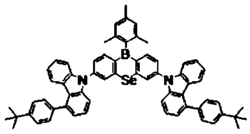
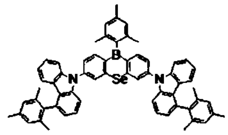
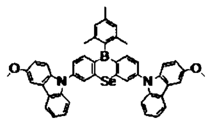
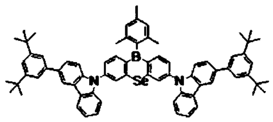
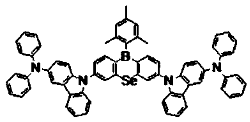
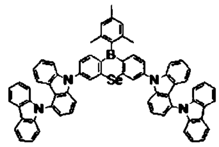
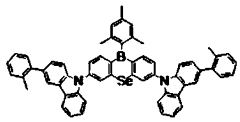
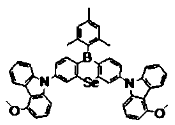
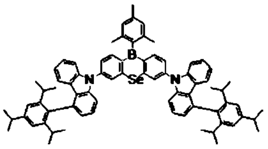
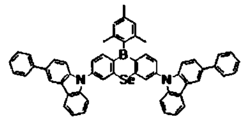
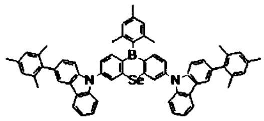
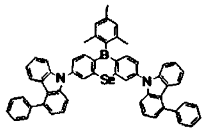
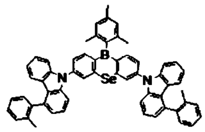
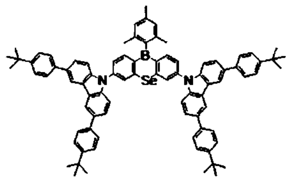
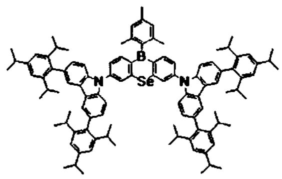
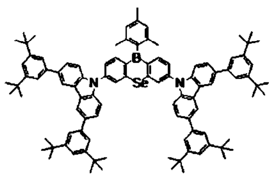
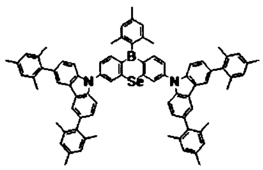
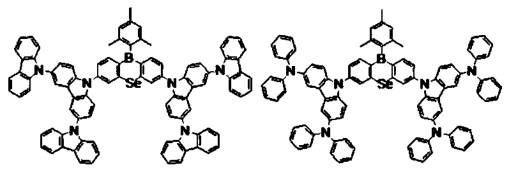
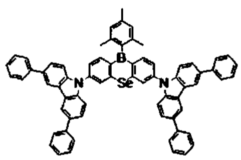
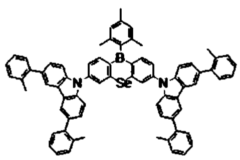
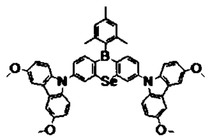

[Chem. 32]

[Group 13-1]

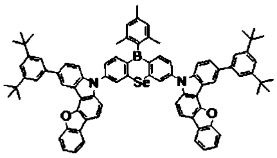 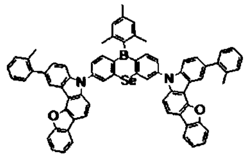 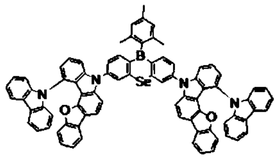 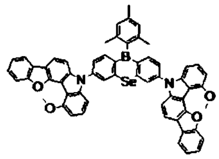

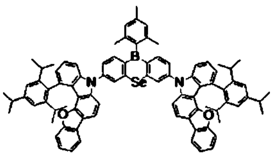 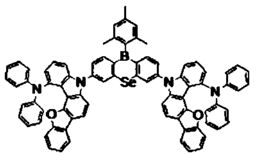 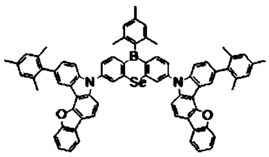 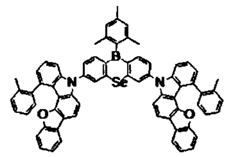

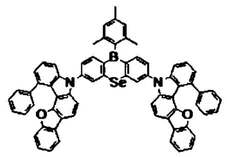 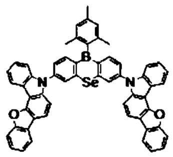 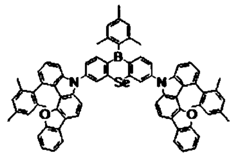 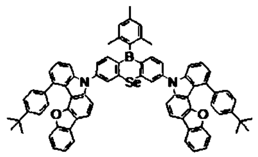

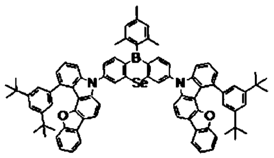 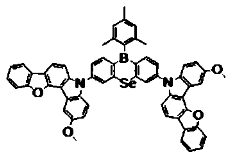 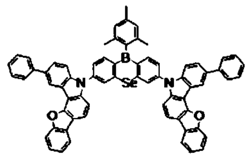 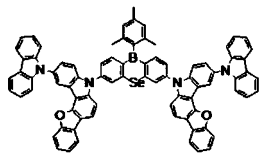

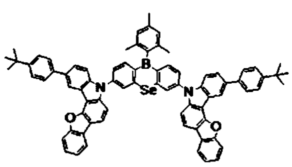 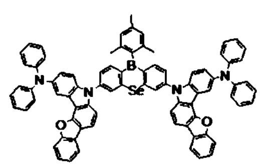 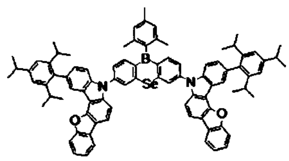

[Chem. 33]

[Group 13-2]

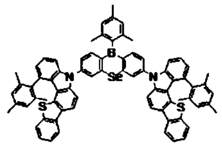
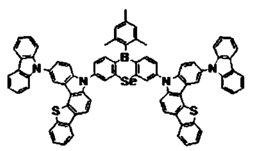
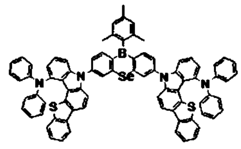
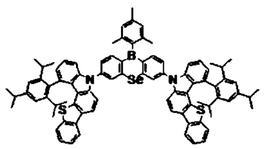
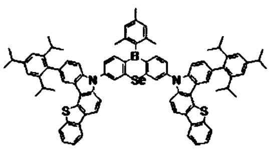
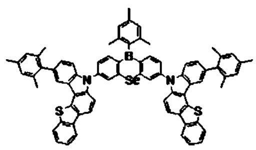
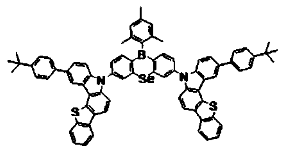
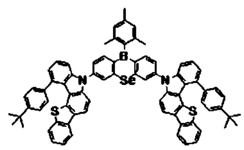
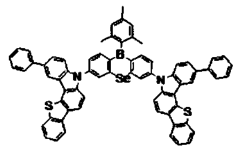
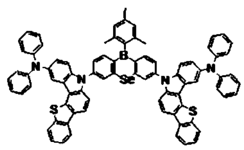
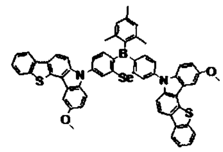
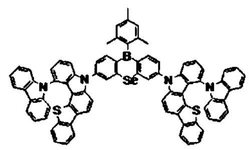
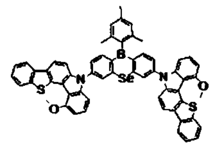
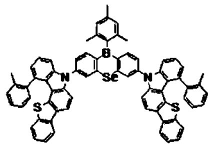
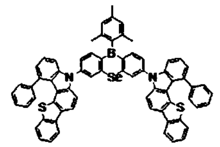
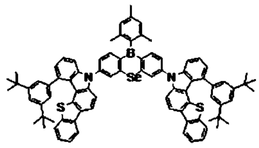
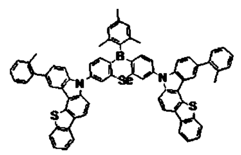
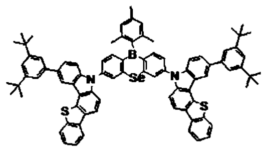

[Chem. 34]

[Group 14]

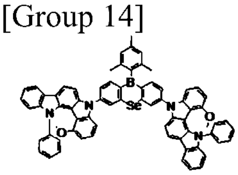
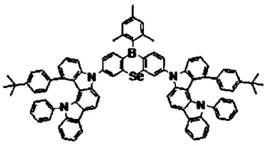
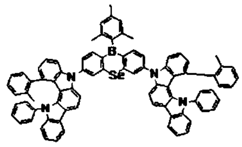
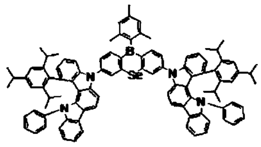
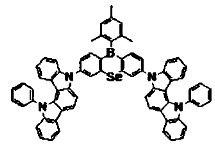
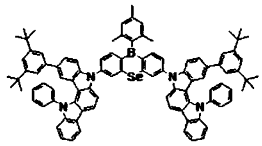
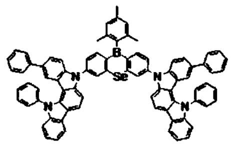
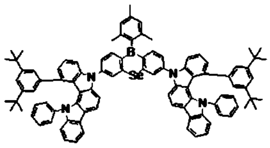
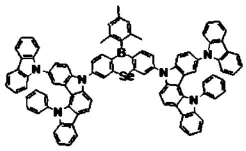
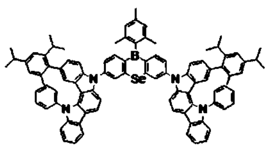
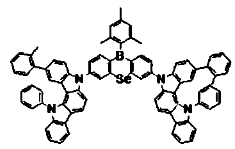
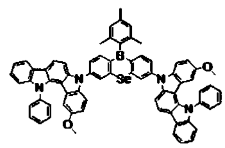
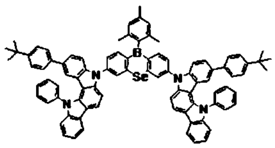
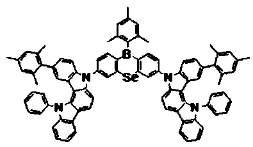
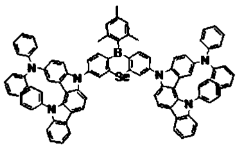
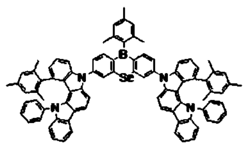
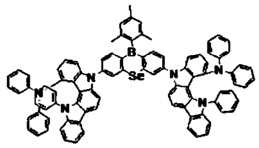
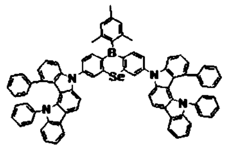
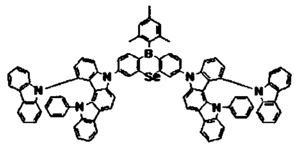
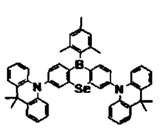
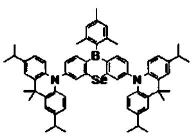
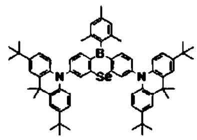
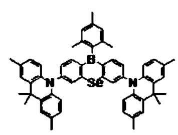
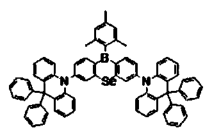
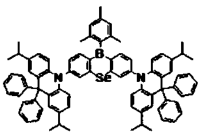
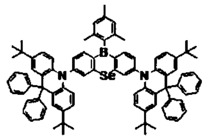
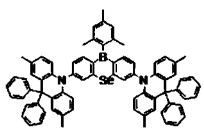
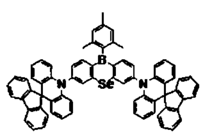
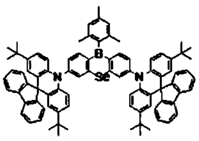
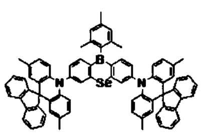
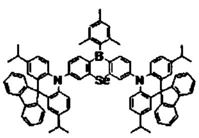

[Chem. 35]

[Group 15]

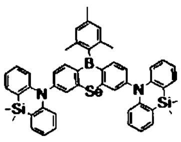
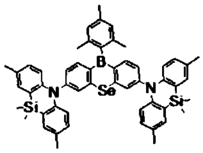
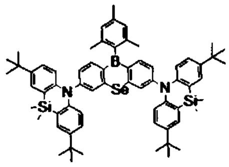
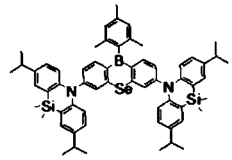
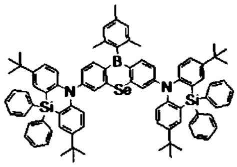
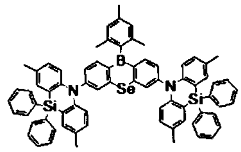
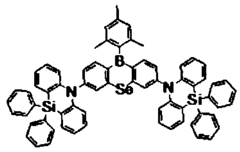
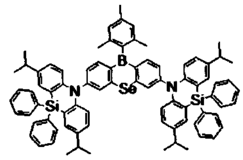
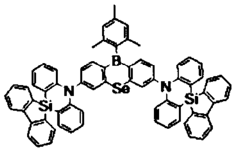
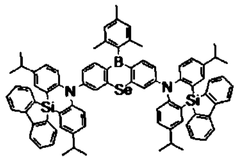
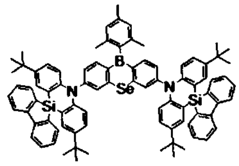
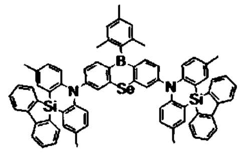
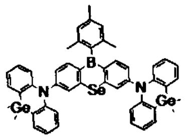
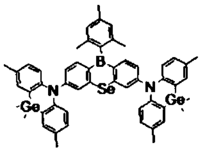
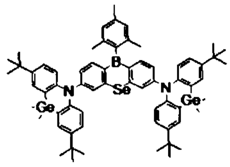
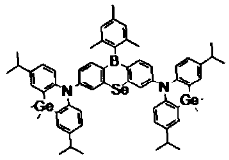
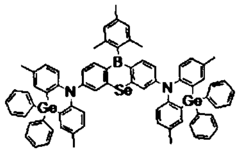
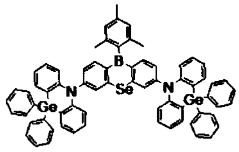
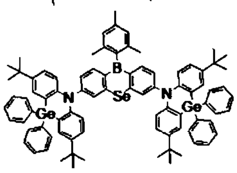
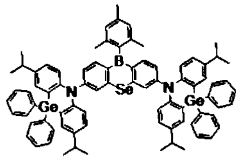
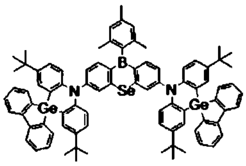
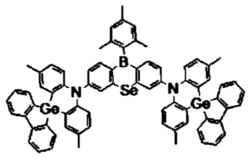
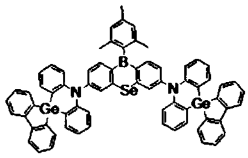
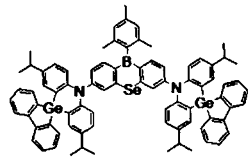

[Chem. 36]

[Group 16-1]

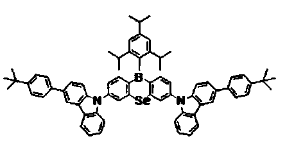
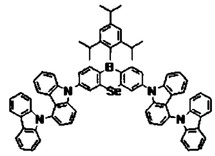
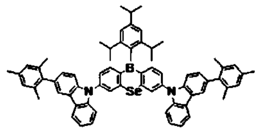
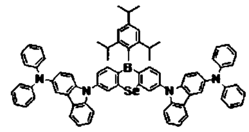
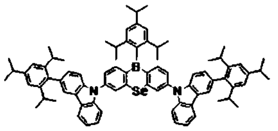
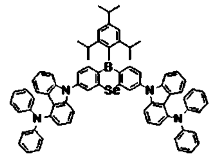
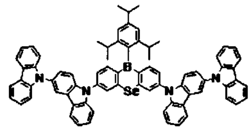
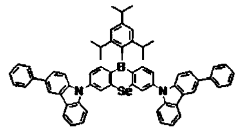
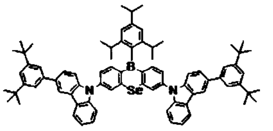
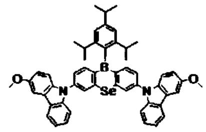
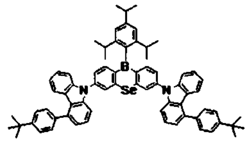
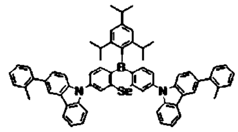
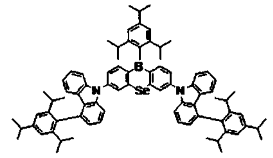
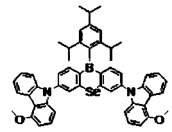
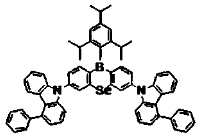
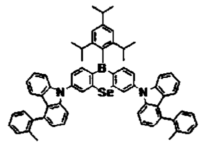
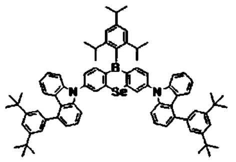
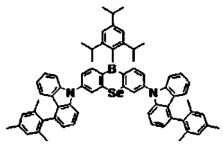

[Chem. 37]

[Group 16-2]

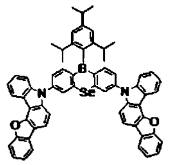
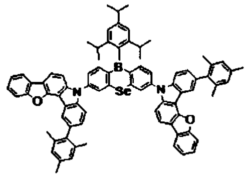
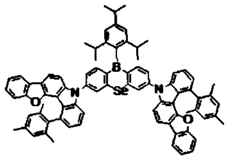
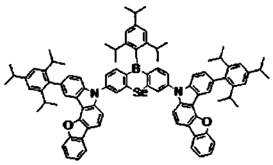
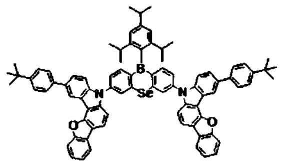
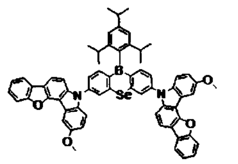
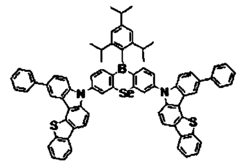
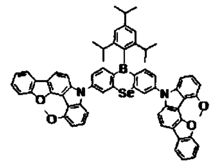
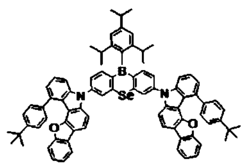
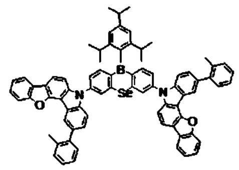
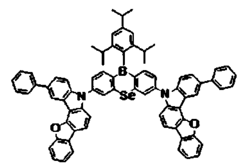
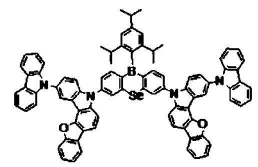
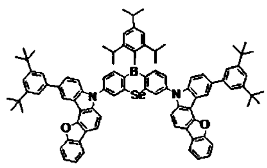
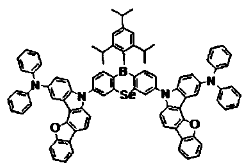
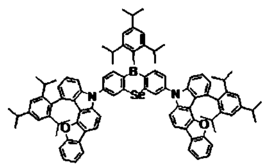
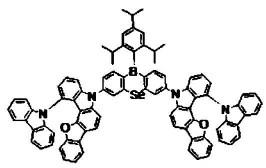
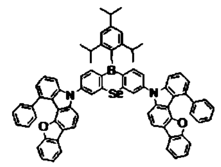
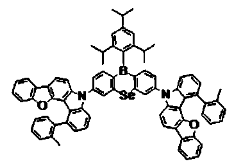
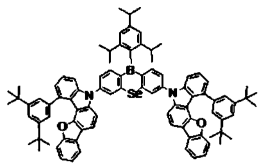
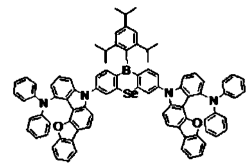

[0086] [Chem. 38]

[Group 17]

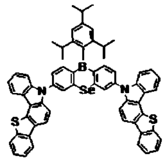
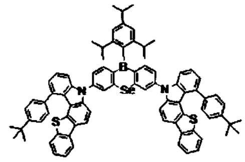
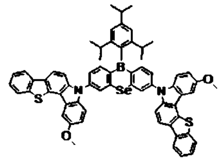
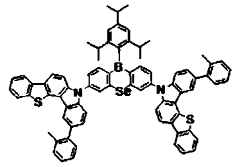
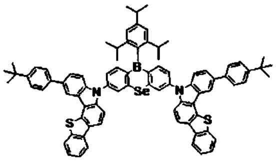
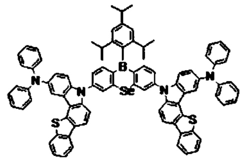
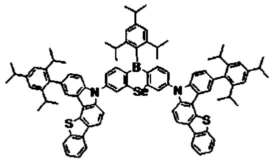
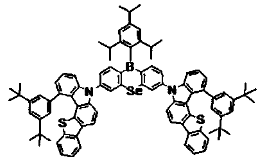
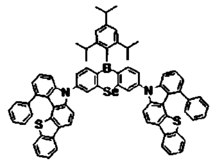
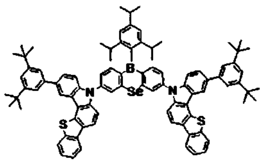
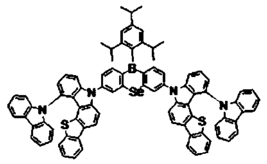
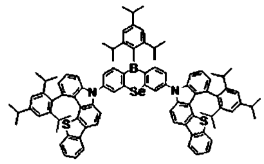
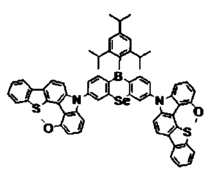
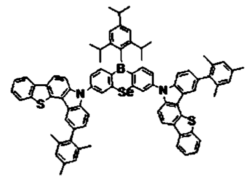
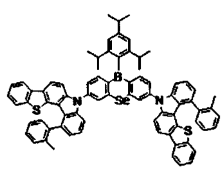
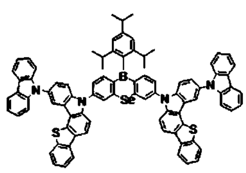
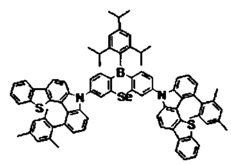
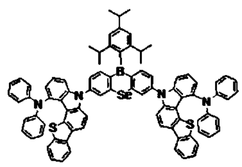
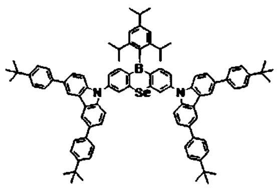
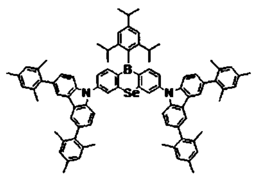
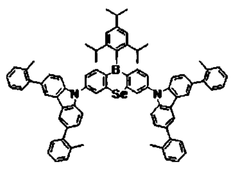
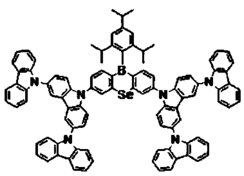
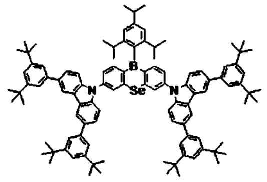
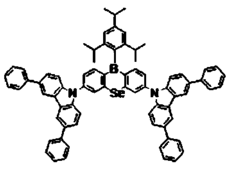
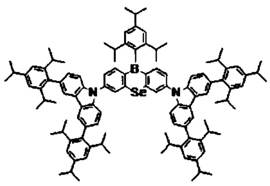
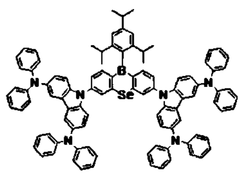
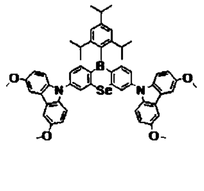

[Chem. 39]

[Group 18]

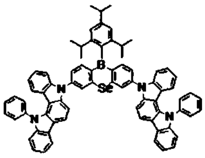 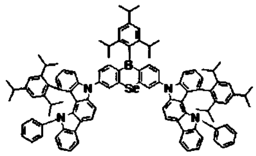 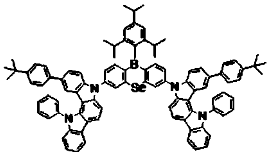 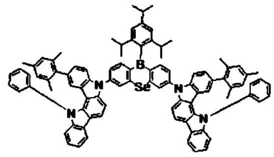

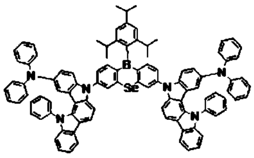 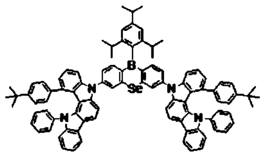 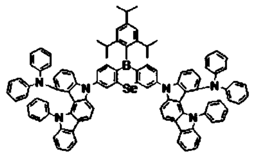 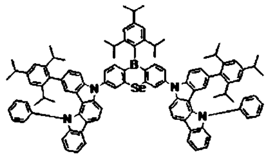

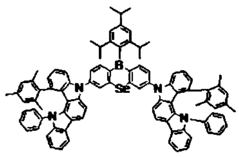 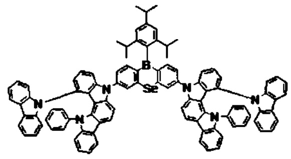 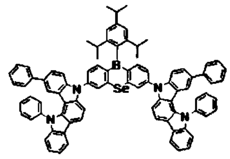 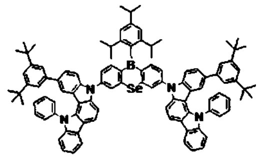

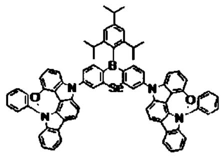 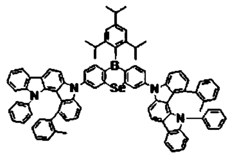 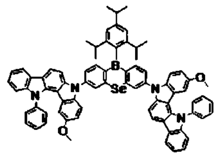 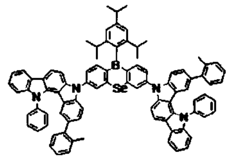

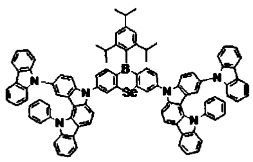 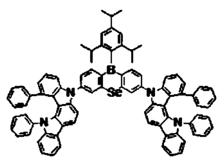 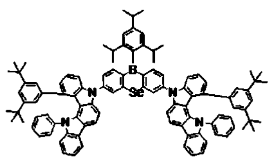

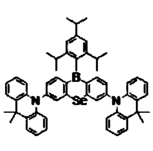 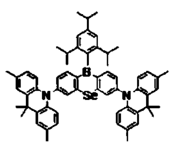 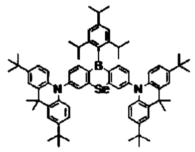 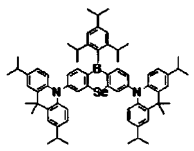

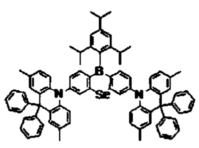 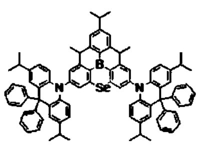 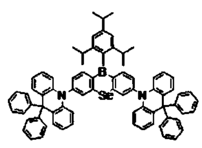 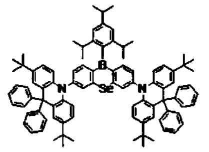

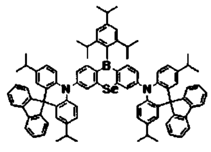 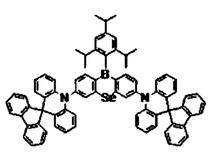 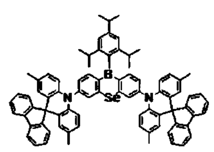 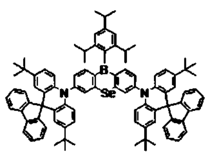

[Chem. 40]

[Group 19]

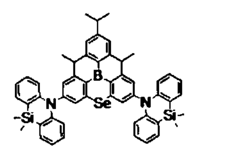
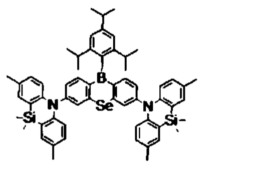
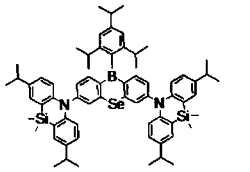
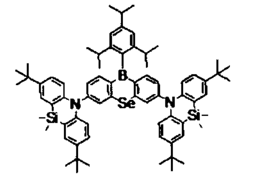
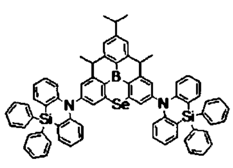
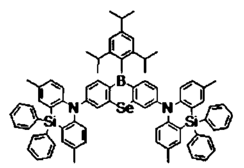
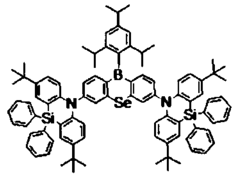
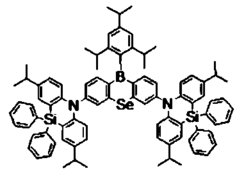
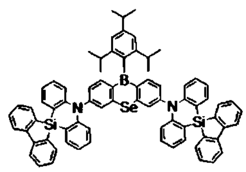
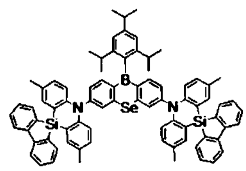
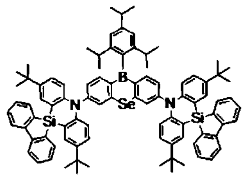
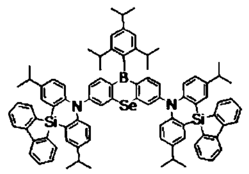
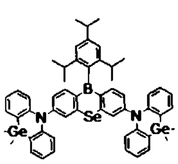
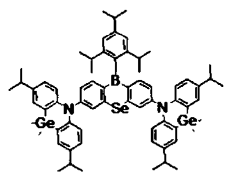
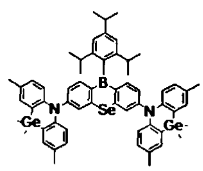
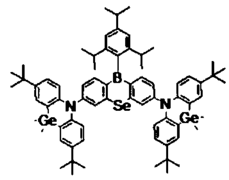
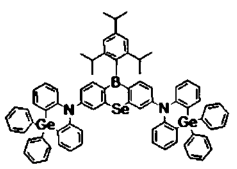
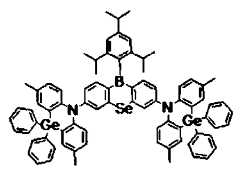
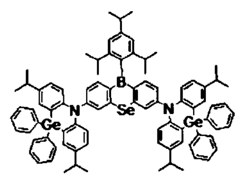
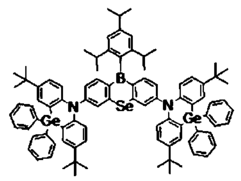
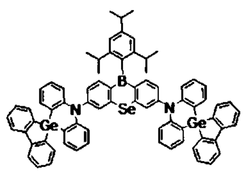
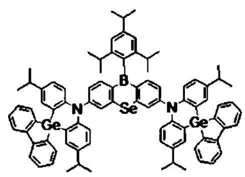
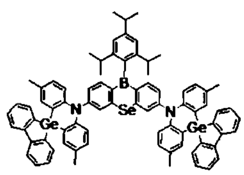
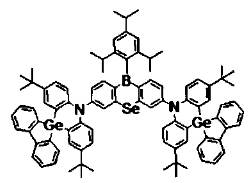

[Chem. 41]

[Group 20]

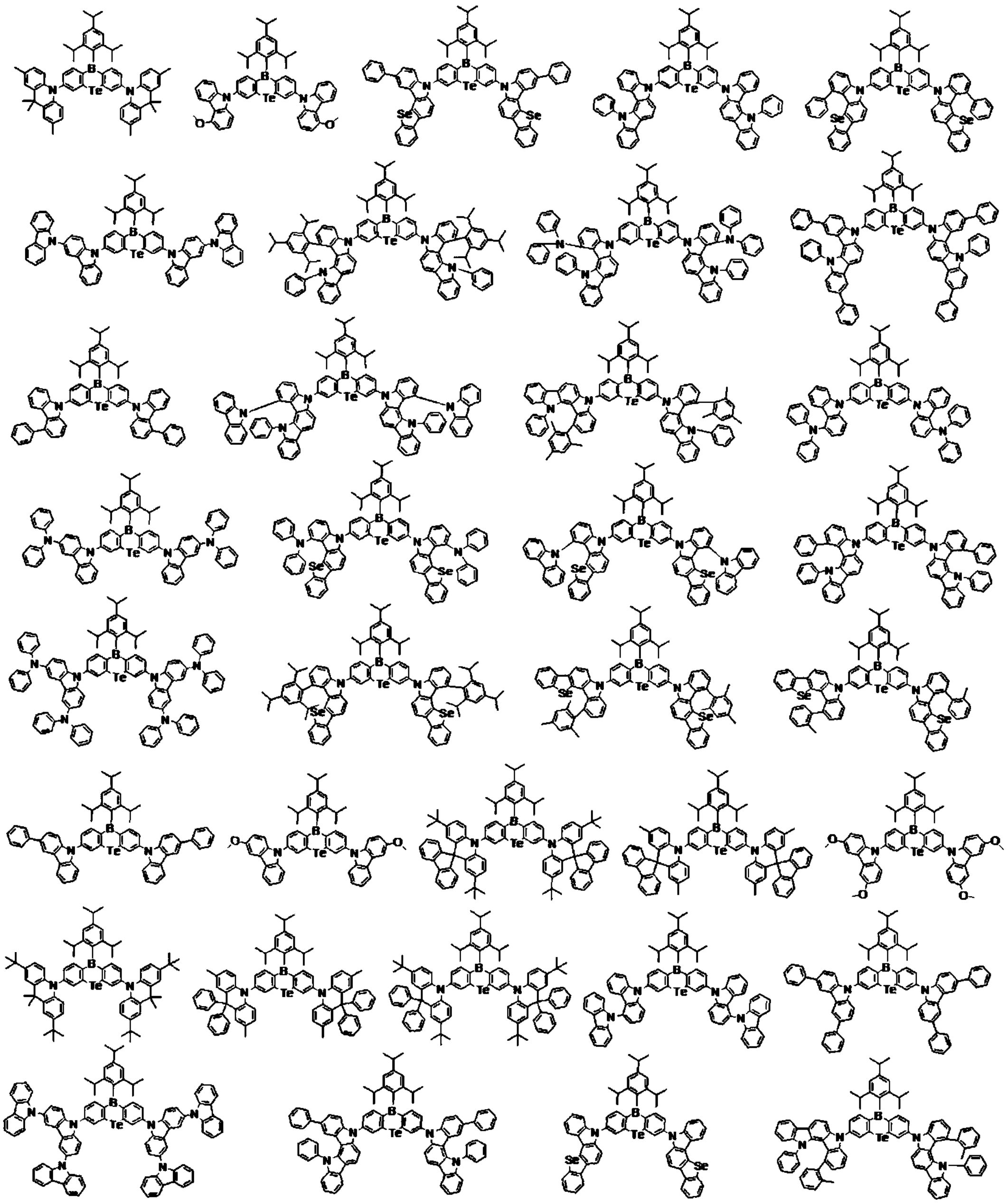

[Chem. 42]

[Group 21]

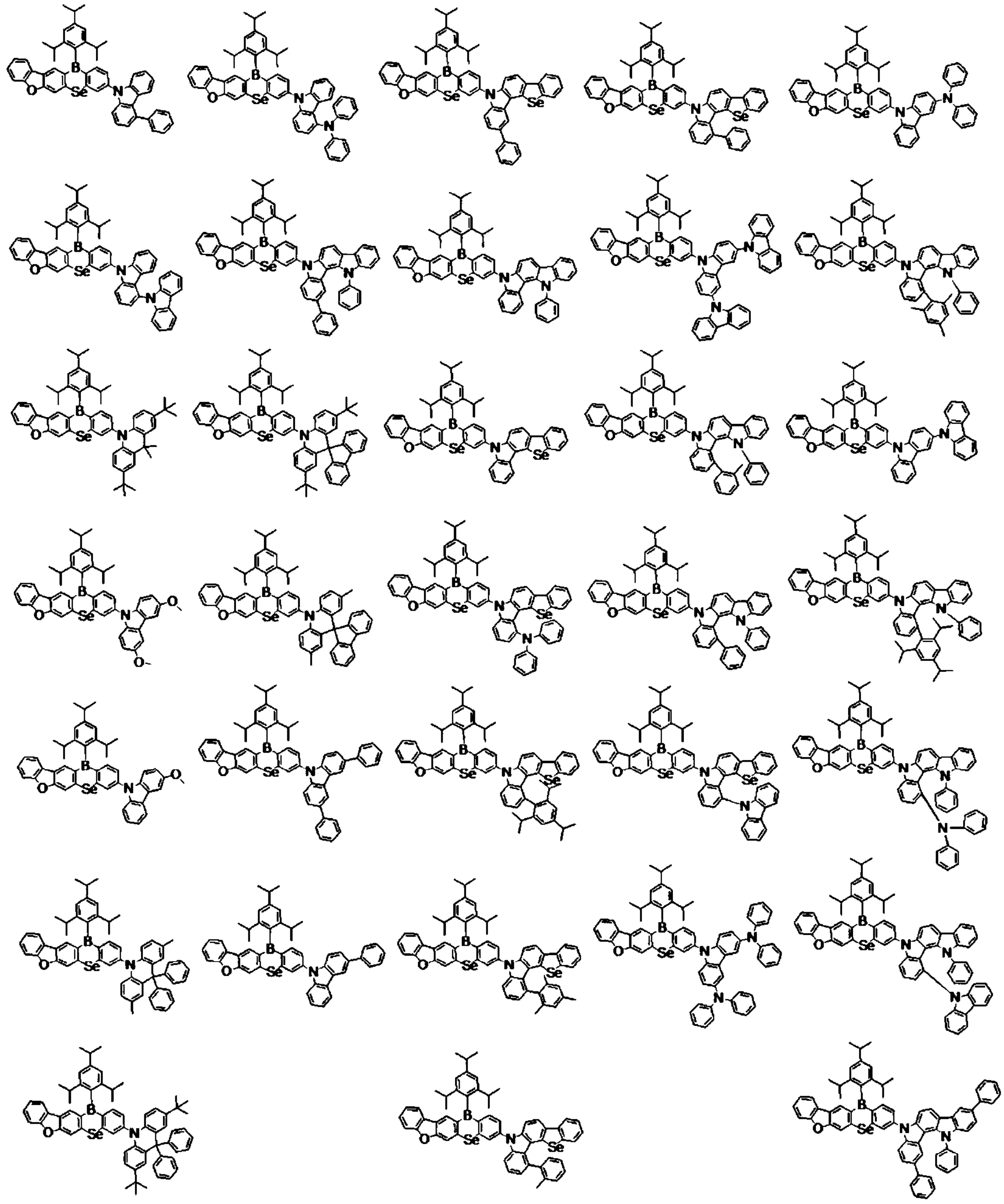

[Chem. 43]

[Group 22]

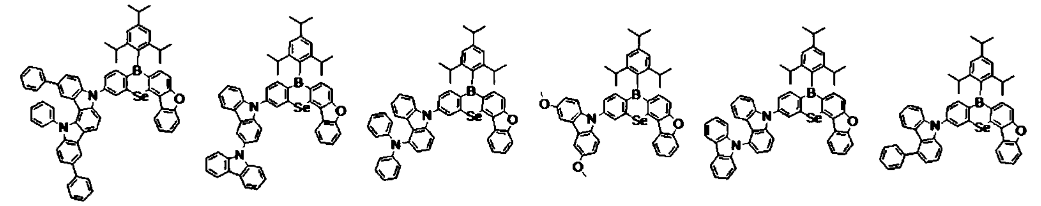

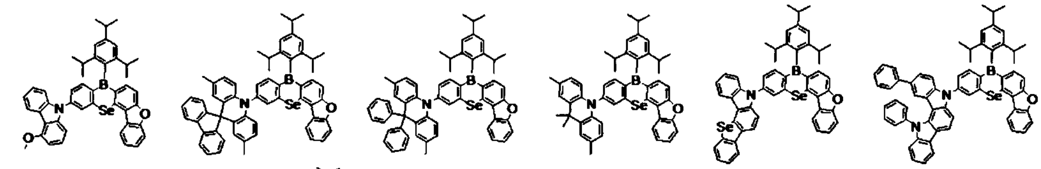

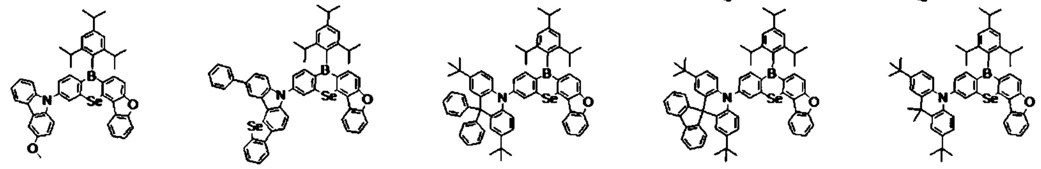

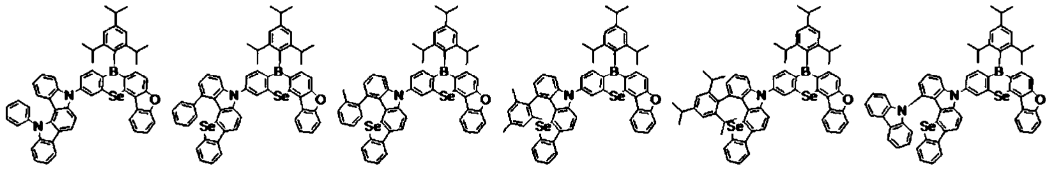

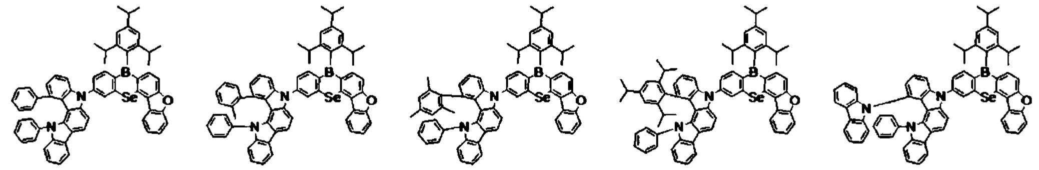

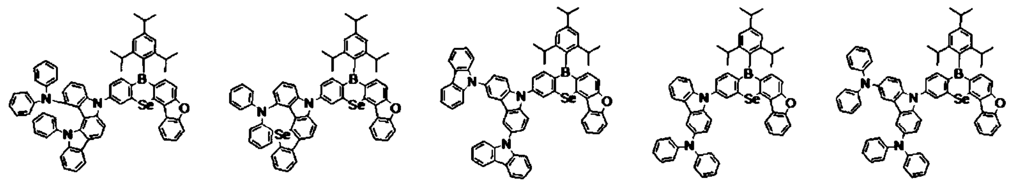

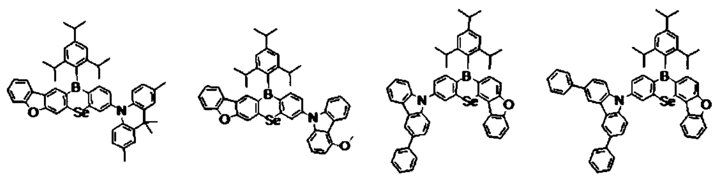

[Chem. 44]

[Group 23]

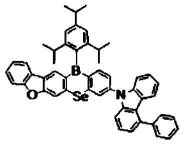 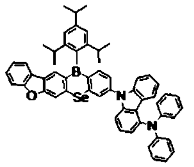 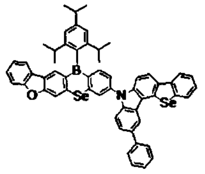 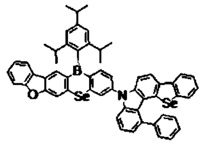 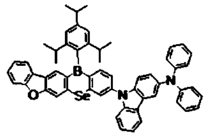

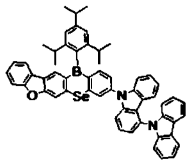 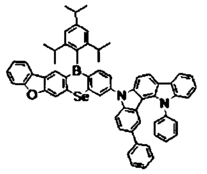 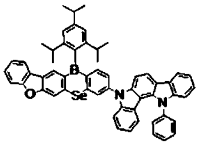 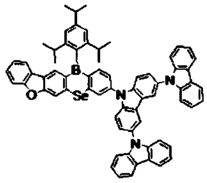 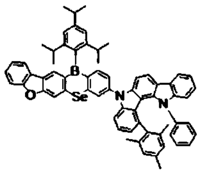

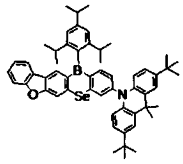 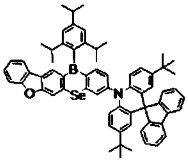 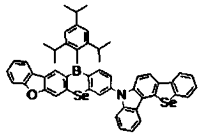 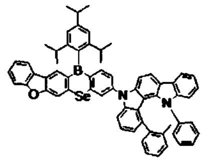 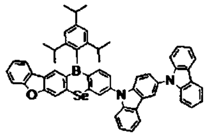

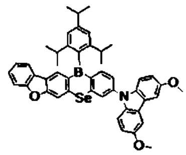 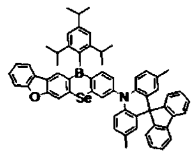 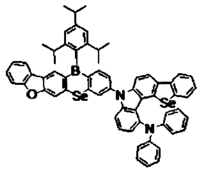 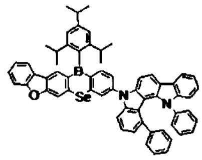 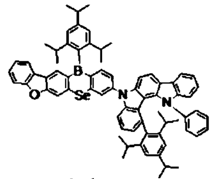

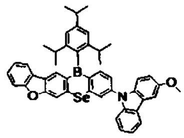 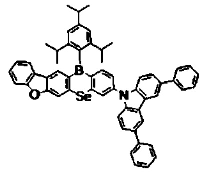 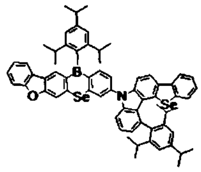 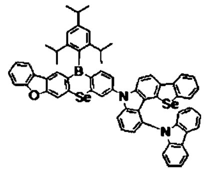 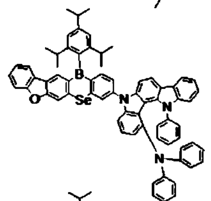

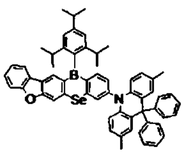 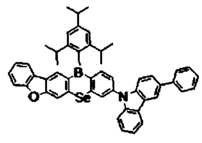 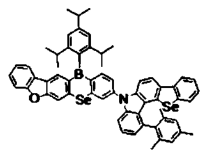 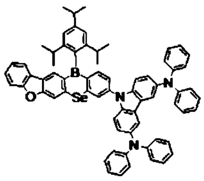 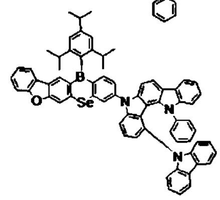

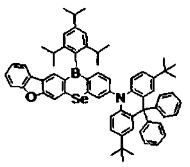 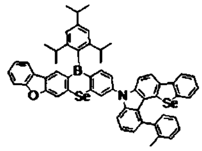 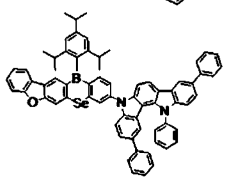

[Chem. 45]

[Group 24]

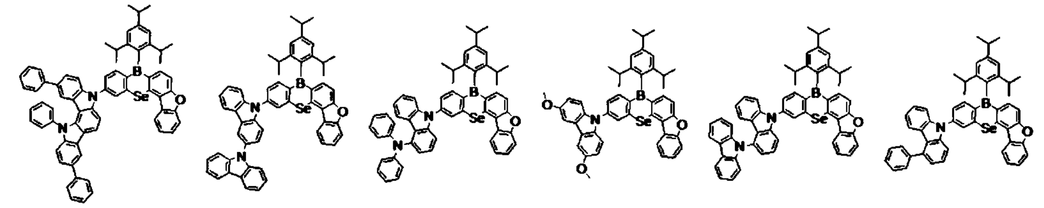

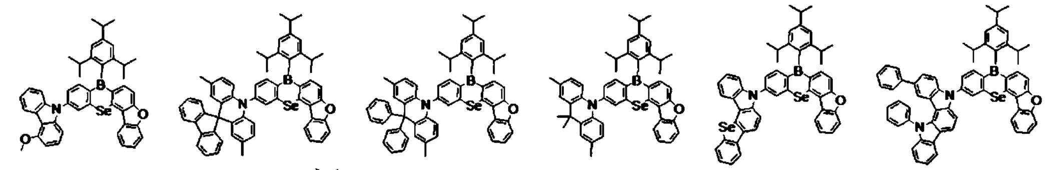

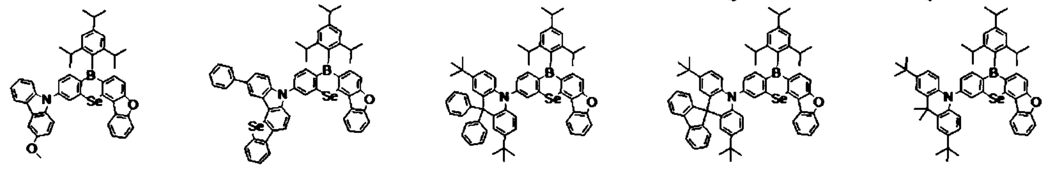

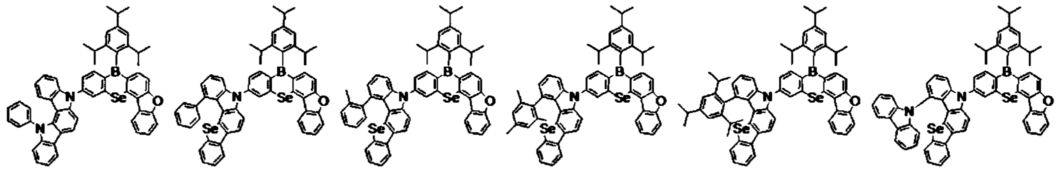

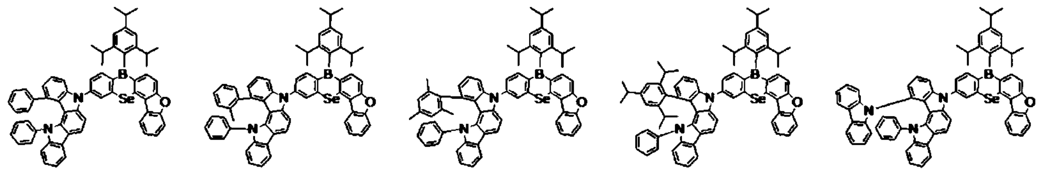

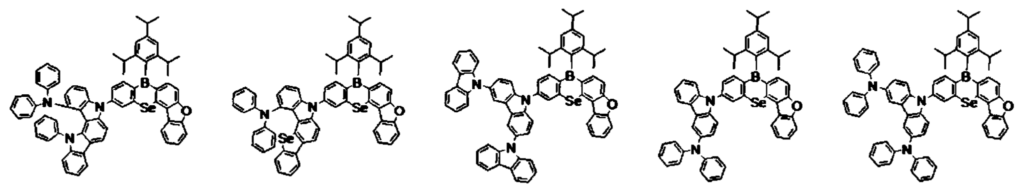

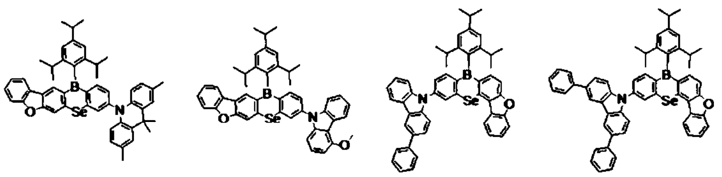

[Chem. 46]

[Group 25]

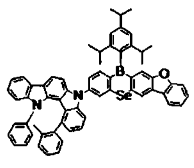
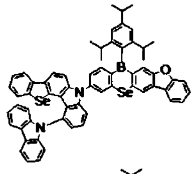
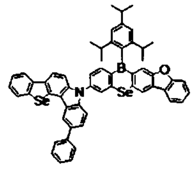
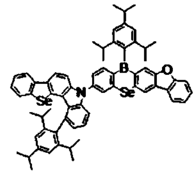
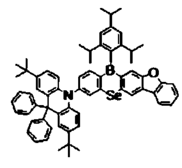
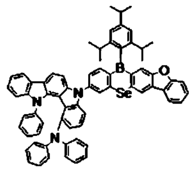
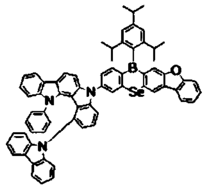
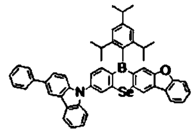
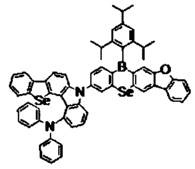
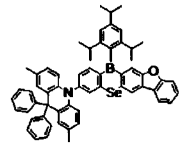
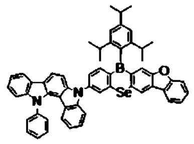
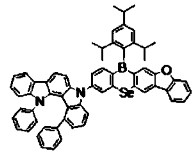
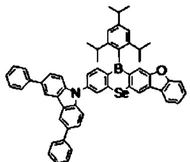
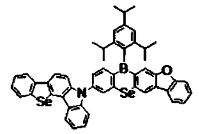
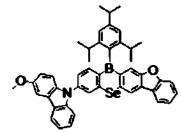
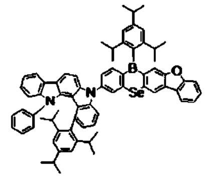
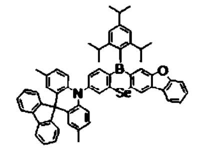
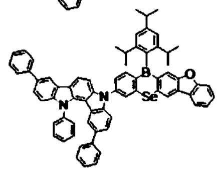
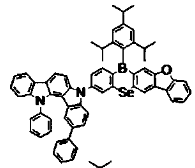
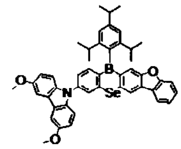
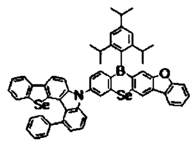
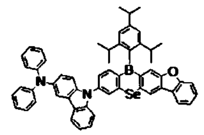
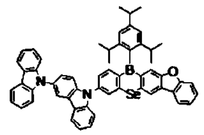
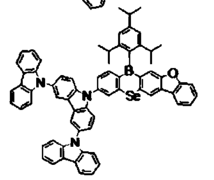
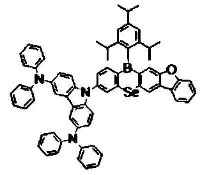
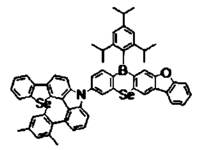
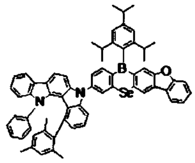
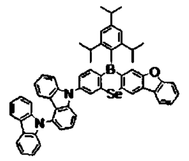
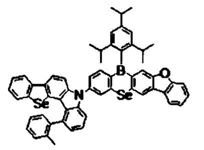
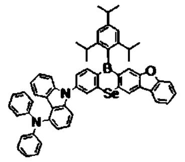
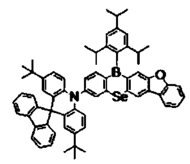
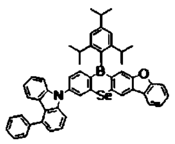
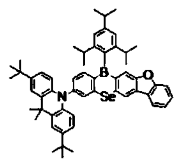
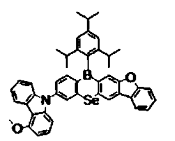
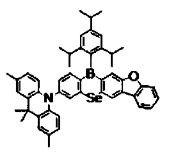

[Chem. 47]

[Group 26]

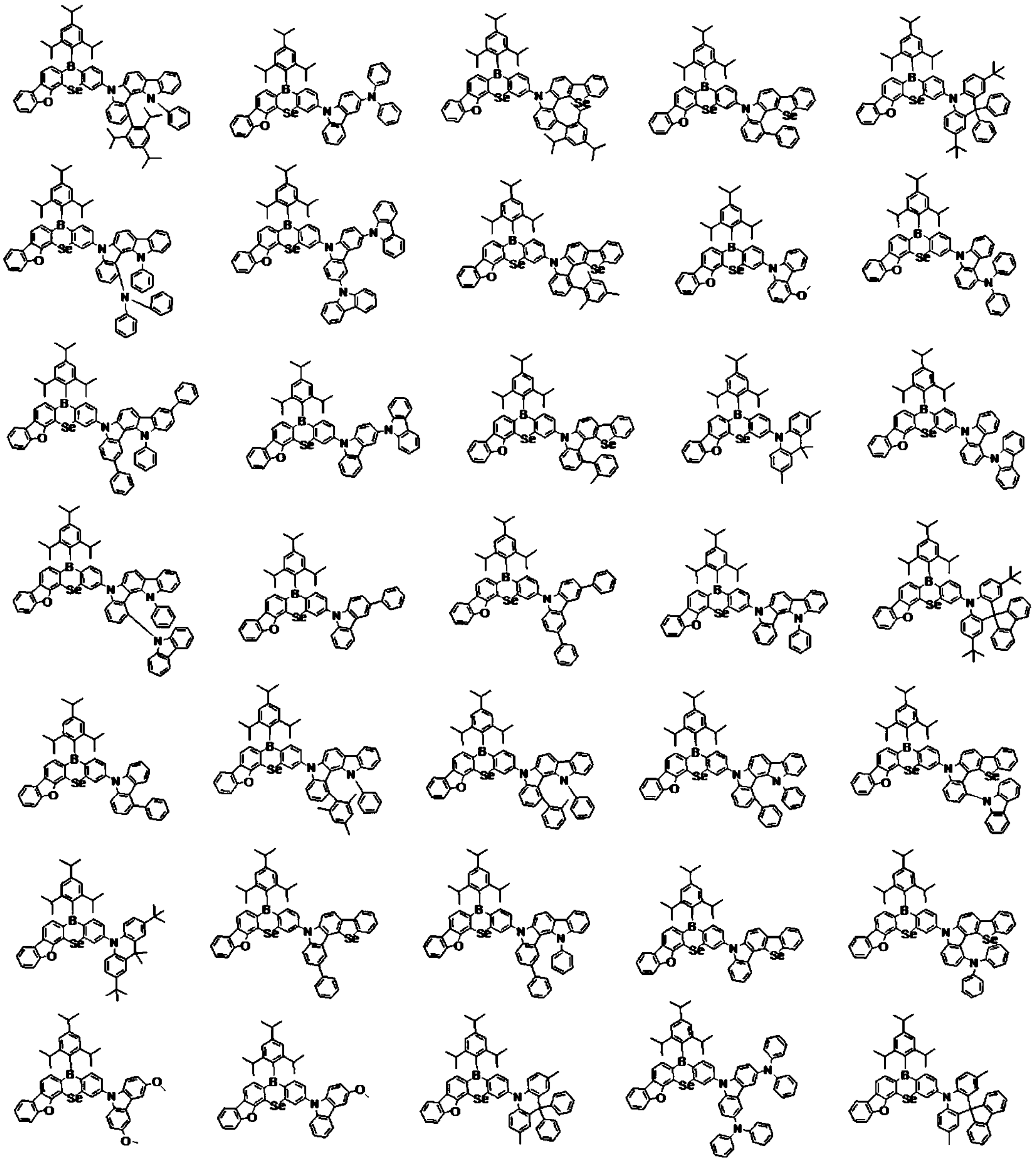

[Chem. 48]

[Group 27]

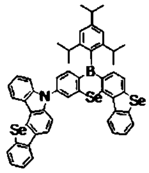
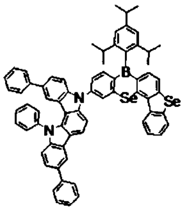
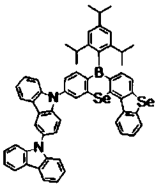
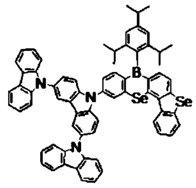
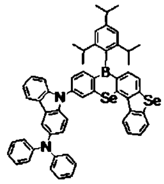
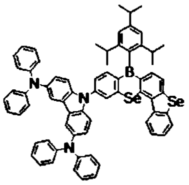
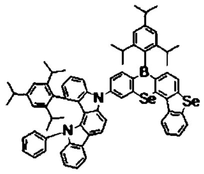
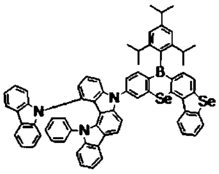
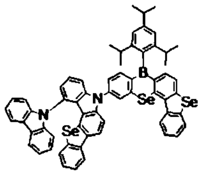
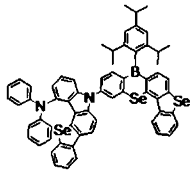
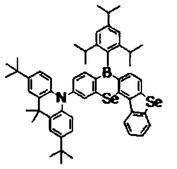
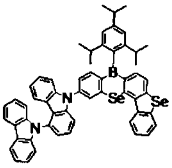
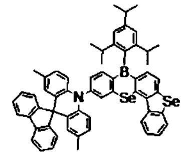
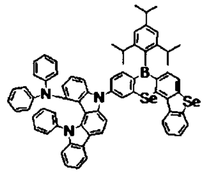
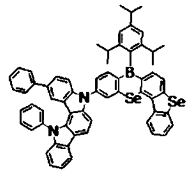
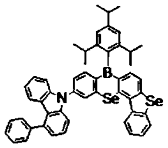
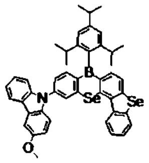
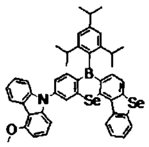
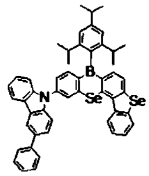
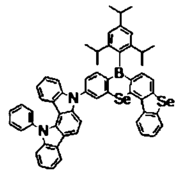
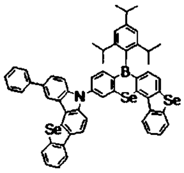
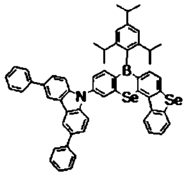
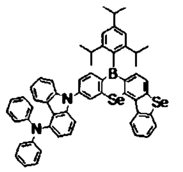
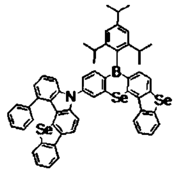
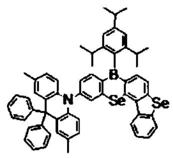
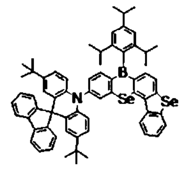
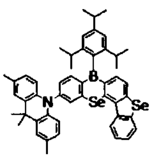
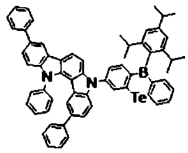
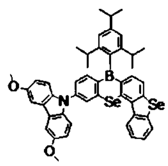
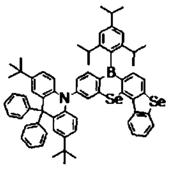
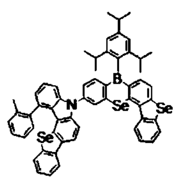
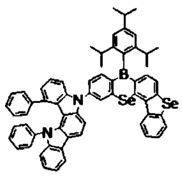
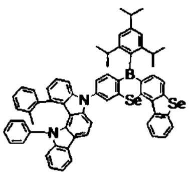
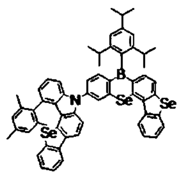
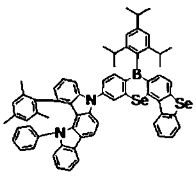
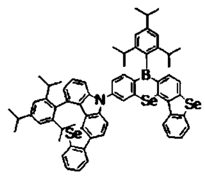

[Chem. 49]

[Group 28]

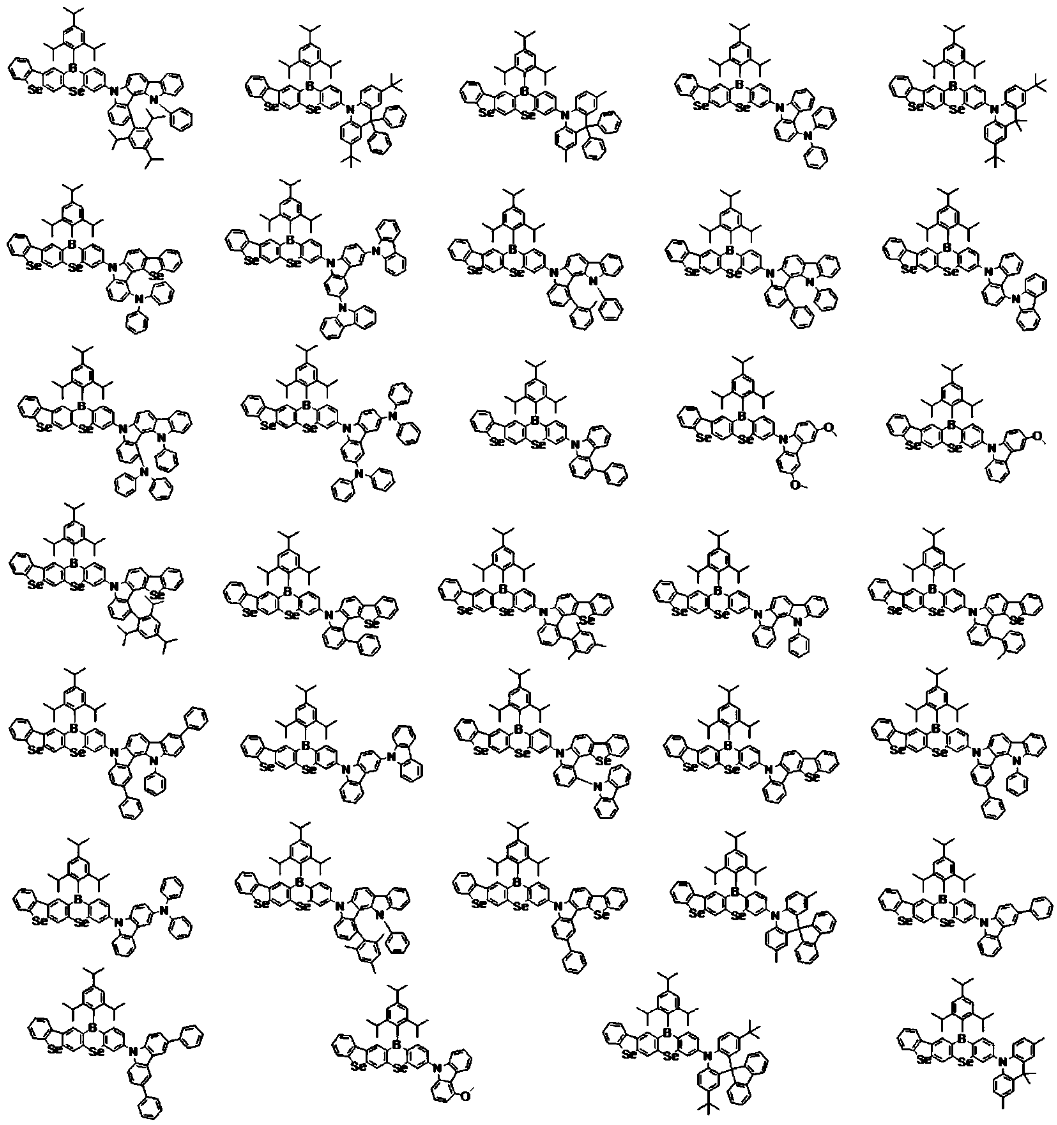

[Chem. 50]

[Group 29]

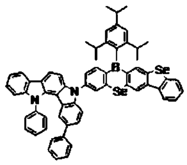 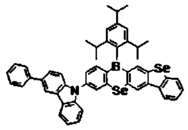 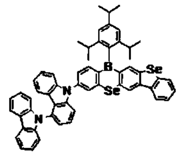 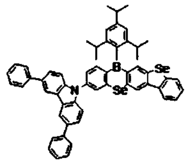 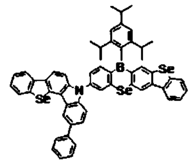

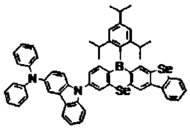 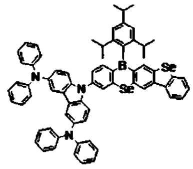 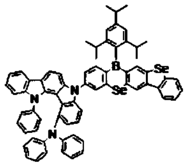 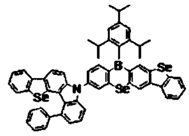 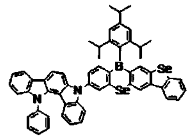

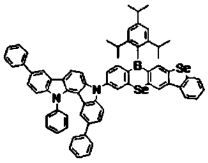 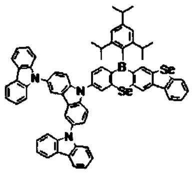 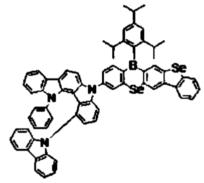 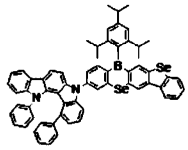 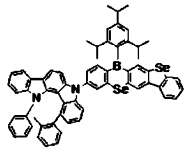

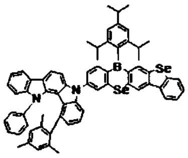 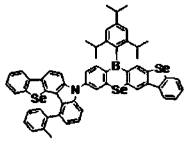 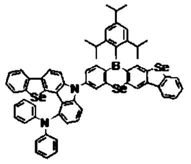 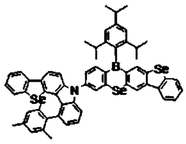 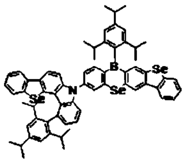

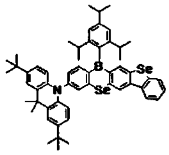 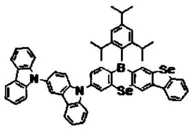 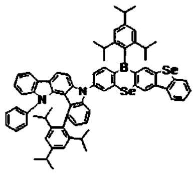 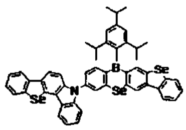 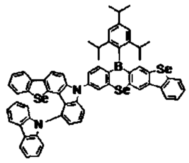

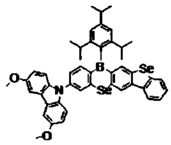 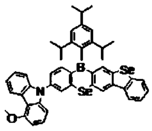 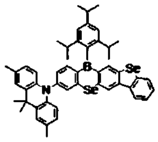 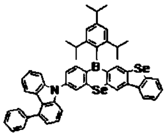 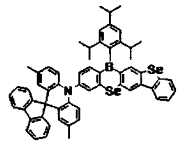

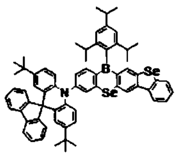 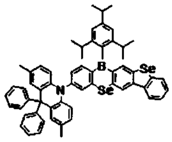 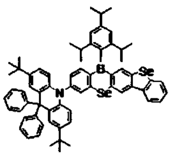 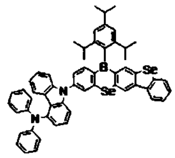 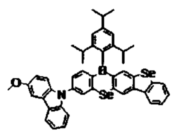

[Chem. 51]

[Group 30]

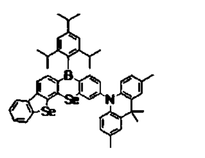 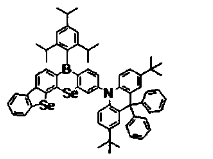 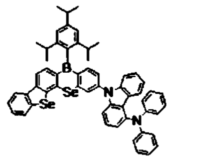 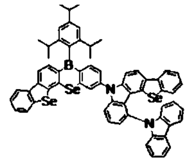 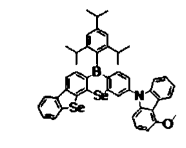

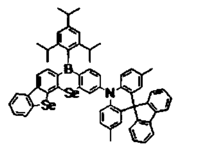 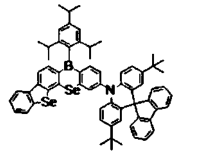 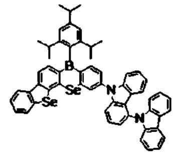 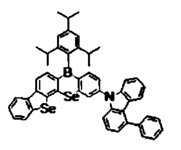 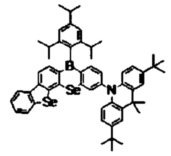

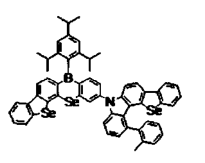 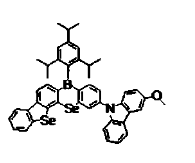 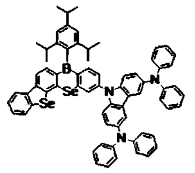 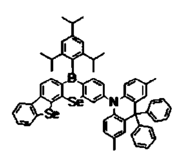 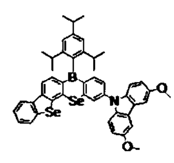

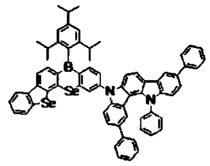 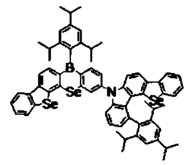 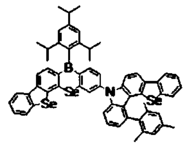 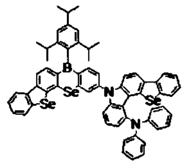 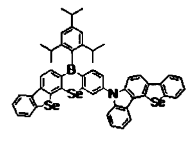

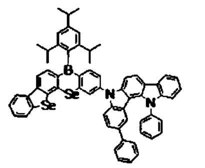 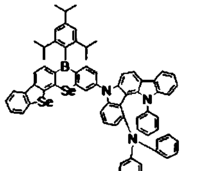 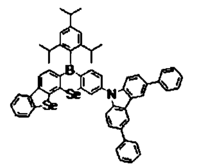 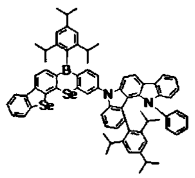 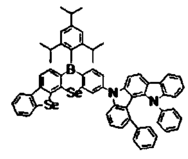

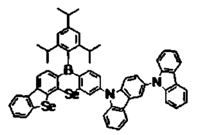 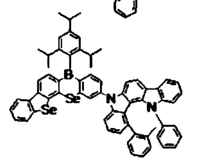 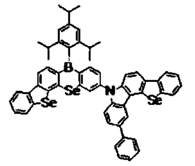 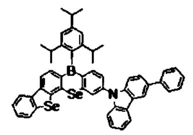 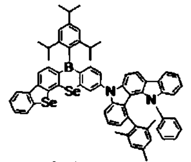

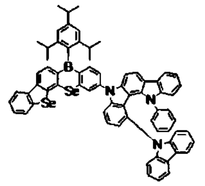 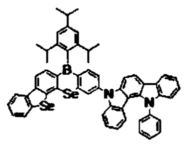 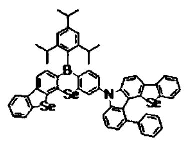 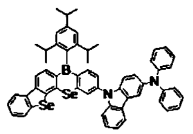 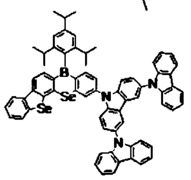

<Other Organic Compounds>

Another organic compound according to the present invention may be a compound that satisfies Expression (a) below, Expression (b) below, and Expression (c) below, is represented by any one of General formulas (1-1), (1-2), and (4) to (7) below, and exhibits delayed fluorescence. Details of compounds represented by General formulas (1-1) and (1-2) are as described above.

$$k_r > 5 \times 10^5\ s^{-1} \qquad \cdots (a)$$

$$k_{RISC}/k_r > 0.2 \qquad \cdots (b)$$

$$k_{RISC}/k_{ISC} > 0.001 \qquad \cdots (c)$$

$k_r$: a rate constant from the excited singlet state to the ground state
$k_{risc}$: a reverse intersystem crossing rate constant between the excited singlet state and the excited triplet state
$k_{ISC}$: an intersystem crossing rate constant between the excited singlet state and the excited triplet state

[Chem. 52]

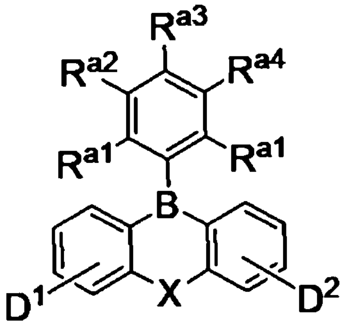

General formula(1-1)

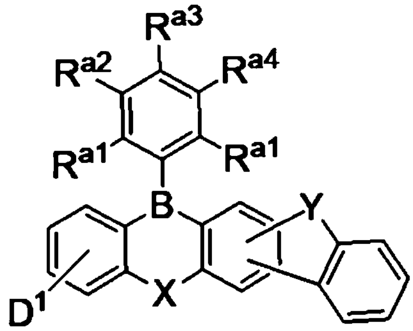

General formula(1-2)

In General formulas (1-1) and (1-2), $R^{a1}$ to $R^{a4}$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group. However, $R^{a1}$ is not a hydrogen atom.

X is a selenium atom or a tellurium atom.

Y is selected from an oxygen atom, a sulfur atom, a selenium atom, a tellurium atom, and a nitrogen atom having an alkyl group or an aryl group as a substituent.

$D^1$ is a group represented by any one of General formulas (2-1) to (2-5) below. $D^2$ is a hydrogen atom or a group represented by any one of General formulas (2-1) to (2-5) below. In General formulas (2-1) to (2-5) below, * represents a binding site.

[Chem. 53]

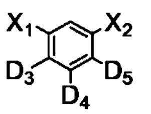

General formula (4)

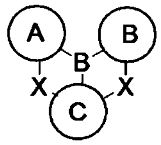

General formula (5)

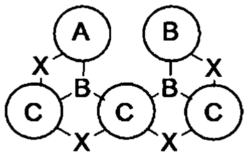

General formula (6)

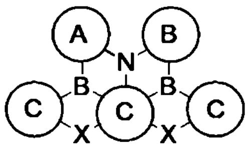

General formula (7)

In General formula (4), $X_1$ and $X_2$ are each independently selected from a hydrogen atom, a deuterium atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group. However, $X_2$ is not a hydrogen atom or a deuterium atom.

$D_3$ to $D_5$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, a cyano group, and groups represented by General formulas (2-1) to (2-5). However, at least one of $D_3$ to $D_5$ is independently selected from the groups represented by General formulas (2-1) to (2-5).

In General formulas (5) to (7), X is selected from an oxygen atom, a sulfur atom, a selenium atom, a tellurium atom, a nitrogen atom having an alkyl group or an aryl group as a substituent, and a single bond.

Rings A to C are each independently selected from a substituted or unsubstituted aryl and a heteroaryl, and the rings A and B may be bound to each other with a single bond.

[Chem. 54]

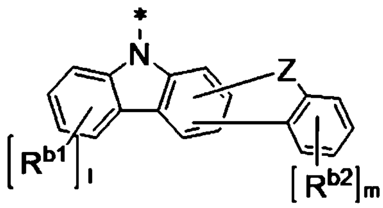

General formula (2-1)

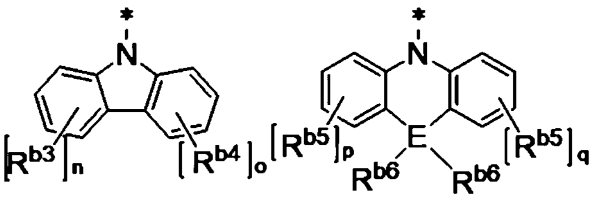

General formula (2-2) General formula (2-3)

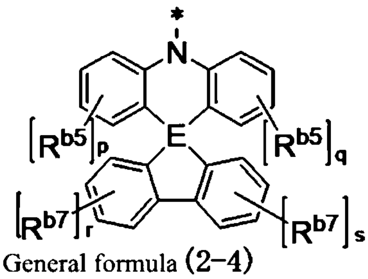

General formula (2-4)

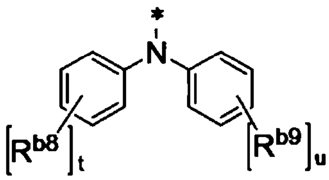

General formula (2-5)

In General formulas (2-1) to (2-5), $R^{b1}$ to $R^{b9}$ are each independently selected from a deuterium atom, a substituted or unsubstituted alkyl group, a substituted or unsubstituted alkoxy group, a substituted or unsubstituted aryl group, a substituted or unsubstituted nitrogen-containing heteroaryl group, and a substituted or unsubstituted amino group.

Z is selected from an oxygen atom, a sulfur atom, a selenium atom, a tellurium atom, and a nitrogen atom having an alkyl group or an aryl group as a substituent.

E is a carbon atom, a silicon atom, or a germanium atom.

Each of 1, m, n, r, and s is an integer of 0 or more and 4 or less. o is an integer of 1 or more and 4 or less. Each of p and q is 0 or 1. Each of t and u is an integer of 0 or more and 5 or less.

<Expressions (a) to (c)>

Another organic compound according to another embodiment of the present invention has the following characteristics.

[Expression (a)]

The organic compound preferably satisfies Expression (a).

$$k_r > 5\times 10^5\ s^{-1} \qquad \cdots (a)$$

$k_r$: the rate constant from the excited singlet state to the ground state

In general, more light tends to be emitted as $k_r$ becomes larger. Ref-2 shown in Table 5, which is an MR-type TADF in which selenium is used, has $k_r$ of $10^5\ s^{-1}$ and its roll-off suppression effect is low.

[Expression (b)]

Also, the organic compound preferably satisfies Expression (b), and more preferably satisfies Expression (b1).

$$k_{RISC}/k_r > 0.2 \qquad \cdots (b)$$

$$k_{RISC}/k_r > 1 \qquad \cdots (b1)$$

$k_r$: the rate constant from the excited singlet state to the ground state
$k_{RISC}$: the reverse intersystem crossing rate constant between the excited singlet state and the excited triplet state

4CzIPN (Ref-5) shown in Table 5, which is a typical D-A-type TADF, has $k_{RISC}/k_r$ not larger than 0.2, and therefore, its roll-off suppression effect is low.

[Expression (c)]

The organic compound preferably satisfies Expression (c), more preferably satisfies Expression (c1), and further preferably satisfies Expression (c2).

$$k_{RISC}/k_{ISC}>0.001 \cdots (c)$$

$$k_{RISC}/k_{ISC}>0.1 \cdots (c1)$$

$$0.3<k_{RISC}/k_{ISC}<0.333 \cdots (c2)$$

$k_{RISC}$: the reverse intersystem crossing rate constant between the excited singlet state and the excited triplet state
$k_{ISC}$: the intersystem crossing rate constant between the excited singlet state and the excited triplet state

$k_{RISC}/k_{ISC}$ is derived from Formula (x) below, assuming that the triplet and the singlet are in equilibrium.

[Math. 1]

$$K=\frac{[S]}{[T]}=\frac{k_{RISC}}{k_{ISC}}=\frac{1}{3}\exp\left(\frac{-\Delta E_{ST}}{k_B T}\right)^{(x)}$$

Here, $k_B$ is the Boltzmann constant, the temperature T is 0.00861 meV, 298 K, and $\Delta E_{ST}$ is an energy difference between the singlet and the triplet.

The larger this equilibrium constant is, the lower the concentration of triplet excitons becomes, and accordingly, triplet-triplet annihilation does not occur, and the roll-off suppression effect becomes high.

In general, $\Delta E_{ST}$ is preferably smaller than 0.15 eV, and accordingly, $k_{RISC}/k_{ISC}$ is preferably larger than 0.001. Specifically, in Formula (x), when $\Delta E_{ST}$ is 0.0259 eV ($k_B$T), $k_{RISC}/k_{ISC}$ is 0.1, and when $\Delta E_{ST}$ is 0, $k_{RISC}/k_{ISC}$ is 0.333. That is to say, $\Delta E_{ST}$ of 0 is more preferable than $\Delta E_{ST}$ of 0.0259 eV, and accordingly, $k_{RISC}/k_{ISC}$ is preferably larger than 0.1, and more preferably larger than 0.3, and is preferably smaller than 0.333 since $\Delta E_{ST}$ does not become smaller than 0.

(2) Organic light emitting element

Next, the following describes an organic light emitting element according to the present embodiment. The organic light emitting element according to the present embodiment includes at least a first electrode, a second electrode, and an organic compound layer between these electrodes. One of the first electrode and the second electrode is an anode, and the other is a cathode. In the organic light emitting element according to the present embodiment, the organic compound layer may be a single layer or a laminated body including a plurality of layers, as long as the organic compound layer includes a light emitting layer. Here, if the organic compound layer is a laminated body including a plurality of layers, the organic compound layer may include, in addition to the light emitting layer, a hole injection layer, a hole transport layer, an electron blocking layer, a hole-exciton blocking layer, an electron transport layer, an electron injection layer, etc. The light emitting layer may be a single layer or a laminated body including a plurality of layers.

In the organic light emitting element according to the present embodiment, at least one layer included in the organic compound layer contains the organic compound according to the present embodiment. Specifically, the organic compound according to the present embodiment is contained in any of the light emitting layer, the hole injection layer, the hole transport layer, the electron blocking layer, the hole-exciton blocking layer, the electron transport layer, and the electron injection layer, etc., described above. The organic compound according to the present embodiment is preferably contained in the light emitting layer.

If the organic compound according to the present embodiment is contained in the light emitting layer of the organic light emitting element according to the present embodiment, the light emitting layer may be a layer constituted by only the organic compound according to the present embodiment or a layer containing the organic compound according to

the present embodiment and other compounds such as a second organic compound and a third organic compound. FIG. 1 shows conceptual diagrams of the light emitting layer. In FIGS. 1A to 1D, TADF represents a compound that exhibits thermally activated delayed fluorescence, which is an example of the organic compound according to the present embodiment. In the light emitting layer, the organic compound according to the present embodiment may be used as a guest to dope a host material (a second organic compound) as shown in FIG. 1A, or may be used as an assist dopant together with a fluorescence material (a third organic compound) to dope a host material (a second organic compound) as shown in FIG. 1B. If the light emitting layer is a non-doped layer, it is possible to use the organic compound according to the present embodiment alone as shown in FIG. 1C, or the organic compound according to the present embodiment may be used as a host material and doped with a fluorescence material as shown in FIG. 1D.

As shown in FIGS. 1A and 1B, in a doped light emitting layer, the host material is a compound having the highest mass ratio among compounds contained in the light emitting layer. The guest is a compound whose mass ratio is lower than the mass ratio of the host material and that mainly emits light among the compounds contained in the light emitting layer. The assist dopant is a compound whose mass ratio is lower than the mass ratio of the host material and that serves to sensitize excitons among the compounds contained in the light emitting layer.

When the organic compound according to the present embodiment is used as a guest as shown in FIG. 1A, the concentration of the organic compound according to the present embodiment is preferably 0.01% by mass or more and 50% by mass or less, and more preferably 10% by mass or more and 50% by mass or less with respect to the whole light emitting layer. When the organic compound according to the present embodiment is used as an assist dopant as shown in FIG. 1B, the concentration of the organic compound according to the present embodiment is preferably 1% by mass or more and 50% by mass or less, and more preferably 10% by mass or more and 50% by mass or less with respect to the whole light emitting layer. In this case, the concentration of the fluorescence material is preferably 0.01% by mass or more and 20% by mass or less, and more preferably 0.01% by mass or more and 5% by mass or less with respect to the whole light emitting layer.

The concentration of the organic compound in a non-doped light emitting layer is as follows. When the organic compound according to the present embodiment is used as a main component, or preferably, when the organic compound according to the present embodiment is used alone as shown in FIG. 1C, the concentration of the organic compound according to the present embodiment is preferably 50% by mass or more, and more preferably 80% by mass or more, and may be substantially 100% by mass with respect to the whole light emitting layer. When the organic compound according to the present embodiment is used as a host material as shown in FIG. 1D, the concentration of the organic compound according to the present embodiment is preferably 50% by mass or more and less than 100% by mass, and more preferably 80% by mass or more and less than 100% by mass with respect to the whole light emitting layer. In this case, the concentration of the fluorescence material is preferably 0.01% by mass or more and 20% by mass or less, and more preferably 0.01% by mass or more and 5% by mass or less with respect to the whole light emitting layer.

The inventors of the present invention conducted various studies and found that, if the organic compound according to the present embodiment is used as a host material or a guest material of a light emitting layer, in particular, if the organic compound is used as a guest material of a light emitting layer, it is possible to obtain an element that outputs light with high luminance and high efficiency and has extremely high durability. The light emitting layer may include one or more light emitting layers, and if a light emitting material that emits light of a different color is contained, the color can be mixed with the color of light emitted by the organic compound according to the present embodiment. The light emitting element including a plurality of layers means that the light emitting layer and another light emitting layer are stacked on each other. In this case, the color of light emitted from the organic light emitting element is not limited to the color of light emitted by the organic compound according to the present embodiment. More specifically, the color of light emitted from the organic light emitting element may be white or an intermediate color. If the organic light emitting element emits white light, the other light emitting layer emits light of a color other than the color of light emitted by the organic compound according to the present embodiment, e.g., if the organic compound according to the present embodiment emits blue light, the other light emitting layer emits green light or red light. The light emitting layer is formed using a vapor deposition method or an application method. Details of the method for forming the light emitting layer will be described later in Examples.

The organic compound according to the present embodiment can be used as a material of an organic compound layer other than the light emitting layer in the organic light emitting element according to the present embodiment. Specifically, the organic compound may be used as a material of an electron transport layer, an electron injection layer, a hole transport layer, a hole injection layer, a hole blocking layer, etc. In this case, the color of light emitted from the organic light emitting element is not limited to the color of light emitted by the organic compound according to the present embodiment. More specifically, the color of light emitted from the organic light emitting element may be white or an intermediate color.

<Other Compounds>

It is possible to use, together with the organic compound according to the present embodiment, a conventionally-known low-molecular-weight or high-molecular-weight hole injection compound or hole transport compound, a host compound, a light emitting compound, an electron injection compound or electron transport compound, etc., as necessary. The following describes examples of these compounds.

In order to facilitate injection of holes from the anode and transport the injected holes to the light emitting layer, a material that has high hole mobility is preferable as a hole injection transport material. Also, in order to suppress degradation of film quality, such as crystallization, in the organic light emitting element, a material that has a high glass transition temperature is preferable. Examples of low-molecular-weight materials and high-molecular-weight materials having hole injection transport properties include triarylamine derivatives, arylcarbazole derivatives, phenylenediamine derivatives, stilbene derivatives, phthalocyanine derivatives, porphyrin derivatives, poly(vinylcarbazole), poly(thiophene), and other conductive polymers. Furthermore, the hole injection transport material described above is suitably used in an electron blocking layer as well. It is also possible to use a mixture (PEDOT:PSS) of polyethylene dioxythiophene and polystyrene sulfonic acid, which is commonly used as a hole injection material when an application method is used. The following shows specific examples of compounds that are used as hole injection transport materials, but it goes without saying that there is no limitation to these examples.

[Chem. 55]

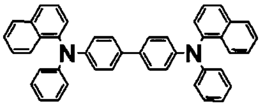

HT1

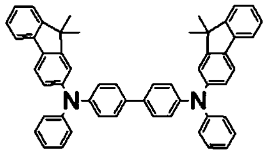

HT2

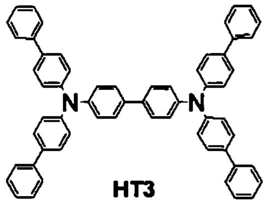

HT3

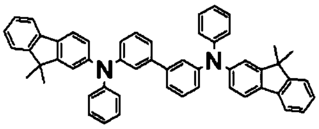

HT4

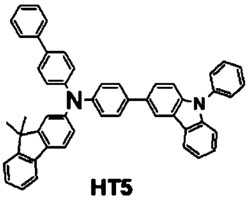

HT5

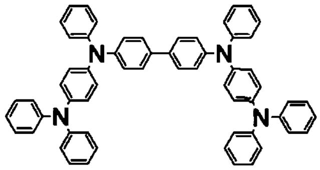

HT6

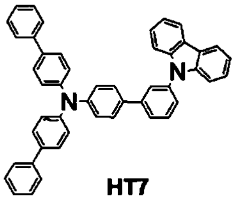

HT7

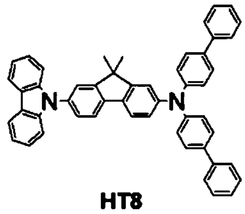

HT8

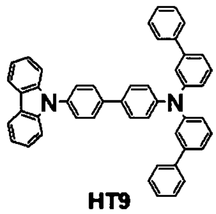

HT9

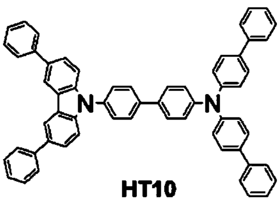

HT10

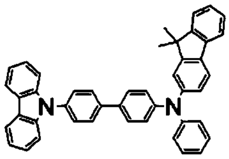

HT11

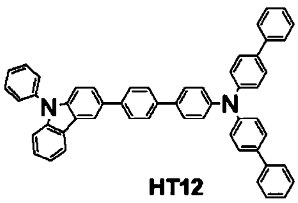

HT12

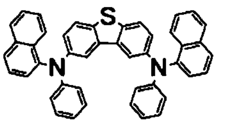

HT13

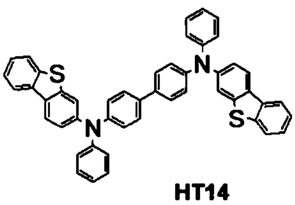

HT14

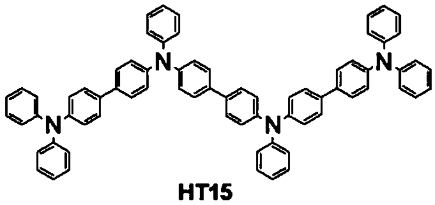

HT15

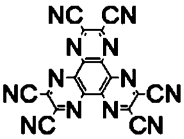

HT16

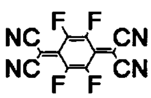

HT17

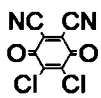

HT18

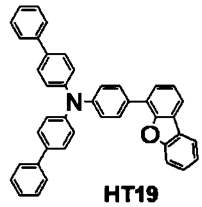

HT19

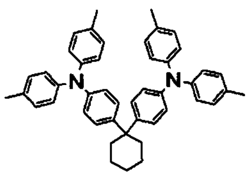

HT20

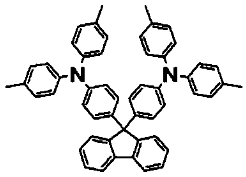

HT21

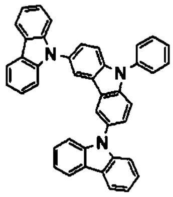

HT22

[Chem. 56]

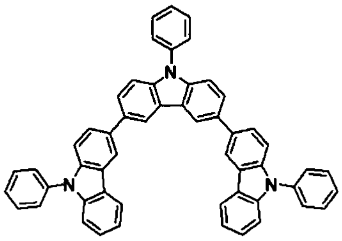

HT23

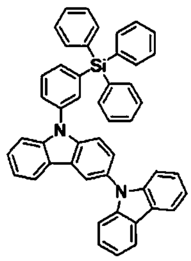

HT24

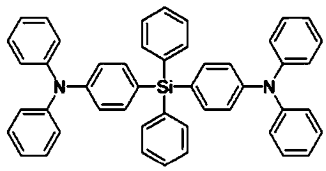

HT25

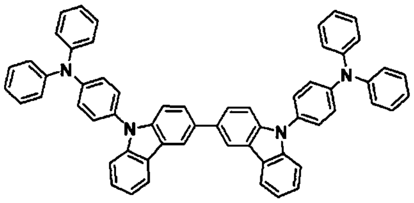

HT26

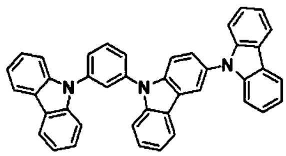

HT27

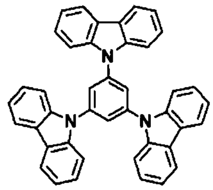

HT28

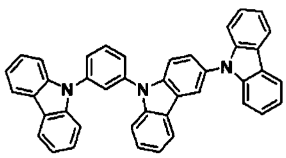

HT29

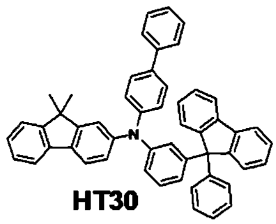

HT30

Out of the compounds listed as examples of the hole transport materials, HT16 to HT18 can reduce a driving voltage when used in a layer that is in contact with the anode. HT16 is widely used in organic light emitting elements. It is possible to use HT2 to HT7, HT10, HT12, and HT22 to HT28 in an organic compound layer adjacent to HT16. It is also possible to use polymer compounds having hole transport properties such as polyphenylene vinylene (PPV), polyfluorene (PF), polyvinyl carbazole (PVK), and derivatives thereof. Other than the above, it is possible to use an inorganic insulating layer of $SiO_2$, SiN, or the like, or an organic silicon-based polymer such as siloxane, for example. It is also possible to use a plurality of materials in a single organic compound layer.

Examples of light emitting materials that mainly relate to the light emitting function include donor acceptor type organic compounds, boron-containing complexes, indocarbazole fused ring compounds, fused ring compounds (e.g., fluorene derivatives, naphthalene derivatives, pyrene derivatives, perylene derivatives, tetracene derivatives, anthracene derivatives, rubrene, etc.), quinacridone derivatives, coumarin derivatives, stilbene derivatives, organic aluminum complexes such as tris(8-quinolinolato)aluminum, iridium complexes, platinum complexes, rhenium complexes, copper complexes, europium complexes, ruthenium complexes, and polymer derivatives such as poly(phenylene vinylene) derivatives, poly(fluorene) derivatives, and poly(phenylene) derivatives. When the light emitting layer is formed using an application method, a polymer compound having light emitting properties is mainly used. This is because a polymer compound has a high degree of amorphousness, and accordingly, is unlikely to be crystallized compared with low-molecular-weight compounds. Specific examples of materials that may be used include polymer compounds such as polyphenylene vinylene (PPV), polyfluorene (PF), polyvinyl carbazole (PVK), and derivatives thereof. The following shows

specific examples of compounds that are used as light emitting materials, but it goes without saying that there is no limitation to these examples.

[Chem. 57]

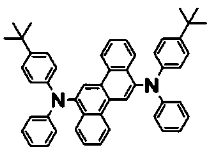

BD1

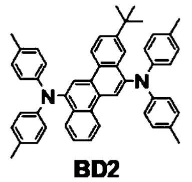

BD2

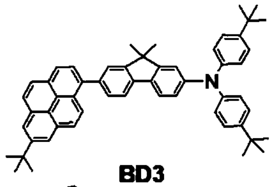

BD3

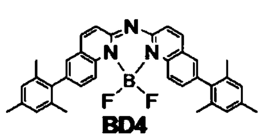

BD4

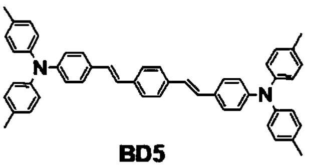

BD5

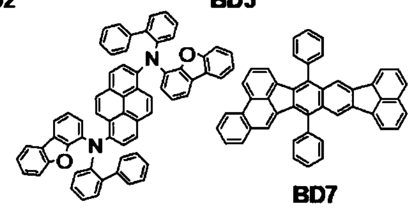

BD6

BD7

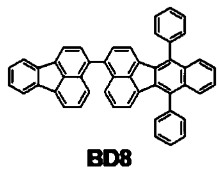

BD8

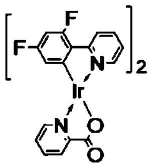

BD9

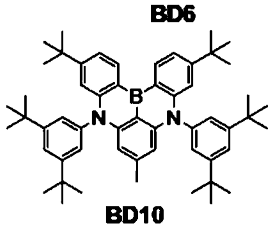

BD10

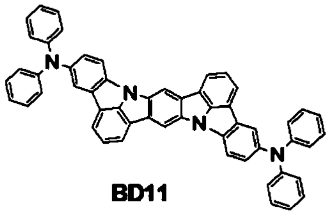

BD11

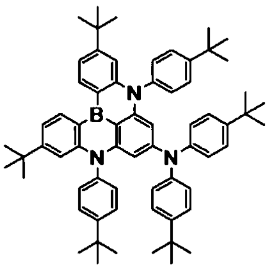

BD12

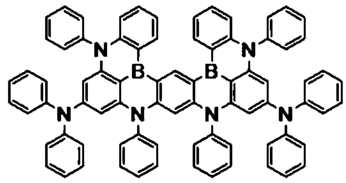

BD13

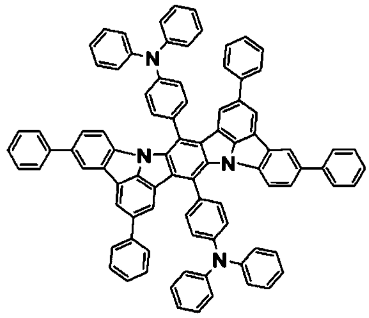

BD14

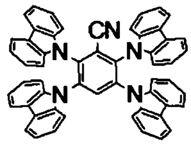

BD15

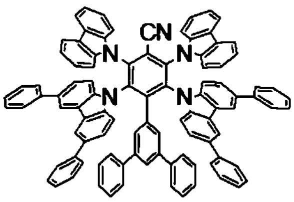

BD16

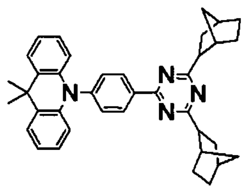

BD17

[Chem. 58]

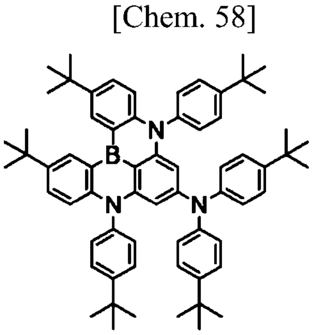

BD18

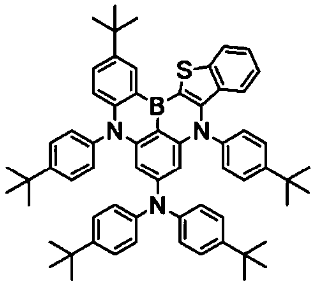

BD19

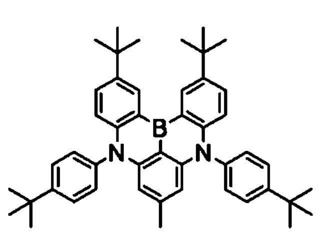

BD20

[Chem. 59]

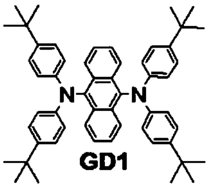
GD1

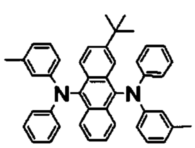
GD2

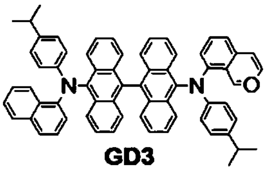
GD3

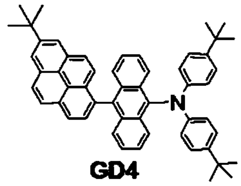
GD4

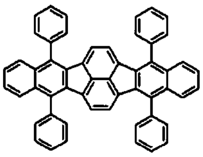
GD5

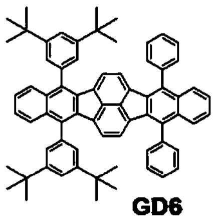
GD6

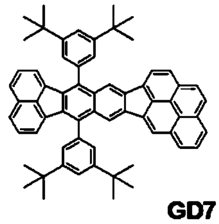
GD7

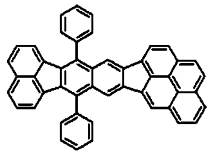
GD8

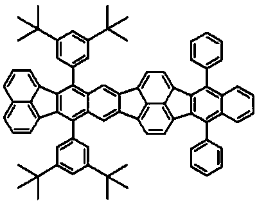
GD9

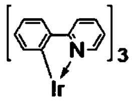
GD10

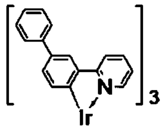
GD11

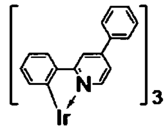
GD12

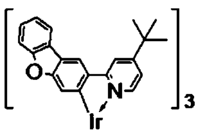
GD13

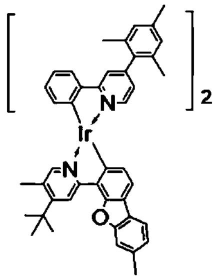
GD14

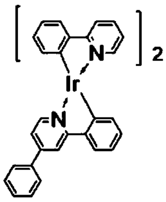
GD15

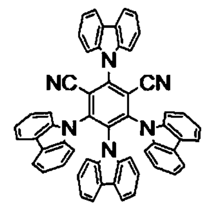
GD16

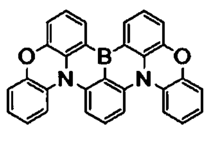
GD17

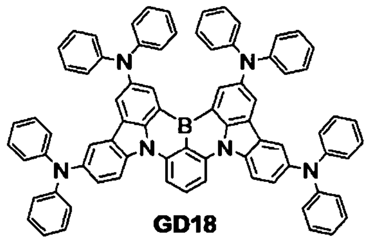
GD18

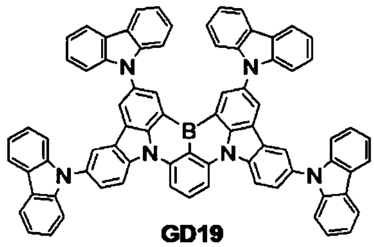
GD19

[Chem. 60]

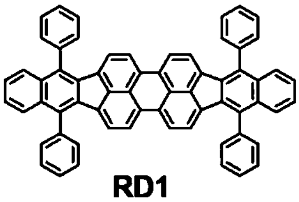

RD1

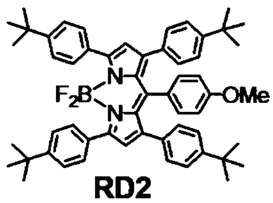

RD2

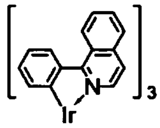

RD3

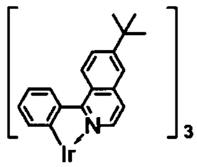

RD4

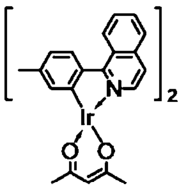

RD5

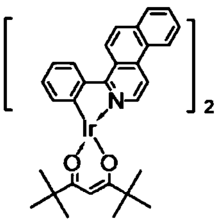

RD6

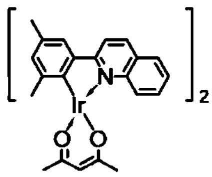

RD7

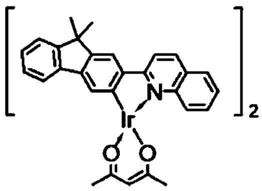

RD8

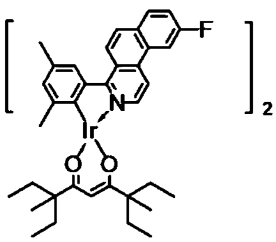

RD9

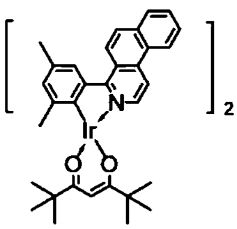

RD10

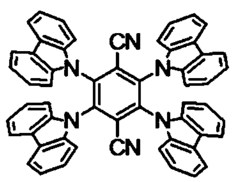

RD11

The following shows specific examples of compounds that are used as light emitting layer host materials or light emission assist materials contained in the light emitting layer, but it goes without saying that there is no limitation to these examples.

[Chem. 61]

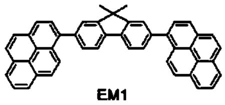
EM1

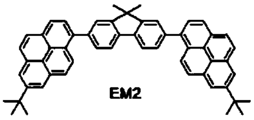
EM2

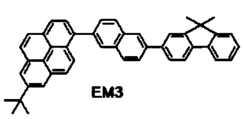
EM3

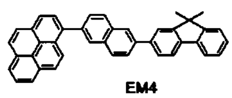
EM4

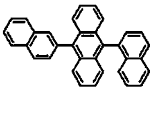
EM5

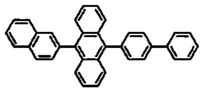
EM6

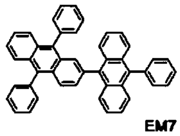
EM7

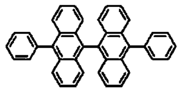
EM8

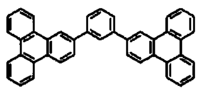
EM9

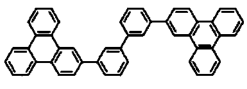
EM10

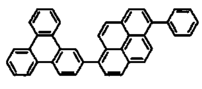
EM11

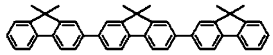
EM12

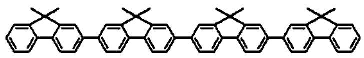
EM13

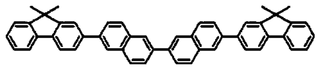
EM14

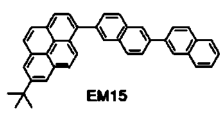
EM15

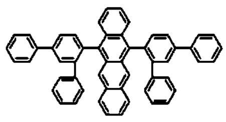
EM16

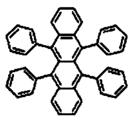
EM17

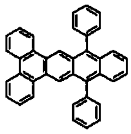
EM18

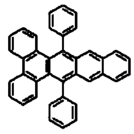
EM19

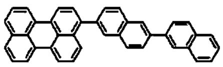
EM20

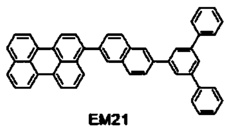
EM21

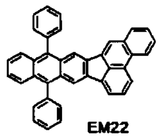
EM22

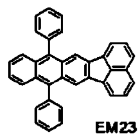
EM23

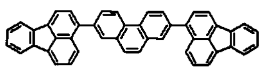
EM24

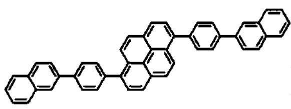
EM25

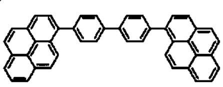
EM26

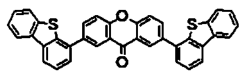
EM27

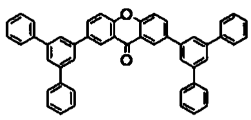
EM28

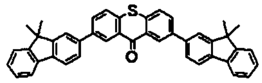
EM29

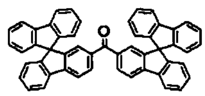
EM30

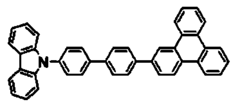
EM31

[Chem. 62]

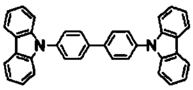
EM32

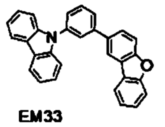
EM33

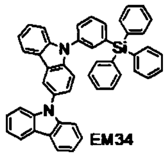
EM34

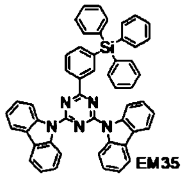
EM35

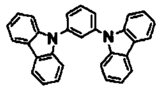
EM36

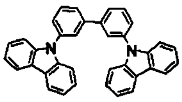
EM37

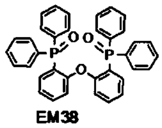
EM38

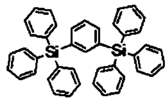
EM39

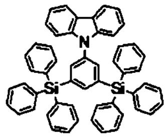
EM40

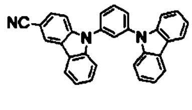
EM41

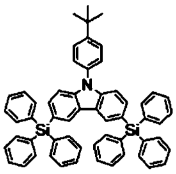
EM42

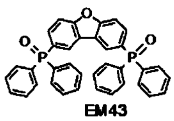
EM43

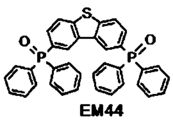
EM44

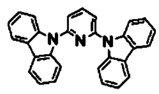
EM45

When a host material is used together with a delayed fluorescence material or a phosphorescent material, it is preferable that the triplet of the host material is higher than the triplet of the delayed fluorescence material. Examples of preferable host materials include EM32 to EM45, but are not limited to these.

A suitable electron transport material can be selected from materials that can transport electrons injected from the cathode to the light emitting layer, and the electron transport material is selected in view of a balance with the hole mobility of the hole transport material, for example. Examples of materials that have electron transport properties include oxadiazole derivatives, oxazole derivatives, pyrazine derivatives, triazole derivatives, triazine derivatives, quinoline derivatives, quinoxaline derivatives, phenanthroline derivatives, organic aluminum complexes, and fused ring compounds (e.g., fluorene derivatives, naphthalene derivatives, chrysene derivatives, and anthracene derivatives). Furthermore, the electron transport material described above can be suitably used in a hole blocking layer as well. The following shows specific examples of compounds that are used as electron transport materials, but it goes without saying that there is no limitation to these examples.

[Chem. 63]

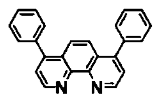
ET1
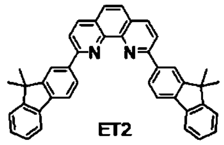
ET2
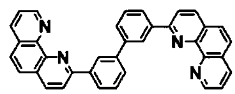
ET3
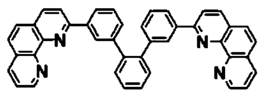
ET4
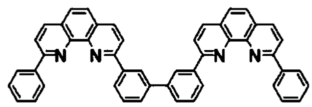
ET5
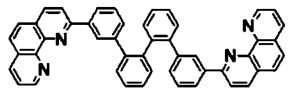
ET6
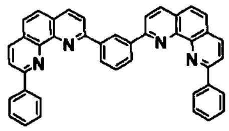
ET7
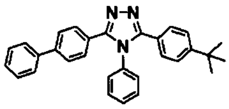
ET8
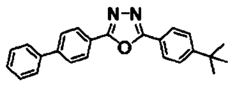
ET9
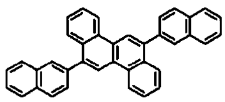
ET10
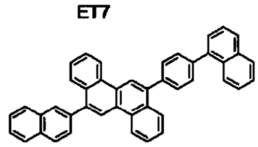
ET11
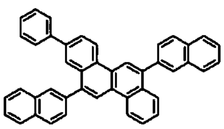
ET12
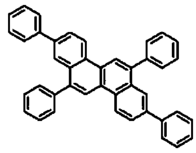
ET13
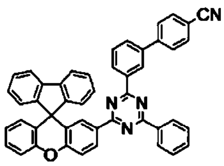
ET14
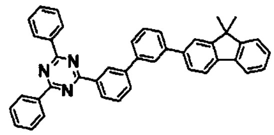
ET15
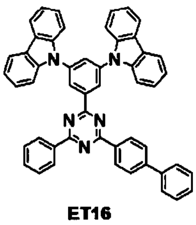
ET16
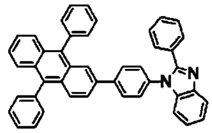
ET17
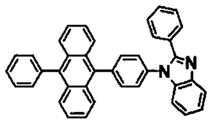
ET18
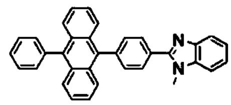
ET19
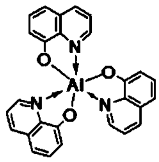
ET20
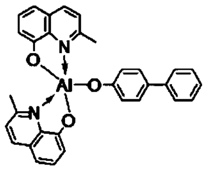
ET21
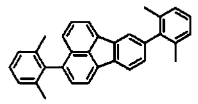
ET22
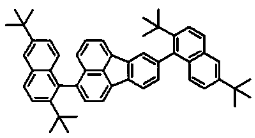
ET23
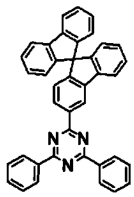
ET24
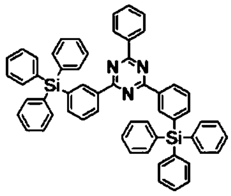
ET25
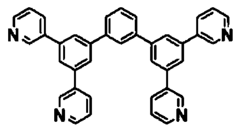
ET26

A suitable electron injection material can be selected from materials that can facilitate injection of electrons from the cathode, and the electron injection material is selected in view of a balance with hole injection properties, for example. N-type dopants and reducible dopants are included as organic compounds. Examples of the electron injection material include compounds containing alkali metals such as lithium fluoride, lithium complexes such as lithium quinolinol, benzimidazolidene derivatives, imidazolidene derivatives, fulvalene derivatives, and acridine derivatives. The electron injection material may be used together with the electron transport material described above.

<Configuration of Organic Light Emitting Element>

The organic light emitting element is obtained by forming an insulating layer, a first electrode, an organic compound layer, and a second electrode on a substrate. It is possible to provide a protective layer, a color filter, a microlens, and the like on the second electrode. When the color filter is provided, a flattening layer may be provided between the

protective layer and the color filter. The flattening layer can be formed using an acrylic resin or the like. This also applies when a flattening layer is provided between the color filter and the microlens. Either one of the first electrode and the second electrode may be an anode, and the other may be a cathode.

[Substrate]

The substrate is constituted by, for example, quartz, glass, a silicon wafer, resin, or metal. A switching element such as a transistor and wiring may be provided on the substrate, and an insulating layer may be formed on the switching element and the wiring. There is no limitation on the material of the insulating layer as long as a contact hole can be formed in the insulating layer to form wiring between the substrate and the first electrode and the insulating layer can assure insulation from wiring that is not connected to the first electrode. For example, it is possible to use resin such as polyimide, silicon oxide, or silicon nitride.

[Electrodes]

A pair of electrodes can be used. The pair of electrodes may be an anode and a cathode. When an electric field is applied in a direction in which the organic light emitting element emits light, an electrode having a higher electrical potential is the anode, and the other electrode is the cathode. It can also be said that an electrode that supplies holes to the light emitting layer is the anode, and an electrode that supplies electrons is the cathode.

It is preferable to use a material having a higher work function as the material of the anode. For example, it is possible to use a single metal such as gold, platinum, silver, copper, nickel, palladium, cobalt, selenium, vanadium, or tungsten, a mixture including any of these, an alloy containing any combination of these, or a metal oxide such as tin oxide, zinc oxide, indium oxide, indium tin oxide (ITO), and indium zinc oxide. It is also possible to use a conductive polymer such as polyaniline, polypyrrole, or polythiophene.

It is possible to use any one of these electrode materials alone, or a combination of two or more of them. Also, the anode may be constituted by a single layer or a plurality of layers.

When the anode is used as a reflective electrode, it is possible to use, for example, chromium, aluminum, silver, titanium, tungsten, molybdenum, or an alloy or stack of these metals. It is also possible to form a reflective film that does not serve as an electrode, from these materials. When the anode is used as a transparent electrode, it is possible to use a transparent conductive layer made of an oxide such as indium tin oxide (ITO) or indium zinc oxide, but there is no limitation to these materials. Photolithography can be used to form the electrode.

On the other hand, it is preferable to use a material having a small work function as the material of the cathode. Examples of the material of the cathode include alkali metals such as lithium, alkaline earth metals such as calcium, aluminum, titanium, manganese, silver, lead, chromium, and a mixture including any of these. It is also possible to use an alloy containing any combination of these metals. For example, it is possible to use a magnesium-silver alloy, an aluminum-lithium alloy, an aluminum-magnesium alloy, a silver-copper alloy, a zinc-silver alloy, etc. It is also possible to use a metal oxide such as indium tin oxide (ITO). It is possible to use any one of these electrode materials alone, or a combination of two or more of them. The cathode may be constituted by a single layer or a plurality of layers. In particular, it is preferable to use silver, and it is more preferable to use a silver alloy to suppress agglomeration of silver. There is no limitation on the ratio between components of the alloy as long as agglomeration of silver can be suppressed. For example, silver and another metal may be contained at a ratio of 1:1 or 3:1, for example.

The cathode may be configured as a top emission element using a conductive oxide layer made of ITO or the like, or may be configured as a bottom emission element using a reflective electrode made of aluminum (Al) or the like, and there is no particular limitation on the configuration of the cathode. There is no particular limitation on the method for forming the cathode, but if a DC sputtering method or an AC sputtering method is used, for example, the cathode can be formed with good coverage and it is easy to reduce the resistance, and therefore, these methods are more preferable.

[Organic Compound Layer]

The organic compound layer may be constituted by a single layer or a plurality of layers. When the organic compound layer includes a plurality of layers, the layers may be called a hole injection layer, a hole transport layer, an electron blocking layer, a light emitting layer, a hole blocking layer, an electron transport layer, and an electron injection layer, depending on their functions. The organic compound layer is mainly constituted by an organic compound, but may also contain inorganic atoms or inorganic compounds. For example, the organic compound layer may contain copper, lithium, magnesium, aluminum, iridium, platinum, molybdenum, zinc, etc. The organic compound layer may be disposed between the first electrode and the second electrode, and may be in contact with the first electrode and the second electrode.

The organic compound layer (a hole injection layer, a hole transport layer, an electron blocking layer, a light

emitting layer, a hole blocking layer, an electron transport layer, an electron injection layer, etc.) in the organic light emitting element according to an embodiment of the present invention is formed using the following methods.

The organic compound layer in the organic light emitting element according to an embodiment of the present invention can be formed using a dry process such as a vacuum vapor deposition method, an ionized deposition method, sputtering, or a plasma method. Instead of a dry process, it is also possible to use a wet process in which the material of the organic compound layer is dissolved in a suitable solvent and applied to form the layer using a known application method (e.g., a spin coating method, a casting method, a micro gravure coating method, a gravure coating method, a bar coating method, a roll coating method, a wire bar coating method, a dip coating method, a spray coating method, a screen printing method, a flexography method, an offset printing method, an inkjet printing method, a capillary coating method, or a nozzle coating method). Among these, the vacuum vapor deposition method, the ionized deposition method, the inkjet printing method, the nozzle coating method, etc., are suitable to manufacture an organic light emitting element having a large area.

When the light emitting layer is formed using a compound that has high solubility to an organic solvent, out of organic compounds according to the present embodiment, it is preferable to form the light emitting layer using an application method. Examples of the application method include a spin coating method, a slit coater method, a printing method, an inkjet method, a dispensing method, and a spraying method. The light emitting layer may also be formed using a vacuum vapor deposition method.

Here, if a layer is formed using a vacuum vapor deposition method, a solution application method, or the like, crystallization and the like are unlikely to occur and the layer shows excellent stability over time. When an application method is used to form a film, it is possible to use a suitable binder resin in combination with the material of the film.

Examples of the binder resin include a polyvinyl carbazole resin, a polycarbonate resin, a polyester resin, an ABS resin, an acrylic resin, a polyimide resin, a phenolic resin, an epoxy resin, a silicone resin, a urea resin, etc., but there is no limitation to these examples.

It is possible to use any one of these binder resins as a homopolymer or a copolymer, or a mixture of two or more of them. Furthermore, it is possible to use known additives such as a plasticizer, an antioxidant, an ultraviolet absorbent, etc., as necessary.

It is usually preferable that each layer in the organic light emitting element has a thickness of 1 nm or more and 10 μm or less. In particular, the light emitting layer in the organic compound layer preferably has a thickness of 10 nm or more and 100 nm or less to have effective light emitting properties.

[Protective Layer]

A protective layer may be provided on the second electrode. For example, by bonding a glass plate provided with a moisture absorbent on the second electrode, it is possible to suppress intrusion of water and the like into the organic compound layer and reduce the occurrence of a display failure. As another embodiment, it is possible to provide a passivation film made of silicon nitride or the like on the second electrode to suppress intrusion of water and the like into the organic compound layer. For example, a protective layer may be formed by conveying the organic light emitting element after the formation of the second electrode to another chamber while maintaining a vacuum, and forming a silicon nitride film with a thickness of 2 μm using a CVD method. It is also possible to provide a protective layer using an atomic layer deposition method (ALD method) after the film is formed using the CVD method. There is no limitation on the material of the film formed using the ALD method, but it is possible to use silicon nitride, silicon oxide, aluminum oxide, etc. It is also possible to further form a silicon nitride film using the CVD method on the film formed using the ALD method. The film formed using the ALD method may have a film thickness smaller than thicknesses of the films formed using the CVD method. Specifically, the film formed using the ALD method may have a thickness not larger than 50% or not larger than 10% of the thicknesses of the films formed using the CVD method.

[Color Filter]

A color filter may be provided on the protective layer. For example, a color filter prepared in view of the size of the organic light emitting element may be provided on another substrate, and this substrate may be bonded to the substrate provided with the organic light emitting element, or a color filter may be patterned on the above-described protective layer by using photolithography. The color filter may be made of a polymer.

[Flattening Layer]

A flattening layer may be provided between the color filter and the protective layer. The flattening layer is provided to reduce unevenness of the lower layer. Such a layer may also be called a resin material layer without limiting its purpose. The flattening layer may be made of an organic compound, and the compound may be a low-molecular-weight compound or a polymer, but is preferably a polymer.

A configuration is also possible in which flattening layers are provided above and below the color filter, and those flattening layers may be made of the same material. Specific examples of the material of the flattening layers include a polyvinyl carbazole resin, a polycarbonate resin, a polyester resin, an ABS resin, an acrylic resin, a polyimide resin, a phenolic resin, an epoxy resin, a silicone resin, and a urea resin.

[Microlens]

The organic light emitting element may include an optical member such as a microlens on the side from which light is emitted. The microlens may be made of an acrylic resin, an epoxy resin, or the like. The microlens may be provided for the purpose of increasing the amount of light to be output from the organic light emitting element and controlling the direction of the light. The microlens may have a hemispherical shape. When the microlens has a hemispherical shape, there is a tangent that is parallel to the insulating layer among tangents to the hemisphere, and the point of contact between the tangent and the hemisphere is the apex of the microlens. The apex of the microlens can be determined similarly in any cross-sectional view. That is to say, among tangents to the semicircle of the microlens in a cross-sectional view, there is a tangent that is parallel to the insulating layer, and the point of contact between the tangent and the semicircle is the apex of the microlens.

It is also possible to define the middle point of the microlens. In a cross section of the microlens, a line segment extending from an end point of an arc shape to another end point of the arc shape is imagined, and the middle point of the line segment can be referred to as the middle point of the microlens. The cross section in which the apex and the middle point are determined may be perpendicular to the insulating layer.

[Counter Substrate]

A counter substrate may be provided on the flattening layer. The counter substrate is provided at a position corresponding to the substrate described above, and therefore is called a counter substrate. The counter substrate may be made of the same material as the substrate described above. When the substrate described above is referred to as a "first substrate", the counter substrate may be referred to as a "second substrate".

[Pixel Circuit]

An organic light emitting device including the organic light emitting element may include a pixel circuit connected to the organic light emitting element. The pixel circuit may be an active matrix circuit that controls light emission from a first light emitting element and a second light emitting element independently from each other. The active matrix circuit may be a voltage programming circuit or a current programming circuit. A driving circuit includes a pixel circuit for each pixel. The pixel circuit may include a light emitting element, a transistor for controlling light emission luminance of the light emitting element, a transistor for controlling light emission timings, a capacitor holding a gate voltage of the transistor for controlling the light emission luminance, and a transistor for connecting the circuit to GND not via the light emitting element.

The light emitting device includes a display region and a peripheral region on the periphery of the display region. The display region includes the pixel circuit, and the peripheral region includes a display control circuit. The mobility of the transistors included in the pixel circuit may be lower than the mobility of transistors included in the display control circuit. The inclination of current-voltage characteristics of the transistors included in the pixel circuit may be smaller than the inclination of current-voltage characteristics of the transistors included in the display control circuit. The inclination of current-voltage characteristics can be measured using so-called Vg-Ig characteristics. The transistors included in the pixel circuit are transistors connected to light emitting elements such as the first light emitting element.

[Pixel]

The organic light emitting device including the organic light emitting element may include a plurality of pixels. Each pixel includes subpixels that emit light of colors different from each other. The subpixels may emit light of R, G, and B colors, respectively, for example.

In each pixel, a region that is called a pixel opening emits light. The pixel opening may be not larger than 15 μm and at least 5 μm. More specifically, the pixel opening may have a size of 11 μm, 9.5 μm, 7.4 μm, or 6.4 μm, for example. The distance between the subpixels may be 10 μm or less, more specifically, 8 μm, 7.4 μm, or 6.4 μm.

The pixels may have a known arrangement in a plan view. For example, a stripe arrangement, a delta arrangement, a PenTile arrangement, or a Bayer arrangement may be used. The subpixels may have any known shape in a plan view. Examples of the shape include quadrilateral shapes such as rectangular shapes and rhombus shapes, hexagonal shapes, etc. It goes without saying that shapes that are not rectangles in strict meaning but are close to rectangles are also included in rectangles. The shape of the subpixels and the arrangement of pixels may be suitably

combined.

<Applications of Organic Light Emitting Element>

The organic light emitting element according to the present embodiment can be used as a component of a display device or an illumination device. Other applications of the organic light emitting element include an exposure light source in an electrophotographic image forming device, a backlight of a liquid crystal display device, and a light emitting device including a color filter for a white light source.

The display device may be an image information processing device that includes an image input unit for inputting image information from an area CCD, a linear CCD, a memory card, or the like and an information processing unit for processing input information and that is configured to display an input image in a display unit. The display device may include a plurality of pixels, and at least one of the plurality of pixels may include the organic light emitting element according to the present embodiment and an active element such as a transistor connected to the organic light emitting element. At this time, the substrate may be a semiconductor substrate made of silicon or the like, and the transistor may be a MOSFET formed on the substrate. An image display device includes an input unit for inputting image information and a display unit for outputting images, and the display unit includes the display device according to the present embodiment.

Also, a display unit included in an imaging device or an inkjet printer may have a touch panel function. There is no particular limitation on the method for driving the touch panel function, and the method may be an infrared method, a capacitance method, a resistive film method, or an electromagnetic induction method. Also, the display device may be used for a display unit of a multifunctional printer.

Next, the following describes a display device according to the present embodiment with reference to the drawings. FIG. 2 shows a schematic cross-sectional view of an example of a display device including an organic light emitting element and a transistor connected to the organic light emitting element. The transistor is an example of an active element. The transistor may be a thin film transistor (TFT).

FIG. 2A is a schematic cross-sectional view showing an example of a pixel that is a constituent element of the display device according to the present embodiment. The pixel includes subpixels 10. The subpixels are classified into 10R, 10G, and 10B according to light emitted therefrom. The color of emitted light may be distinguished based on the wavelength of light emitted from a light emitting layer, or light emitted from the subpixels may be selectively passed or subjected to color conversion using a color filter or the like. Each subpixel 10 includes a reflective electrode as a first electrode 2 on an interlayer insulating layer 1, an insulating layer 3 covering edges of the first electrode 2, an organic compound layer 4 covering the first electrode 2 and the insulating layer 3, a transparent electrode as a second electrode 5, a protective layer 6, and a color filter 7.

A transistor and a capacitor element may be provided under or inside the interlayer insulating layer 1. The transistor and the first electrode 2 may be electrically connected via a contact hole (not shown) or the like.

The insulating layer 3 is also called a bank or a pixel separation film. The insulating layer covers edges of the first electrode 2 and surrounds the first electrode 2. Portions that are not covered with the insulating layer 3 are in contact with the organic compound layer 4 and serve as a light emitting region.

The organic compound layer 4 includes a hole injection layer 41, a hole transport layer 42, a light emitting layer 43, a hole blocking layer 44, and an electron transport layer 45.

The second electrode 5 may be a transparent electrode, a reflective electrode, or a semitransparent electrode.

The protective layer 6 suppresses intrusion of moisture into the organic compound layer 4. Although the protective layer 6 is illustrated as a single layer, the protective layer 6 may include a plurality of layers. The layers may include an inorganic compound layer and an organic compound layer.

The color filters 7 are classified into 7R, 7G, and 7B according to their colors. The color filters 7 may be formed on a flattening film (not shown). Also, a resin protective layer (not shown) may be provided on the color filters 7. The color filters 7 may also be formed on the protective layer 6. Alternatively, the color filters may be formed on a counter substrate such as a glass substrate and then attached to the pixel.

A display device 100 shown in FIG. 2B includes an organic light emitting element 26 and a TFT 18 that is an example of a transistor. The display device includes a substrate 11 made of glass, silicon, or the like, and an insulating layer 12 formed on the substrate 11. An active element such as the TFT 18 is provided on the insulating layer 12, and a gate electrode 13 of the active element, a gate insulating film 14, and a semiconductor layer 15 are provided on the insulating layer 12. The TFT 18 includes a drain electrode 16 and a source electrode 17. An insulating film 19 is provided on the TFT 18. An anode 21 of the organic light emitting element 26 is connected to the source electrode 17 via a contact hole 20 provided in the insulating film 19.

Note that the method for electrically connecting an electrode (the anode 21 or a cathode 23) included in the organic light emitting element 26 and an electrode (the source electrode 17 or the drain electrode 16) included in the TFT 18 is not limited to that shown in FIG. 2B. It is sufficient that either one of the anode 21 and the cathode 23 is electrically connected to either one of the source electrode 17 and the drain electrode 16 of the TFT 18.

Although an organic compound layer 22 of the display device 100 shown in FIG. 2B is illustrated as a single layer, the organic compound layer 22 may include a plurality of layers. A first protective layer 24 and a second protective layer 25 for suppressing degradation of the organic light emitting element 26 are provided on the cathode 23.

In the display device 100 shown in FIG. 2B, a transistor is used as a switching element, but another switching element such as a MIM element may also be used instead of the transistor.

Also, the transistor used in the display device 100 shown in FIG. 2B is not limited to a thin film transistor including an active layer on the insulating surface of the substrate, and may also be a transistor in which a single crystal silicon wafer is used. Examples of the active layer include single crystal silicon, amorphous silicon, non-single-crystal silicon such as microcrystalline silicon, and non-single-crystal oxide semiconductors such as indium zinc oxide and indium gallium zinc oxide. Note that a thin film transistor is also called a TFT element.

The transistor included in the display device 100 shown in FIG. 2B may also be formed in the substrate such as a Si substrate. Here, forming the transistor in the substrate means forming the transistor by processing the substrate such as a Si substrate itself. That is to say, the transistor included in the substrate can be regarded as being formed integrally with the substrate.

The light emission luminance of the organic light emitting element according to the present embodiment is controlled by the TFT, which is an example of a switching element, and by providing a plurality of organic light emitting elements in a plane, it is possible to display an image with the light emission luminance of the respective organic light emitting elements. Note that the switching element according to the present embodiment is not limited to the TFT, and may also be a transistor made of low-temperature polysilicone or an active matrix driver formed on the substrate such as a Si substrate. The wording "on the substrate" may also mean "in the substrate". Whether to form the transistor in the substrate or use a TFT is selected according to the size of a display unit, e.g., if the display unit has a size of about 0.5 inches, it is preferable to provide the organic light emitting element on a Si substrate.

FIG. 3 is a schematic diagram showing an example of a display device according to the present embodiment. A display device 1000 may include a touch panel 1003, a display panel 1005, a frame 1006, a circuit board 1007, and a battery 1008 between an upper cover 1001 and a lower cover 1009. Flexible printed circuits FPC 1002 and 1004 are connected to the touch panel 1003 and the display panel 1005. A transistor is printed on the circuit board 1007. The battery 1008 may be omitted if the display device is not a portable device, or even if the display device is a portable device, the battery may be provided at a different position.

The display device according to the present embodiment may include color filters having red, green, and blue colors. The color filters having the red, green, and blue colors may be arranged in a delta arrangement.

The display device according to the present embodiment may be used for a display unit of a portable terminal. In such a case, the display device may have both a display function and an operation function. Examples of the portable terminal include mobile phones such as a smartphone, a tablet, and a head mounted display.

The display device according to the present embodiment may also be used for a display unit of an imaging device that includes an optical unit including a plurality of lenses and an imaging element that receives light that has passed through the optical unit. The imaging device may include a display unit that displays information obtained by the imaging element. The display unit may be exposed to the outside of the imaging device or may be disposed inside a finder. The imaging device may be a digital camera or a digital video camera.

FIG. 4A is a schematic diagram showing an example of an imaging device according to the present embodiment. An imaging device 1100 may include a viewfinder 1101, a rear display 1102, an operation unit 1103, and a housing 1104. The viewfinder 1101 may include a display device according to the present embodiment. In this case, the display device may display not only images to be captured but also environmental information, imaging instructions, etc. The environmental information may indicate the intensity and direction of external light, the movement speed of a subject, and the possibility of the subject being hidden by an obstacle, for example.

A timing suitable for imaging is a very short time, and therefore, it is desirable to display information as soon as possible. Accordingly, it is preferable to use the display device in which the organic light emitting element according to the present embodiment is used. This is because the organic light emitting element has a high response speed. The display device in which the organic light emitting element is used can be used more preferably than a liquid crystal display device in such devices that require a high display speed.

The imaging device 1100 includes an optical unit (not shown). The optical unit includes a plurality of lenses and forms an image on an imaging element housed in the housing 1104. It is possible to adjust the focus by adjusting the positions of the plurality of lenses relative to each other. This operation may be performed automatically. The imaging device may also be called a photoelectric conversion device. The photoelectric conversion device may include, as an imaging method, a method for detecting a difference from a previous image, a method for extracting an image from images that are always recorded, and the like, rather than capturing images one by one.

FIG. 4B is a schematic diagram showing an example of an electronic device according to the present embodiment. An electronic device 1200 includes a display unit 1201, an operation unit 1202, and a housing 1203. The housing 1203 may include a circuit, a printed circuit board having the circuit, a battery, and a communication unit. The

operation unit 1202 may be a button or a touch panel type reaction unit. The operation unit 1202 may be a biometric recognition unit that recognizes a fingerprint for unlocking. The electronic device including a communication unit may also be called a communication device. The electronic device 1200 may further include a lens and an imaging element to have a camera function. Images captured using the camera function are displayed on the display unit 1201. Examples of the electronic device 1200 include a smartphone and a notebook personal computer.

FIG. 5 shows a schematic diagram of an example of a display device according to the present embodiment. FIG. 5A shows a display device such as a television monitor or a PC monitor. A display device 1300 includes a frame 1301 and a display unit 1302. The light emitting element according to the present embodiment may be used in the display unit 1302. The display device 1300 includes a base 1303 supporting the frame 1301 and the display unit 1302. The form of the base 1303 is not limited to that shown in FIG. 5A. The lower side of the frame 1301 may also serve as the base. Also, the frame 1301 and the display unit 1302 may be curved. The radius of curvature may be 5000 mm or more and 6000 mm or less.

FIG. 5B is a schematic diagram showing another example of a display device according to the present embodiment. A display device 1310 shown in FIG. 5B is a so-called foldable display device that can be folded. The display device 1310 includes a first display unit 1311, a second display unit 1312, a housing 1313, and a folding point 1314. The first display unit 1311 and the second display unit 1312 may include the light emitting element according to the present embodiment. The first display unit 1311 and the second display unit 1312 may be a single seamless display device. The first display unit 1311 and the second display unit 1312 can be separated at the folding point. The first display unit 1311 and the second display unit 1312 may display different images, respectively, or display one image together.

FIG. 6A is a schematic diagram showing an example of an illumination device according to the present embodiment. An illumination device 1400 may include a housing 1401, a light source 1402, a circuit board 1403, an optical filter 1404 through which light emitted from the light source 1402 passes, and a light diffusion unit 1405. The light source 1402 may include the organic light emitting element according to the present embodiment. The optical filter 1404 may be a filter that improves the color rendering of the light source. The light diffusion unit 1405 can effectively diffuse light from the light source so that the light reaches a wide area when lighting-up, for example. The optical filter 1404 and the light diffusion unit 1405 may be provided on the side of the illumination device from which light is emitted. A cover may be provided as the outermost member as necessary.

The illumination device illuminates the interior of a room, for example. The illumination device may emit any of white light, natural white light, and light of a color within a range from blue to red. The illumination device may include a light control circuit for controlling emitted light or a color control circuit for controlling the color of emitted light. The illumination device may include the organic light emitting element according to the present embodiment and a power source circuit connected to the organic light emitting element. The power source circuit converts an AC voltage to a DC voltage. The illumination device may include an inverter circuit. Note that white has a color temperature of 4200 K, and natural white has a color temperature of 5000 K. The illumination device may include a color filter.

Also, the illumination device according to the present embodiment may include a heat dissipation unit. The heat dissipation unit dissipates heat from the inside of the device to the outside of the device, and is made of a metal having a high specific heat or liquid silicone, for example.

FIG. 6B is a schematic diagram of an automobile that is an example of a movable body according to the present embodiment. The automobile includes a taillight that is an example of a lighting device. An automobile 1500 includes a taillight 1501 and may be configured such that the taillight illuminates in response to a braking operation or the like.

The taillight 1501 may include the organic light emitting element according to the present embodiment. The taillight 1501 may include a protective member for protecting the organic light emitting element. As long as the protective member is transparent and has a strength that is high to some extent, there is no limitation on the material of the protective member, but the protective member is preferably made of polycarbonate or the like. It is possible to mix a furandicarboxylic acid derivative, an acrylonitrile derivative, or the like with polycarbonate.

The automobile 1500 may include a body 1503 and a window 1502 attached to the body. If the window 1502 is not a window for checking the front and rear of the automobile, the window may be a transparent display. The transparent display may include the organic light emitting element according to the present embodiment. In this case, the components such as the electrodes of the organic light emitting element are constituted by transparent members.

The movable body according to the present embodiment may also be a ship, an aircraft, a drone, or the like. The movable body may include a body and a lighting device provided on the body. The lighting device may emit light to make the position of the body known. The lighting device includes the organic light emitting element according to the present embodiment.

The following describes an application example of the display device according to each embodiment described above with reference to FIG. 7. The display device is applicable to a system that can be worn as a wearable device such as smart glasses, an HMD, or a smart contact lens, for example. An imaging display device that is used in such application examples includes an imaging device that can perform photoelectric conversion on visible light and a display device that can emit visible light.

FIG. 7A is a schematic diagram showing an example of a wearable device according to an embodiment of the

present invention. The following describes glasses 1600 (smart glasses) according to an application example with reference to FIG. 7A. An imaging device 1602 such as a CMOS sensor or a SPAD is provided on the front surface side of a lens 1601 of the glasses 1600. Also, the display device according to each embodiment described above is provided on the rear surface side of the lens 1601.

The glasses 1600 further include a control device 1603. The control device 1603 functions as a power source for supplying power to the imaging device 1602 and the display device. Also, the control device 1603 controls operations of the imaging device 1602 and the display device. An optical system for gathering light to the imaging device 1602 is formed in the lens 1601.

FIG. 7B is a schematic diagram showing another example of a wearable device according to an embodiment of the present invention. The following describes glasses 1610 (smart glasses) according to an application example with reference to FIG. 7B. The glasses 1610 include a control device 1612, and an imaging device corresponding to the imaging device 1602 shown in FIG. 7A and a display device are installed in the control device 1612. An optical system for projecting light emitted from the imaging device and the display device included in the control device 1612 is formed in a lens 1611, and an image is projected onto the lens 1611. The control device 1612 functions as a power source for supplying power to the imaging device and the display device, and controls operations of the imaging device and the display device.

The control device 1612 may also include a line-of-sight detection unit that detects a line of sight of a person wearing the glasses. Infrared light may be used to detect the line of sight. An infrared light emitting unit emits infrared light toward an eyeball of a user who is gazing at a displayed image. The imaging unit including a light receiving element detects infrared light emitted from the infrared light emitting unit and then reflected off the eyeball, and thus obtains a captured image of the eyeball. A reduction means for reducing light emitted from the infrared light emitting unit toward a display unit in a plan view is provided to suppress degradation of image quality. The line of sight of the user toward the displayed image is detected from the captured image of the eyeball obtained by imaging the infrared light. Any known method can be applied to detect the line of sight using the captured image of the eyeball. For example, it is possible to use a method for detecting a line of sight based on a Purkinje image formed by the emitted light reflected off the cornea. More specifically, line-of-sight detection processing based on a pupil-corneal reflection method is performed. The line of sight of the user is detected by calculating a line-of-sight vector showing the orientation (rotation angle) of the eyeball based on an image of the pupil included in the captured image of the eyeball and the Purkinje image using the pupil-corneal reflection method.

The display device according to an embodiment of the present invention may include an imaging device including a light receiving element, and control a displayed image on the display device based on line-of-sight information of the user, which is obtained from the imaging device. Specifically, the display device determines a first field of vision range that the user is gazing at and a second field of vision range other than the first field of vision range based on the line-of-sight information. The first field of vision range and the second field of vision range may be determined by a control device of the display device, or the display device may receive those ranges determined by an external control device. The display resolution of the first field of vision range may be controlled to be higher than the display resolution of the second field of vision range in a display region of the display device. That is to say, the resolution of the second field of vision range may be controlled to be lower than the resolution of the first field of vision range.

Also, the display region includes a first display region and a second display region different from the first display region, and a region having a higher degree of priority is determined from the first display region and the second display region based on the line-of-sight information. The first field of vision range and the second field of vision range may be determined by the control device of the display device, or the display device may receive those ranges determined by an external control device. The resolution of the region having the higher degree of priority may be controlled to be higher than the resolution of the region other than the region having the higher degree of priority. That is to say, the resolution of the region having a relatively low degree of priority may be set to be low.

Note that AI may be used to determine the first field of vision range and the region having a higher degree of priority. The AI may be a model that is configured to estimate an angle of the line of sight and a distance to an object to which the line of sight is directed from the image of the eyeball by using, as teacher data, images of eyeballs and directions at which the imaged eyeballs were actually looking. The AI program may be included in the display device, the imaging device, or an external device. If the AI program is included in an external device, the AI program is transmitted to the display device via communication.

When display is controlled based on the detection of a line of sight, the present invention can be preferably applied to smart glasses that further include an imaging device for capturing images of the outside. The smart glasses can display captured information of the outside in real time.

FIG. 8A is a schematic diagram showing an example of an image forming device according to an embodiment of the present invention. An image forming device 40 is an electrophotographic image forming device, and includes a photosensitive member 27, an exposure light source 28, a charging unit 30, a developing unit 31, a transfer device 32, a conveyance roller 33, and a fixing device 35. Light 29 is emitted from the exposure light source 28 to form an electrostatic latent image on the surface of the photosensitive member 27. The exposure light source 28 includes the organic light emitting element according to the present embodiment. The developing unit 31 includes toner or the like. The charging unit

30 charges the photosensitive member 27. The transfer device 32 transfers a developed image onto a recording medium 34. The conveyance roller 33 conveys the recording medium 34. The recording medium 34 is paper, for example. The fixing device 35 fixes the image formed on the recording medium 34.

FIGS. 8B and 8C are schematic diagrams showing the exposure light source 28 in which a plurality of light emitting units 36 are arranged on an elongated substrate. Arrows 37 show a row direction that is parallel to the axis of the photosensitive member and in which organic light emitting elements are arranged. The row direction is the same as the direction of the axis about which the photosensitive member 27 rotates. This direction can also be called a long axis direction of the photosensitive member 27. FIG. 8B shows an arrangement in which the light emitting units 36 are arranged along the long axis direction of the photosensitive member 27. FIG. 8C shows an arrangement different from that shown in FIG. 8B, including a first row and a second row in which the light emitting units 36 are alternately arranged in the row direction. The first row and the second row are located at different positions in a column direction. A plurality of light emitting units 36 are arranged at intervals in the first row. The second row includes light emitting units 36 at positions corresponding to the intervals between the light emitting units 36 included in the first row. That is to say, a plurality of light emitting units 36 are arranged at intervals in the column direction as well. The arrangement shown in FIG. 8C can also be called a lattice arrangement, a staggered arrangement, or a checkerboard arrangement.

As described above, by using a device in which the organic light emitting element according to the present embodiment is used, it is possible to realize display with good image quality stably for a long period of time. Also, by using a device in which the organic light emitting element according to the present embodiment is used, it is possible to realize good visibility outdoors by outputting light with high efficiency and high luminance while saving power at the same time.

(3) Ink composition

Next, the following describes an ink composition according to an embodiment of the present invention. The ink composition according to the present embodiment contains at least one type of organic compound according to the present embodiment described above.

The organic compound according to the present embodiment has high solubility to an organic solvent, and therefore can be used as an ink composition. The use of the ink composition according to the present embodiment makes it possible to manufacture an organic compound layer, in particular, a light emitting layer of the organic light emitting element according to the present embodiment by using an application method, and therefore, makes it possible to easily manufacture an element having a large area at a relatively low cost.

Examples of the solvent in which the organic compound according to the present embodiment is dissolved include toluene, xylene, mesitylene, dioxane, methylnaphthalene, tetrahydrofuran, diglyme, 1,2-dichlorobenzene, and 1,2-dichloropropane. Any one of these organic solvents may be used alone, or two or more of them may be used in combination. Among these, it is preferable to use an organic solvent having an appropriate evaporation rate, or more specifically, a boiling point of about 70°C to 200°C in terms of making it easy to form a thin film having a uniform thickness.

The ink composition according to the present embodiment may further contain a compound used as an additive. Examples of the compound used as an additive include the known materials described above as the light emitting layer host material, the light emission assist material, the hole transport material, the light emitting material, the electron transport material, etc.

The concentration of the organic compound according to the present embodiment in the ink composition is preferably 0.05% by mass or more and 20% by mass or less, and more preferably 0.1% by mass or more and 5% by mass or less with respect to the whole composition.

The ink composition according to the present embodiment can be used to form a film using a spin coating method, a bar coating method, a slit coating method, an inkjet method, a nozzle coating method, a casting method, a gravure printing method, etc. The organic light emitting element according to the present embodiment can constitute a display device such as a display by forming a layer containing the organic compound according to the present embodiment on an electrode formed on a pixel pattern.

Examples

The following describes examples. However, the present invention is not limited to these examples.

<<Example 1 (synthesis of exemplary compounds)>>

(1) Synthesis of intermediate (compound [3])

A compound [3] was synthesized using the following procedure.

[Chem. 64]

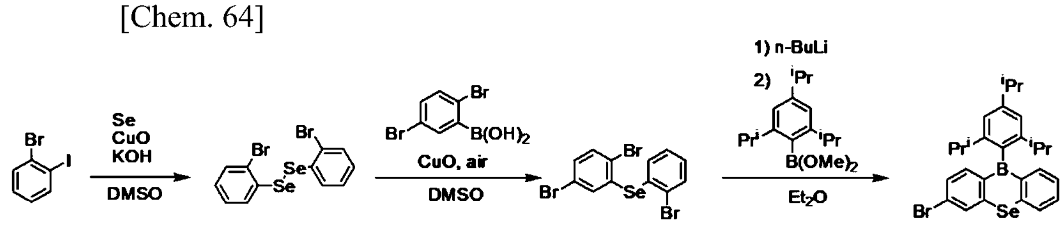


a) Synthesis of compound [1] (1,2-bis(2-bromophenyl)diselane)

1-Bromo-2-iodobenzene (12.6 g, 44.5 mmol), Se powder (7.2 g, 91.2 mmol), CuO nanopower (particle size:<50 nm, 0.35 g, 4.4 mmol), KOH (5.1 g, 90.9 mmol), and DMSO (130 mL) were placed in a 500-mL Schlenk flask in a nitrogen atmosphere and agitated vigorously. The agitation was performed at 95°C for 18 hours. Water was poured into the reaction solution, extraction was performed using dichloromethane, drying was performed using sodium sulfate, and the solvent was removed using an evaporator. The obtained crude product was separated by performing column chromatography ($SiO_2$, hexane), and thus an yellow solid was obtained (5.0 g, yield: 48%).

$^1$H NMR (400 MHz, $CDCl_3$): δ 7.58 (dd, J=7.6, 1.4 Hz, 2H), 7.50 (dd, J=8.0, 1.2 Hz, 2H), 7.21 (td, J=7.8, 1.2 Hz, 2H), 7.09 (td, J=7.8, 1.5 Hz, 2H).

MS (MALDI-TOF): m/z calcd 469.73 $[M-H]^+$; found 468.29.

b) Synthesis of compound [2] (2-bromophenyl)(2,5-dibromophenyl)selane)

The compound [1] (2.00 g, 4.26 mmol), (2,5-dibromophenyl) boronic acid (8.00 g, 28.6 mmol), CuO nanopower (particle size:<50 nm, 0.49 g, 6.16 mmol), and DMSO (12 mL) were placed in a 100-mL Schlenk flask in an air atmosphere (in the presence of oxygen) and agitated. The agitation was performed at 120°C for 24 hours. Water was poured into the reaction solution, extraction was performed using dichloromethane, drying was performed using sodium sulfate, and the solvent was removed using an evaporator. The obtained crude product was separated by performing column chromatography ($SiO_2$, hexane) and left to stand in a freezer (-5°C), and thus a white solid was obtained (1.38 g, yield: 69%).

$^1$H NMR (400 MHz, DMSO-$d_6$): δ 7.82-7.84 (m, 1H), 7.69 (d, J=8.5 Hz, 1H), 7.48 (dd, J=8.4, 2.4 Hz, 1H), 7.37-7.44 (m, 3H), 7.14 (d, J=2.3 Hz, 1H).

MS (MALDI-TOF): m/z calcd 467.73 $[M+H]^+$; found 468.57.

c) Synthesis of compound [3] (3-bromo-10-(2,4,6-triisopropylphenyl)-10H-dibenzo[b,e][1,4]selenaborinine)

The compound [2] (1.50 g, 3.19 mmol) and dehydrated diethyl ether (50 mL) were placed in a 100-mL Schlenk flask in a nitrogen atmosphere and cooled to -80°C. Agitation was performed at -80°C for 30 minutes, and then n-buthyllithium (2.6 M, 2.6 mL, 6.76 mmol) was slowly dripped. After agitation was performed at -80°C for 1 hour, 2,4,6-triisopropylphenylboronic acid methyl ester (970 mg, 3.51 mmol) was added, and agitation was further performed for 1 hour. After the temperature of the reaction solution was gradually raised to room temperature, water was poured into the reaction solution, extraction was performed using dichloromethane, drying was performed using sodium sulfate, and the solvent was removed using an evaporator. The obtained crude product was separated by performing column chromatography ($SiO_2$, hexane), GPC was further performed for purification, and thus a bright yellow solid was obtained (720 mg, yield: 43%).

$^1$H NMR (400 MHz, $CDCl_3$): δ 7.97 (d, J=2.0 Hz, 1H), 7.93 (dd, J=7.6, 1.2 Hz, 1H), 7.79-7.76 (m, 2H), 7.53 (td, J=7.6, 1.6 Hz, 1H), 7.39 (dd, J=8.0, 2.0 Hz, 1H), 7.30 (td, J=7.6, 1.2 Hz, 1H), 7.06 (s, 2H), 2.98 (sept, J=6.9 Hz, 1H), 2.15 (sept, J=6.7 Hz, 2H), 1.35 (d, J=7.2 Hz, 6H), 1.03 (d, J=6.8 Hz, 6H), 0.96 (d, J=6.8 Hz, 6H).

MS (MALDI-TOF): m/z calcd 524.08 $[M-H]^+$; found 523.29.

(2) Synthesis of exemplary compounds T1 to T10

Exemplary compounds T1 to T10 were synthesized using the following procedure.

[Chem. 65]

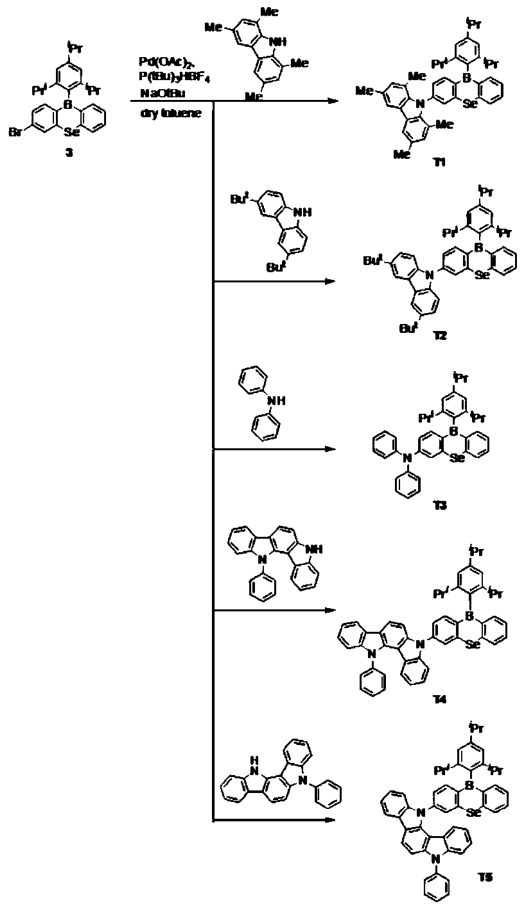


3, T1, T2, T3, T4, T5

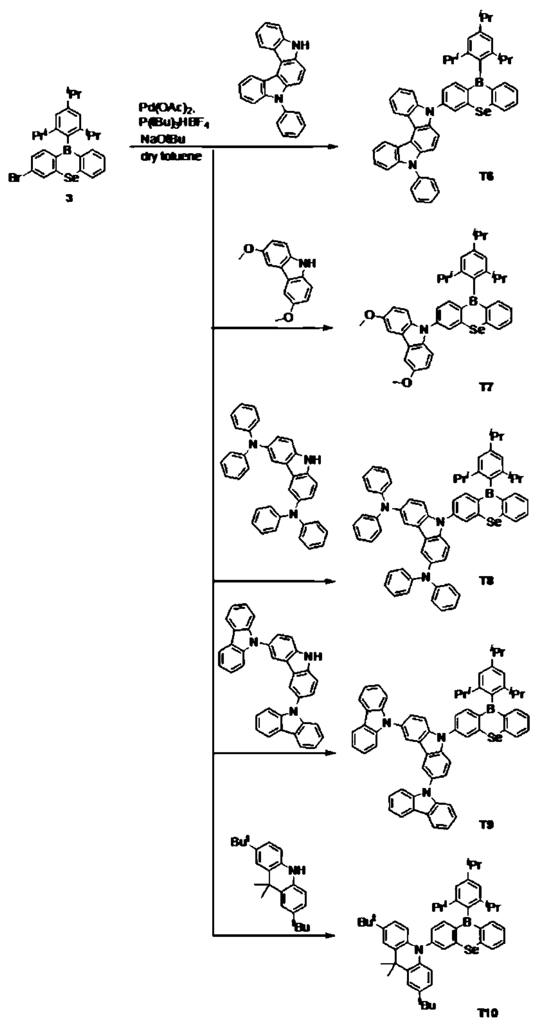


3, T6, T7, T8, T9, T10

<Synthesis of exemplary compound T1>

The compound [3] (400 mg, 0.76 mmol), 1,3,6,8-tetramethyl-9H-carbazole (0.17 g, 0.76 mmol), tri-tert-butylphosphonium tetrafluoroborate (12 mg, 0.04 mmol), sodium tert-butoxide (150 mg, 1.52 mmol), and dehydrated toluene (10 mL) were placed in a 50-mL Schlenk flask, and then palladium acetate (9 mg, 0.04 mmol) was added in a nitrogen atmosphere and agitation was performed at 110°C for 3 hours to cause a reaction. Water was poured into the reaction solution, extraction was performed using chloroform, drying was performed using sodium sulfate, and the solvent was removed using an evaporator. The obtained crude product was separated by performing column chromatography ($SiO_2$, hexane:chloroform=9:1), and then a bright yellow solid was obtained (460 mg, yield: 91%) through recrystallization (chloroform/methanol).

$^1H$ NMR (500 MHz, $CDCl_3$): δ 8.03 (d, J=8.5 Hz, 1H), 7.98 (d, J=8.0 Hz, 1H), 7.86 (s, 1H), 7.80 (d, J=8.0 Hz, 1H), 7.74 (s, 2H), 7.54 (t, J=7.5 Hz, 1H), 7.43 (d, J=8.5 Hz, 1H), 7.33 (t, J=7.5 Hz, 1H), 7.09 (s, 2H), 6.91 (s, 2H), 3.00 (sept, J=6.9 Hz, 1H), 2.47 (s, 6H), 1.87 (sept, J=6.6 Hz, 2H), 1.36 (d, J=7.0 Hz, 6H), 1.03 (d, J=6.5 Hz, 6H), 0.98 (d, J=6.5 Hz, 6H).

MS (MALDI-TOF): m/z calcd 667.29 $[M]^+$; found 667.26.

<Synthesis of exemplary compound T2>

The compound [3] (400 mg, 0.76 mmol), 3,6-di-tert-butyl-9H-carbazole (0.21 g, 0.76 mmol), tri-tert-butylphosphonium tetrafluoroborate (12 mg, 0.04 mmol), sodium tert-butoxide (150 mg, 1.52 mmol), and dehydrated toluene (10 mL) were placed in a 50-mL Schlenk flask, and then palladium acetate (9 mg, 0.04 mmol) was added in a nitrogen atmosphere and agitation was performed at 110°C for 3 hours to cause a reaction. Water was poured into the reaction solution, extraction was performed using chloroform, drying was performed using sodium sulfate, and the solvent was removed using an evaporator. The obtained crude product was separated by performing column chromatography ($SiO_2$, hexane:chloroform=9:1), and then a bright yellow solid was obtained (510 mg, yield: 93%) through recrystallization

(chloroform/methanol).

$^1$H NMR (400 MHz, $CDCl_3$): δ 8.35 (d, J=2.0 Hz, 1H), 8.33 (s, 2H), 8.06-8.03 (m, 2H), 7.84 (dd, J=7.6, 1.4 Hz, 1H), 7.74 (dd, J=8.0, 1.6 Hz, 1H), 7.67 (td, J=7.6, 1.6 Hz, 1H), 7.52-7.49 (m, 4H), 7.44 (td, J=7.4, 1.0 Hz, 1H), 7.16 (s, 2H), 2.98 (sept, J=6.9 Hz, 1H), 2.21 (sept, J=6.6 Hz, 2H), 1.33 (d, J=7.2 Hz, 6H), 1.03 (d, J=6.8 Hz, 6H), 0.99 (d, J=6.4 Hz, 6H).

MS (MALDI-TOF): m/z calcd 723.35 $[M]^+$; found 723.40.

<Synthesis of exemplary compound T3>

The compound [3] (400 mg, 0.76 mmol), diphenylamine (0.13 g, 0.76 mmol), tri-tert-butylphosphonium tetrafluoroborate (12 mg, 0.04 mmol), sodium tert-butoxide (150 mg, 1.52 mmol), and dehydrated toluene (10 mL) were placed in a 50-mL Schlenk flask, and then palladium acetate (9 mg, 0.04 mmol) was added in a nitrogen atmosphere and agitation was performed at 110°C for 3 hours to cause a reaction. Water was poured into the reaction solution, extraction was performed using chloroform, drying was performed using sodium sulfate, and the solvent was removed using an evaporator. The obtained crude product was separated by performing column chromatography ($SiO_2$, hexane:chloroform=9:1), and then a bright yellow solid was obtained (440 mg, yield: 94%) through recrystallization (chloroform/methanol).

$^1$H NMR (500 MHz, $CDCl_3$): δ 7.83 (d, J=8.0 Hz, 1H), 7.66 (d, J=7.5 Hz, 1H), 7.54 (t, J=8.3 Hz, 2H), 7.44 (d, J=7.3 Hz, 4H), 7.33 (t, J=7.3 Hz, 1H), 7.27-7.24 (m, 6H), 7.07 (s, 3H), 6.76 (d, J=8.5 Hz, 1H), 2.93 (sept, J=6.8 Hz, 1H), 2.18 (sept, J=6.6 Hz, 2H), 1.28 (d, J=7.0 Hz, 6H), 0.96 (d, J=6.5 Hz, 6H), 0.93 (d, J=6.0 Hz, 6H).

MS (MALDI-TOF): m/z calcd 613.24 $[M]^+$; found 613.62.

<Synthesis of exemplary compound T4>

The compound [3] (1.00 g, 1.91 mmol), 12-phenyl-5,12-dihydroindolo[3,2-a]carbazole (825 mg, 2.56 mmol), tri-tert-butylphosphonium tetrafluoroborate (170 mg, 0.59 mmol), sodium tert-butoxide (367 mg, 3.82 mmol), and dehydrated toluene (25 mL) were placed in a 100-mL Schlenk flask, and then palladium acetate (45 mg, 0.20 mmol) was added in a nitrogen atmosphere, and agitation was performed at 110°C for 10 hours to cause a reaction. Water was poured into the reaction solution, extraction was performed using dichloromethane, drying was performed using sodium sulfate, and the solvent was removed using an evaporator. The obtained crude product was separated by performing column chromatography ($SiO_2$, hexane:dichloromethane=6:1), and then a bright yellow solid was obtained (840 mg, yield: 57%) through reprecipitation (dichloromethane/methanol).

$^1$H NMR (400 MHz, $CD_2Cl_2$): δ 8.21-8.10 (m, 4H), 7.98 (d, J=8.0, 1H), 7.86 (d, J=8.0, 1H), 7.66-7.64 (m, 5H), 7.59-7.55 (m, 2H), 7.48 (d, J=8.0 Hz, 1H), 7.43 (d, J=8.8 Hz, 1H), 7.37-7.28 (m, 4H), 7.23 (dd, J=8.2, 8.2 Hz, 1H), 7.12 (s, 2H), 6.78 (dd, J=7.6, 7.6 Hz, 1H), 5.95 (d, J=8.0 Hz, 1H), 3.02-2.95 (m, 1H), 2.24-2.27 (m, 2H), 1.35 (d, J=6.8 Hz, 6H), 1.07 (d, J=6.4 Hz, 6H), 1.02 (d, J=6.4 Hz, 6H).

MS (MALDI-TOF): m/z 776.28. $[M]^+$; found 776.413.

<Synthesis of exemplary compound T5>

The compound [3] (700 mg, 1.34 mmol), 5-phenyl-5,12-dihydroindolo[3,2-a]carbazole (600 mg,1.80 mmol), tri-tert-butylphosphonium tetrafluoroborate (120 mg, 0.41 mmol), sodium tert-butoxide (260 mg, 2.71 mmol), and dehydrated toluene (20 mL) were placed in a 100-mL Schlenk flask, and then palladium acetate (35 mg, 0.15 mmol) was added in a nitrogen atmosphere and agitation was performed at 110°C for 12 hours to cause a reaction. Water was poured into the reaction solution, extraction was performed using dichloromethane, drying was performed using sodium sulfate, and the solvent was removed using an evaporator. The obtained crude product was separated by performing column chromatography ($SiO_2$, hexane:dichloromethane=9:1→6:1), and then a bright yellow solid was obtained (650 mg, yield: 63%) through reprecipitation (dichloromethane/methanol).

$^1$H NMR (400 MHz, $CD_2Cl_2$): δ 8.21 (m, 3H), 8.02-7.95 (m, 2H), 7.79 (d, J=7.6, 1H), 7.68-7.64 (m, 3H), 7.61-7.48 (m, 5H), 7.38-7.31 (m, 4H), 7.27 (d, J=8.4 Hz, 1H), 7.16 (d, J=6.8 Hz, 1H), 7.13 (s, 2H), 6.59 (dd, J=7.6, 7.6 Hz, 1H), 6.09 (d, J=8.0 Hz, 1H), 3.02-2.95 (m, 1H), 2.49-2.42 (m, 1H), 2.37-2.31 (m, 1H), 1.34 (d, J=7.2 Hz, 6H), 1.14-1.02 (m, 12H). MS (MALDI-TOF): m/z 776.28. $[M]^+$; found. 776.468

<Synthesis of exemplary compound T6>

The compound [3] (700 mg, 1.34 mmol), 5-phenyl-5,8-dihydroindolo[2,3-c]carbazole (600 mg, 1.80 mmol), tri-tert-butylphosphonium tetrafluoroborate (130 mg, 0.45 mmol), sodium tert-butoxide (260 mg, 2.71 mmol), and dehydrated toluene (20 mL) were placed in a 100-mL Schlenk flask, and then palladium acetate (34 mg, 0.15 mmol) was added in a

nitrogen atmosphere and agitation was performed at 110°C for 10 hours to cause a reaction. Water was poured into the reaction solution, extraction was performed using dichloromethane, drying was performed using sodium sulfate, and the solvent was removed using an evaporator. The obtained crude product was separated by performing column chromatography ($SiO_2$, hexane:dichloromethane=6:1), and then an yellow solid was obtained (445 mg, yield: 43%) through reprecipitation (dichloromethane/methanol).

$^1H$ NMR (400 MHz, $CD_2Cl_2$): δ 8.95 (dd, J=7.2, 7.2 Hz, 1H), 8.16-8.13 (m, 2H), 7.96 (d, J=7.2, 1H), 7.85 (d, J=7.6, 1H), 7.67-7.45 (m, 15H), 7.34 (dd, J=7.4, 7.4 Hz, 1H), 7.12 (s, 2H), 3.02-2.95 (m, 1H), 2.30-2.26 (m, 2H), 1.34 (d, J=6.8 Hz, 6H), 1.05 (d, J=6.4 Hz, 6H), 1.01 (d, J=6.8 Hz, 6H).

MS (MALDI-TOF): m/z 776.28. $[M]^+$; found 776.408.

<Synthesis of exemplary compound T7>

The compound [3] (700 mg, 1.34 mmol), 3,6-dimethoxy-9H-carbazole (400 mg, 1.76 mmol), tri-tert-butylphosphonium tetrafluoroborate (130 mg, 0.45 mmol), sodium tert-butoxide (257 mg, 2.67 mmol), and dehydrated toluene (20 mL) were placed in a 100-mL Schlenk flask, and then palladium acetate (59 mg, 0.26 mmol) was added in a nitrogen atmosphere and agitation was performed at 95°C for 10 hours to cause a reaction. Water was poured into the reaction solution, extraction was performed using dichloromethane, drying was performed using sodium sulfate, and the solvent was removed using an evaporator. The obtained crude product was separated by performing column chromatography ($SiO_2$, hexane:dichloromethane=3:1→1:1), and then an yellow solid was obtained (682 mg, yield: 76%) through reprecipitation (dichloromethane/methanol).

$^1H$ NMR (400 MHz, $CD_2Cl_2$): δ 8.09-8.04 (m, 2H), 7.94 (d, J=8.0, 1H), 7.83 (d, J=8.0, 1H), 7.57-7.49 (m, 6H), 7.32 (dd, J=7.4, 7.4 Hz, 1H), 7.11 (s, 2H), 7.04-7.02 (m, 2H), 3.91 (s, 6H), 3.01-2.94 (m, 1H), 2.31-2.24 (m, 2H), 1.34 (d, J=6.4 Hz, 6H), 1.03 (d, J=6.8 Hz, 6H), 1.00 (d, J=6.4 Hz, 6H).

MS (MALDI-TOF): m/z 671.25. $[M]^+$; found 671.592.

<Synthesis of exemplary compound T8>

The compound [3] (600 mg, 1.14 mmol), $N^3$,$N^3$,$N^6$,$N^6$-tetraphenyl-9H-carbazole-3,6-diamine (750 mg, 1.49 mmol), tri-tert-butylphosphonium tetrafluoroborate (120 mg, 0.41 mmol), sodium tert-butoxide (219 mg, 2.27 mmol), and dehydrated toluene (20 mL) were placed in a 100-mL Schlenk flask, and then palladium acetate (49 mg, 0.22 mmol) was added in a nitrogen atmosphere and agitation was performed at 90°C for 14 hours to cause a reaction. Water was poured into the reaction solution, extraction was performed using dichloromethane, drying was performed using sodium sulfate, and the solvent was removed using an evaporator. The obtained crude product was separated by performing column chromatography ($SiO_2$, hexane:dichloromethane=3:1), and then a bright yellow solid was obtained (842 mg, yield: 78%) through reprecipitation (dichloromethane/methanol).

$^1H$ NMR (400 MHz, $CD_2Cl_2$): δ 8.12-8.08 (m, 2H), 7.95 (d, J=7.2, 1H), 7.84 (d, J=8.4, 1H), 7.72 (bs, 1H), 7.57-7.49 (m, 3H), 7.33 (dd, J=7.4, 7.4 Hz, 1H), 7.22-6.92 (m, 26H), 3.01-2.94 (m, 1H), 2.30-2.23 (m, 2H), 1.34 (d, J=6.8 Hz, 6H), 1.02 (d, J=6.4 Hz, 6H), 1.00 (d, J=6.8 Hz, 6H).

MS (MALDI-TOF): m/z 945.37. $[M]^+$; found 945.431.

<Synthesis of exemplary compound T9>

The compound [3] (600 mg, 1.14 mmol), 9'H-9,3':6',9"-tercarbazole (780 mg, 1.56 mmol), tri-tert-butylphosphonium tetrafluoroborate (120 mg, 0.41 mmol), sodium tert-butoxide (215 mg, 2.24 mmol), and dehydrated toluene (19 mL) were placed in a 100-mL Schlenk flask, and then palladium acetate (50 mg, 0.22 mmol) was added in a nitrogen atmosphere and agitation was performed at 90°C for 12 hours to cause a reaction. Water was poured into the reaction solution, extraction was performed using dichloromethane, drying was performed using sodium sulfate, and the solvent was removed using an evaporator. The obtained crude product was separated by performing column chromatography ($SiO_2$, hexane:dichloromethane=4:1→3:1), and then a cream-colored solid was obtained (750 mg, yield: 69%) through reprecipitation (dichloromethane/methanol).

$^1H$ NMR (400 MHz, $CD_2Cl_2$): δ 8.30-8.24 (m, 4H), 8.15 (d, J=7.6, 4H), 7.99 (d, J=8.0, 1H), 7.88-7.83 (m, 3H), 7.73-7.59 (m, 4H), 7.41-7.35 (m, 9H), 7.29-7.24 (m, 4H), 7.14 (s, 2H), 3.02-2.96 (m, 1H), 2.35-2.29 (m, 2H), 1.36 (d, J=6.8 Hz, 6H), 1.09 (d, J=6.4 Hz, 6H), 1.03 (d, J=6.8 Hz, 6H).

MS (MALDI-TOF): m/z 941.34. $[M]^+$; found 941.337.

<Synthesis of exemplary compound T10>

The compound [3] (800 mg, 1.53 mmol), 2,7-di-tert-butyl-9,9-dimethyl-9,10-dihydroacridine (540 mg, 1.68

mmol), tri-tert-butylphosphonium tetrafluoroborate (22 mg, 0.08 mmol), sodium tert-butoxide (293 mg, 3.05 mmol), and dehydrated toluene (10 mL) were placed in a 50-mL Schlenk flask, and then palladium acetate (17 mg, 0.08 mmol) was added in a nitrogen atmosphere and agitation was performed at 110°C for 6 hours to cause a reaction. Water was poured into the reaction solution, extraction was performed using dichloromethane, drying was performed using sodium sulfate, and the solvent was removed using an evaporator. The obtained crude product was separated by performing column chromatography ($SiO_2$, hexane:dichloromethane=9:1), and then an yellow solid was obtained (900 mg, yield: 77%) through recrystallization (dichloromethane/methanol).

$^1H$ NMR (400 MHz, $CDCl_3$): δ 8.11 (d, J=8.3 Hz, 1H), 7.98 (d, J=7.5 Hz, 1H), 7.81-7.79 (m, 2H), 7.53 (t, J=7.7 Hz, 1H), 7.48 (s, 2H), 7.31 (t, J=7.4 Hz, 1H), 7.25 (s, 1H), 7.09 (s, 2H), 7.02 (d, J=8.5 Hz, 2H), 6.36 (d, J=8.5 Hz, 2H), 3.00 (sept, J=7.1 Hz, 1H), 2.29 (sept, J=6.7 Hz, 2H), 1.70 (s, 6H), 1.36 (d, J=6.8 Hz, 6H), 1.30 (s, 18H), 1.05-1.01 (m, 12H).

MS (MALDI-TOF): m/z calcd 765.40 $[M]^+$; found 765.48.

(3) Synthesis of exemplary compound T11

An exemplary compound T11 was synthesized using the following procedure.

[Chem. 66]

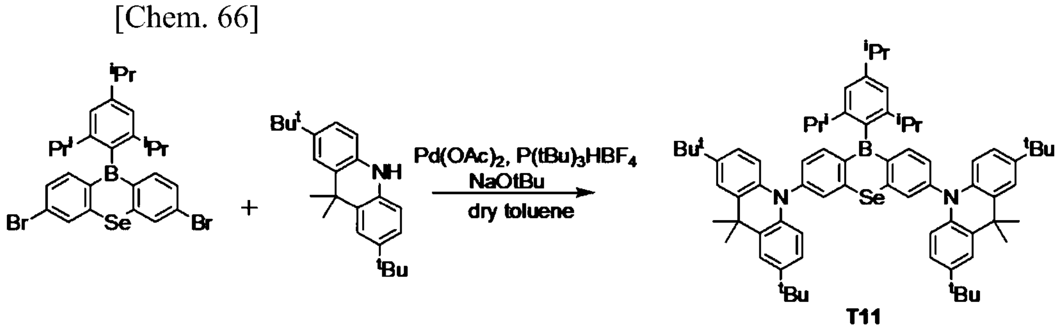


T11

3,7-Dibromo-10-(2,4,6-triisopropylphenyl)-10H-dibenzo[b,e][1,4]selenaborinine (400 mg, 0.66 mmol), 2,7-di-tert-butyl-9,9-dimethyl-9,10-dihydroacridine (450 mg, 1.39 mmol), tri-tert-butylphosphonium tetrafluoroborate (19 mg, 0.07 mmol), sodium tert-butoxide (254 mg, 2.64 mmol), and dehydrated toluene (20 mL) were placed in a 100-mL Schlenk flask, and then palladium acetate (15 mg, 0.07 mmol) was added in a nitrogen atmosphere and agitation was performed at 110°C for 6 hours to cause a reaction. Water was poured into the reaction solution, extraction was performed using dichloromethane, drying was performed using sodium sulfate, and the solvent was removed using an evaporator. The obtained crude product was separated by performing column chromatography ($SiO_2$, hexane:dichloromethane=4:1), and then a bright yellow solid was obtained (600 mg, yield: 84%) through recrystallization (dichloromethane/methanol).

$^1H$ NMR (400 MHz, $CDCl_3$): δ 8.14 (d, J=8.0 Hz, 2H), 7.78 (s, 2H), 7.48 (s, 4H), 7.29 (d, J=8.0 Hz, 2H), 7.11 (s, 2H), 7.03 (d, J=8.8 Hz, 4H), 6.39 (d, J=8.5 Hz, 4H), 3.01 (sept, J=6.8 Hz, 1H), 2.39 (sept, J=6.6 Hz, 2H), 1.70 (s, 12H), 1.37 (d, J=6.8 Hz, 6H), 1.31 (s, 36H), 1.09 (d, J=6.5 Hz, 12H).

MS (MALDI-TOF): m/z calcd 1084.63 $[M]^+$; found 1084.94.

<<Example 2 (optical property spectrum in solution)>>

The PL spectrum (PL [nm]), PLQY ($\Phi_{PL}$ [%]), and the reverse intersystem crossing rate ($k_{RISC}[10^{-6}s^{-1}]$) were measured for each of adjustment solutions to which the exemplary compounds T1 to T11 were respectively added in an amount of $10^{-5}$ mol/L. Results are shown in Table 1.

[Table 1]

| | PL [nm] | $\Phi_{PL}$ [%] | $k_{RISC}$ [$10^6s^{-1}$] |
|---|---|---|---|
| Exemplary compound T1 | 460 | 88 | 8.6 |
| Exemplary compound T2 | 458 | 77 | 6.7 |
| Exemplary compound T4 | 458 | 90 | 62 |
| Exemplary compound T5 | 464 | 59 | 11 |
| Exemplary compound T6 | 482 | 89 | 24 |
| Exemplary compound T7 | 477 | 99 | 300 |

(continued)

| | PL [nm] | $\Phi_{PL}$ [%] | $k_{RISC}$ [$10^6 s^{-1}$] |
|---|---|---|---|
| Exemplary compound T8 | 530 | 99 | 34 |
| Exemplary compound T9 | 464 | 77 | 4.7 |
| Exemplary compound T10 | 520 | 99 | 1000 |
| Exemplary compound T11 | 533 | 97 | 510 |

It was found from Table 1 that the exemplary compounds T1, T2, and T4 to T11 have high PLQYs and high reverse intersystem crossing rates. Also, the exemplary compound T3 emitted strong sky blue light.

<<Examples 3 to 5, Comparative Examples 1 to 4 (evaluation of EL Spectrum)>>

The following compounds were used in comparative examples.

[Chem. 67]

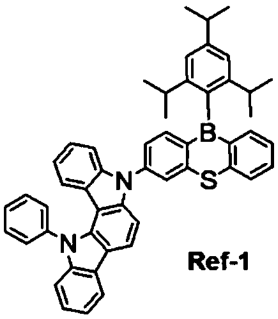

Ref-1

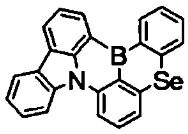

Ref-2

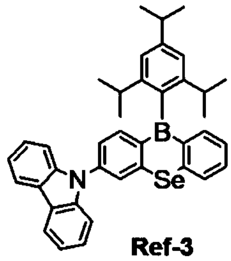

Ref-3

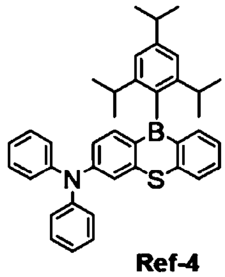

Ref-4

<Example 3-1>

An ITO film was formed as an anode with a film thickness of 50 nm through sputtering on a glass substrate, and the thus obtained transparent conductive support substrate (ITO substrate) was used. Organic compound layer and electrode layers shown in Table 2 were successively formed on the ITO substrate through vacuum vapor deposition by performing resistance heating in a vacuum chamber under a pressure of $10^{-5}$ Pa. At this time, the electrodes were formed to have an area of 3 $mm^2$.

[Table 2]

| Layers | Thickness [nm] | Material |
|---|---|---|
| Hole injection layer | 10 | HT16 |
| Hole transport layer | 40 | HT20 |
| Second hole transport layer | 10 | HT29 |
| Electron blocking (EB) layer | 10 | EM36 |
| Light emitting layer | 20 | Host material: EM43(80 wt%)<br>Guest material: Exemplary compound T3 (20 wt%) |
| Hole blocking (HB) layer | 10 | EM43 |
| Electron transport layer | 30 | ET26 |
| Metal electrode layer 1 | 1 | Liq |
| Metal electrode layer 2 | 100 | Al |

Next, the layers were covered with a protective glass plate and sealed with an acrylic resin-based adhesive in a dry air atmosphere to prevent element degradation due to moisture absorption. Thus, an organic light emitting element was obtained.

A constant current of 2 mA/cm$^2$ was caused to flow through the obtained organic light emitting element using the ITO electrode as the anode and the Al electrode as the cathode, and an initial luminance 50% attenuation time (LT50) (hr) was measured as driving lifespan measurement. Table 3 shows the result as a relative value when a result of Example 3-2 is taken to be 100%.

Also, a ratio ($EQE_{1000}/EQE_{100}$) of EQE ($EQE_{1000}$) when the driving current was 1,000 mA/m$^2$ to EQE ($EQE_{100}$) when the driving current was 100 mA/m$^2$ was measured as a Rolle-off suppression effect (%). Table 3 shows the result as a relative value when a result of Example 3-2 is taken to be 100%.

<Examples 3-2 and 3-3, Comparative Example 1>

Light emitting elements were produced and evaluated in the same manner as in Example 3-1, except that the exemplary compounds T1 and T2 and the compound Ref-1 were respectively used as guest materials of the light emitting layer instead of the exemplary compound T3. Results are shown in Table 3.

The lifespan dramatically increased with the use of the exemplary compounds T1, T2, and T3 (Examples 3-1, 3-2, and 3-3) compared with the case where the compound Ref-1 was used (Comparative Example 1). Also, both the lifespan and the Rolle-off suppression effect dramatically increased with the use of the exemplary compounds T1 and T2 (Examples 3-2 and 3-3) compared with the case where the compound Ref-1 was used (Comparative Example 1).

<Example 4, Comparative Examples 2 and 3>

A light emitting element of Example 4 was produced and evaluated in the same manner as in Example 3-1, except that the light emitting layer was constituted by "the exemplary compound T10 (100 wt%)". Also, light emitting elements of Comparative Examples 2 and 3 were produced and evaluated in the same manner as in Example 4, except that the compounds Ref-2 and Ref-3 were respectively used instead of the exemplary compound T10. Results are shown in Table 3.

Both the lifespan and the Rolle-off suppression effect dramatically increased with the use of the exemplary compound T10 alone (Example 4) in the light emitting layer compared with the cases where the compound Ref-2 or Ref-3 was used alone (Comparative Examples 2 and 3).

<Examples 5-1 and 5-2, Comparative Example 4>

A light emitting element of Example 5-1 was produced and evaluated in the same manner as in Example 3-1, except that the light emitting layer was constituted by "host material: the exemplary compound T4 (97 wt%), guest material: BD13 (3 wt%)". Also, light emitting elements of Example 5-2 and Comparative Example 4 were produced and evaluated in the same manner as in Example 5-1, except that the exemplary compound T1 and the compound Ref-4 were respectively used as host materials instead of the exemplary compound T4. Results are shown in Table 3.

Both the lifespan and the Rolle-off suppression effect dramatically increased with the use of the exemplary compounds T4 and T1 (Examples 5-1 and 5-2) in the light emitting layer compared with the case where the compound Ref-4 was used (Comparative Example 4).

[Table 3]

| | Host | TADF | Dopant | LT50 [%] | Rolle-off suppression [%] |
|---|---|---|---|---|---|
| Ex. 3-1 | EM43 | Exemplary compound T3 | - | 98 | 43 |
| Ex. 3-2 | EM43 | Exemplary compound T1 | - | 100 | 100 |
| Ex. 3-3 | EM43 | Exemplary compound T2 | - | 98 | 85 |
| Com. Ex. 1 | EM43 | Compound Ref-1 | - | 60 | 71 |
| Ex. 4 | - | Exemplary compound T10 | - | 103 | 124 |
| Com. Ex. 2 | - | Compound Ref-2 | - | 20 | 86 |
| Com. Ex. 3 | - | Compound Ref-3 | - | 40 | 57 |
| Ex. 5-1 | - | Exemplary compound T4 | BD13 | 85 | 121 |
| Ex. 5-2 | - | Exemplary compound T1 | BD13 | 120 | 124 |
| Com. Ex. 4 | - | Compound Ref-4 | BD13 | 20 | 42 |

As described above, according to the present invention, it is possible to provide a material that realizes a high reverse intersystem crossing rate, a long element lifespan, and suppression of the roll-off characteristics.

<<Examples 6 to 12, Comparative Examples 5 to 14>>

Compounds T12 to T15 and Ref-5 are shown below.

[Chem. 68]

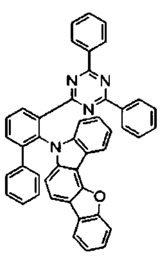

T12

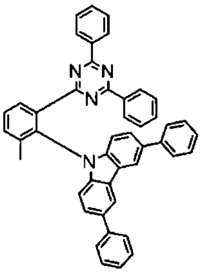

T13

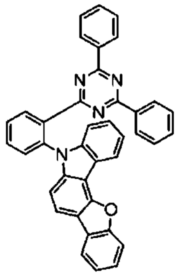

T14

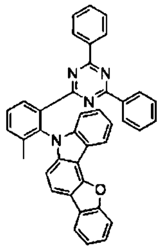

T15

[Chem. 69]

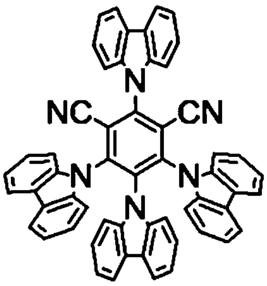

Ref-5
(4CzIPN)

Light emitting elements were produced and evaluated in the same manner as in Example 3-1, adopting film thicknesses and materials shown in Table 4.

[Table 4]

| Layers | Thickness [nm] | Material |
|---|---|---|
| Hole injection layer | 10 | HT16 |
| Hole transport layer | 40 | HT20 |
| Second hole transport layer | 10 | HT29 |
| Electron blocking (EB) layer | 10 | EM37 |
| Light emitting layer | 20 | Host material: EM37 (80 wt%)<br>Guest material: Exemplary compound T10 (20 wt%) |
| Hole blocking (HB) layer | 10 | EM43 |
| Electron transport layer | 30 | ET26 |
| Metal electrode layer 1 | 1 | Liq |
| Metal electrode layer 2 | 100 | Al |

A ratio ($EQE_{1000}/EQE_{max}$) of EQE ($EQE_{1000}$) when the driving current was 1,000 $mA/m^2$ to the maximum EQE ($EQE_{max}$) while the elements were driven was measured as a roll-off suppression effect (%). Table 5 shows the results as relative values when a result of Comparative Example 13 is taken to be 100%. A smaller value of this index indicates a higher roll-off suppression effect.

[Table 5]

| | Guest | $K_{RISC}$ [$\times 10^5 s^{-1}$] | $K_r$ [$\times 10^5 s^{-1}$] | $K_{RISC}/K_r$ | $K_{RISC}/K_{ISC}$ | Roll-off (1000/max) |
|---|---|---|---|---|---|---|
| Ex. 6 | T10 | 10000 | 40 | 250.00 | 0.3226 | 12 |
| Ex. 7 | T11 | 5100 | 75 | 68.00 | 0.1821 | 25 |
| Ex. 8 | T7 | 3000 | 63 | 47.62 | 0.015 | 21 |
| Ex. 9 | T4 | 620 | 67 | 9.25 | 0.0028 | 23 |
| Ex. 10 | T6 | 240 | 200 | 1.20 | 0.0015 | 23 |
| Ex. 11 | T9 | 340 | 370 | 0.92 | 0.0382 | 18 |
| Ex. 12 | T15 | 24 | 6 | 4.00 | 0.0198 | 27 |
| Com. Ex. 5 | T1 | 86 | 230 | 0.37 | 0.0007 | 167 |
| Com. Ex. 6 | T2 | 67 | 110 | 0.61 | 0.0003 | 125 |
| Com. Ex. 7 | T5 | 110 | 120 | 0.92 | 0.0005 | 41 |
| Com. Ex. 8 | T8 | 47 | 170 | 0.28 | 0.0002 | 130 |
| Com. Ex. 9 | T3 | 1.3 | 700 | 0.00 | 0.0000 | 250 |
| Com. Ex. 10 | T12 | 9.4 | 103 | 0.09 | 0.0783 | 69 |
| Com. Ex. 11 | T13 | 7.7 | 79 | 0.10 | 0.0592 | 75 |
| Com. Ex. 12 | T14 | 6.7 | 89 | 0.08 | 0.0957 | 75 |
| Com. Ex. 13 | Ref-5 | 19 | 130 | 0.15 | 0.02 | 100 |
| Com. Ex. 14 | Ref-2 | 1800 | 5 | 360.00 | 0.16 | 80 |

When the compounds T10, T11, T7, T4, T6, T9, and T15 were used, $k_r$ became higher and the roll-off suppression effect significantly increased compared with the case where the compound Ref-2 was used. When the compounds T10, T11, T7, T4, T6, and T9 were used, $k_{RISC}/k_r$ became larger than the case where the compound Ref-5 was used, and accordingly, the roll-off suppression effect increased to be 25% or less compared with the case where the compound Ref-5 was used. The compounds T10, T11, T7, T4, T6, T9, and T15 satisfied Expressions (a) to (c), and accordingly, the roll-off suppression effect significantly increased compared with Comparative Examples 5 to 14.

Out of the Examples, the organic light emitting element of Example 6 included the compound T10 satisfying Expressions (b1) and (c2) as the light emitting material, and therefore, the value indicating the roll-off suppression effect was 12% relative to Comparative Example 13, which indicates a particularly high effect.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2023-076114 filed May 2, 2023 and Japanese Patent Application No. 2024-049552 filed March 26, 2024, which are hereby incorporated by reference herein.

REFERENCE SIGNS LIST

1: interlayer insulating layer, 2: first electrode, 3: insulating layer, 4: organic compound layer, 5: second electrode, 6: protective layer, 7: color filter, 10: subpixel, 11: substrate, 12: insulating layer, 13: gate electrode, 14: gate insulating film, 15: semiconductor layer, 16: drain electrode, 17: source electrode, 18: TFT, 19: insulating film, 20: contact hole, 21: anode, 22: organic compound layer, 23: cathode, 24: first protective layer, 25: second protective layer, 26: organic light emitting element, 100: display device

## Claims

1. An organic compound **characterized by** being represented by General formula (1-1) or (1-2) below,

[Chem. 1]

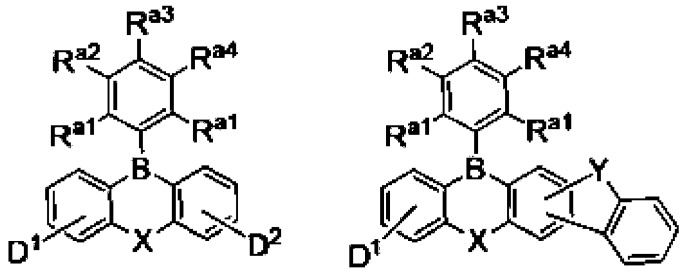

General formula (1-1) General formula(1-2)

wherein, in General formulas (1-1) and (1-2), $R^{a1}$ to $R^{a4}$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group, provided that $R^{a1}$ is not a hydrogen atom,
X is a selenium atom or a tellurium atom,
Y is selected from an oxygen atom, a sulfur atom, a selenium atom, a tellurium atom, and a nitrogen atom having an alkyl group or an aryl group as a substituent,
$D^1$ is a group represented by any one of General formulas (2-1) to (2-5) below, $D^2$ is a hydrogen atom or a group represented by any one of General formulas (2-1) to (2-5) below, in General formulas (2-1) to (2-5) below, * represents a binding site,

[Chem. 2]

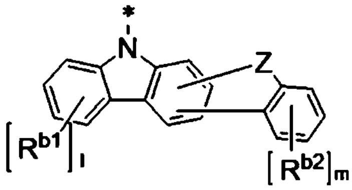

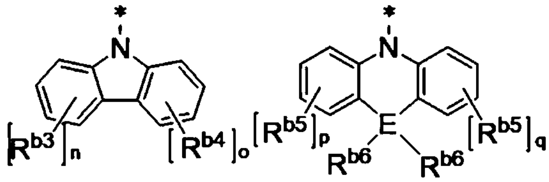

General formula (2-1) General formula (2-2) General formula (2-3)

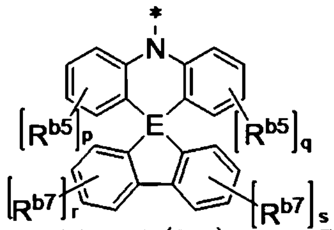

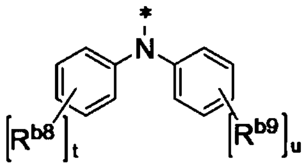

General formula (2-4) General formula (2-5)

in General formulas (2-1) to (2-5), $R^{b1}$ to $R^{b9}$ are each independently selected from a deuterium atom, a substituted or unsubstituted alkyl group, a substituted or unsubstituted alkoxy group, a substituted or unsubstituted aryl group, a substituted or unsubstituted nitrogen-containing heteroaryl group, and a substituted or unsubstituted amino group,

Z is selected from an oxygen atom, a sulfur atom, a selenium atom, a tellurium atom, and a nitrogen atom having an alkyl group or an aryl group as a substituent,

E is a carbon atom, a silicon atom, or a germanium atom,

each of 1, m, n, r, and s is an integer of 0 or more and 4 or less, o is an integer of 1 or more and 4 or less, each of p and q is 0 or 1, and each of t and u is an integer of 0 or more and 5 or less.

2. The organic compound according to claim 1, **characterized by** being represented by General formula (1-3) below,

[Chem. 3]

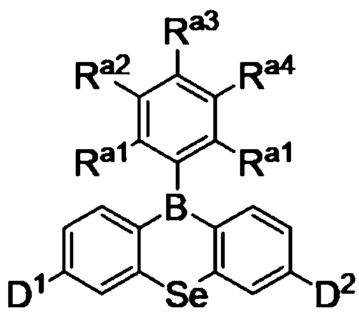

General formula (1-3)

.

3. The organic compound according to claim 1 or 2, **characterized in that** the $D^1$ is a group represented by any one of General formulas (2-1) to (2-4), and the $D^2$ is a hydrogen atom or a group represented by any one of General formulas (2-1) to (2-4).

4. The organic compound according to claim 3, **characterized in that** the $D^1$ is a group represented by any one of General formulas (3-1) to (3-4) below, and the $D^2$ is a hydrogen atom or a group represented by any one of General formulas (3-1) to (3-4) below,

[Chem. 4]

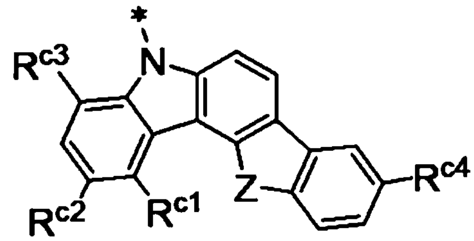

General formula (3-1)

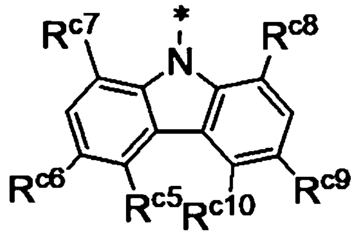

General formula (3-2)

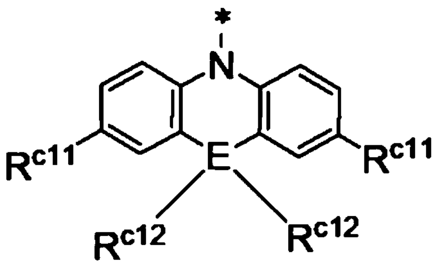

General formula (3-3)

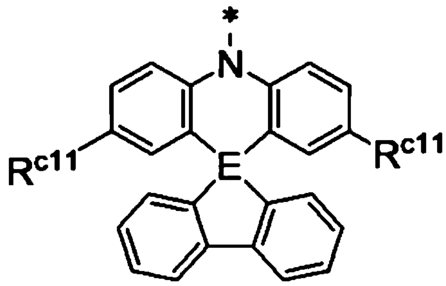

General formula (3-4)

wherein, in General formulas (3-1) and (3-2), $R^{c1}$ to $R^{c10}$ are each independently selected from a hydrogen atom, a deuterium atom, a substituted or unsubstituted alkyl group, a substituted or unsubstituted alkoxy group, a substituted or unsubstituted phenyl group, a substituted or unsubstituted carbazole group, and a substituted or unsubstituted diphenylamino group, provided that at least one of $R^{c8}$ to $R^{c10}$ is not a hydrogen atom,
in General formulas (3-3) and (3-4), $R^{c11}$s are each independently selected from a hydrogen atom, a methyl group, an isopropyl group, and a tertiary butyl group, and $R^{c12}$s are each independently selected from a methyl group and a substituted or unsubstituted phenyl group.

5. The organic compound according to claim 1 or 2, **characterized in that** the group represented by any one of General formulas (2-1) to (2-5) is any one of groups represented by Da1 to Dw4 below,

[Chem. 5]

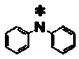
Da1

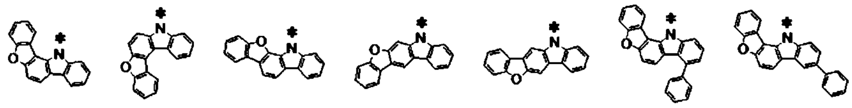
Db1 Db2 Db3 Db4 Db5 Db6 Db7

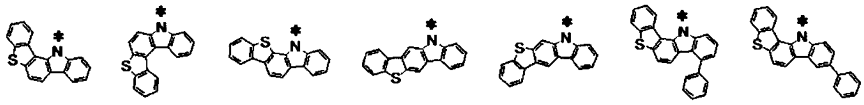
Dc1 Dc2 Dc3 Dc4 Dc5 Dc6 Dc7

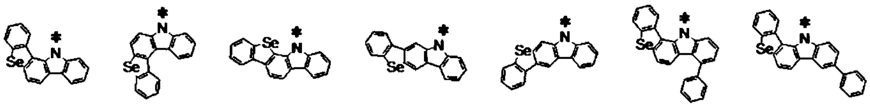
Dd1 Dd2 Dd3 Dd4 Dd5 Dd6 Dd7

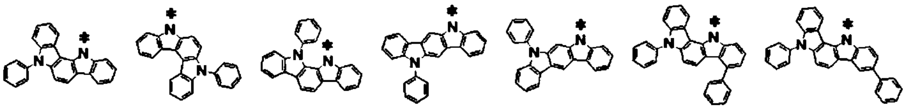
De1 De2 De3 De4 De5 De6 De7

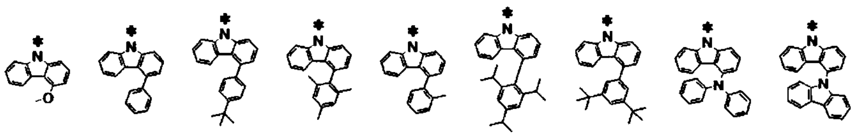
Df1 Df2 Df3 Df4 Df5 Df6 Df7 Df8 Df9

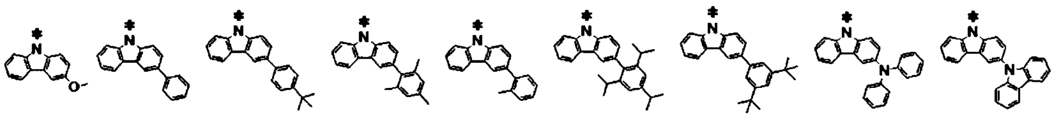
Dg1 Dg2 Dg3 Dg4 Dg5 Dg6 Dg7 Dg8 Dg9

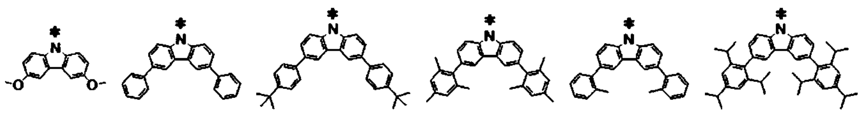
Dh1 Dh2 Dh3 Dh4 Dh5 Dh6

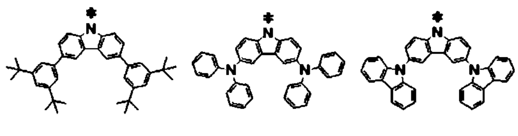
Dh7 Dh8 Dh9

[Chem. 6]

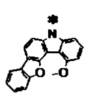
Di1
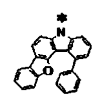
Di2
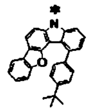
Di3
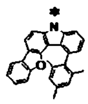
Di4
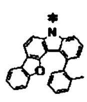
Di5
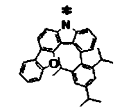
Di6
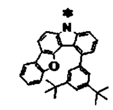
Di7
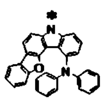
Di8
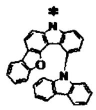
Di9

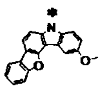
Dj1
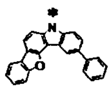
Dj2
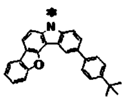
Dj3
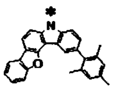
Dj4
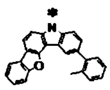
Dj5
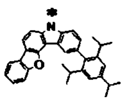
Dj6
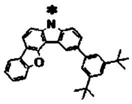
Dj7
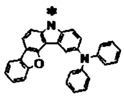
Dj8
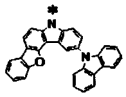
Dj9

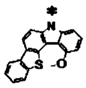
Dk1
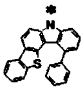
Dk2
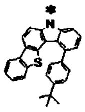
Dk3
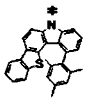
Dk4
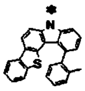
Dk5
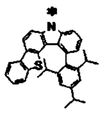
Dk6
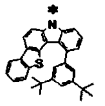
Dk7
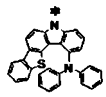
Dk8
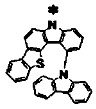
Dk9

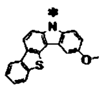
Dl1
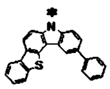
Dl2
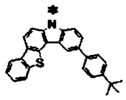
Dl3
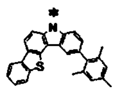
Dl4
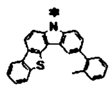
Dl5
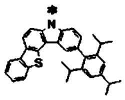
Dl6

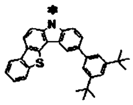
Dl7
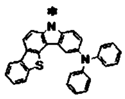
Dl8
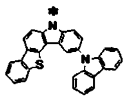
Dl9

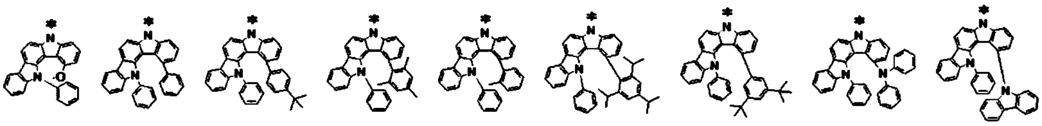
Dm1 Dm2 Dm3 Dm4 Dm5 Dm6 Dm7 Dm8 Dm9

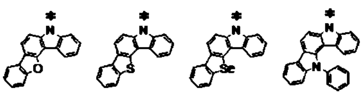
Dn1 Dn2 Dn3 Dn4

[Chem. 7]

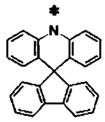 Do1 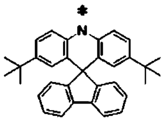 Do2 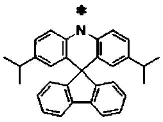 Do3 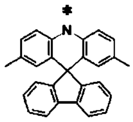 Do4 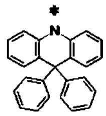 Dp1 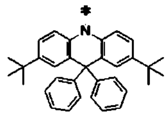 Dp2

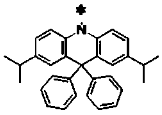 Dp3 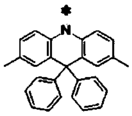 Dp4 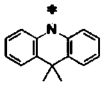 Dq1 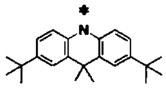 Dq2 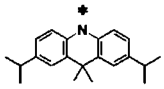 Dq3 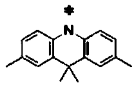 Dq4

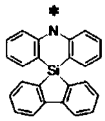 Dr1 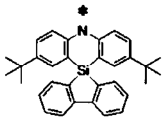 Dr2 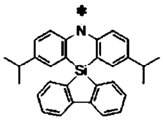 Dr3 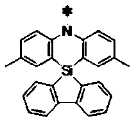 Dr4 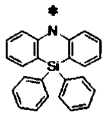 Ds1 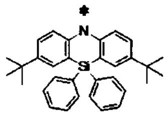 Ds2

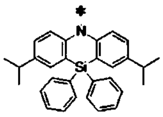 Ds3 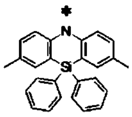 Ds4 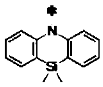 Dt1 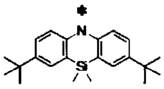 Dt2 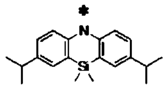 Dt3 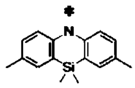 Dt4

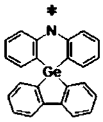 Du1 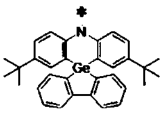 Du2 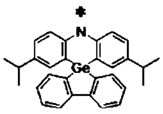 Du3 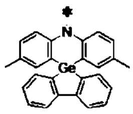 Du4 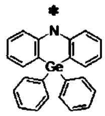 Dv1 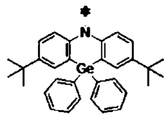 Dv2

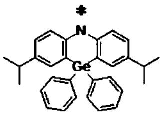 Dv3 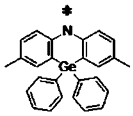 Dv4 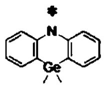 Dw1 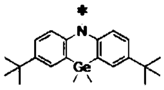 Dw2 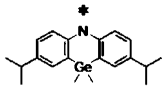 Dw3 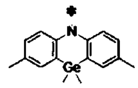 Dw4

.

6. The organic compound according to claim 5, **characterized in that** the group represented by any one of General formulas (2-1) to (2-5) is any one of the groups represented by the Db1 to the Dw4.

7. The organic compound according to claim 6, **characterized in that** the group represented by any one of General formulas (2-1) to (2-5) is any one of the groups represented by the Df1 to the Dw4.

8. The organic compound according to claim 1, **characterized by** being any one of organic compounds shown in Groups 1 to 30 below,

[Chem. 8]

[Group 1]

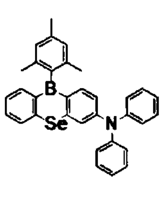 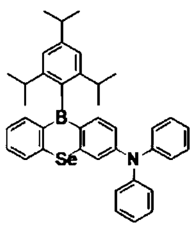 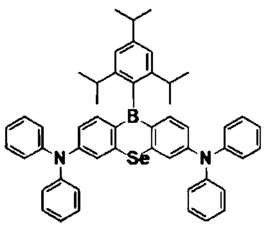 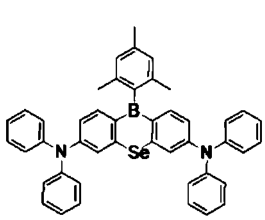

[Chem. 9]

[Group 2-1]

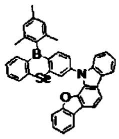 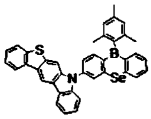 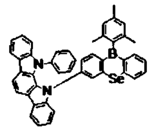 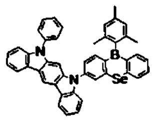 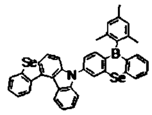 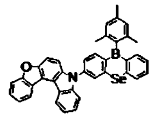

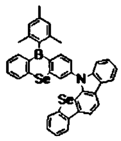 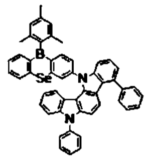 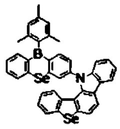 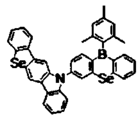 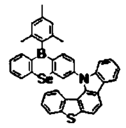 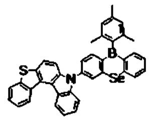 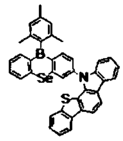

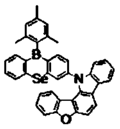 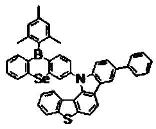 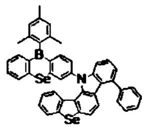 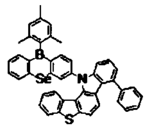 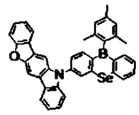 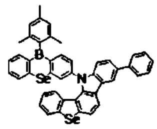

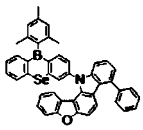 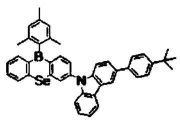 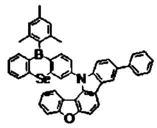 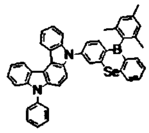 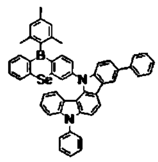

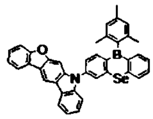 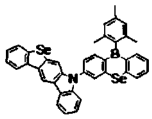 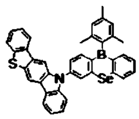

[Chem. 10]

[Group 2-2]

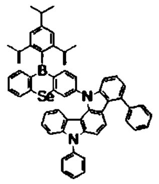 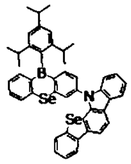 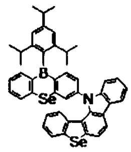 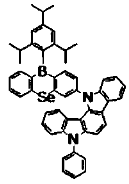 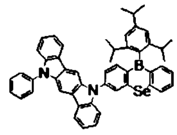 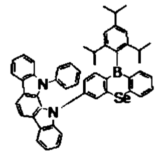

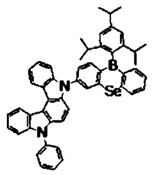 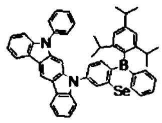 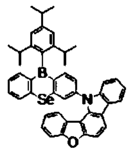 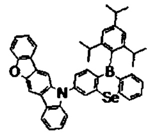 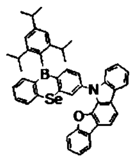

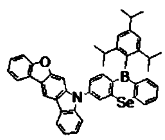 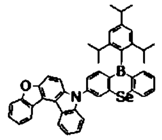 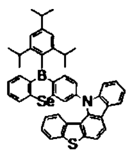 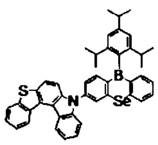 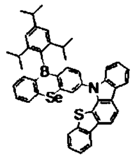

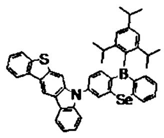 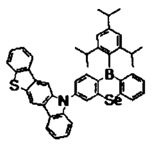 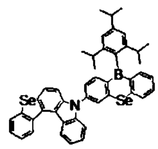 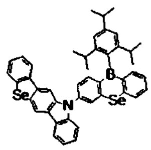 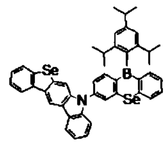

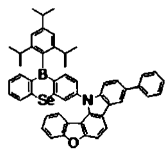 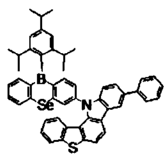 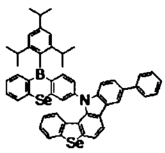 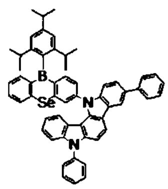 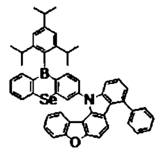

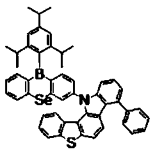 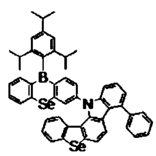

[Chem. 11]

[Group 3]

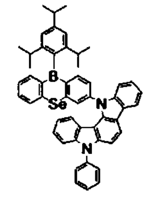
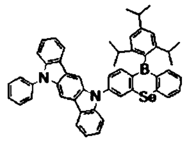
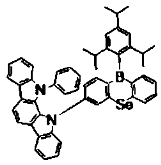
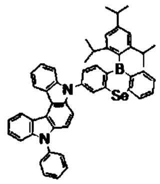
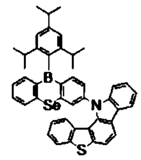
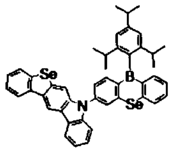
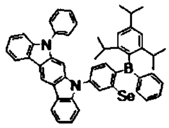
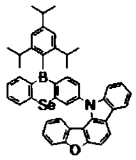
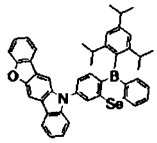
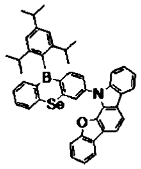
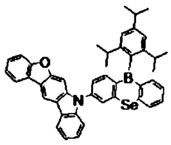
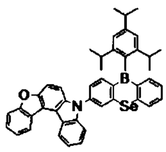
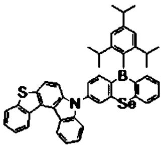
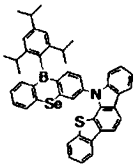
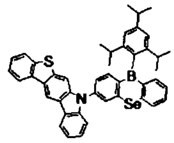
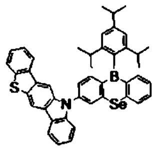
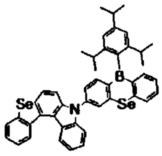
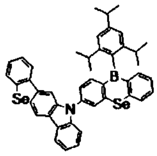
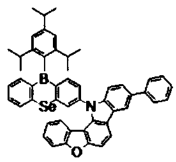
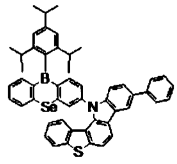
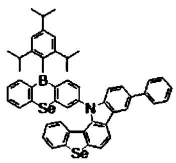
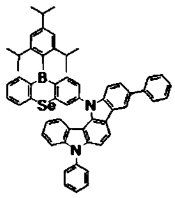
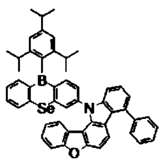
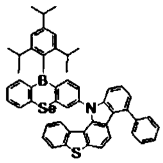
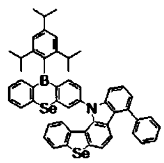

[Chem. 12]

[Group 4]

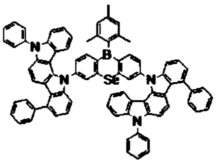
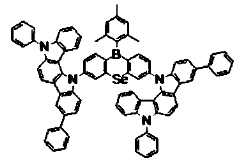
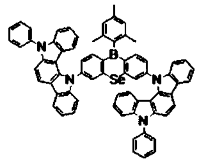
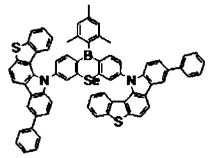

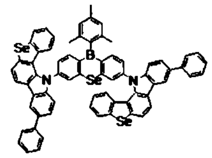
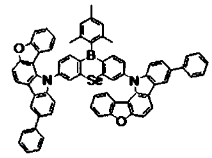
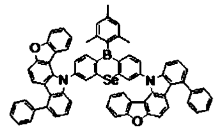
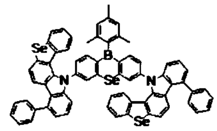

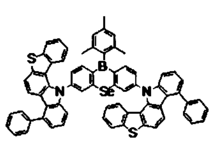
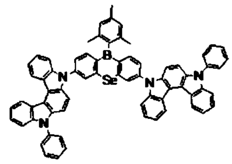
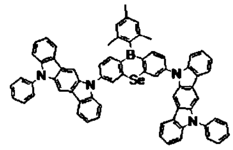

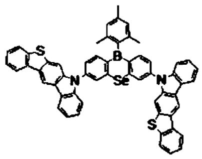
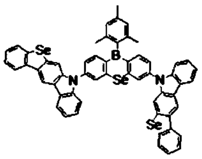
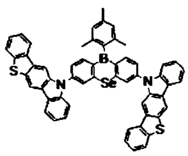
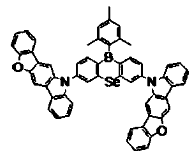
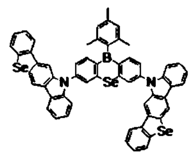

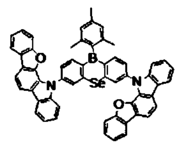
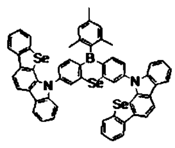
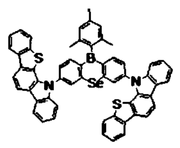
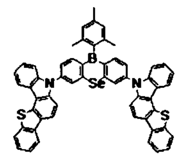
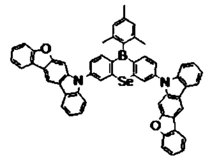

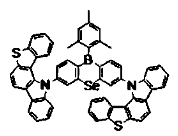
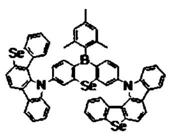
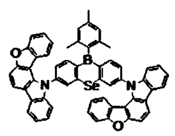
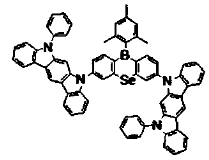

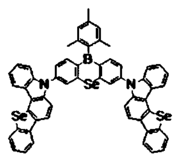
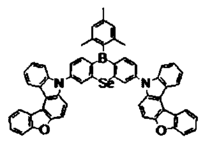
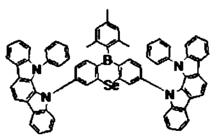
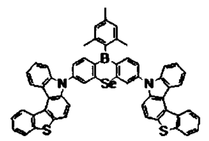
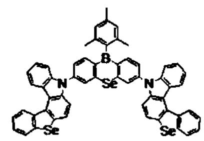

[Chem. 13]

[Group 5]

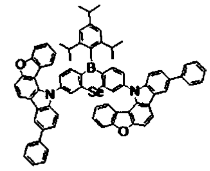
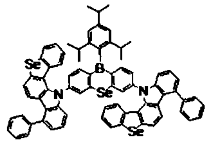
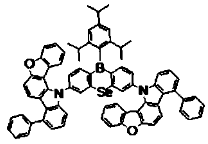
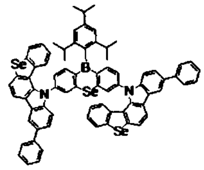
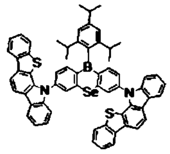
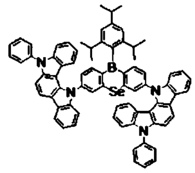
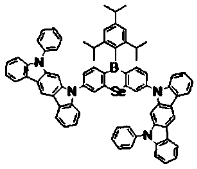
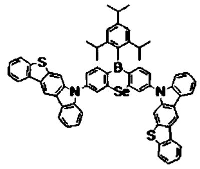
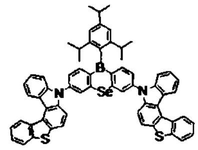
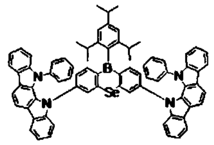
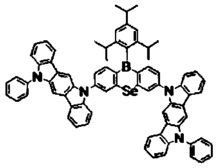
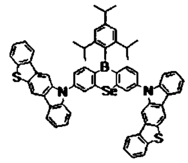
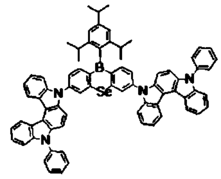
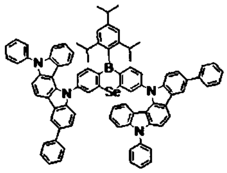
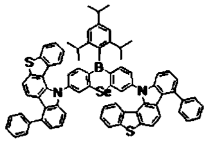
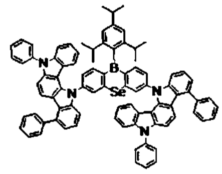
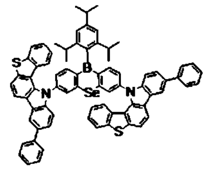
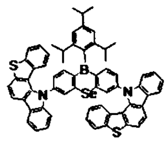
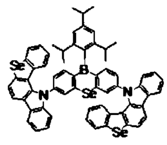
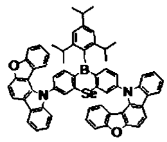
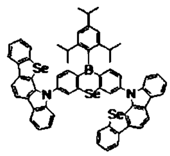
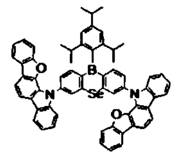
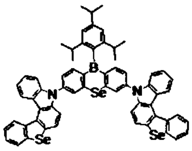
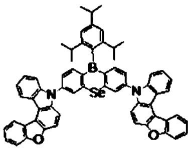
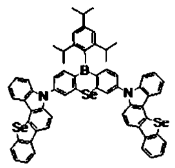
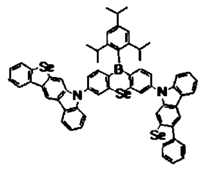
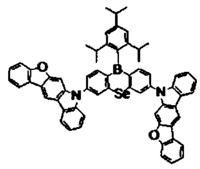
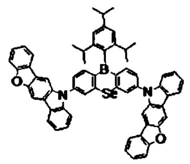
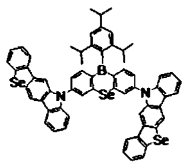

[Chem. 14]

[Group 6-1]

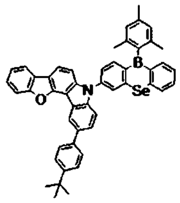
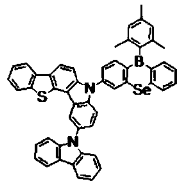
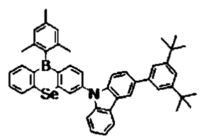
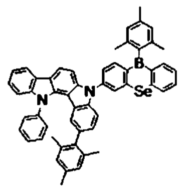
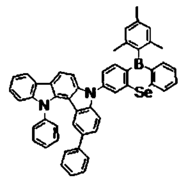

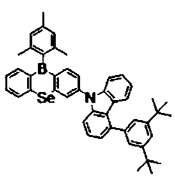
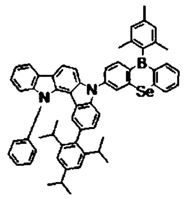
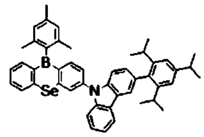
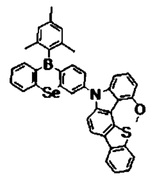
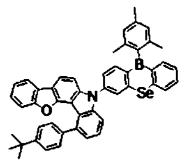

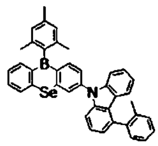
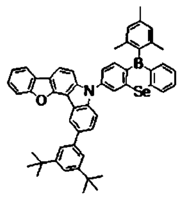
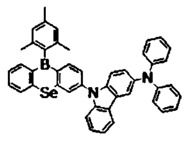
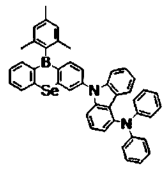
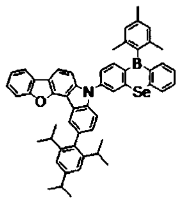

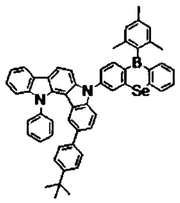
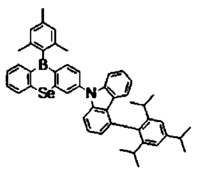
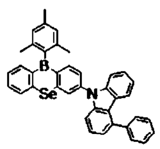
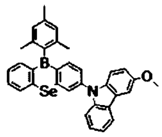
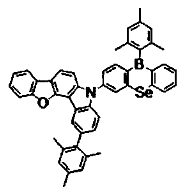

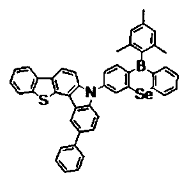

[Chem. 15]

[Group 6-2]

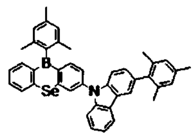
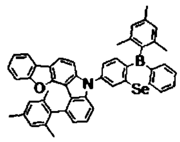
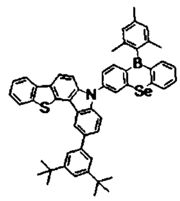
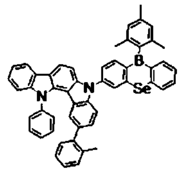
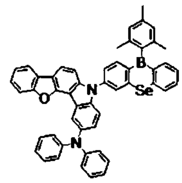
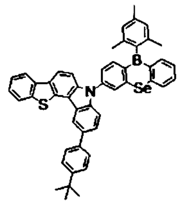
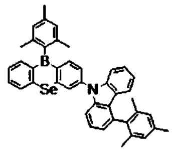
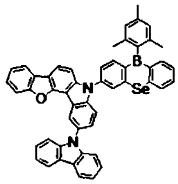
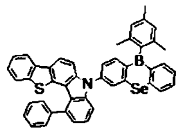
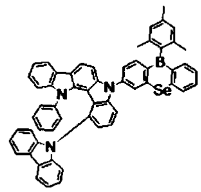
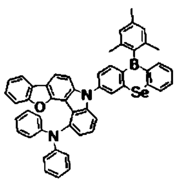
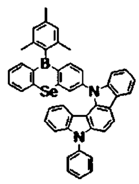
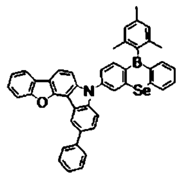
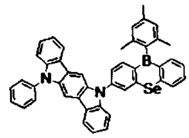
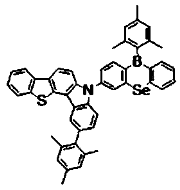
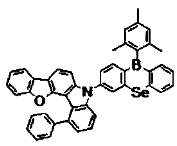
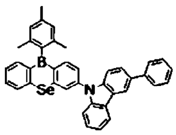
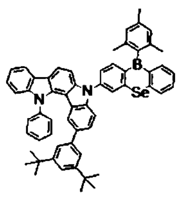
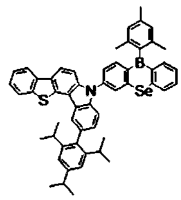
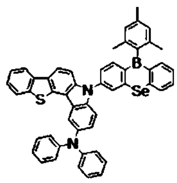
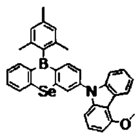
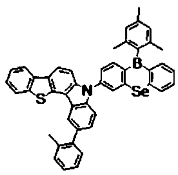
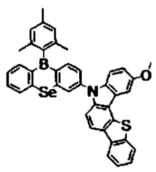
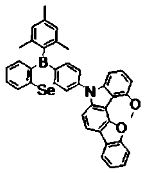
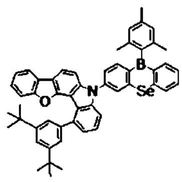
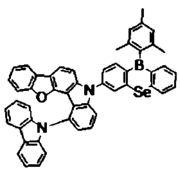
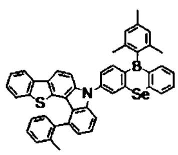
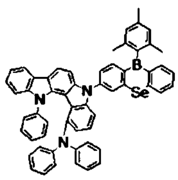
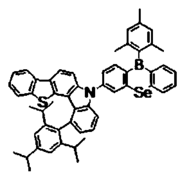

[Chem. 16]

[Group 7-1]

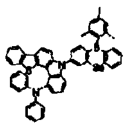 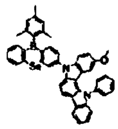 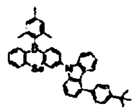 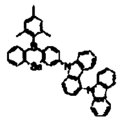 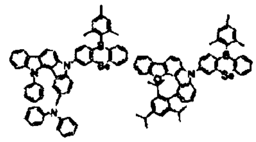 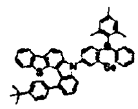

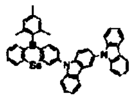 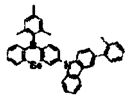 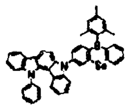 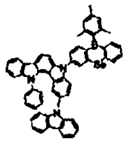 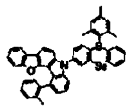 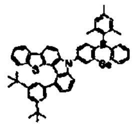 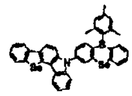

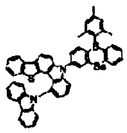 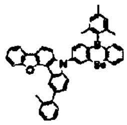 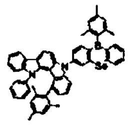 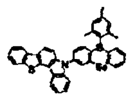 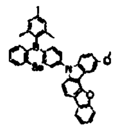 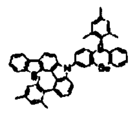 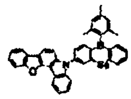

[Chem. 17]

[Group 7-2]

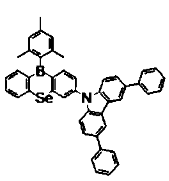 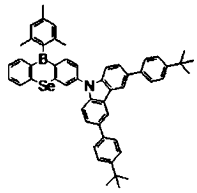 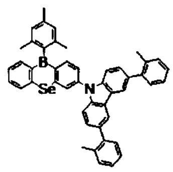 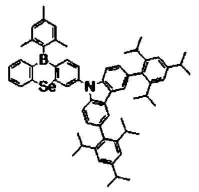 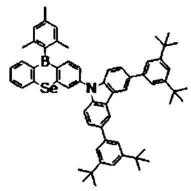

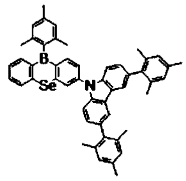 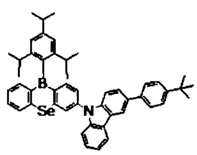 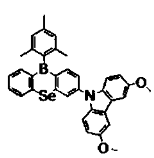 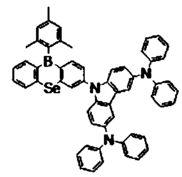 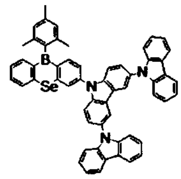

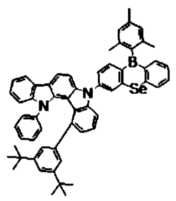 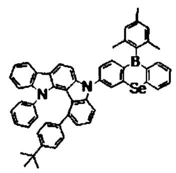 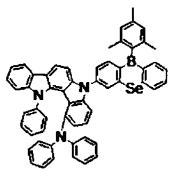 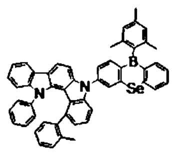 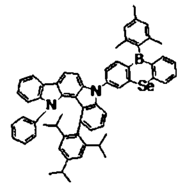

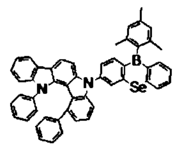 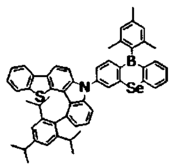 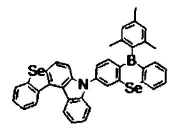 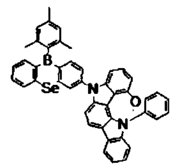 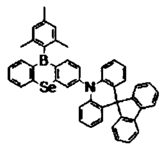

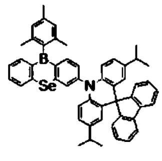 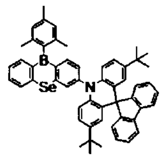 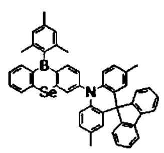 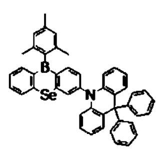 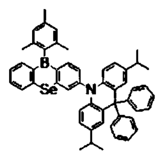

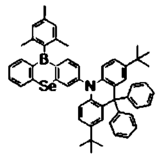 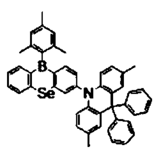 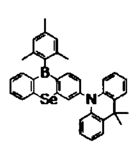 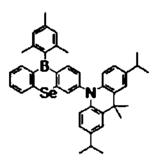 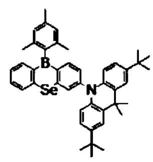

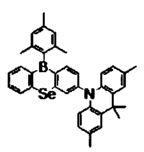 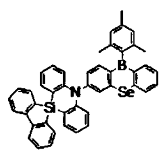 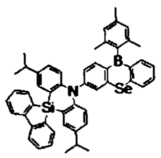 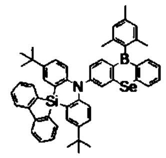 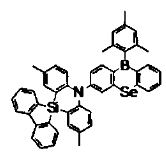 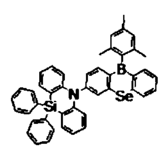

[Chem. 18]

[Group 8-1]

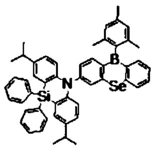
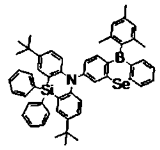
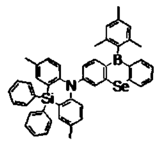
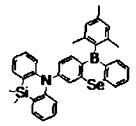
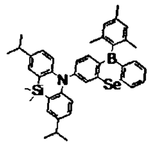
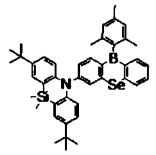
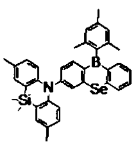
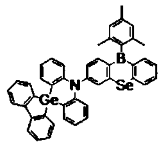
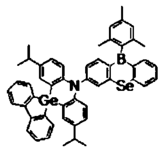
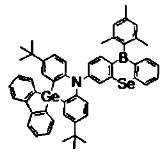
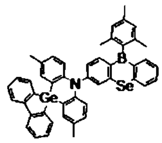
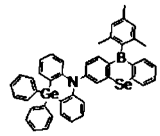
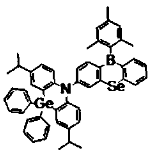
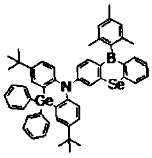
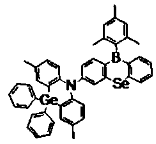
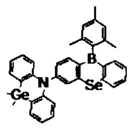
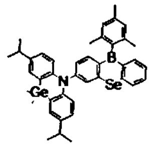
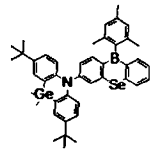
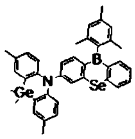

[Chem. 19]

[Group 8-2]

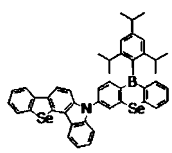
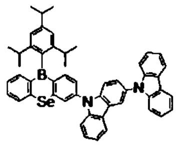
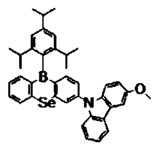
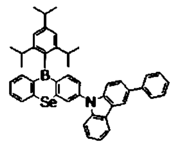
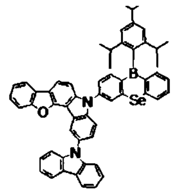
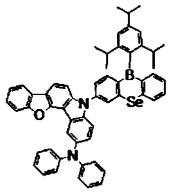
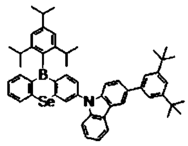
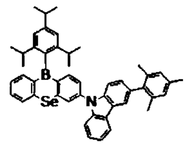
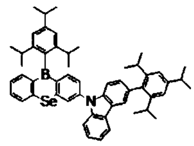
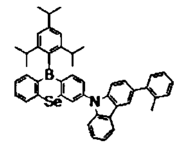
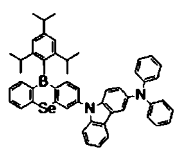
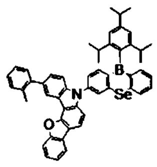
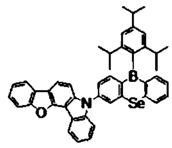
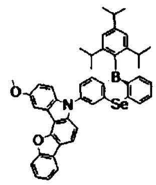
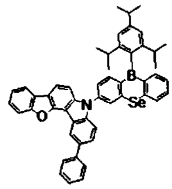
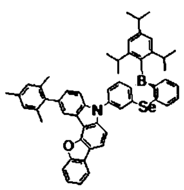
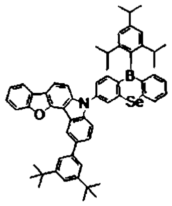
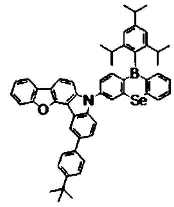
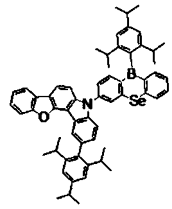
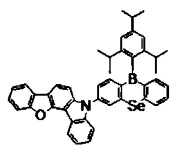
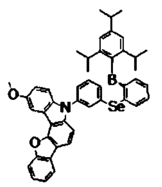
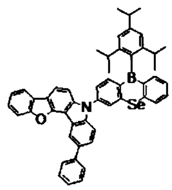
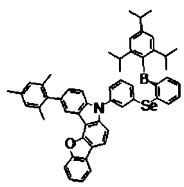
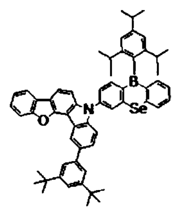
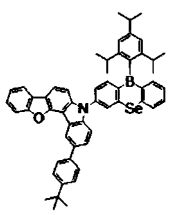
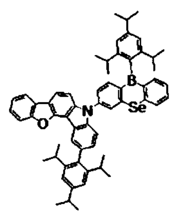
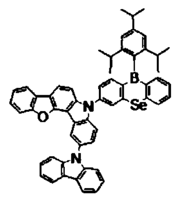
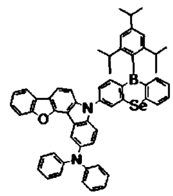
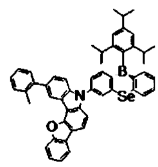

[Chem. 20]

[Group 9-1]

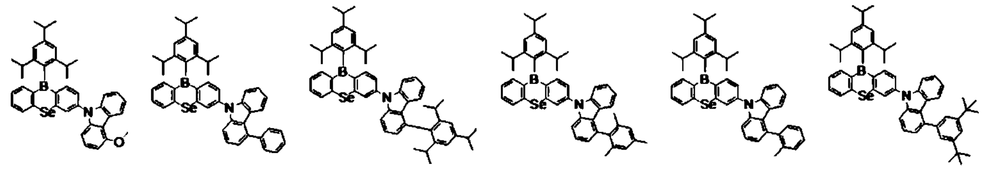

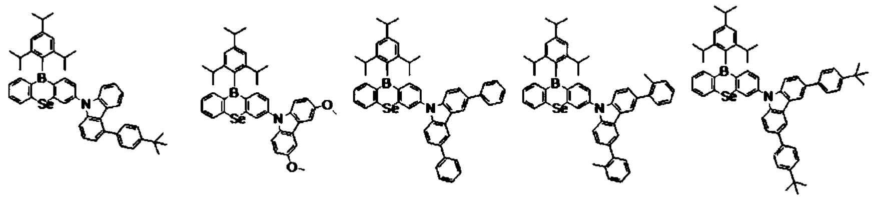

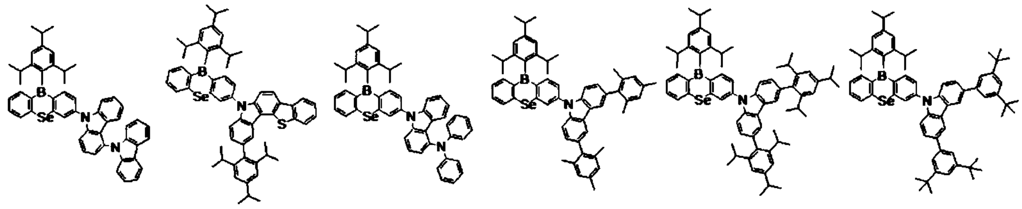

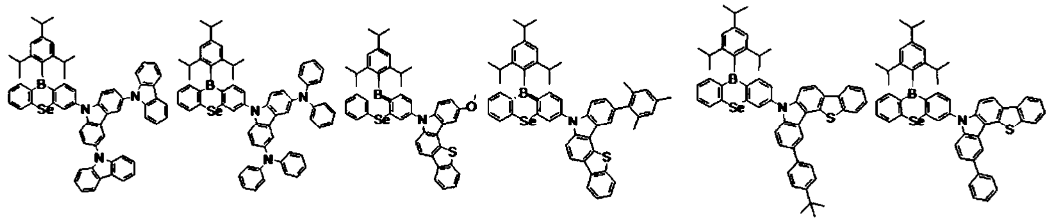

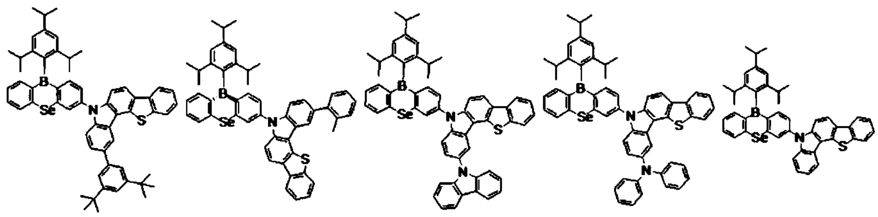

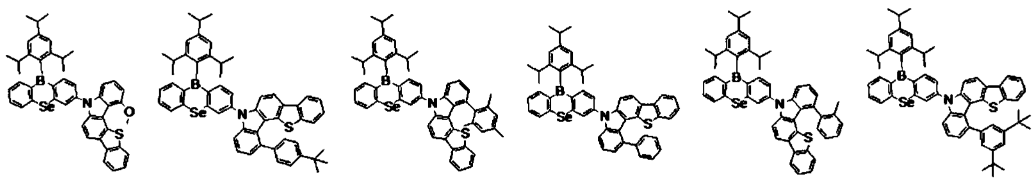

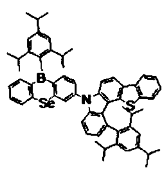

[Chem. 21]

[Group 9-2]

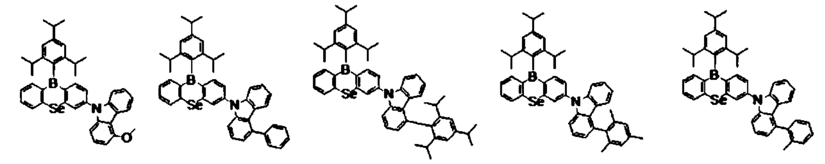

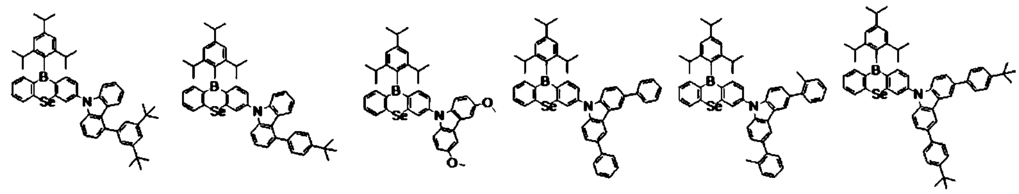

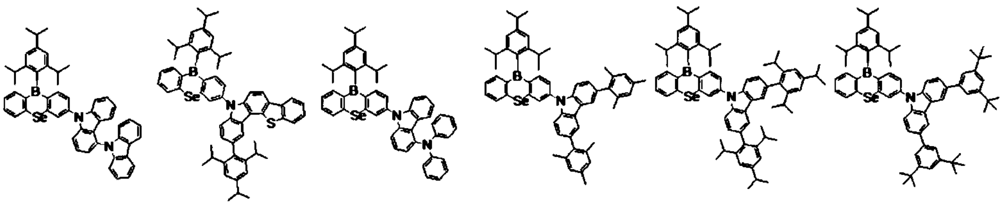

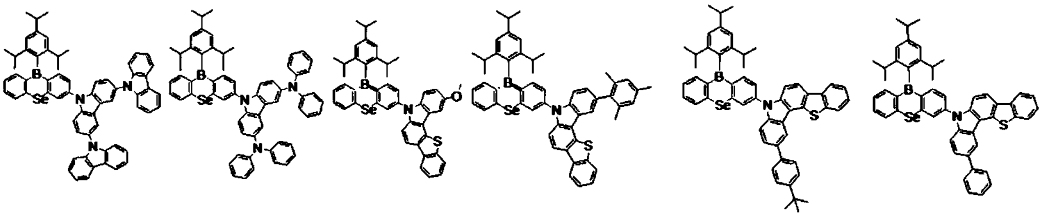

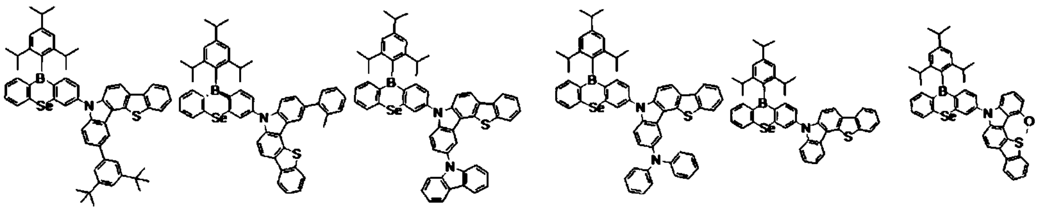

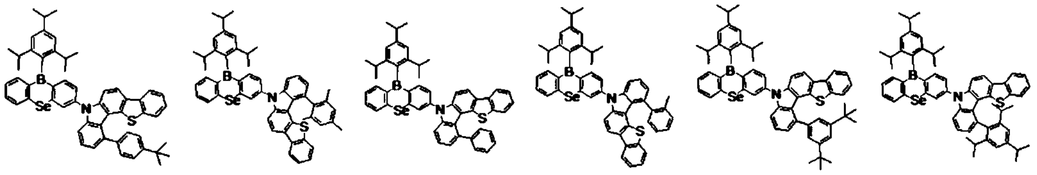

[Chem. 22]

[Group 10-1]

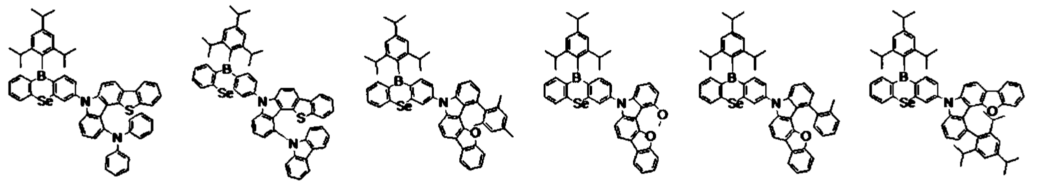

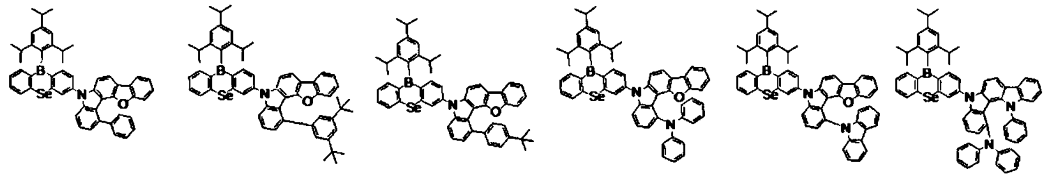

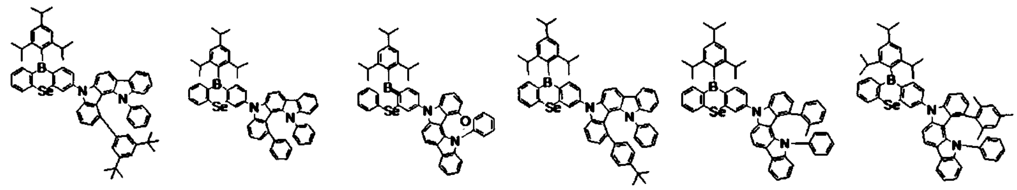

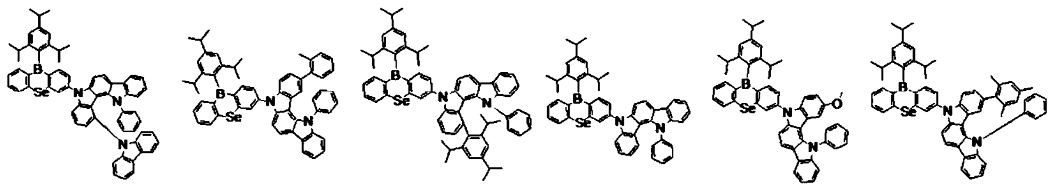

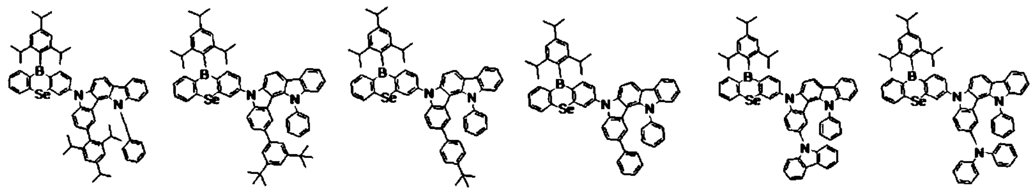

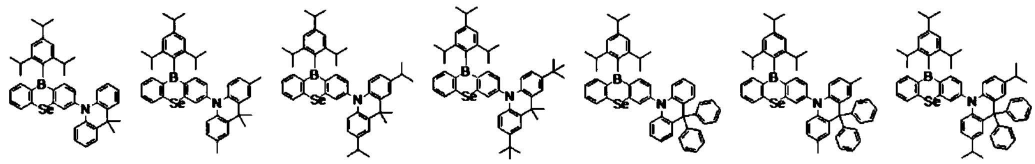

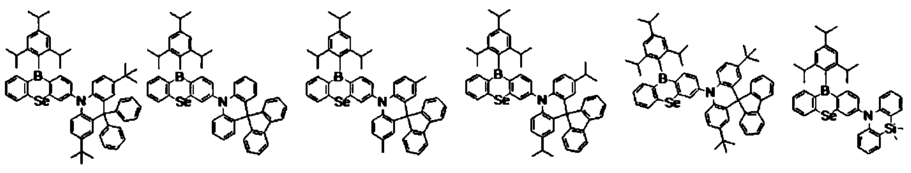

[Chem. 23]

[Group 10-2]

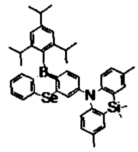 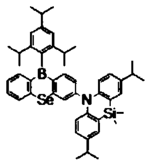 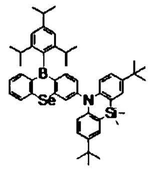 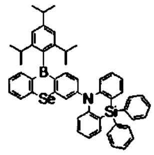 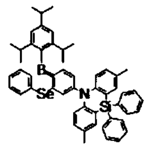 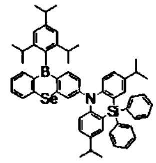

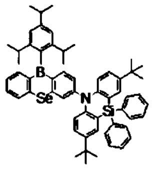 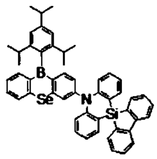 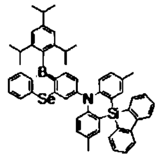 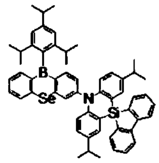 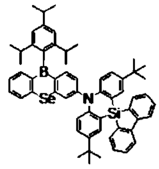 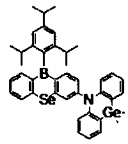

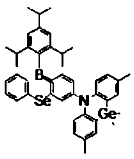 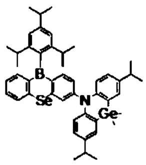 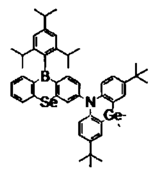 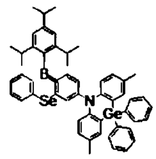 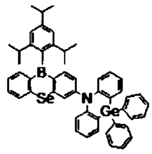 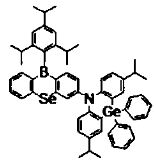

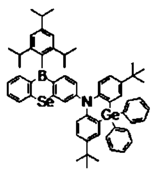 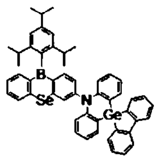 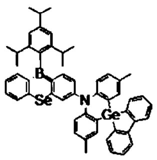 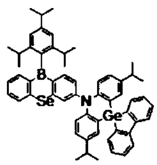 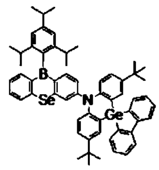 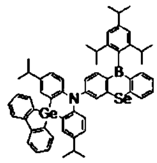

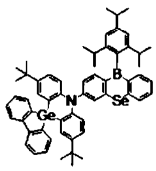

[Chem. 24]

[Group 11]

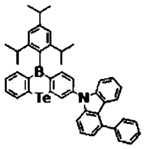
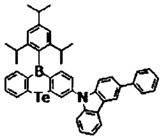
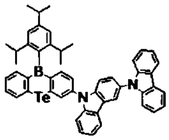
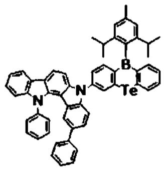
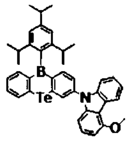
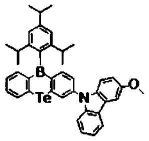

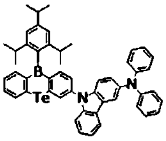
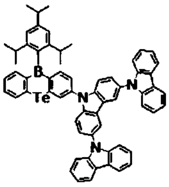
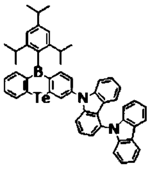
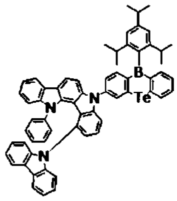
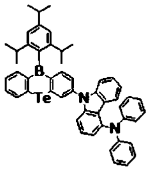

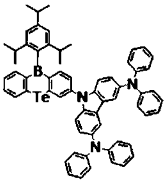
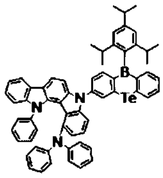
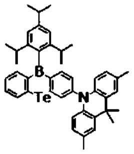
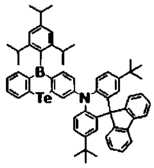
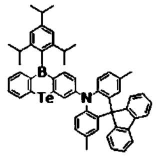
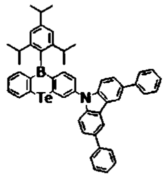

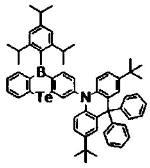
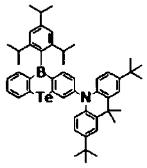
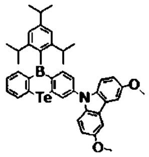
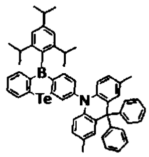
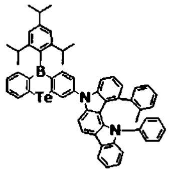
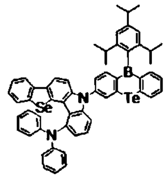

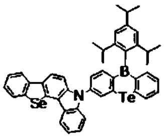
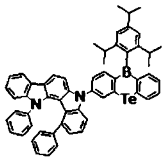
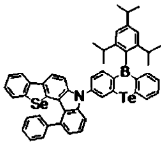
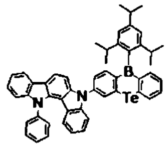
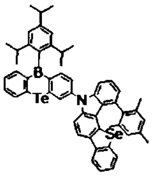
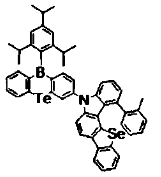

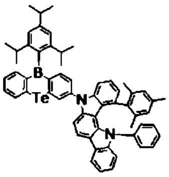
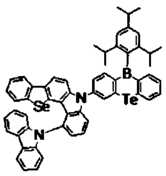
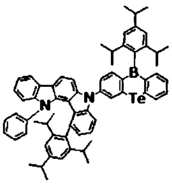
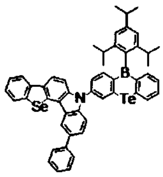
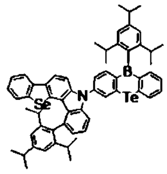

[Chem. 25]

[Group 12]

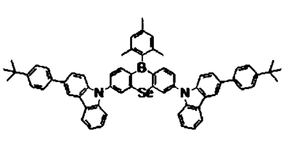 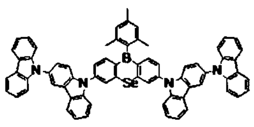 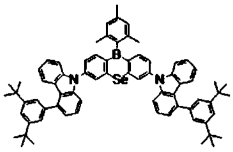 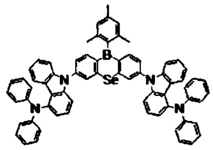

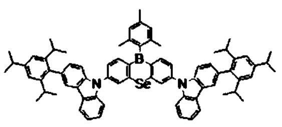 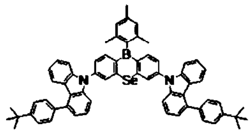 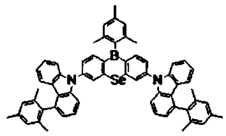 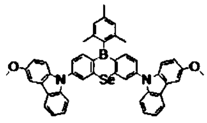

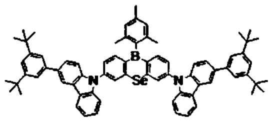 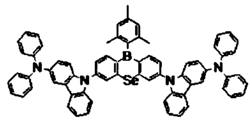 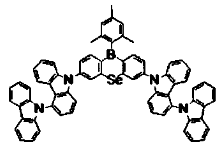 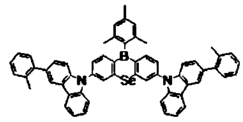

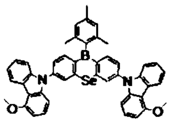 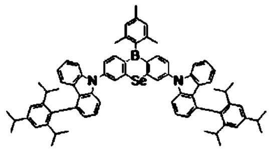 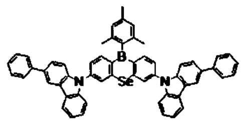 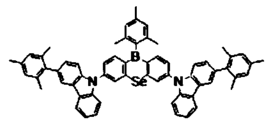

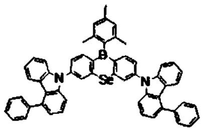 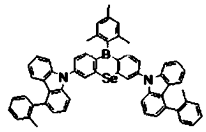

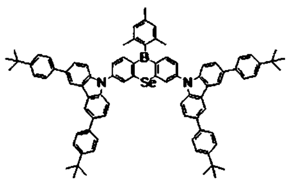 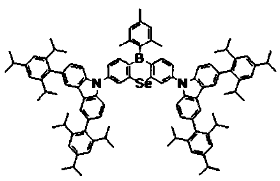 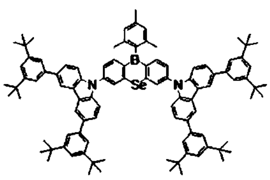

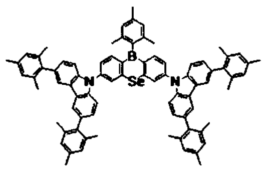 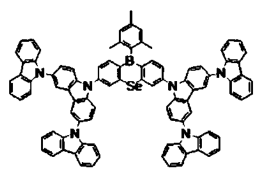 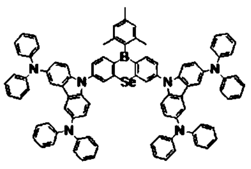

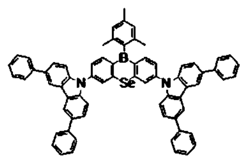 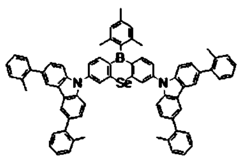 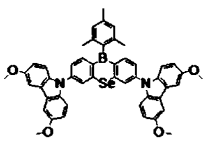

[Chem. 26]

[Group 13-1]

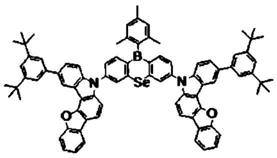
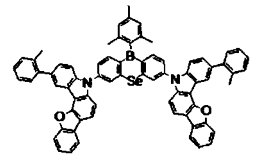
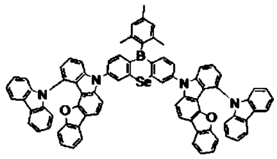
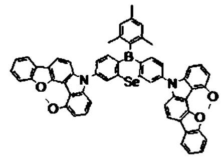

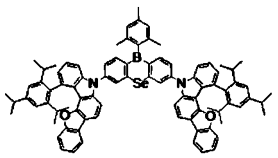
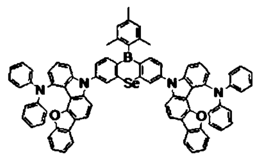
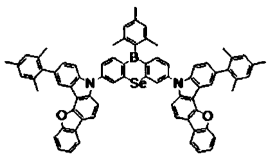
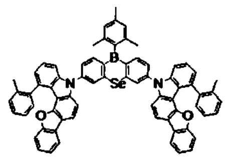

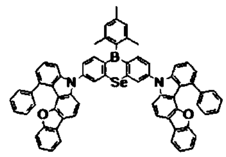
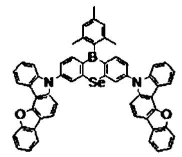
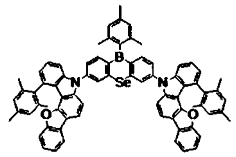
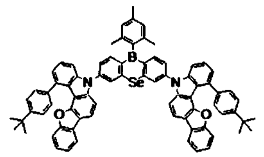

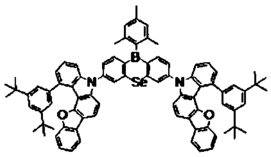
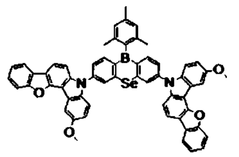
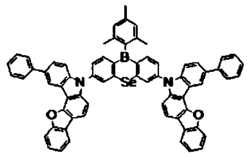
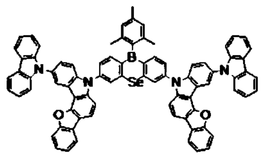

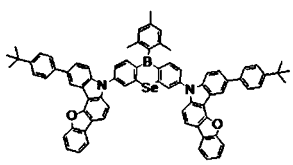
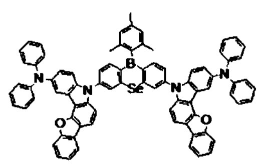
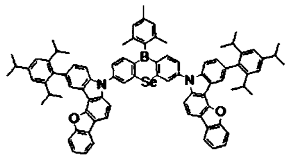

[Chem. 27]

[Group 13-2]

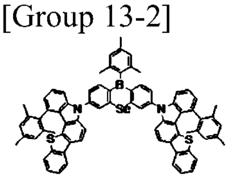
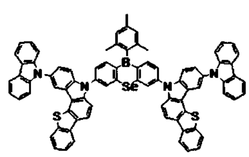
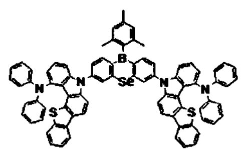
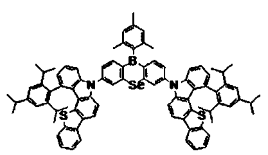
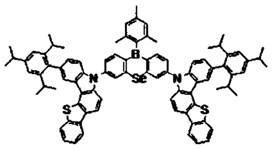
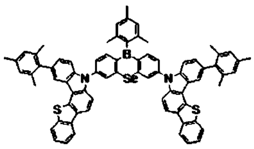
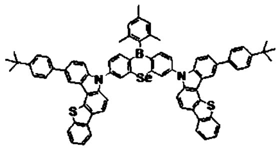
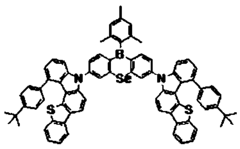
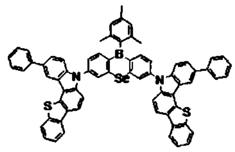
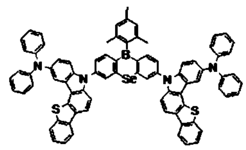
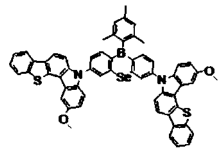
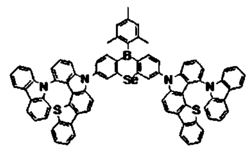
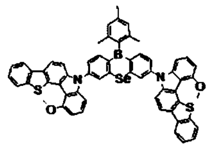
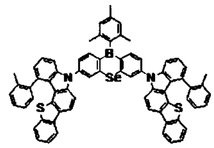
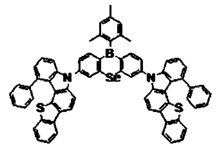
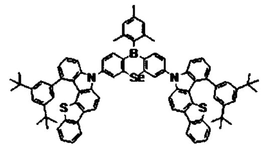
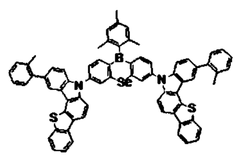
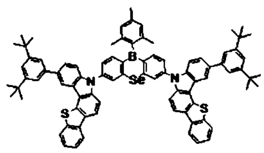

[Chem. 28]

[Group 14]

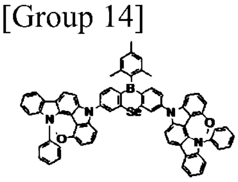
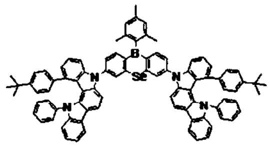
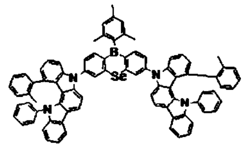
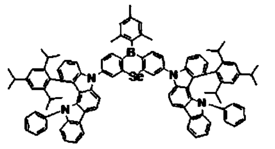
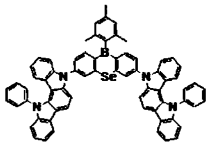
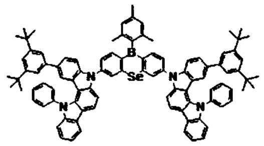
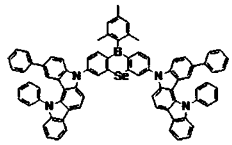
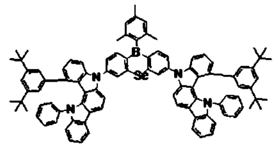
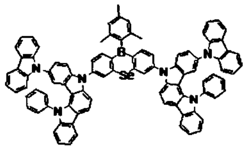
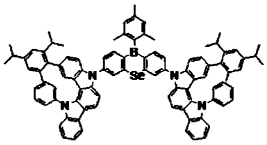
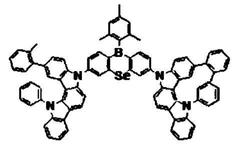
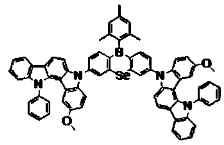
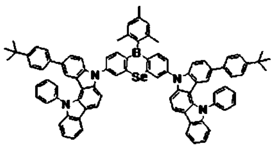
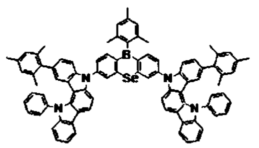
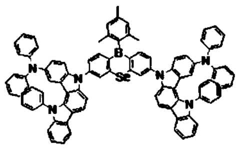
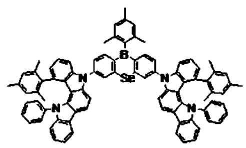
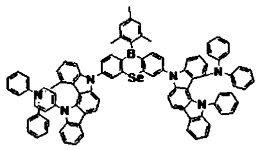
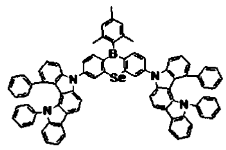
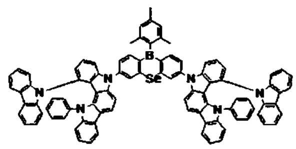
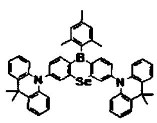
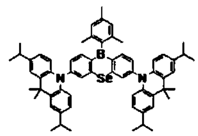
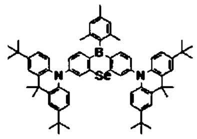
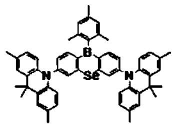
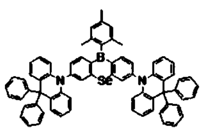
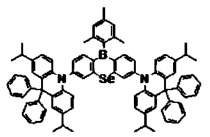
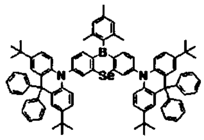
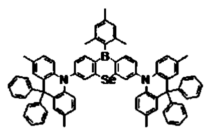
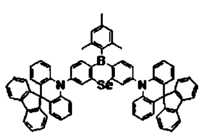
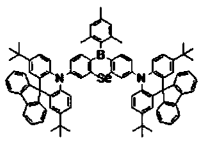
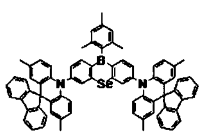
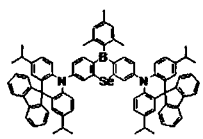

[Chem. 29]

[Group 15]

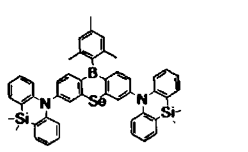
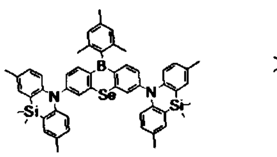
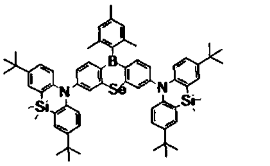
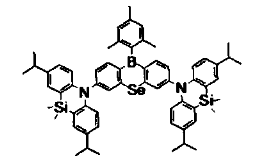
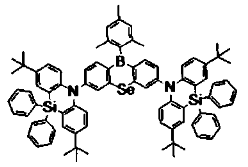
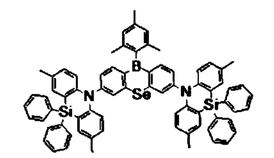
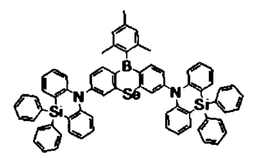
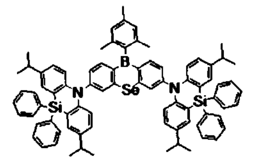
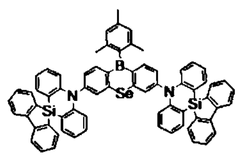
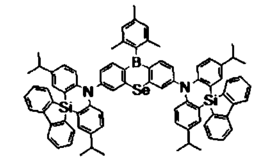
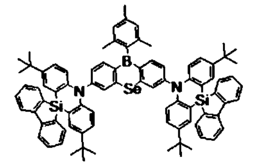
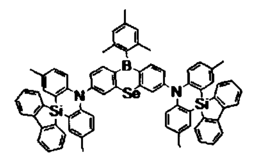
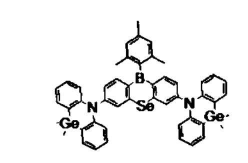
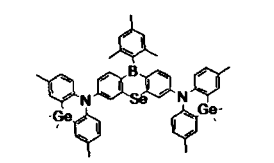
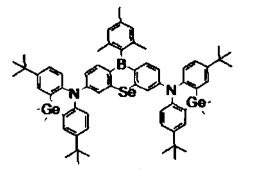
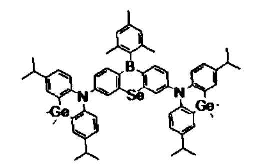
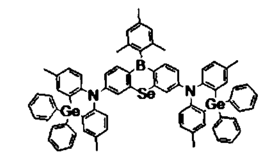
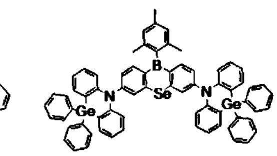
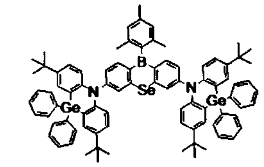
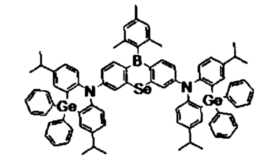
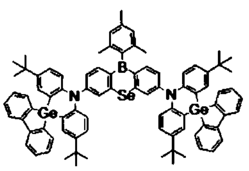
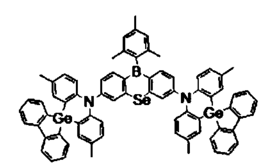
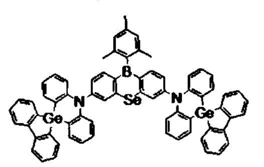
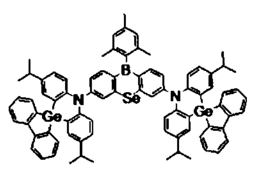

[Chem. 30]

[Group 16-1]

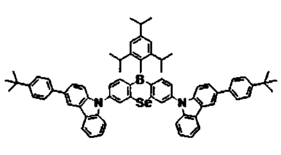
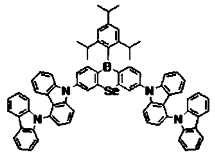
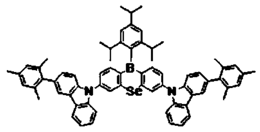
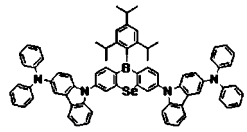

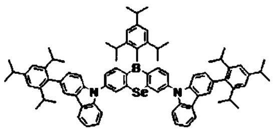
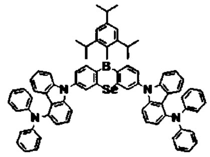
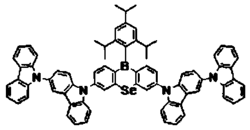
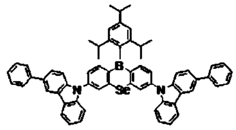

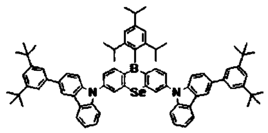
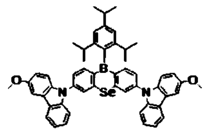
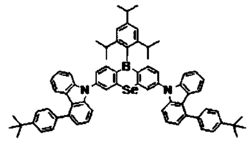
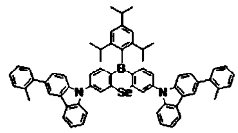

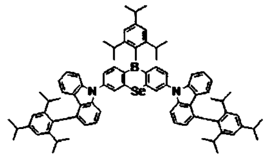
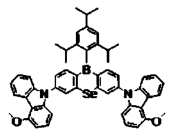
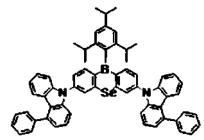
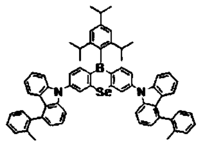

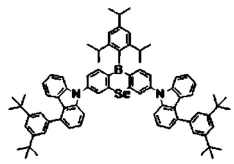
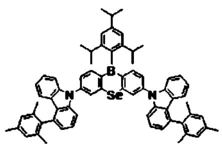

[Chem. 31]

[Group 16-2]

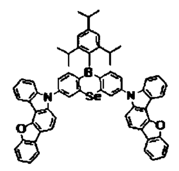
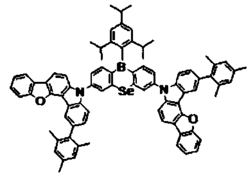
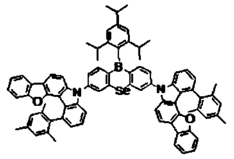
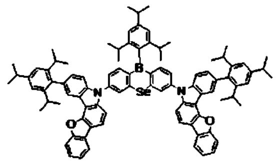

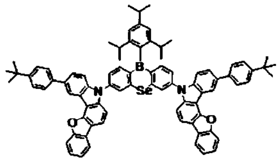
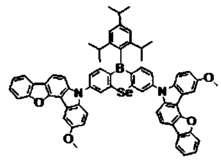
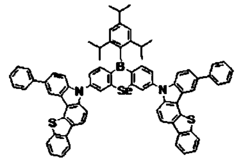
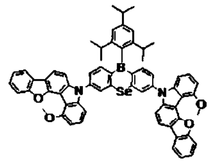

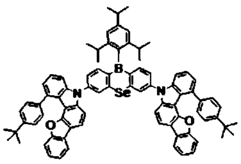
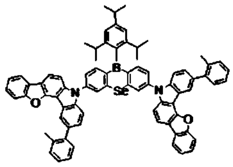
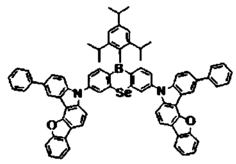
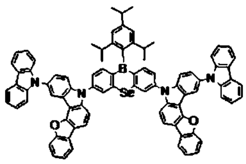

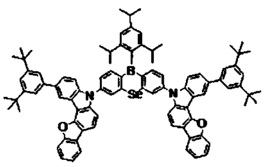
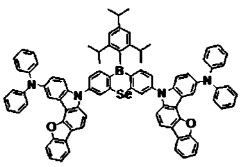
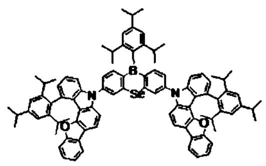
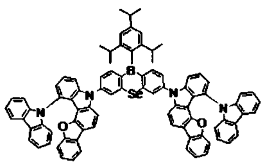

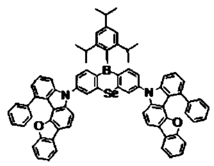
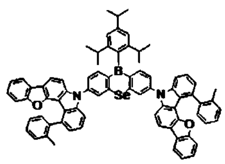
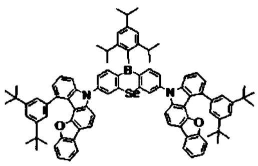
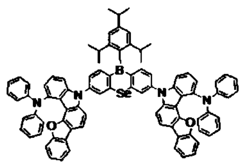

[Chem. 32]

[Group 17]

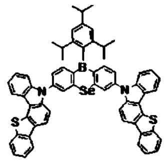
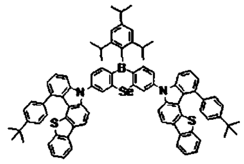
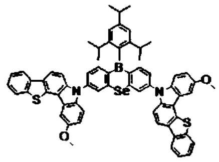
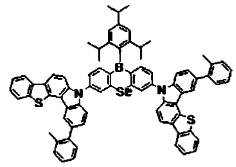
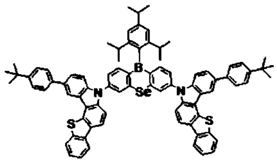
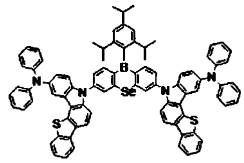
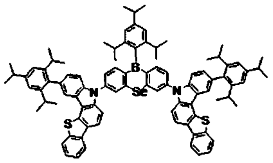
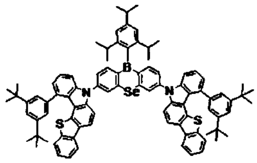
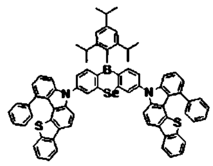
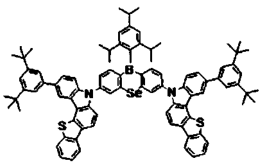
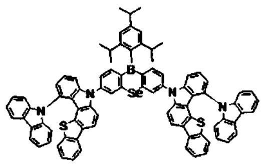
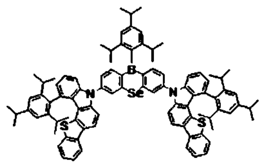
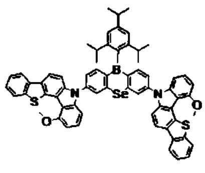
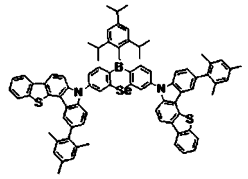
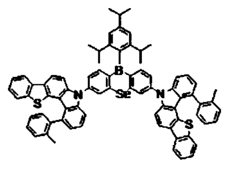
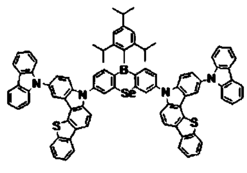
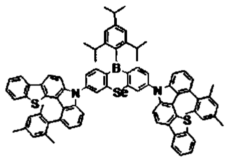
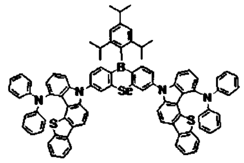
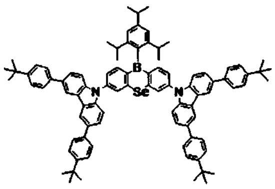
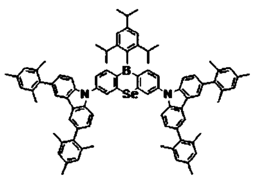
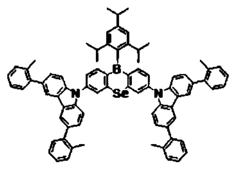
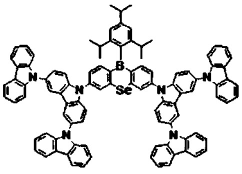
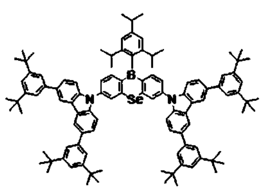
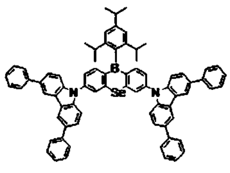
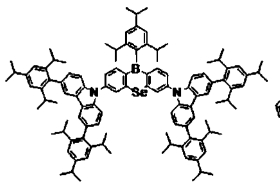
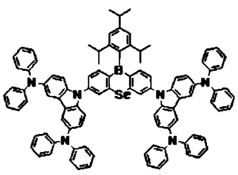
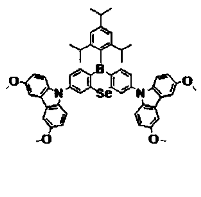

[Chem. 33]

[Group 18]

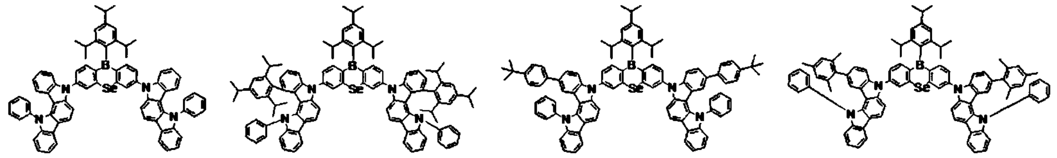

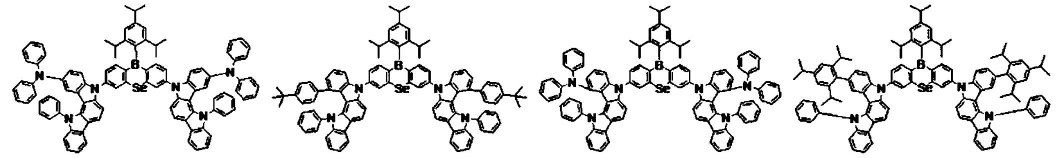

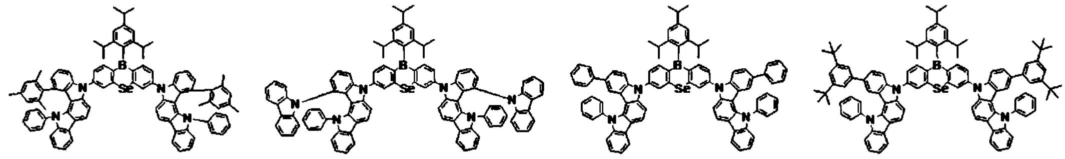

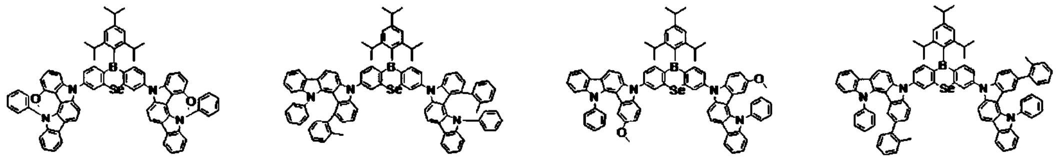

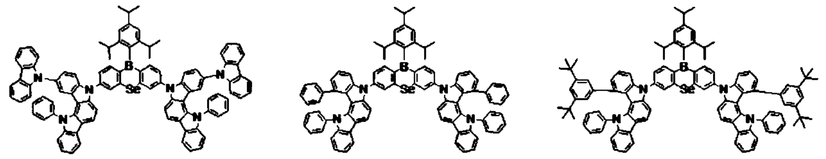

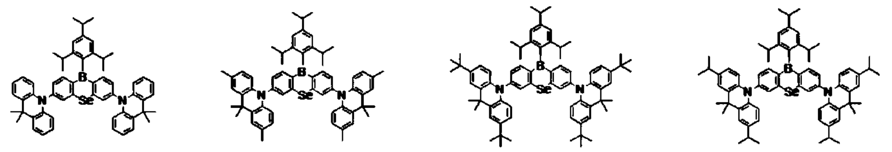

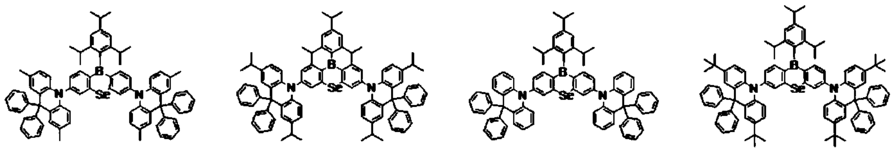

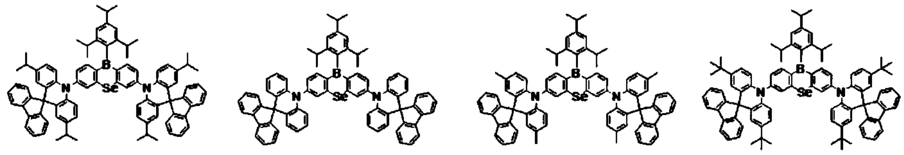

[Chem. 34]

[Group 19]

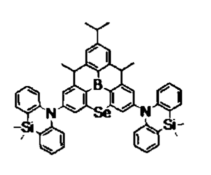
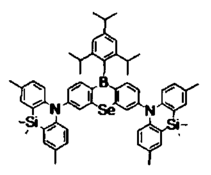
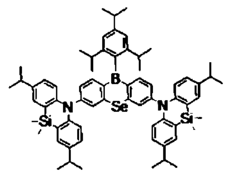
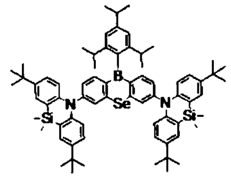
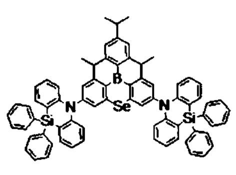
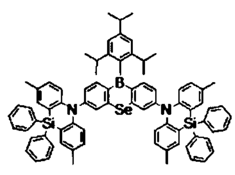
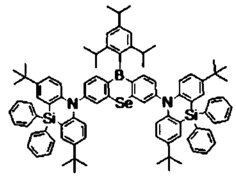
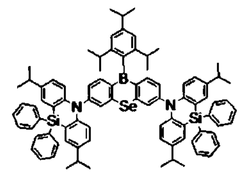
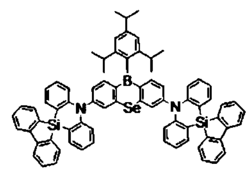
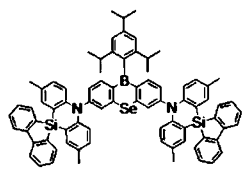
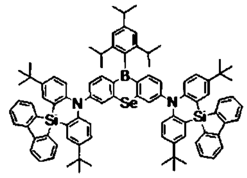
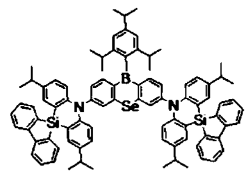
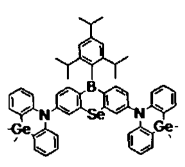
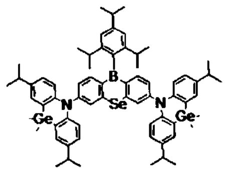
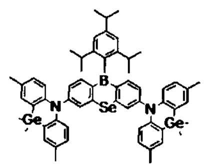
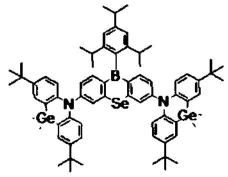
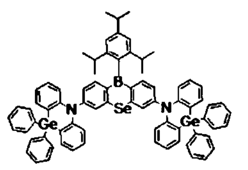
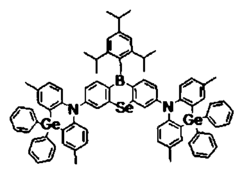
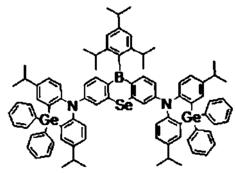
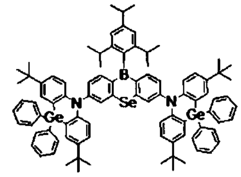
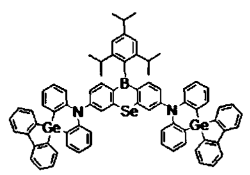
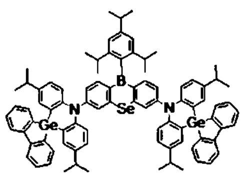
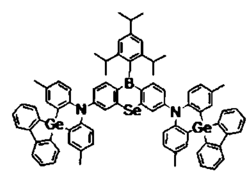
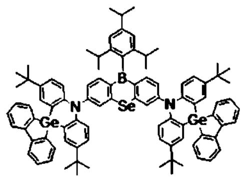

[Chem. 35]

[Group 20]

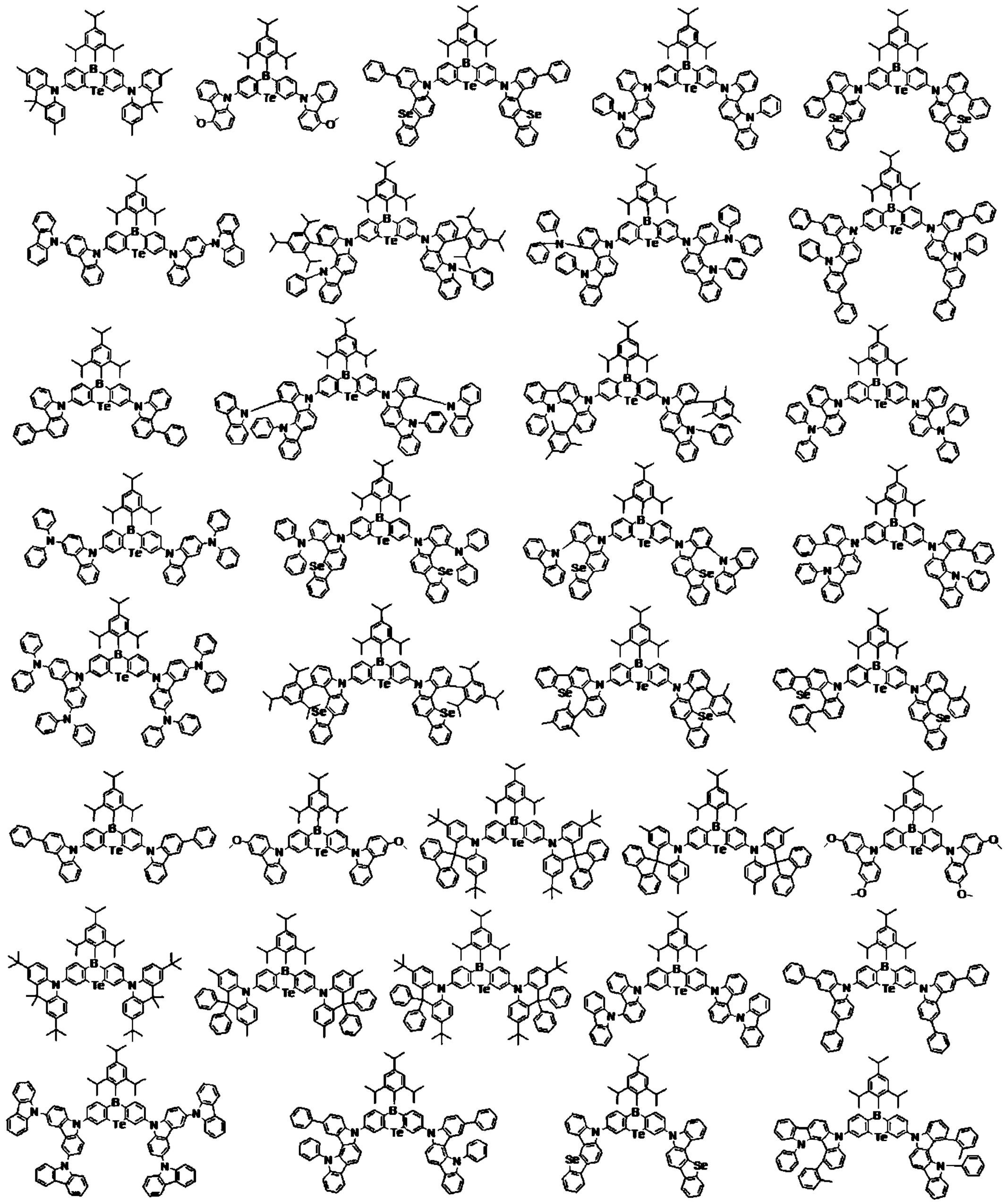

[Chem. 36]

[Group 21]

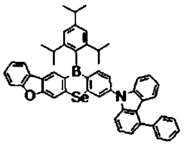
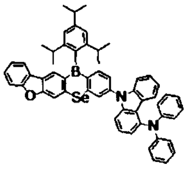
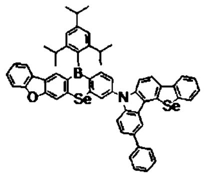
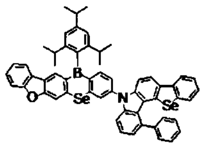
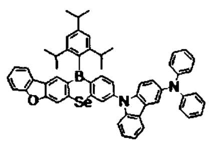

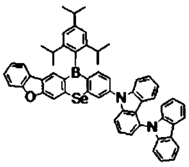
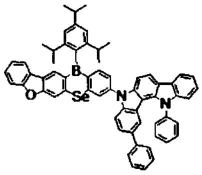
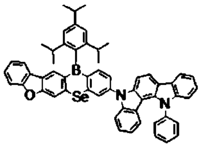
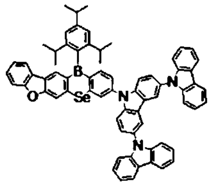
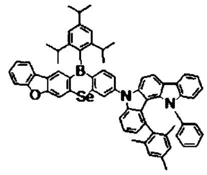

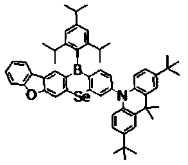
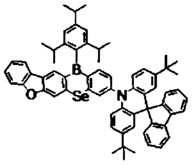
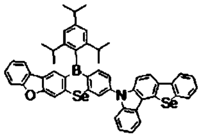
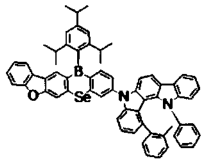
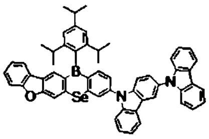

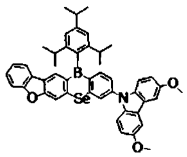
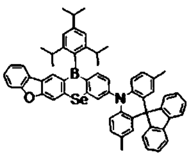
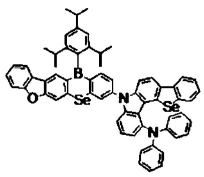
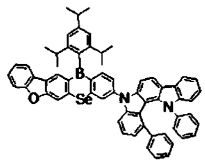
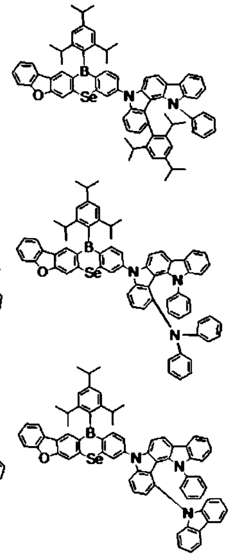

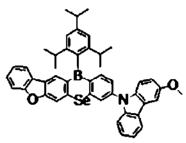
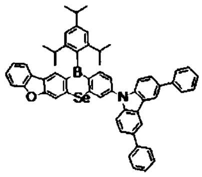
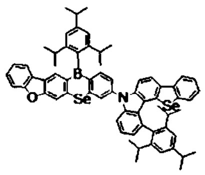
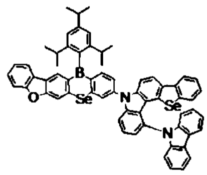

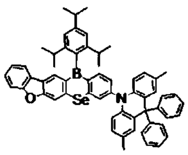
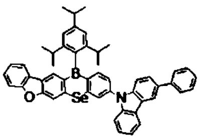
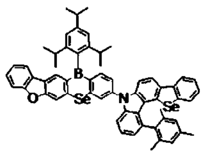
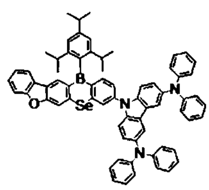

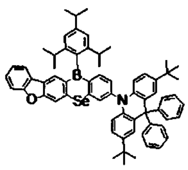
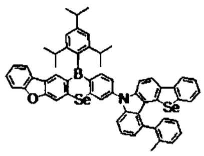
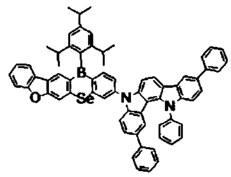

[Chem. 37]

[Group 22]

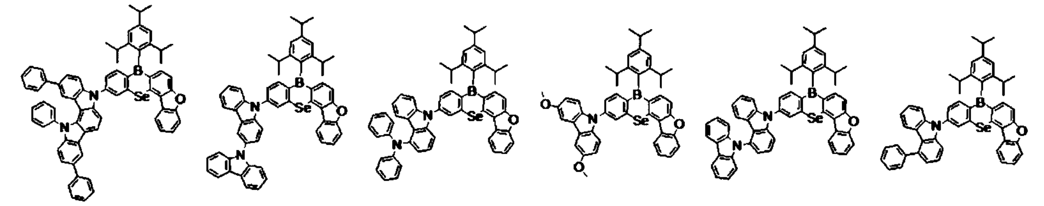

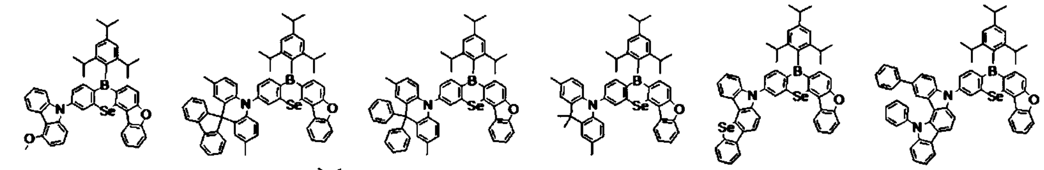

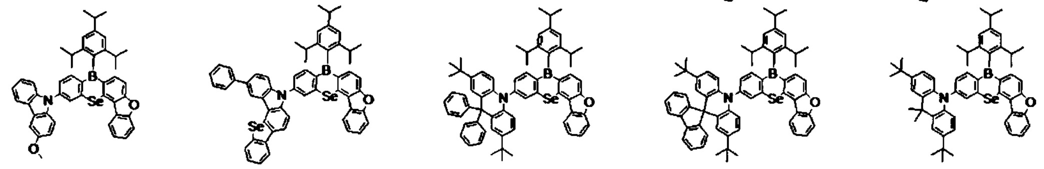

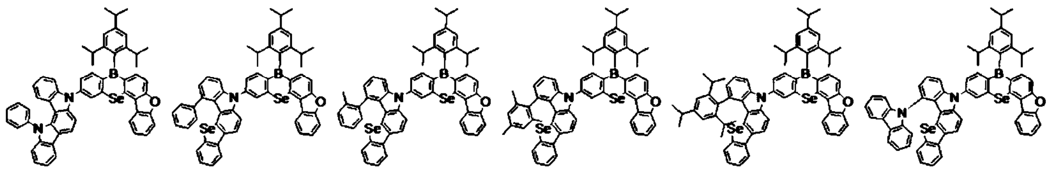

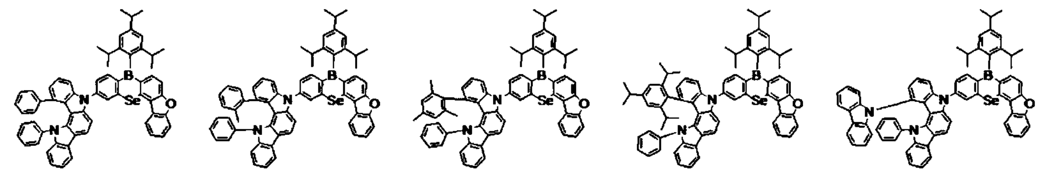

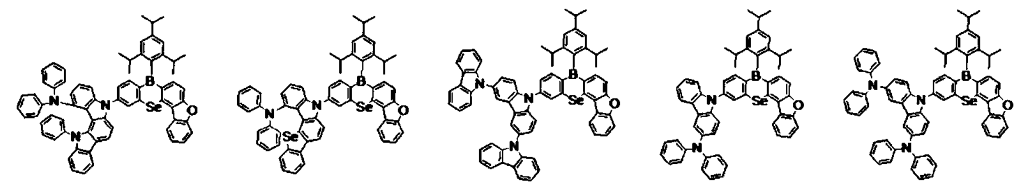

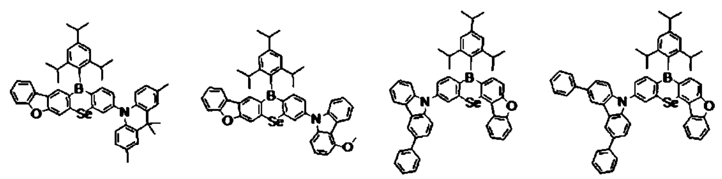

[Chem. 38]

[Group 23]

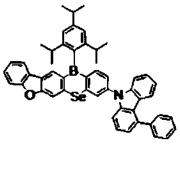 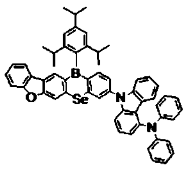 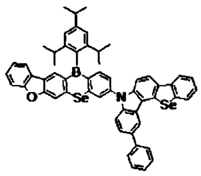 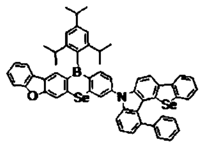 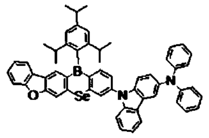

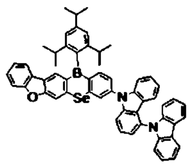 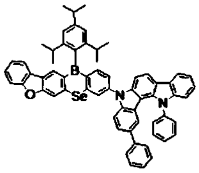 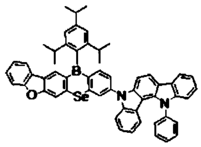 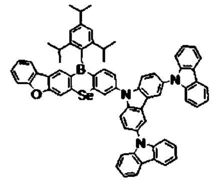 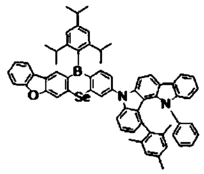

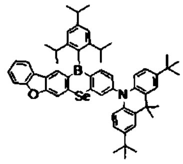 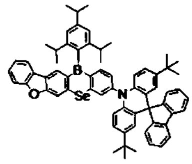 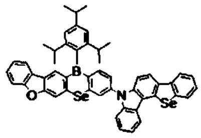 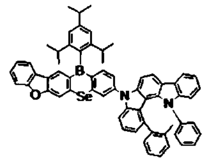 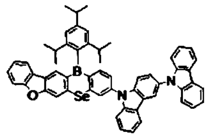

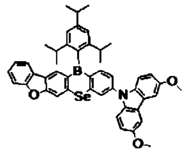 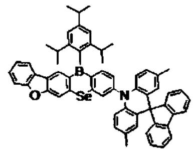 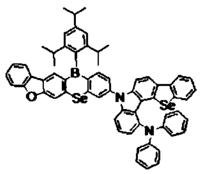 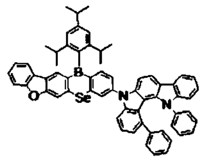 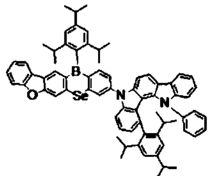

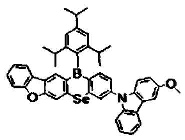 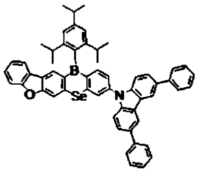 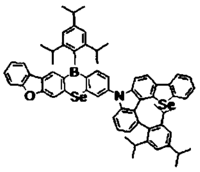 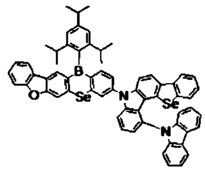 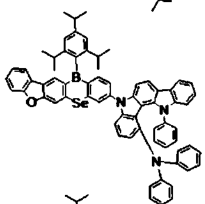

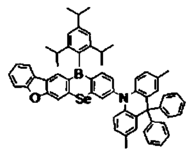 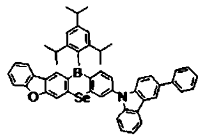 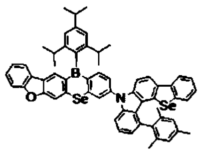 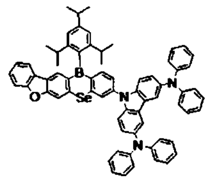 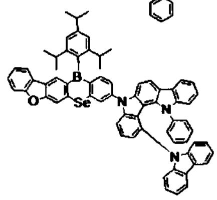

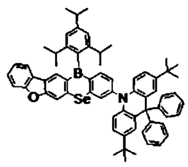 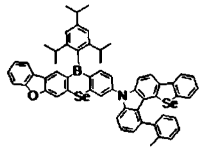 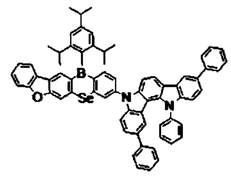

[Chem. 39]

[Group 24]

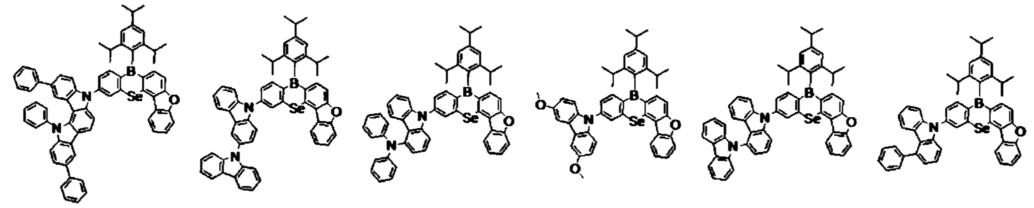

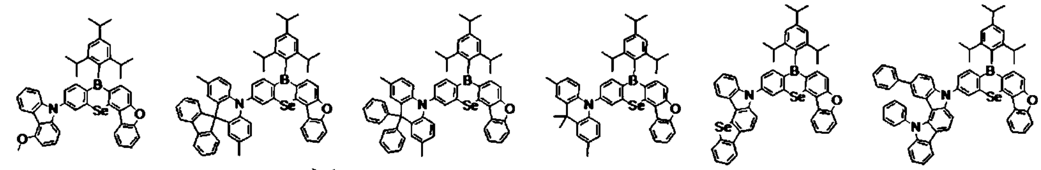

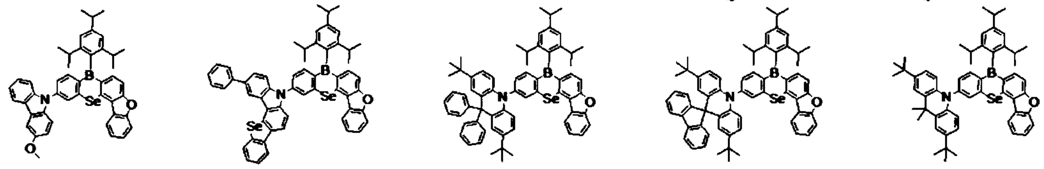

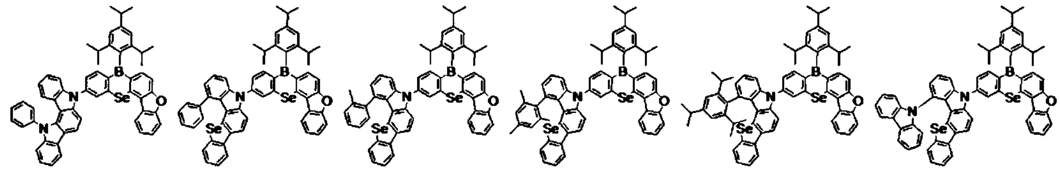

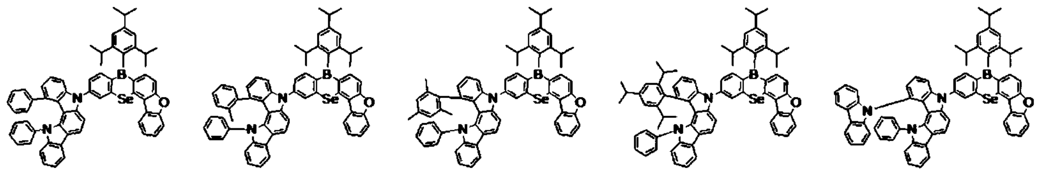

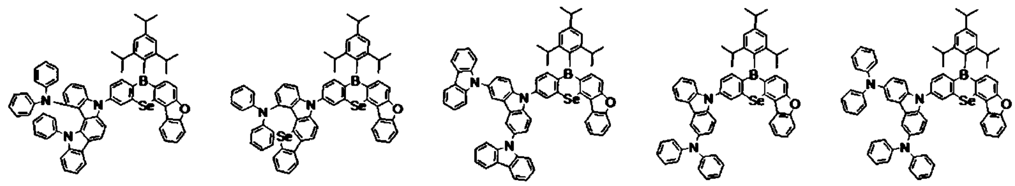

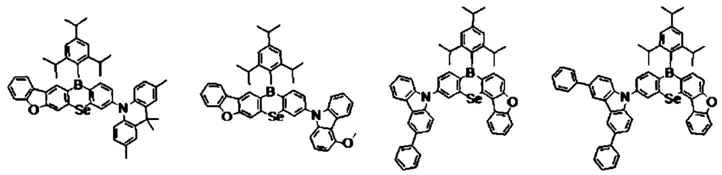

[Chem. 40]

[Group 25]

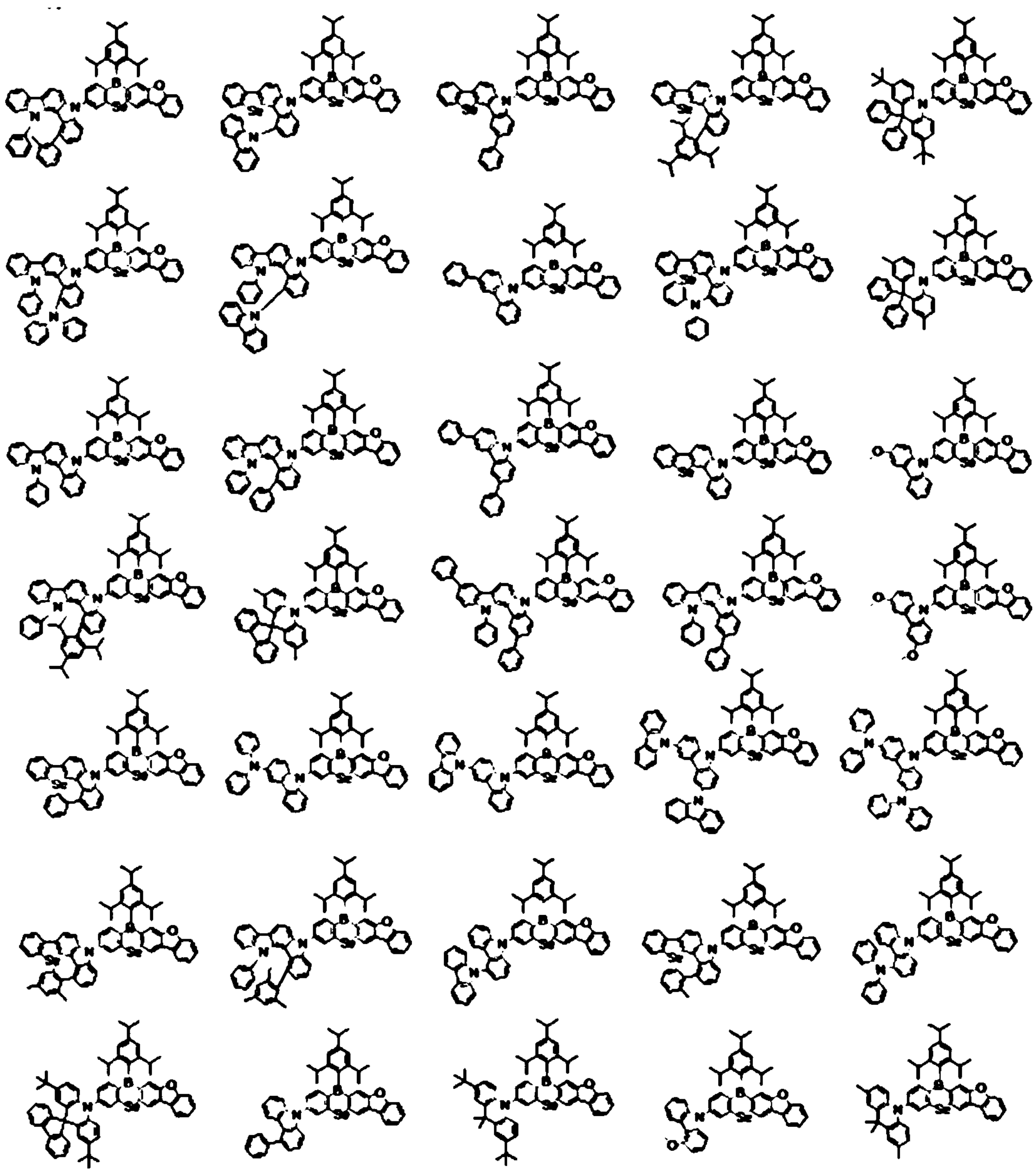

[Chem. 41]

[Group 26]

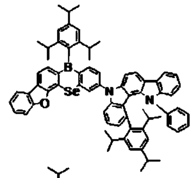 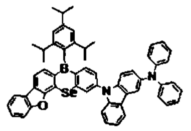 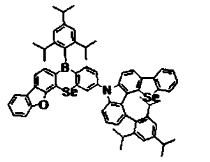 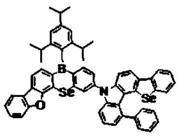 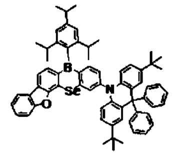

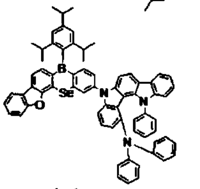 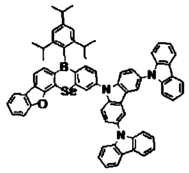 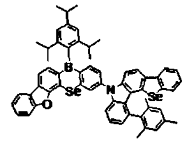 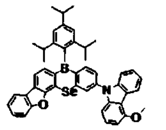 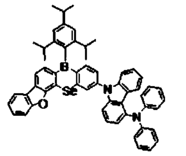

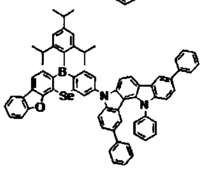 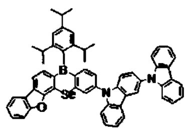 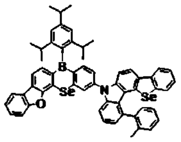 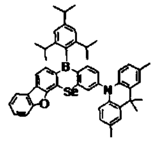 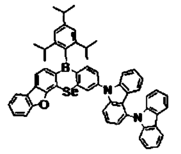

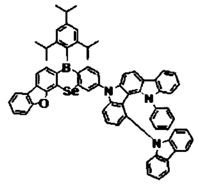 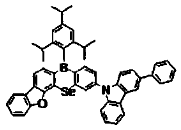 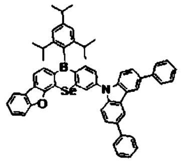 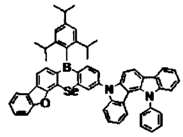 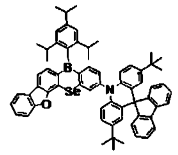

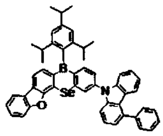 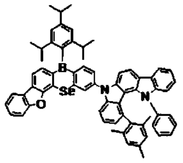 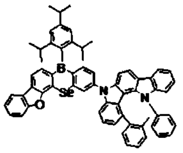 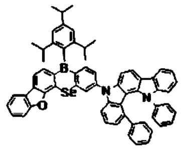 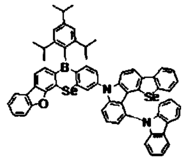

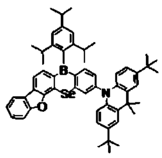 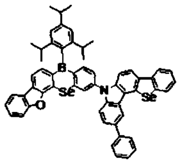 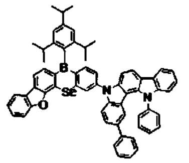 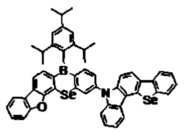 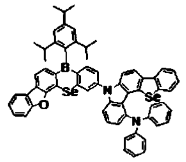

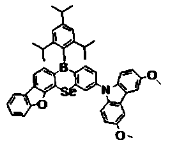 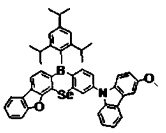 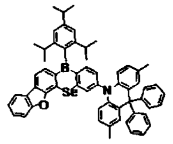 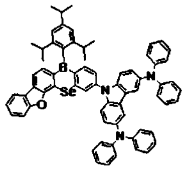 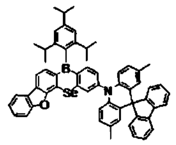

[Chem. 42]

[Group 27]

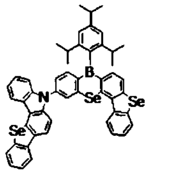
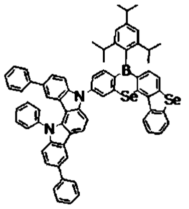
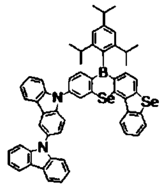
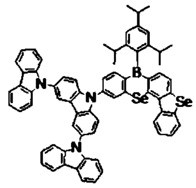
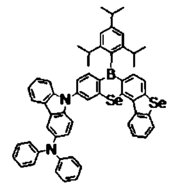

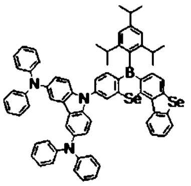
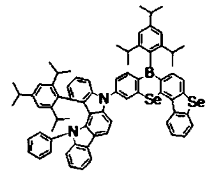
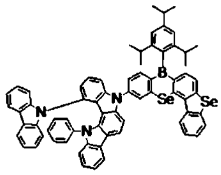
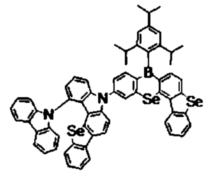
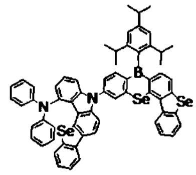

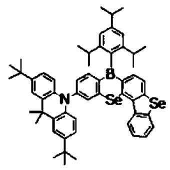
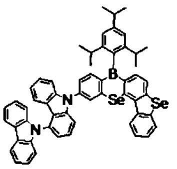
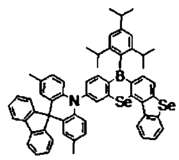
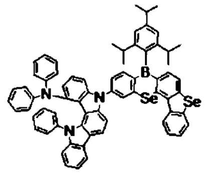
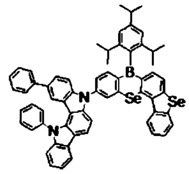

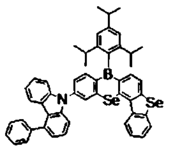
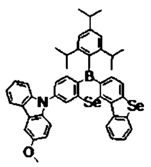
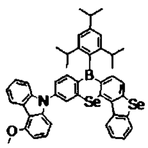
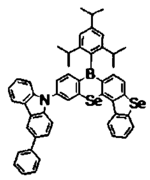
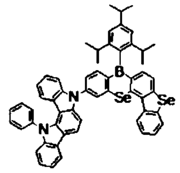

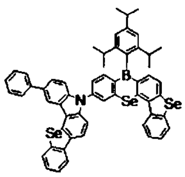
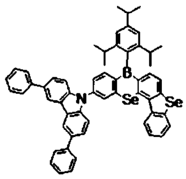
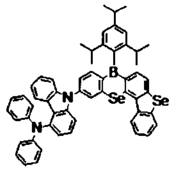
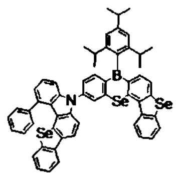
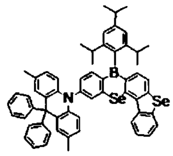

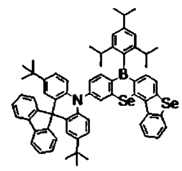
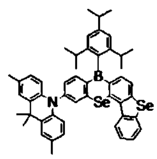
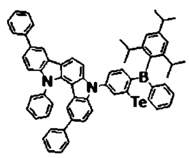
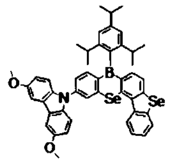
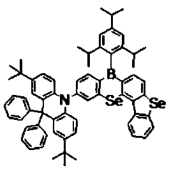

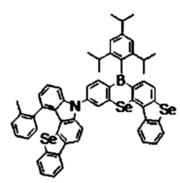
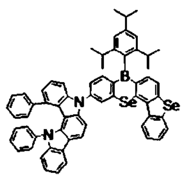
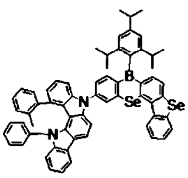
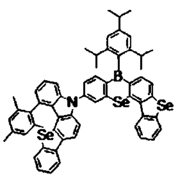
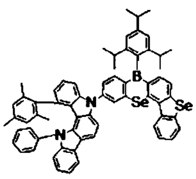

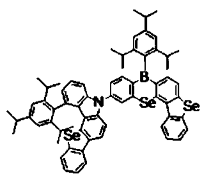

[Chem. 43]

[Group 28]

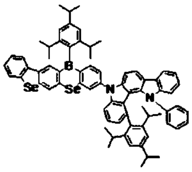
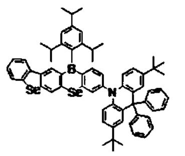
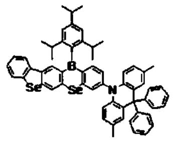
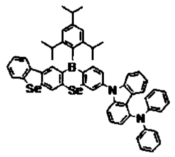
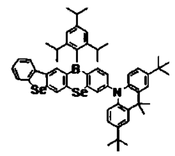
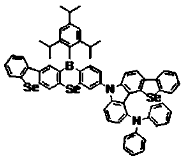
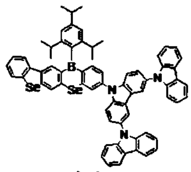
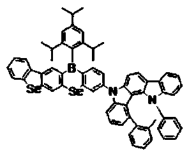
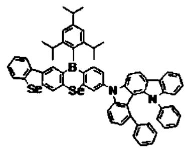
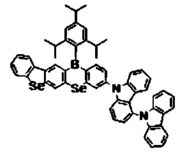
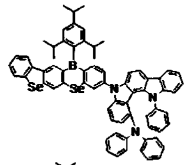
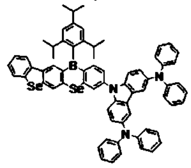
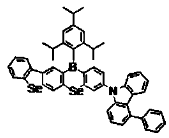
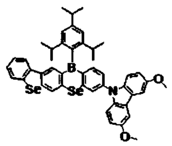
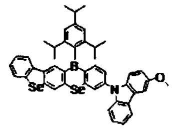
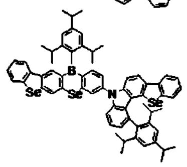
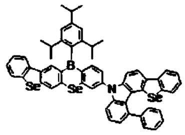
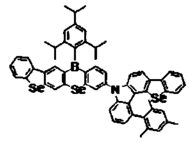
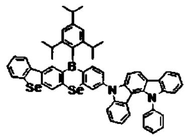
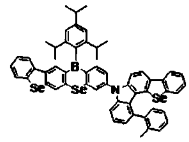
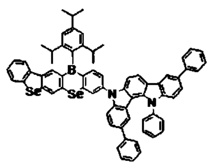
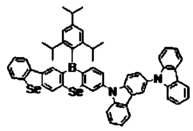
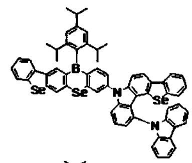
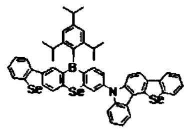
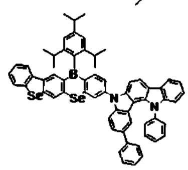
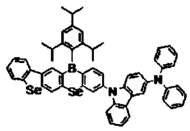
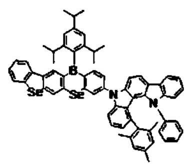
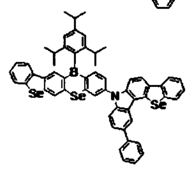
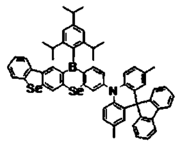
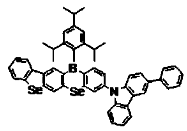
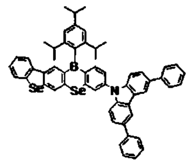
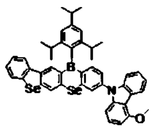

[Chem. 44]

[Group 29]

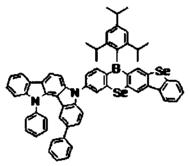
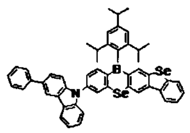
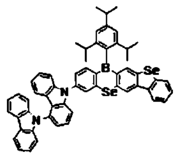
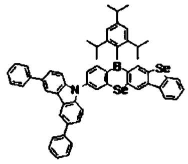
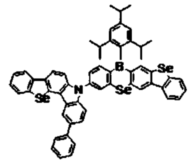
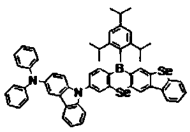
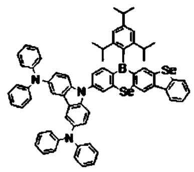
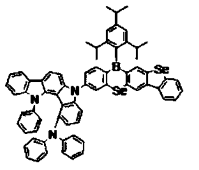
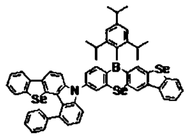
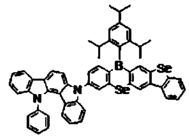
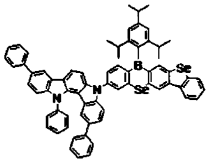
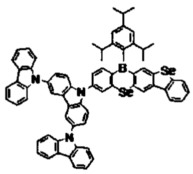
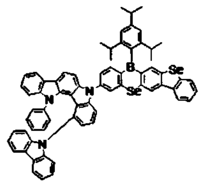
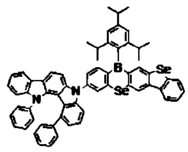
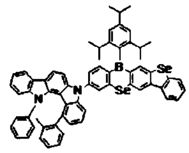
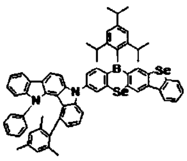
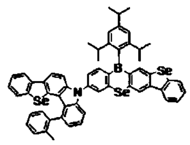
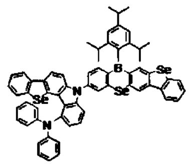
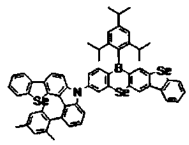
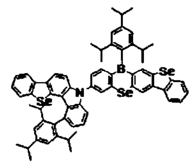
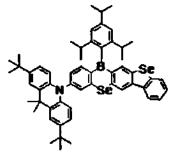
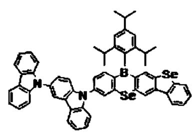
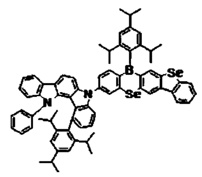
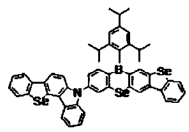
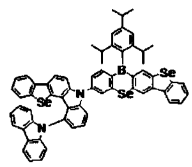
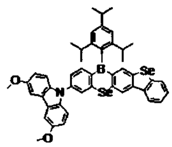
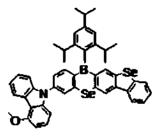
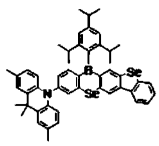
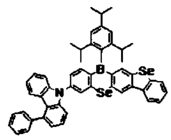
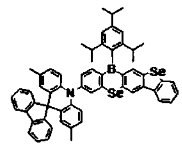
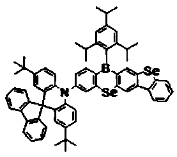
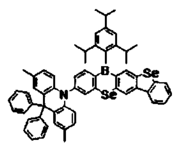
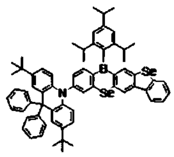
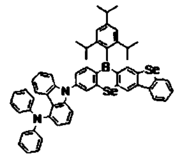
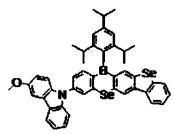

[Chem. 45]

[Group 30]

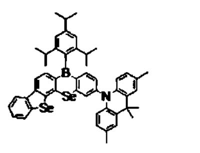 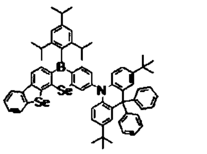 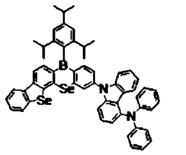 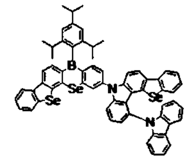 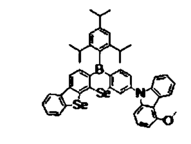

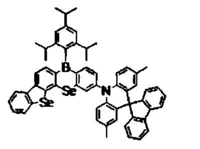 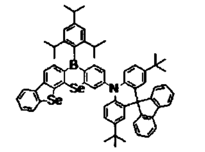 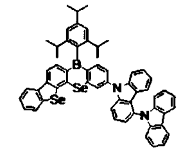 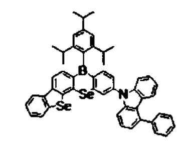 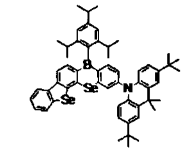

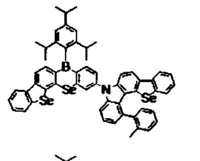 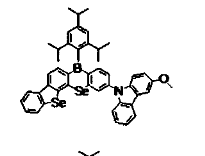 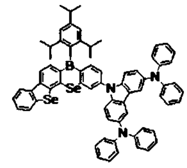 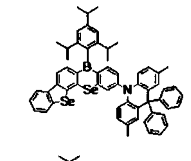 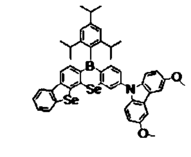

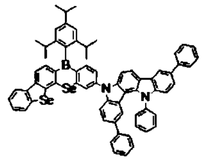 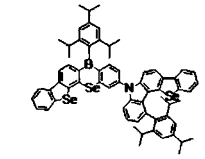 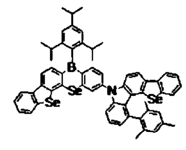 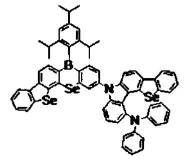 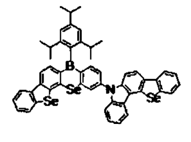

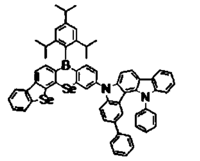 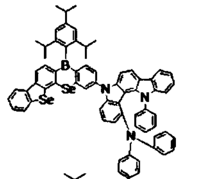 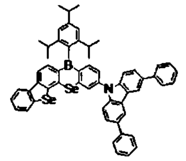 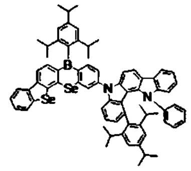 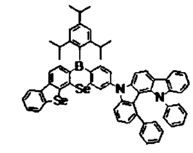

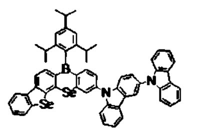 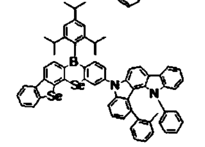 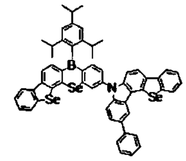 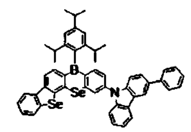 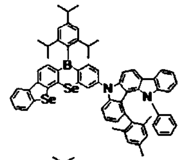

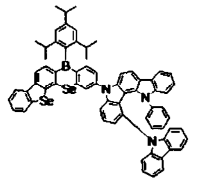 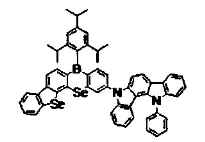 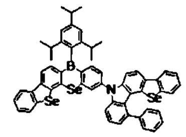 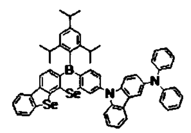 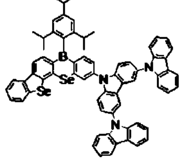 .

**9.** The organic compound according to claim 8, **characterized by** being any one of the organic compounds shown in the Groups 1 to 20.

**10.** The organic compound according to claim 9, **characterized by** being any one of the organic compounds shown in the Groups 2 to 20.

**11.** The organic compound according to claim 10, **characterized by** being any one of the organic compounds shown in the Groups 6 to 20.

**12.** An organic compound **characterized by** satisfying Expression (a) below, Expression (b) below, and Expression (c) below, and being represented by any one of General formulas (1-1), (1-2), and (4) to (7) below,

$$k_r > 5 \times 10^5\ s^{-1} \quad \cdots (a)$$

$$k_{RISC}/k_r > 0.2 \quad \cdots (b)$$

$$k_{RISC}/k_{ISC} > 0.001 \cdots (c)$$

$k_r$: a rate constant from an excited singlet state to a ground state,
$k_{RISC}$: a reverse intersystem crossing rate constant between the excited singlet state and an excited triplet state,
$k_{ISC}$: an intersystem crossing rate constant between the excited singlet state and the excited triplet state,

[Chem. 46]

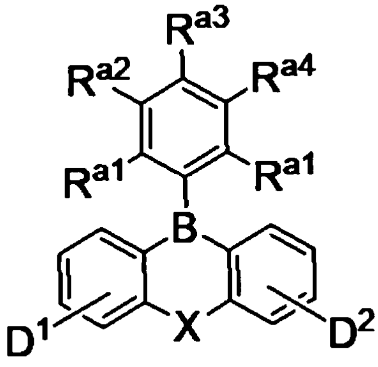

General formula (1-1)

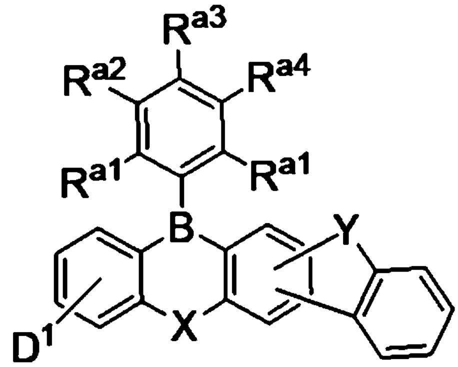

General formula (1-2)

wherein, in General formulas (1-1) and (1-2), $R^{a1}$ to $R^{a4}$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group, provided that $R^{a1}$ is not a hydrogen atom,
X is a selenium atom or a tellurium atom,
Y is selected from an oxygen atom, a sulfur atom, a selenium atom, a tellurium atom, and a nitrogen atom having an alkyl group or an aryl group as a substituent,
$D^1$ is a group represented by any one of General formulas (2-1) to (2-5) below, $D^2$ is a hydrogen atom or a group represented by any one of General formulas (2-1) to (2-5) below, in General formulas (2-1) to (2-5) below, * represents a binding site,

[Chem. 47]

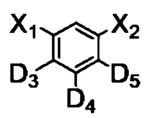

General formula (4)

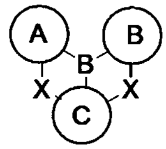

General formula (5)

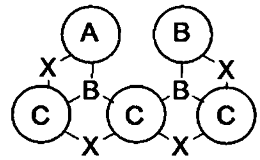

General formula (6)

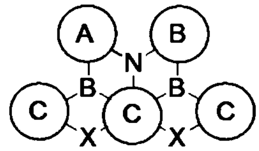

General formula (7)

in General formula (4), $X_1$ and $X_2$ are each independently selected from a hydrogen atom, a deuterium atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, and a cyano group, provided that $X_2$ is not a hydrogen atom or a deuterium atom,
$D_3$ to $D_5$ are each independently selected from a hydrogen atom, a deuterium atom, a halogen atom, a substituted or unsubstituted alkyl group, a substituted or unsubstituted alkoxy group, a substituted or unsubstituted aryl group, a substituted or unsubstituted heterocyclic group, a substituted or unsubstituted aralkyl group, a substituted or unsubstituted amino group, a silyl group, a cyano group, and groups represented by General formulas (2-1) to (2-5), provided that at least one of $D_3$ to $D_5$ is independently selected from the groups represented by General formulas (2-1) to (2-5),
in General formulas (5) to (7), X is selected from an oxygen atom, a sulfur atom, a selenium atom, a tellurium atom, a nitrogen atom having an alkyl group or an aryl group as a substituent, and a single bond,
rings A to C are each independently selected from a substituted or unsubstituted aryl and a heteroaryl, and the rings A and B may be bound to each other with a single bond,

[Chem. 48]

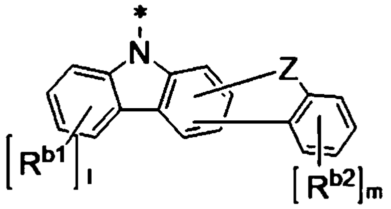

General formula(2-1)

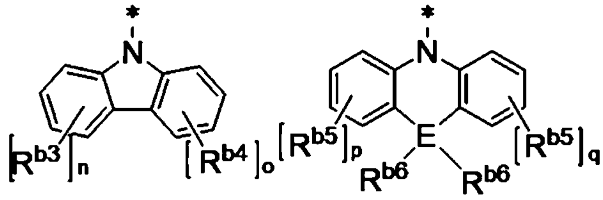

General formula(2-2) General formula(2-3)

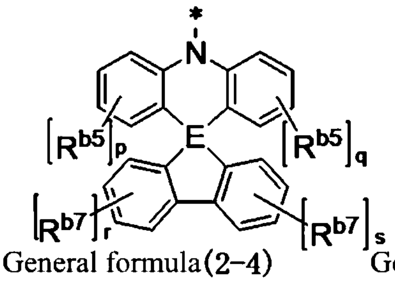

General formula(2-4)

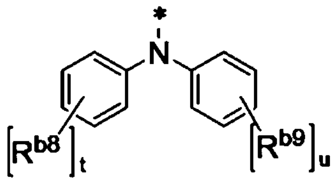

General formula(2-5)

in General formulas (2-1) to (2-5), $R^{b1}$ to $R^{b9}$ are each independently selected from a deuterium atom, a substituted or unsubstituted alkyl group, a substituted or unsubstituted alkoxy group, a substituted or unsubstituted aryl group, a substituted or unsubstituted nitrogen-containing heteroaryl group, and a substituted or unsubstituted amino group,

Z is selected from an oxygen atom, a sulfur atom, a selenium atom, a tellurium atom, and a nitrogen atom having an alkyl group or an aryl group as a substituent,

E is a carbon atom, a silicon atom, or a germanium atom,

each of 1, m, n, r, and s is an integer of 0 or more and 4 or less, o is an integer of 1 or more and 4 or less, each of p and q is 0 or 1, and each of t and u is an integer of 0 or more and 5 or less.

**13.** The organic compound according to claim 12, **characterized by** exhibiting delayed fluorescence.

**14.** The organic compound according to claim 12 or 13, **characterized by** satisfying Expression (b1) below,

$$k_{RISC}/k_r > 1 \quad \cdots (b1).$$

**15.** The organic compound according to any one of claims 12 to 14, **characterized by** satisfying Expression (c1) below,

$$k_{RISC}/k_{ISC} > 0.1 \quad \cdots (c1).$$

**16.** The organic compound according to any one of claims 12 to 15, **characterized by** satisfying Expression (c2) below,

$$0.3 < k_{RISC}/k_{ISC} < 0.333 \quad \cdots (c2).$$

**17.** An organic light emitting element **characterized by** comprising:

a first electrode;
a second electrode; and
an organic compound layer between the first electrode and the second electrode,
wherein at least one layer included in the organic compound layer contains the organic compound according to any one of claims 1 to 16.

**18.** The organic light emitting element according to claim 17, **characterized in that** the layer containing the organic

compound is a light emitting layer.

19. The organic light emitting element according to claim 18, **characterized in that** the light emitting layer contains a second organic compound that differs from the organic compound.

20. The organic light emitting element according to claim 19, **characterized in that** a concentration of the organic compound is 0.01% by mass or more and 50% by mass or less with respect to the whole light emitting layer.

21. The organic light emitting element according to claim 20, **characterized in that** the concentration of the organic compound is 10% by mass or more and 50% by mass or less with respect to the whole light emitting layer.

22. The organic light emitting element according to claim 19, **characterized in that** the light emitting layer contains a third organic compound that differs from both the organic compound and the second organic compound.

23. The organic light emitting element according to claim 22, **characterized in that** a concentration of the organic compound is 1% by mass or more and 50% by mass or less with respect to the whole light emitting layer.

24. The organic light emitting element according to claim 23, **characterized in that** the concentration of the organic compound is 10% by mass or more and 50% by mass or less with respect to the whole light emitting layer.

25. The organic light emitting element according to claim 18, **characterized in that** a concentration of the organic compound is 80% by mass or more with respect to the whole light emitting layer.

26. An ink composition **characterized by** containing the organic compound according to any one of claims 1 to 16.

27. A display device **characterized by** comprising a plurality of pixels,
wherein at least one of the plurality of pixels includes the organic light emitting element according to any one of claims 17 to 25 and a transistor connected to the organic light emitting element.

28. A photoelectric conversion device **characterized by** comprising:

an optical unit including a plurality of lenses;
an imaging element configured to receive light that has passed through the optical unit; and
a display unit configured to display an image captured by the imaging element,
wherein the display unit includes the organic light emitting element according to any one of claims 17 to 25.

29. An electronic device **characterized by** comprising:

a display unit including the organic light emitting element according to any one of claims 17 to 25;
a housing in which the display unit is provided; and
a communication unit provided in the housing and configured to communicate with an external device.

30. An illumination device **characterized by** comprising:

a light source including the organic light emitting element according to any one of claims 17 to 25; and
a light diffusion unit or an optical filter through which light emitted from the light source passes.

31. A movable body **characterized by** comprising:

a lighting device including the organic light emitting element according to any one of claims 17 to 25; and
a body provided with the lighting device.

32. An exposure light source for an electrophotographic image forming device **characterized by** comprising the organic light emitting element according to any one of claims 17 to 25.

F I G. 1A

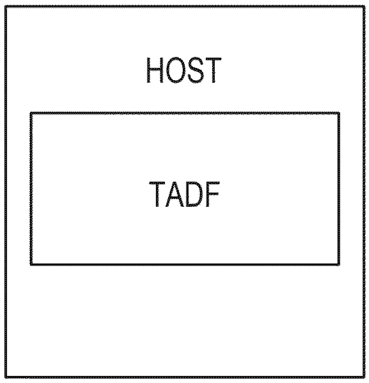


F I G. 1B

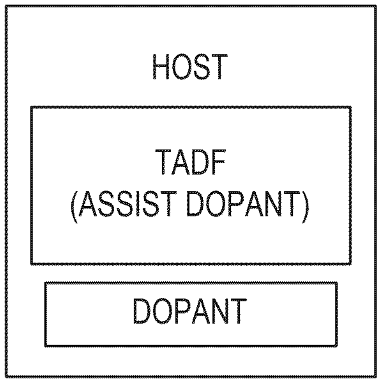


F I G. 1C

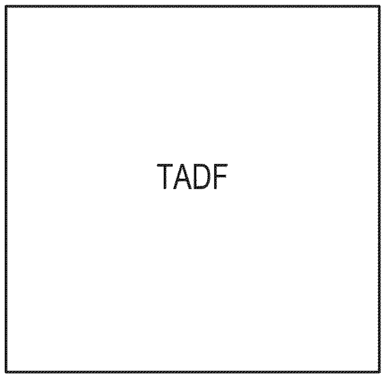


F I G. 1D

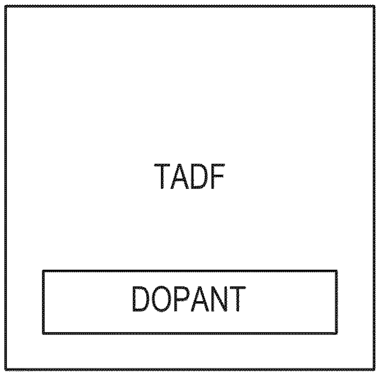

# FIG. 2A

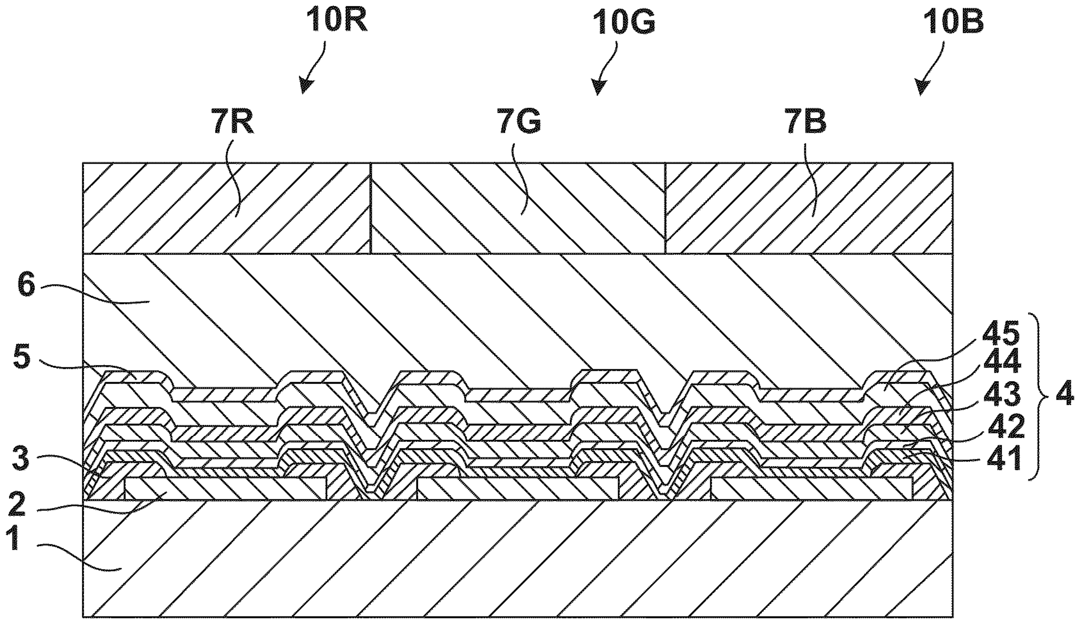

10R
10G
10B
7R
7G
7B
6
5
3
2
1
45
44
43
42
41
4


# FIG. 2B

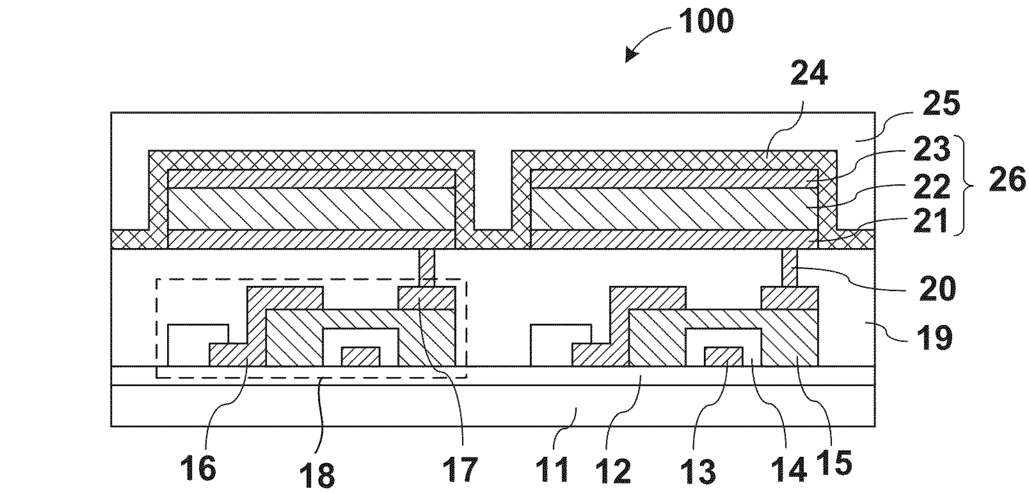

100
24
25
23
22
21
26
20
19
16
18
17
11
12
13
14
15

# FIG. 3

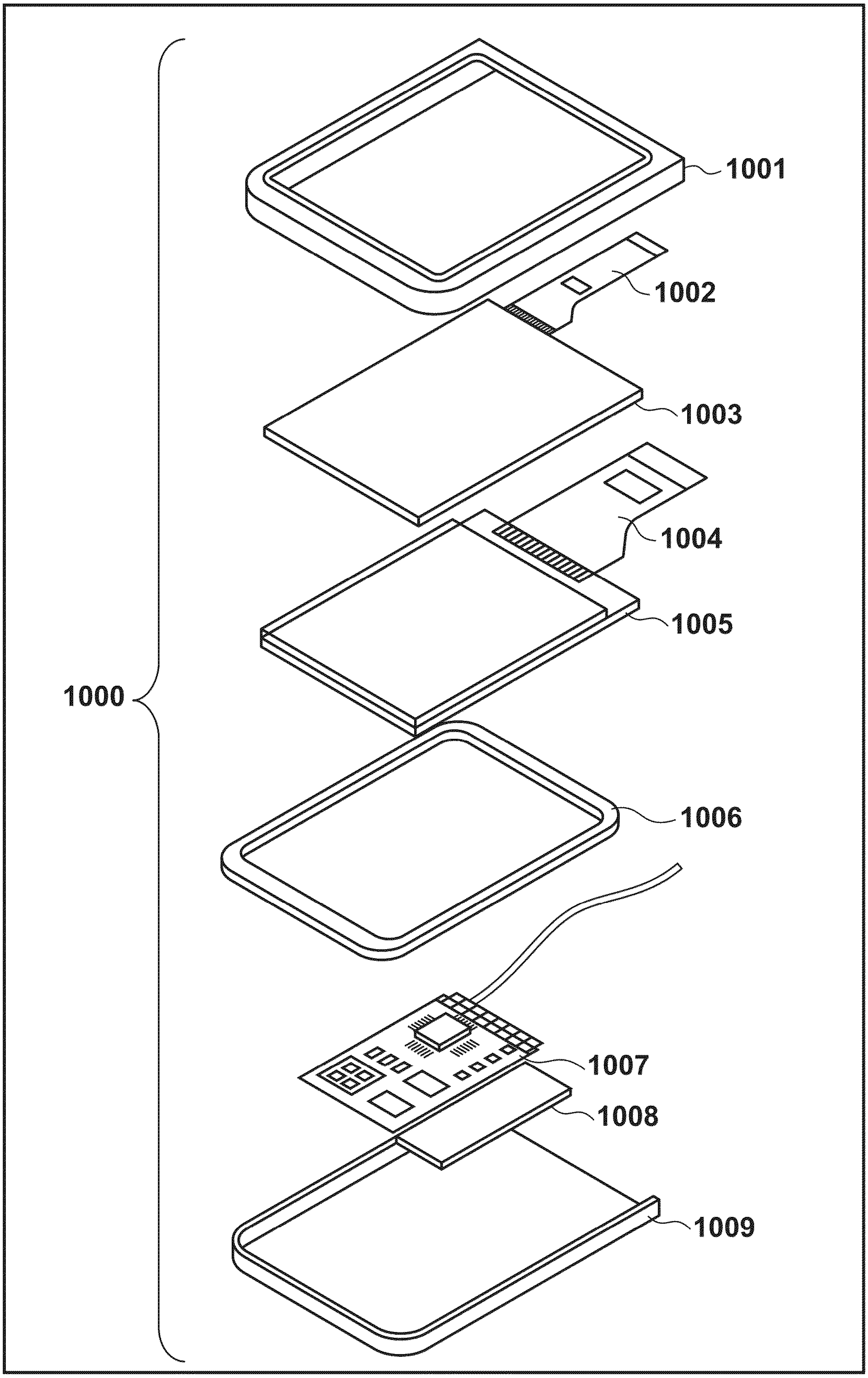

F I G. 4A

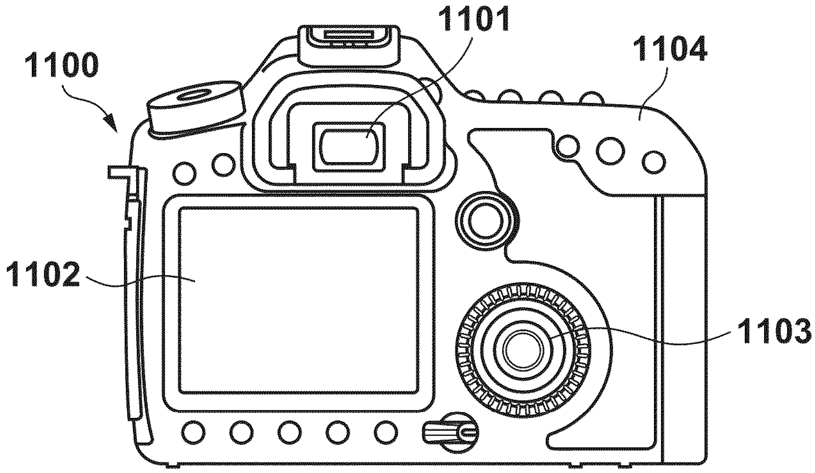


F I G. 4B

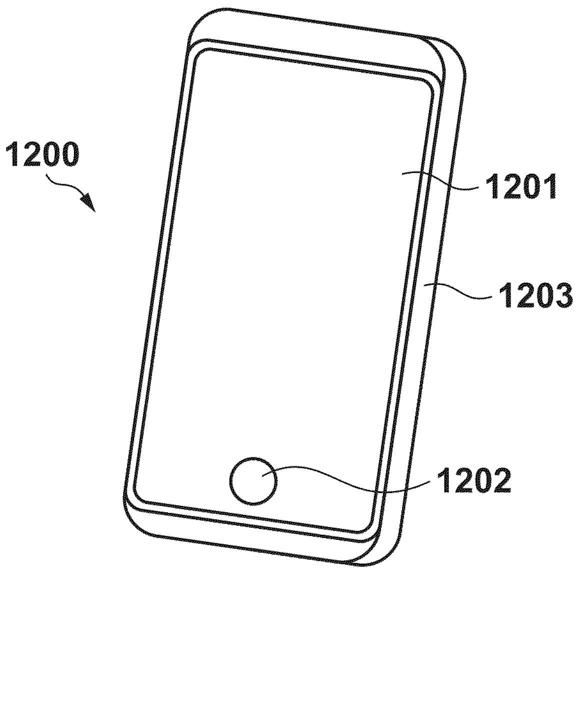

# FIG. 5A

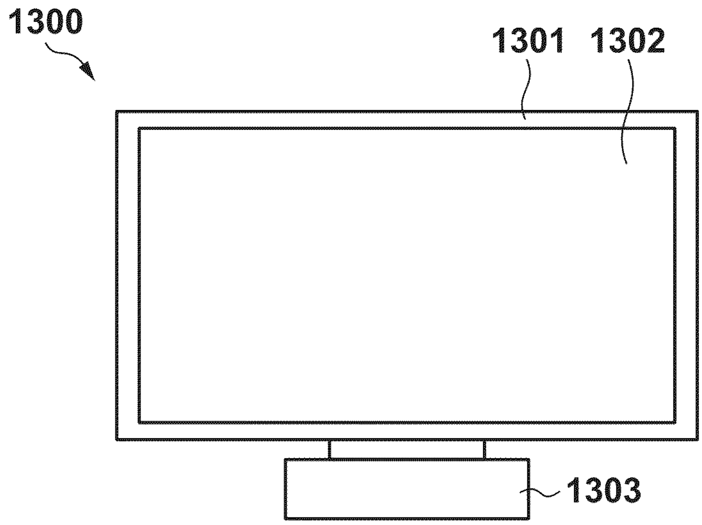


# FIG. 5B

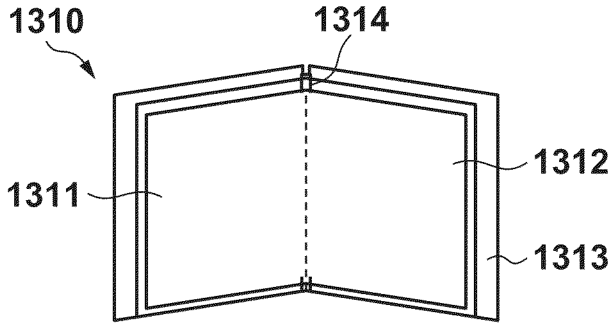

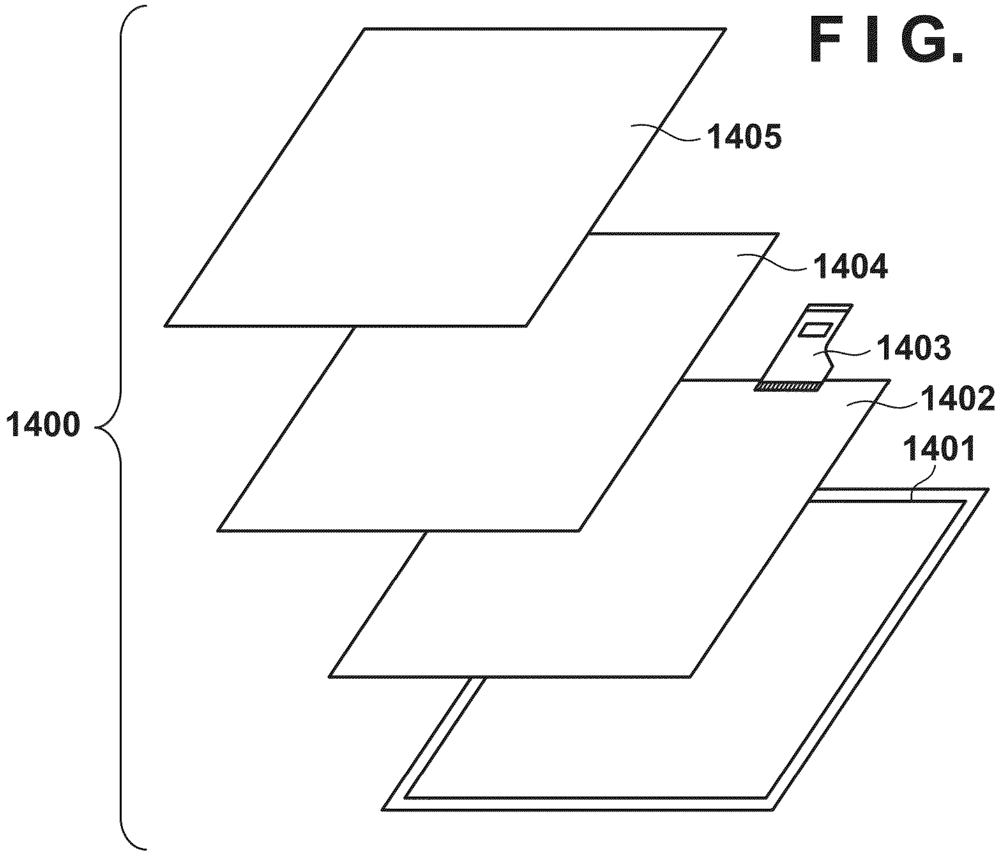


FIG. 6A

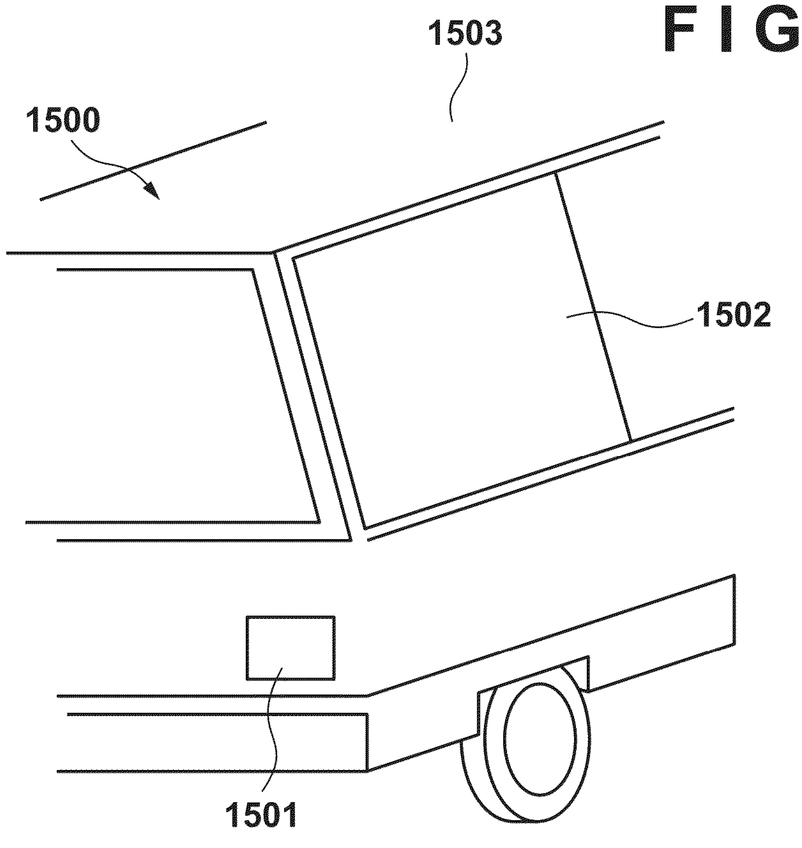


FIG. 6B

FIG. 7A

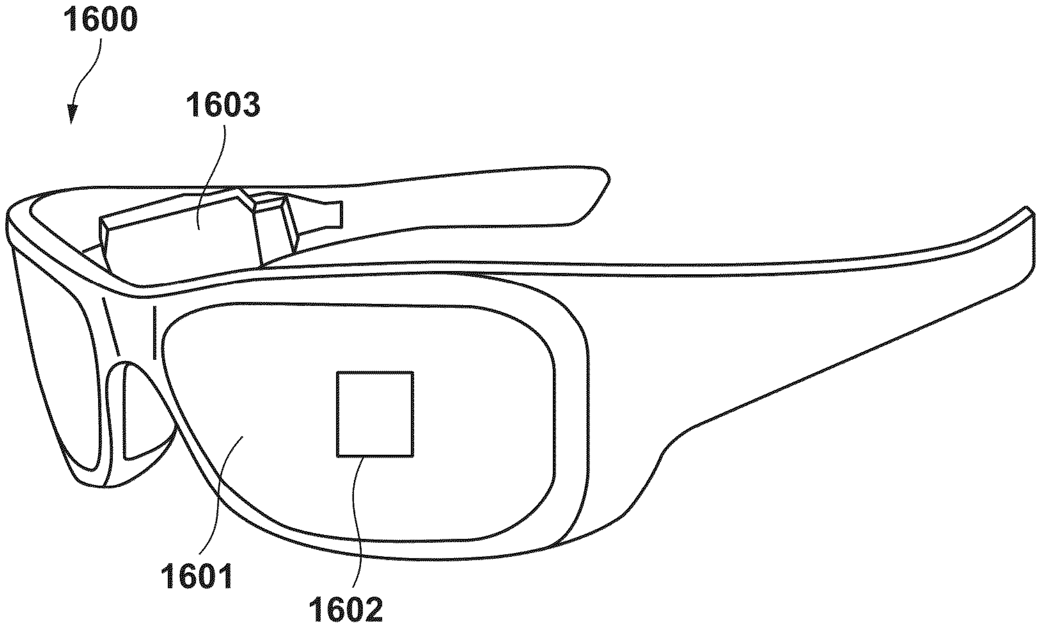


FIG. 7B

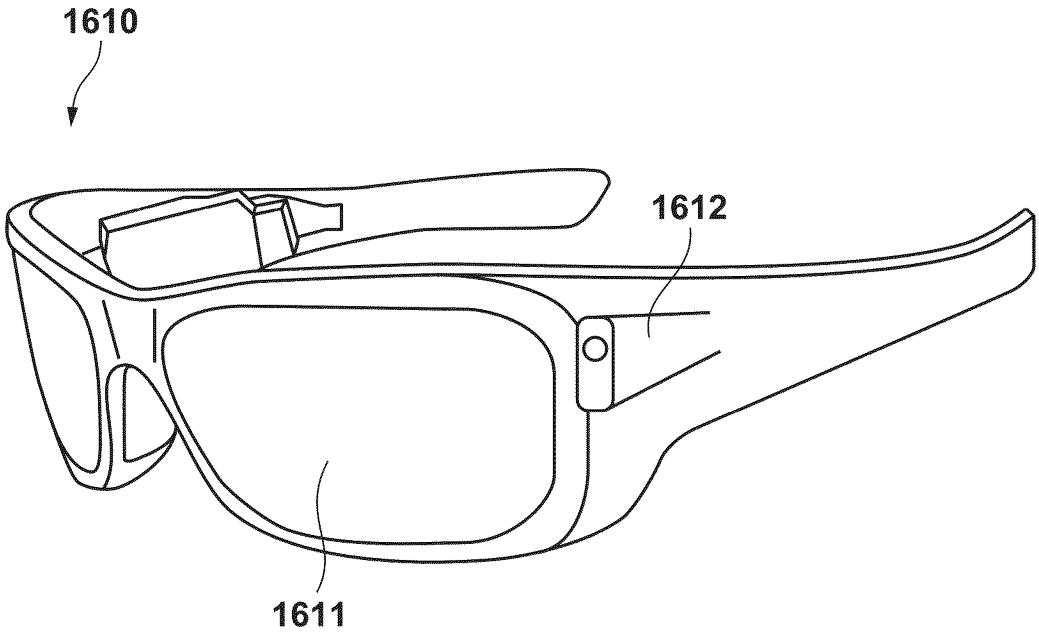

FIG. 8A

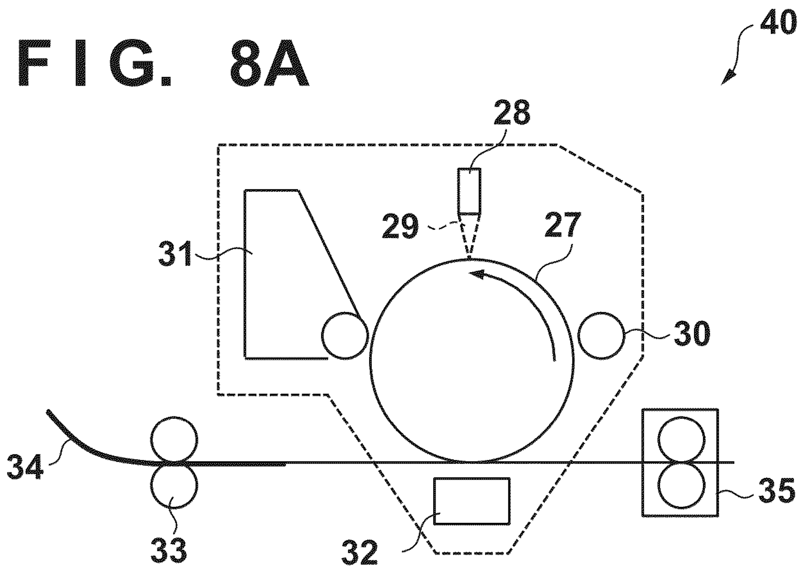


FIG. 8B

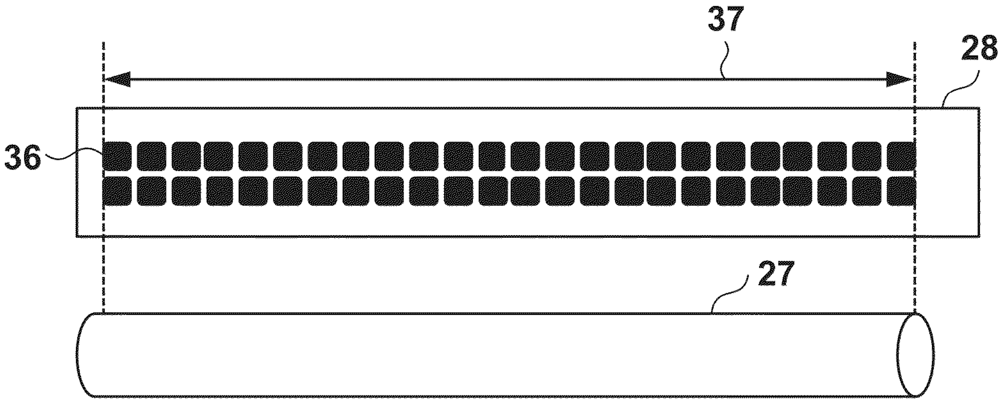


FIG. 8C

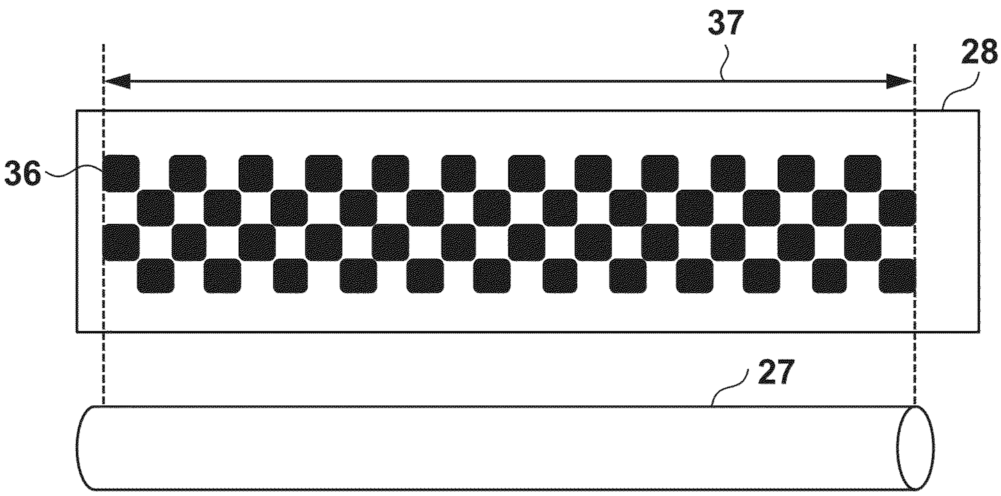

## INTERNATIONAL SEARCH REPORT

International application No.
**PCT/JP2024/016708**

### A. CLASSIFICATION OF SUBJECT MATTER

***C07F 5/02***(2006.01)i; ***C09D 11/00***(2014.01)i; ***C09K 11/06***(2006.01)i; ***H10K 50/12***(2023.01)i; ***H10K 50/854***(2023.01)i; ***H10K 59/00***(2023.01)i; ***H10K 59/10***(2023.01)i; ***H10K 59/123***(2023.01)i; ***H10K 59/65***(2023.01)i; ***H10K 59/90***(2023.01)i; ***H10K 59/95***(2023.01)i; ***H10K 71/12***(2023.01)i; ***H10K 85/30***(2023.01)i; ***H10K 85/60***(2023.01)i; *H10K 101/20*(2023.01)n; *H10K 101/40*(2023.01)n

FI: C07F5/02 F CSP; C09D11/00; C09K11/06 660; H10K50/12; H10K50/854; H10K59/00; H10K59/10; H10K59/123; H10K59/65; H10K59/90; H10K59/95; H10K71/12; H10K85/30; H10K85/60; H10K101:20; H10K101:40

According to International Patent Classification (IPC) or to both national classification and IPC

### B. FIELDS SEARCHED

Minimum documentation searched (classification system followed by classification symbols)

C07F5/02; C09D11/00; C09K11/06; H10K50/12; H10K50/854; H10K59/00; H10K59/10; H10K59/123; H10K59/65; H10K59/90; H10K59/95; H10K71/12; H10K85/30; H10K85/60; H10K101/20; H10K101/40

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| A | WO 2022/009883 A1 (NIPPON STEEL CHEMICAL & MATERIAL CO., LTD.) 13 January 2022 (2022-01-13)<br>claims, paragraph [0032] | 1-32 |
| A | US 2020/0044159 A1 (SAMSUNG DISPLAY CO., LTD.) 06 February 2020 (2020-02-06)<br>p. 80 | 1-32 |
| A | CN 114671872 A (QINGHUA UNIVERSITY) 28 June 2022 (2022-06-28)<br>p. 34 | 1-32 |
| A | CN 112645969 A (CHANGCHUN INSTITUTE OF APPLIED CHEMISTRY, CHINESE ACADEMY OF SCIENCES) 13 April 2021 (2021-04-13)<br>claims | 1-32 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 July 2024** | **16 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (July 2022)

**INTERNATIONAL SEARCH REPORT**

International application No.
**PCT/JP2024/016708**

**C. DOCUMENTS CONSIDERED TO BE RELEVANT**

| Category* | Citation of document, with indication, where appropriate, of the relevant passages | Relevant to claim No. |
|---|---|---|
| A | KOBAYASHI, J. et al. Synthesis of Dibenzochalcogenaborins and Systematic Comparisons of Their Optical Properties by Changing a Bridging Chalcogen Atom. Chemistry An Asian Journal. 23 December 2008, vol. 4, no. 1, pp. 42-49<br>abstract | 1-32 |

Form PCT/ISA/210 (second sheet) (July 2022)

**INTERNATIONAL SEARCH REPORT**
**Information on patent family members**

International application No.
**PCT/JP2024/016708**

| Patent document cited in search report | Publication date (day/month/year) | Patent family member(s) | Publication date (day/month/year) |
|---|---|---|---|
| WO 2022/009883 A1 | 13 January 2022 | US 2023/0309400 A1<br>claims, paragraph [0036]<br>EP 4180500 A1<br>KR 10-2023-0035528 A<br>CN 115943193 A | |
| US 2020/0044159 A1 | 06 February 2020 | KR 10-2020-0014451 A<br>p. 9<br>CN 110776509 A | |
| CN 114671872 A | 28 June 2022 | (Family: none) | |
| CN 112645969 A | 13 April 2021 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2022009883 A
- WO 2015072537 A
- JP 2023076114 A
- JP 2024049552 A


### Non-patent literature cited in the description


- *Nat Commun*, 2020, vol. 11 (3909), s41467
- *Angew. Chem. Int. Ed.*, 2022, vol. 61, e202205684